# EUROPEAN PATENT SPECIFICATION

(11) **EP 4 299 692 B1**
(45) Date of publication and mention of the grant of the patent: **14.05.2025**
(21) Application number: 23162080.8
(22) Date of filing: 15.03.2023
(51) Int. Cl.: H10K 85/60, C09K 11/06, C07F 15/00, H10K 50/11

(54) **ORGANOMETALLIC COMPOUND, ORGANIC LIGHT-EMITTING DEVICE INCLUDING THE SAME, AND ELECTRONIC APPARATUS INCLUDING THE ORGANIC LIGHT-EMITTING DEVICE**
ORGANOMETALLISCHE VERBINDUNG, ORGANISCHE LICHTEMITTIERENDE VORRICHTUNG DAMIT UND ELEKTRONISCHE VORRICHTUNG MIT DER ORGANISCHEN LICHTEMITTIERENDEN VORRICHTUNG
COMPOSÉ ORGANOMÉTALLIQUE, DISPOSITIF ÉLECTROLUMINESCENT ORGANIQUE LE COMPRENANT ET APPAREIL ÉLECTRONIQUE COMPRENANT LE DISPOSITIF ÉLECTROLUMINESCENT ORGANIQUE

(30) Priority: 30.06.2022 KR 20220080854
(43) Date of publication of application: 03.01.2024
(73) Proprietor: Samsung Electronics Co., Ltd., Suwon-si, Gyeonggi-do 16677 (KR)
(72) Inventor: KIM, Hwang Suk, 16678 Suwon-si (KR); PARK, Sangho, 16678 Suwon-si (KR); MIN, Minsik, 16678 Suwon-si (KR); BAE, Hyejin, 16678 Suwon-si (KR); JEON, Soonok, 16678 Suwon-si (KR); CHOI, Hyesung, 16678 Suwon-si (KR); KANG, Hosuk, 16678 Suwon-si (KR); KIM, Jong Soo, 16678 Suwon-si (KR); WON, Joonghee, 16678 Suwon-si (KR); CHWAE, Jun, 16678 Suwon-si (KR)
(74) Representative: Elkington and Fife LLP

(56) References cited:
- EP-A1- 3 822 280

## Description

### FIELD OF THE INVENTION

The subject matter relates to an organometallic compound, an organic light-emitting device including the same, and an electronic apparatus including the organic light-emitting device.

### BACKGROUND OF THE INVENTION

Organic light-emitting devices (OLEDs) are self-emissive devices, which have improved characteristics in terms of viewing angles, response time, luminance, driving voltage, and response speed. In addition, OLEDS can produce full-color images.

In a typical example, an organic light-emitting device may include an anode, a cathode, and an organic layer arranged between the anode and the cathode, wherein the organic layer includes an emission layer. A hole transport region may be arranged between the anode and the emission layer, and an electron transport region may be arranged between the emission layer and the cathode. Holes provided from the anode may move toward the emission layer through the hole transport region, and electrons provided from the cathode may move toward the emission layer through the electron transport region. The holes and the electrons recombine in the emission layer to produce excitons. These excitons may transition from an excited state to a ground state, thereby generating light. Organic light-emitting devices are known from EP 3 822 280 A1, for instance.

### SUMMARY OF THE INVENTION

Provided are an organometallic compound, an organic light-emitting device including the same, and an electronic apparatus including the organic light-emitting device.

According to an aspect, provided is an organometallic compound represented by Formula 1: 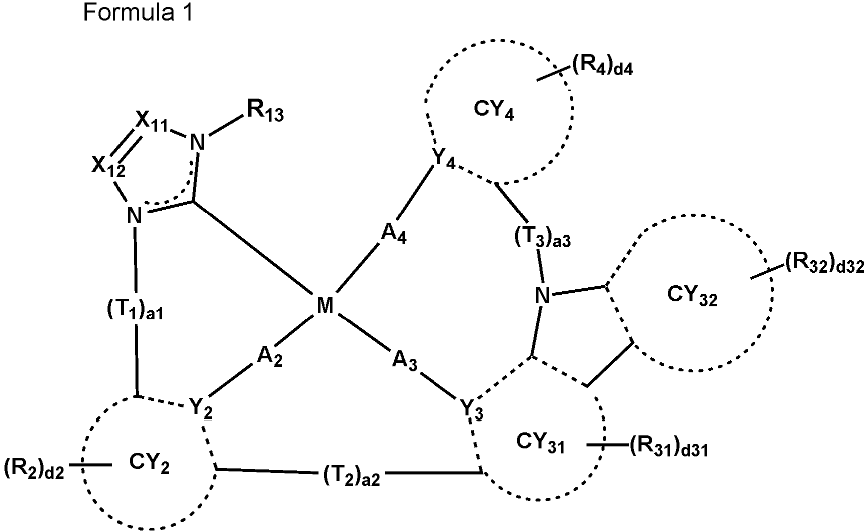 wherein, in Formula 1,
M is a transition metal, X11 is N and X12 is C(R12), or X11 is C(R11) and X12 is N;
ring CY₂, ring CY₃₁, ring CY₃₂, and ring CY₄ are each independently a C₃-C₆₀ carbocyclic group or a C₁-C₆₀ heterocyclic group,
Y₂ to Y₄ are each independently C or N,
A₂ to A₄ are each independently a chemical bond, O, or S,
T1 may be *-N[(L₁)_{b1}-(R₁ₐ)]-*', *-B(R₁ₐ)-*', *-P(R₁ₐ)-*', *-C(R₁ₐ)(R_{1b})-*', *-Si(R₁ₐ)(R_{1b})-*', *-Ge(R₁ₐ)(R_{1b})-*', *-S-*', *-Se-*', *-O-*', *-C(=O)-*', *-S(=O)-*', *-S(=O)2-*', *-C(R₁ₐ)=*', *=C(R₁ₐ)-*', *-C(R₁ₐ)=C(R_{1b})-*', *-C(=S)-*', or *-C≡C-*',
T2 may be *-N[(L₂)_{b2}-(R₂ₐ)]-*', *-B(R₂ₐ)-*', *-P(R₂ₐ)-*', *-C(R₂ₐ)(R_{2b})-*', *-Si(R₂ₐ)(R_{2b})-*', *-Ge(R₂ₐ)(R_{2b})-*', *-S-*', *-Se-*', *-O-*', *-C(=O)-*', *-S(=O)-*', *-S(=O)₂-*', *-C(R₂ₐ)=*', *=C(R₂ₐ)-*', *-C(R₂ₐ)=C(R_{2b})-*', *-C(=S)-*', or *-C≡C-*',
T3 may be *-N[(L₃)_{b3}-(R₃ₐ)]-*', *-B(R₃ₐ)-*', *-P(R₃ₐ)-*', *-C(R₃ₐ)(R_{3b})-*', *-Si(R₃ₐ)(R_{3b})-*', *-Ge(R₃ₐ)(R_{3b})-*', *-S-*', *-Se-*', *-O-*', *-C(=O)-*', *-S(=O)-*', *-S(=O)₂-*', *-C(R₃ₐ)=*', *=C(R₃ₐ)-*', *-C(R₃ₐ)=C(R_{3b})-*', *-C(=S)-*', or *-C≡C-*',
a1 to a3 are each independently an integer from 1 to 3,
* and *' each indicate a binding site to a neighboring atom,
L₁ to L₃ are each independently a single bond, a C₅-C₃₀ carbocyclic group unsubstituted or substituted with at least one R₁₀ₐ, or a C₁-C₃₀ heterocyclic group unsubstituted or substituted with at least one R₁₀ₐ,
b1 to b3 are each independently an integer from 1 to 3,
R₁ₐ, R_{1b}, R₂, R₂ₐ, R_{2b}, R₃ₐ, R_{3b}, R₄, R₁₀ₐ, R₁₁ to R₁₃, R₃₁, and R₃₂ are each independently hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₂-C₁₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a substituted or unsubstituted C₁-C₆₀ heteroaryloxy group, a substituted or unsubstituted C₁-C₆₀ heteroarylthio group, a substituted or unsubstituted monovalent non-aromatic condensed polycyclic group, a substituted or unsubstituted monovalent non-aromatic condensed heteropolycyclic group, -Si(Q₁)(Q₂)(Q₃), -Ge(Q₁)(Q₂)(Q₃), -N(Q₄)(Q₅), - B(Q₆)(Q₇), -P(Q₈)(Q₉), or -P(=O)(Q₈)(Q₉),
d2, d31, d32, and d4 are each independently an integer from 0 to 10,
at least one substituent of the substituted C₅-C₃₀ carbocyclic group, the substituted C₁-C₃₀ heterocyclic group, the substituted C₁-C₆₀ alkyl group, the substituted C₂-C₆₀ alkenyl group, the substituted C₂-C₆₀ alkynyl group, the substituted C₁-C₆₀ alkoxy group, the substituted C₁-C₆₀ alkylthio group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₇-C₆₀ alkyl aryl group, the substituted C₇-C₆₀ aryl alkyl group, the substituted C₆-C₆₀ aryloxy group, the substituted C₆-C₆₀ arylthio group, the substituted C₁-C₆₀ heteroaryl group, the substituted C₂-C₆₀ alkyl heteroaryl group, the substituted C₂-C₆₀ heteroaryl alkyl group, the substituted C₁-C₆₀ heteroaryloxy group, the substituted C₁-C₆₀ heteroarylthio group, the substituted monovalent non-aromatic condensed polycyclic group, and the substituted monovalent non-aromatic condensed heteropolycyclic group is:
   deuterium, -F, -Cl, -Br, -I, -SF₅, -CD₃, -CD₂H, -CDH₂, -CF₃, -CF₂H, - CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, or a C₁-C₆₀ alkylthio group,
   a C₁-C₆₀ alkyl group, a C₂-C₆₀ alkenyl group, a C₂-C₆₀ alkynyl group, a C₁-C₆₀ alkoxy group, or a C₁-C₆₀ alkylthio group, each substituted with at least one of deuterium, -F, -Cl, -Br, -I, -SF₅, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -Si(Q₁₁)(Q₁₂)(Q₁₃), - Ge(Q₁₁)(Q₁₂)(Q₁₃), -N(Q₁₄)(Q₁₅), -B(Q₁₆)(Q₁₇), -P(Q₁₈)(Q₁₉), -P(=O)(Q₁₈)(Q₁₉), or a combination thereof,
   a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, or a monovalent non-aromatic condensed heteropolycyclic group,
   a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a monovalent non-aromatic condensed polycyclic group, or a monovalent non-aromatic condensed heteropolycyclic group, each substituted with at least one of deuterium, -F, -Cl, -Br, -I, -SF₅, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -Si(Q₂₁)(Q₂₂)(Q₂₃), - Ge(Q₂₁)(Q₂₂)(Q₂₃), -N(Q₂₄)(Q₂₅), -B(Q₂₆)(Q₂₇), -P(Q₂₈)(Q₂₉), -P(=O)(Q₂₈)(Q₂₉), or a combination thereof, or
   -Si(Q₃₁)(Q₃₂)(Q₃₃), -Ge(Q₃₁)(Q₃₂)(Q₃₃), -N(Q₃₄)(Q₃₅), -B(Q₃₆)(Q₃₇), - P(Q₃₈)(Q₃₉), or -P(=O)(Q₃₈)(Q₃₉), and
   Q₁ to Q₉, Q₁₁ to Q₁₉, Q₂₁ to Q₂₉, and Q₃₁ to Q₃₉ are each independently hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a substituted or unsubstituted C₁-C₆₀ heteroaryloxy group, a substituted or unsubstituted C₁-C₆₀ heteroarylthio group, a substituted or unsubstituted monovalent non-aromatic condensed polycyclic group, or a substituted or unsubstituted monovalent non-aromatic condensed heteropolycyclic group.

According to another aspect, an organic light-emitting device includes a first electrode, a second electrode, and an organic layer arranged between the first electrode and the second electrode, wherein the organic layer includes an emission layer, and wherein the organic layer further includes at least one of the organometallic compound.

According to still another aspect, an electronic apparatus includes the organic light-emitting device.

Additional aspects will be set forth in part in the detailed description that follows and, in part, will be apparent from the detailed description, or may be learned by practice of the presented exemplary embodiments.

### BRIEF DESCRIPTION OF THE DRAWINGS

The above and other aspects, features, and advantages of certain exemplary embodiments will be more apparent from the following detailed description taken in conjunction with the accompanying drawings, in which:
FIG. 1 is a schematic cross-sectional view of an organic light-emitting device according to one or more embodiments;
FIG. 2 is a graph of normalized intensity (arbitrary units, a.u.) versus wavelength (nanometers, nm) and shows photoluminescence (PL) spectra of compounds according to one or more exemplary embodiments and comparative compounds;

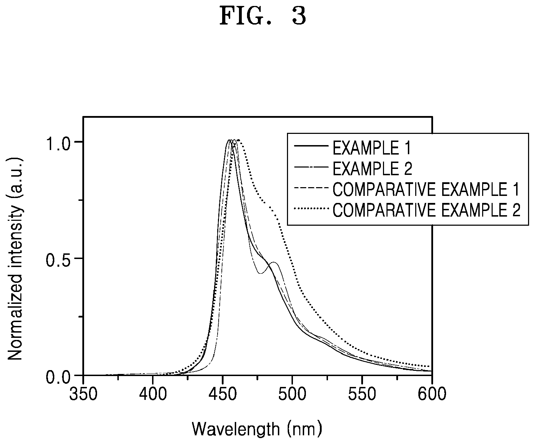

FIG. 3 is a graph of normalized intensity (a.u.) versus wavelength (nm) and shows electroluminescence (EL) spectra of light-emitting devices respectively including compounds according to one or more exemplary embodiments and comparative compounds; and
FIG. 4 is a graph of luminance (candela per square meter, cd/m²) versus voltage (Volts, V) and shows luminance of compounds according to one or more exemplary embodiments and comparative compounds according to voltages.

### DETAILED DESCRIPTION OF THE EMBODIMENTS

Reference will now be made in further detail to exemplary embodiments, examples of which are illustrated in the accompanying drawings, wherein like reference numerals refer to like elements throughout. In this regard, the present exemplary embodiments may have different forms and should not be construed as being limited to the detailed descriptions set forth herein. Accordingly, the exemplary embodiments are merely described in further detail below, and by referring to the figures, to explain particular aspects and features. As used herein, the term "and/or" includes any and all combinations of one or more of the associated listed items. Expressions such as "at least one of," when preceding a list of elements, modify the entire list of elements and do not modify the individual elements of the list.

The terminology used herein is for the purpose of describing one or more exemplary embodiments only and is not intended to be limiting. As used herein, the singular forms "a," "an," and "the" are intended to include the plural forms as well, unless the context clearly indicates otherwise. The term "or" means "and/or." It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

It will be understood that, although the terms first, second, third etc. may be used herein to describe various elements, components, regions, layers, and/or sections, these elements, components, regions, layers, and/or sections should not be limited by these terms. These terms are only used to distinguish one element, component, region, layer, or section from another element, component, region, layer, or section. Thus, a first element, component, region, layer, or section discussed below could be termed a second element, component, region, layer, or section without departing from the teachings of the present embodiments.

Exemplary embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

It will be understood that when an element is referred to as being "on" another element, it can be directly in contact with the other element or intervening elements may be present therebetween. In contrast, when an element is referred to as being "directly on" another element, there are no intervening elements present.

Unless otherwise defined, all terms (including technical and scientific terms) used herein have the same meaning as commonly understood by one of ordinary skill in the art to which this general inventive concept belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ± 30%, 20%, 10%, 5% of the stated value.

Hereinafter, a work function or a highest occupied molecular orbital (HOMO) energy level is expressed as an absolute value from a vacuum level. In addition, when the work function or the HOMO energy level is referred to be "deep," "high" or "large," the work function or the HOMO energy level has a large absolute value based on "0 eV" of the vacuum level, while when the work function or the HOMO energy level is referred to be "shallow," "low," or "small," the work function or HOMO energy level has a small absolute value based on "0 eV" of the vacuum level.

An aspect provides an organometallic compound represented by Formula 1: 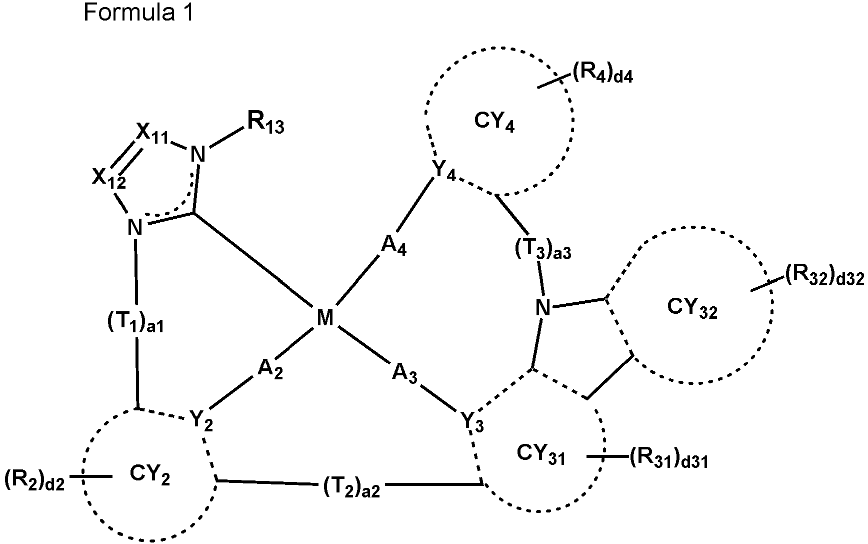 wherein, in Formula 1,
M is a transition metal.

In one or more embodiments, M in Formula 1 may be a first-row transition metal of the Periodic Table of Elements, a second-row transition metal of the Periodic Table of Elements, or a third-row transition metal of the Periodic Table of Elements.

For example, M in Formula 1 may be iridium (Ir), platinum (Pt), osmium (Os), titanium (Ti), zirconium (Zr), hafnium (Hf), europium (Eu), terbium (Tb), thulium (Tm), rhodium (Rh), palladium (Pd), or gold (Au).

In one or more embodiments, M in Formula 1 may be platinum, palladium, or gold.

For example, M in Formula 1 may be platinum.

In Formula 1,
i) X₁₁ is N, and X₁₂ is C(R12),
ii) X₁₁ is C(R₁₁), and X₁₂ is
   and
R₁₁ and R₁₂ are each as described herein.

In Formula 1, ring CY₂, ring CY₃₁, ring CY₃₂, and ring CY₄ are each independently a C₃-C₆₀ carbocyclic group or a C₁-C₆₀ heterocyclic group.

In one or more embodiments, ring CY₂, ring CY₃₁, ring CY₃₂, and ring CY₄ may each independently be a benzene group, a naphthalene group, an anthracene group, a phenanthrene group, a triphenylene group, a pyrene group, a chrysene group, a cyclopentadiene group, a 1,2,3,4-tetrahydronaphthalene group, a thiophene group, a furan group, an indole group, a benzoborole group, a benzophosphole group, an indene group, a benzosilole group, a benzogermole group, a benzothiophene group, a benzoselenophene group, a benzofuran group, a carbazole group, a dibenzoborole group, a dibenzophosphole group, a fluorene group, a dibenzosilole group, a dibenzogermole group, a dibenzothiophene group, a dibenzoselenophene group, a dibenzofuran group, a dibenzothiophene 5-oxide group, a 9H-fluoren-9-one group, a dibenzothiophene 5,5-dioxide group, an azaindole group, an azabenzoborole group, an azabenzophosphole group, an azaindene group, an azabenzosilole group, an azabenzogermole group, an azabenzothiophene group, an azabenzoselenophene group, an azabenzofuran group, an azacarbazole group, an azadibenzoborole group, an azadibenzophosphole group, an azafluorene group, an azadibenzosilole group, an azadibenzogermole group, an azadibenzothiophene group, an azadibenzoselenophene group, an azadibenzofuran group, an azadibenzothiophene 5-oxide group, an aza-9H-fluoren-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an isoxazole group, a thiazole group, an isothiazole group, an oxadiazole group, a thiadiazole group, a benzopyrazole group, a benzimidazole group, a benzotriazole, a benzoxazole group, a benzothiazole group, a benzoxadiazole group, a benzothiadiazole group, a 5,6,7,8-tetrahydroisoquinoline group, or a 5,6,7,8-tetrahydroquinoline group.

Y₂ to Y₄ are each independently C or N.

In one or more embodiments, at least one of Y₂ to Y₄ may be N.

In one or more embodiments, Y₂ may be C, Y₃ may be C, and Y₄ may be N;
Y₂ may be N, Y₃ may be C, and Y₄ may be C;
Y₂ may be C, Y₃ may be N, and Y₄ may be C;
Y₂ may be N, Y₃ may be C, and Y₄ may be N;
Y₂ may be N, Y₃ may be N, and Y₄ may be C;
Y₂ may be C, Y₃ may be N, and Y₄ may be N; or
Y₂ may be N, Y₃ may be N, and Y₄ may be N.

A₂ to A₄ are each independently a chemical bond, O, or S.

The chemical bond may be a covalent bond, a metal bond, or a coordinate bond, but embodiments are not limited thereto.

T₁ may be a single bond, a double bond, *-N[(L₁)_{b1}-(R₁ₐ)]-*', *-B(R₁ₐ)-*', *- P(R₁ₐ)-*', *-C(R₁ₐ)(R_{1b})-*', *-Si(R₁ₐ)(R_{1b})-*', *-Ge(R₁ₐ)(R_{1b})-*', *-S-*', *-Se-*', *-O-*', *- C(=O)-*', *-S(=O)-*', *-S(=O)₂-*', *-C(R₁ₐ)=*', *=C(R₁ₐ)-*', *-C(R₁ₐ)=C(R_{1b})-*', *-C(=S)-*', or *-C≡C-*'.

T₂ may be a single bond, a double bond, *-N[(L₂)_{b2}-(R₂ₐ)]-*', *-B(R₂ₐ)-*', *-P(R₂ₐ)-*', *-C(R₂ₐ)(R_{2b})-*', *-Si(R₂ₐ)(R_{2b})-*', *-Ge(R₂ₐ)(R_{2b})-*', *-S-*', *-Se-*', *-O-*', *- C(=O)-*', *-S(=O)-*', *-S(=O)₂-*', *-C(R₂ₐ)=*', *=C(R₂ₐ)-*', *-C(R₂ₐ)=C(R_{2b})-*', *-C(=S)-*', or *-C≡C-*'.

T₃ may be a single bond, a double bond, *-N[(L₃)_{b3}-(R₃ₐ)]-*', *-B(R₃ₐ)-*', *-P(R₃ₐ)-*', *-C(R₃ₐ)(R_{3b})-*', *-Si(R₃ₐ)(R_{3b})-*', *-Ge(R₃ₐ)(R_{3b})-*', *-S-*', *-Se-*', *-O-*', *-C(=O)-*', *-S(=O)-*', *-S(=O)₂-*', *-C(R₃ₐ)=*', *=C(R₃ₐ)-*', *-C(R₃ₐ)=C(R_{3b})-*', *-C(=S)-*', or *-C≡C-*'.

a1 to a3 in Formula 1 respectively indicate the number of T₁(s) to the number of T₃(s) and may each independently be an integer from 1 to 3 (for example, 1, 2, or 3).

a1 to a3 are each independently an integer from 1 to 3.

In one or more embodiments, at least one of T₁ and T₃ may be a single bond.

For example, T₁ may be a single bond; T₃ may be a single bond; or T₁ and T₃ may each be a single bond.

When a1 is 2 or greater, two or more of T₁ may be identical to or different from each other, when a2 is 2 or greater, two or more of T₂ may be identical to or different from each other, and when a3 is 2 or greater, two or more of T₃ may be identical to or different from each other.

In one or more embodiments, T₂ may be *-N[(L₂)_{b2}-(R₂ₐ)]-*', *-S-*', *-Se-*', or *-O-*', and a2 may be 1.

In one or more embodiments, T₂ may be *-O-*' and a2 may be 1.

* and *' each indicate a binding site to a neighboring atom in the formulae for T₁, T₂, and T₃.

L₁ to L₃ are each independently a single bond, a C₅-C₃₀ carbocyclic group unsubstituted or substituted with at least one R₁₀ₐ, or a C₁-C₃₀ heterocyclic group unsubstituted or substituted with at least one R₁₀ₐ.

b1 to b3 are each independently an integer from 1 to 3.

R₁ₐ, R_{1b}, R₂, R₂ₐ, R_{2b}, R₃ₐ, R_{3b}, R₄, R₁₀ₐ, R₁₁ to R₁₃, R₃₁, and R₃₂ are each independently hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₂-C₁₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a substituted or unsubstituted C₁-C₆₀ heteroaryloxy group, a substituted or unsubstituted C₁-C₆₀ heteroarylthio group, a substituted or unsubstituted monovalent non-aromatic condensed polycyclic group, a substituted or unsubstituted monovalent non-aromatic condensed heteropolycyclic group, -Si(Q₁)(Q₂)(Q₃), -Ge(Q₁)(Q₂)(Q₃), - N(Q₄)(Q₅), -B(Q₆)(Q₇), -P(Q₈)(Q₉), or -P(=O)(Q₈)(Q₉).

d2, d31, d32, and d4 are each independently an integer from 0 to 10.

d2, d31, d32, and d4 in Formula 1 respectively indicate the number of R₂, the number of R₃₁, the number of R₃₂, and the number of R₄, and may each independently be an integer from 0 to 10 (for example, 0, 1, 2, 3, or 4). When d2 is 2 or greater, two or more of R₂ may be identical to or different from each other, when d31 is 2 or greater, two or more of R₃₁ may be identical to or different from each other, when d32 is 2 or greater, two or more of R₃₂ may be identical to or different from each other, and when d4 is 2 or greater, two or more of R₄ may be identical to or different from each other.

At least one substituent of the substituted C₅-C₃₀ carbocyclic group, the substituted C₁-C₃₀ heterocyclic group, the substituted C₁-C₆₀ alkyl group, the substituted C₂-C₆₀ alkenyl group, the substituted C₂-C₆₀ alkynyl group, the substituted C₁-C₆₀ alkoxy group, the substituted C₁-C₆₀ alkylthio group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₇-C₆₀ alkyl aryl group, the substituted C₇-C₆₀ aryl alkyl group, the substituted C₆-C₆₀ aryloxy group, the substituted C₆-C₆₀ arylthio group, the substituted C₁-C₆₀ heteroaryl group, the substituted C₂-C₆₀ alkyl heteroaryl group, the substituted C₂-C₆₀ heteroaryl alkyl group, the substituted C₁-C₆₀ heteroaryloxy group, the substituted C₁-C₆₀ heteroarylthio group, the substituted monovalent non-aromatic condensed polycyclic group, and the substituted monovalent non-aromatic condensed heteropolycyclic group is:
deuterium, -F, -Cl, -Br, -I, -SF₅, -CD₃, -CD₂H, -CDH₂, -CF₃, -CF₂H, - CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, or a C₁-C₆₀ alkylthio group;
a C₁-C₆₀ alkyl group, a C₂-C₆₀ alkenyl group, a C₂-C₆₀ alkynyl group, a C₁-C₆₀ alkoxy group, or a C₁-C₆₀ alkylthio group, each substituted with at least one of deuterium, -F, -Cl, -Br, -I, -SF₅, -CD₃, -CD₂H, -CDH₂, -CF₃, -CF₂H, - CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₁-C₆₀ heteroaryloxy group, a C₁-C₆₀ heteroaryloxy group, a C₁-C₆₀ heteroarylthio group, a monovalent non-aromatic condensed polycyclic group, a monovalent non-aromatic condensed heteropolycyclic group, -Si(Q₁₁)(Q₁₂)(Q₁₃), -Ge(Q₁₁)(Q₁₂)(Q₁₃), -N(Q₁₄)(Q₁₅), - B(Q₁₆)(Q₁₇), -P(Q₁₈)(Q₁₉), -P(=O)(Q₁₈)(Q₁₉), or a combination thereof;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₁-C₆₀ heteroaryloxy group, a C₁-C₆₀ heteroaryloxy group, a C₁-C₆₀ heteroarylthio group, a monovalent non-aromatic condensed polycyclic group, or a monovalent non-aromatic condensed heteropolycyclic group;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, or a monovalent non-aromatic condensed heteropolycyclic group, each substituted with at least one of deuterium, -F, -Cl, -Br, -I, -SF₅, - CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -Si(Q₂₁)(Q₂₂)(Q₂₃), -Ge(Q₂₁)(Q₂₂)(Q₂₃), -N(Q₂₄)(Q₂₅), -B(Q₂₆)(Q₂₇), - P(Q₂₈)(Q₂₉), -P(=O)(Q₂₈)(Q₂₉), or a combination thereof; or
-Si(Q₃₁)(Q₃₂)(Q₃₃), -Ge(Q₃₁)(Q₃₂)(Q₃₃), -N(Q₃₄)(Q₃₅), -B(Q₃₆)(Q₃₇), - P(Q₃₈)(Q₃₉), or -P(=O)(Q₃₈)(Q₃₉).

Q₁ to Q₉, Q₁₁ to Q₁₉, Q₂₁ to Q₂₉, and Q₃₁ to Q₃₉ are each independently hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a substituted or unsubstituted C₁-C₆₀ heteroaryloxy group, a substituted or unsubstituted C₁-C₆₀ heteroarylthio group, a substituted or unsubstituted monovalent non-aromatic condensed polycyclic group, or a substituted or unsubstituted monovalent non-aromatic condensed heteropolycyclic group.

In one or more embodiments, R₁ₐ, R_{1b}, R₂ₐ, R_{2b}, R₃ₐ, R_{3b}, R₄, R₁₀ₐ, R₁₁ to R₁₃, R₂, R₃₁, and R₃₂ may each independently be:
hydrogen, deuterium, -F, -Cl, -Br, -I, -SF₅, -CD₃, -CD₂H, -CDH₂, -CF₃, - CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, or a C₁-C₂₀ alkylthio group;
a C₁-C₂₀ alkyl group, a C₁-C₂₀ alkoxy group, or a C₁-C₆₀ alkylthio group, each substituted with at least one of deuterium, -F, -Cl, -Br, -I, -SF₅, -CD₃, - CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a pyridinyl group, a pyrimidinyl group, or a combination thereof;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, or an imidazopyrimidinyl group;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzoisothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, or an imidazopyrimidinyl group, each substituted with at least one of deuterium, -F, -Cl, -Br, -I, -SF₅, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a C₁-C₂₀ alkylthio group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzoisothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, -Si(Q₃₁)(Q₃₂)(Q₃₃), or a combination thereof; or
-Si(Q₁)(Q₂)(Q₃), -Ge(Q₁)(Q₂)(Q₃), -N(Q₄)(Q₅), -B(Q₆)(Q₇), -P(Q₈)(Q₉), or -P(=O)(Q₈)(Q₉), and
Q₁ to Q₉ and Q₃₁ to Q₃₃ may each independently be:
   -CH₃, -CD₃, -CD₂H, -CDH₂, -CH₂CH₃, -CH₂CD₃, -CH₂CD₂H, -CH₂CDH₂, -CHDCH₃, -CHDCD₂H, -CHDCDH₂, -CHDCD₃, -CD₂CD₃, -CD₂CD₂H, or - CD₂CDH₂;
   an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, or a naphthyl group; or
   an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, or a naphthyl group, each substituted with at least one of deuterium, a C₁-C₁₀ alkyl group, a phenyl group, or a combination thereof.

In one or more embodiments, R₁ₐ, R_{1b}, R₂ₐ, R_{2b}, R₃ₐ, R_{3b}, R₄, R₁₀ₐ, R₁₁ to R₁₃, R₂, R₃₁, and R₃₂ may each independently be:
hydrogen, deuterium, -F, -Cl, -Br, -I, -SF₅, -CD₃, -CD₂H, -CDH₂, -CF₃, - CF₂H, -CFH₂, a cyano group, a C₁-C₆₀ alkyl group, a C₂-C₆₀ alkenyl group, a C₂-C₆₀ alkynyl group, a C₁-C₆₀ alkoxy group, or a C₁-C₆₀ alkylthio group;
a group represented by one of Formulae 9-1 to 9-61, 9-201 to 9-237, 10-1 to 10-129, or 10-201 to 10-355;
a group represented by one of Formulae 9-1 to 9-61, 9-201 to 9-237, 10-1 to 10-129, or 10-201 to 10-350 in which at least one hydrogen is substituted with deuterium, -F, or a cyano group; or
-Si(Q₁)(Q₂)(Q₃), -Ge(Q₁)(Q₂)(Q₃), or -N(Q₄)(Q₅), and
Q₁ to Q₅ are each as described herein: 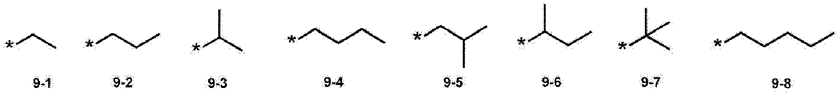 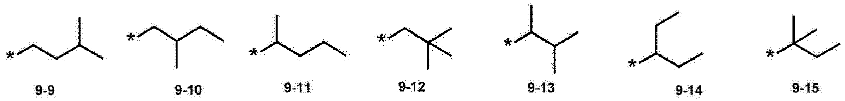 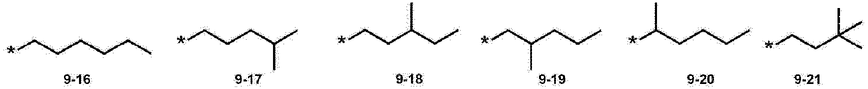 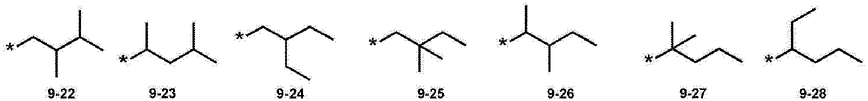 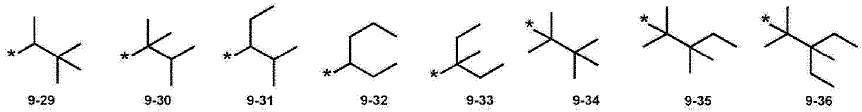 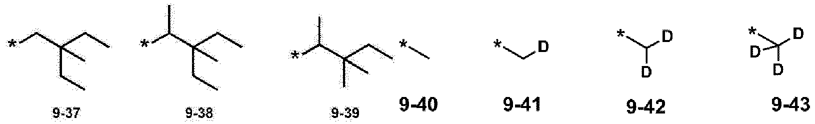 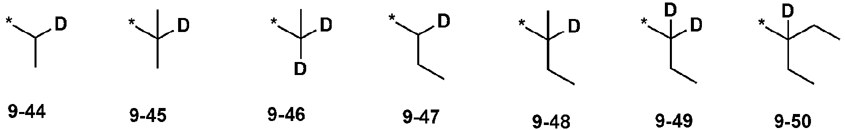 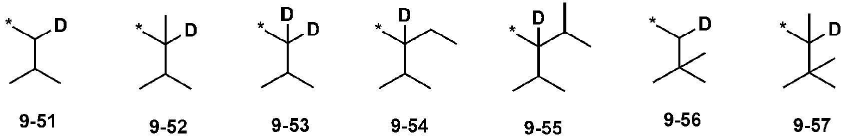 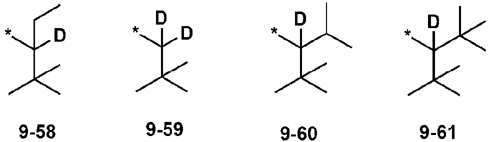 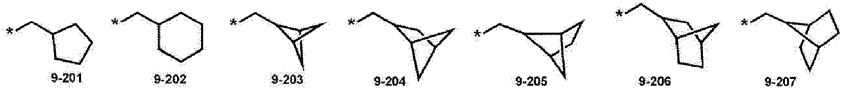 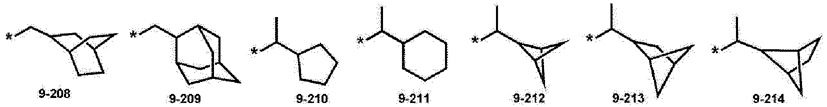 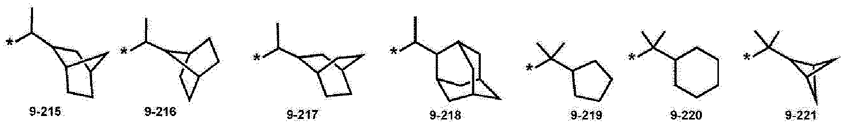 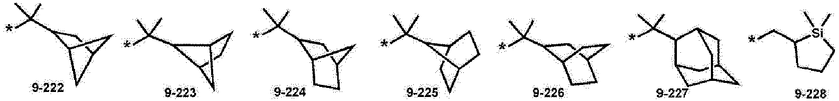 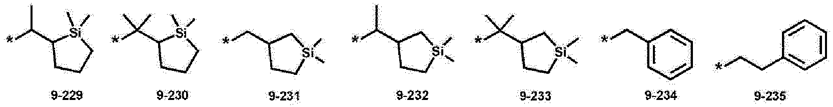 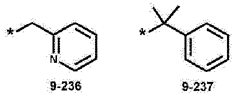 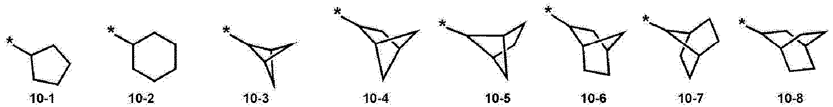 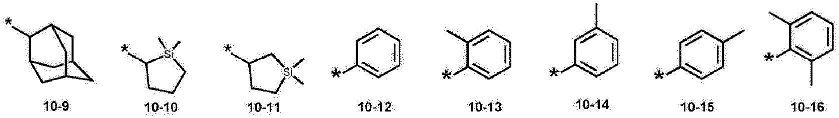 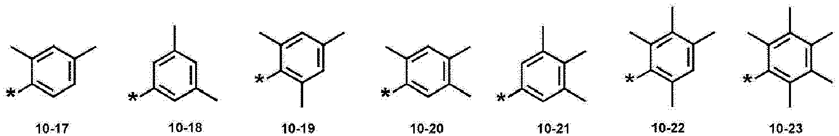 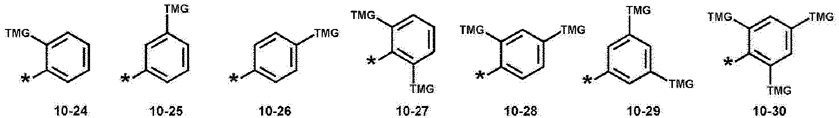 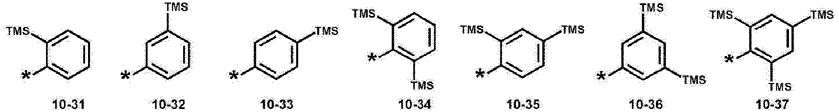 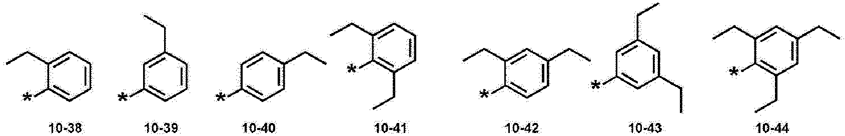 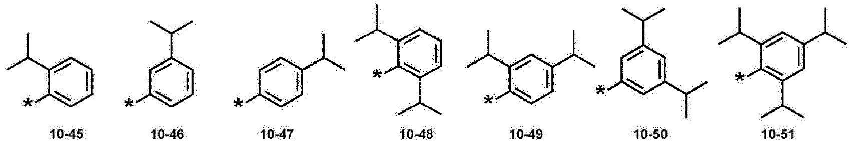 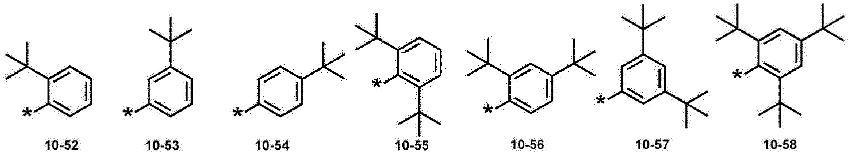 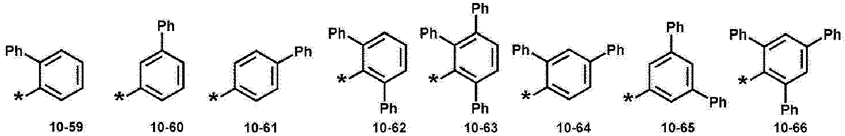 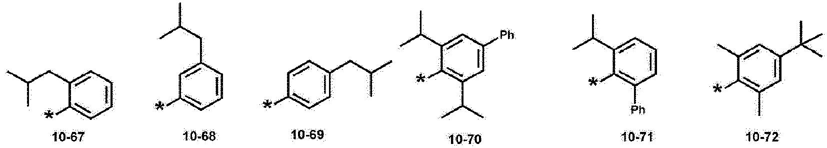 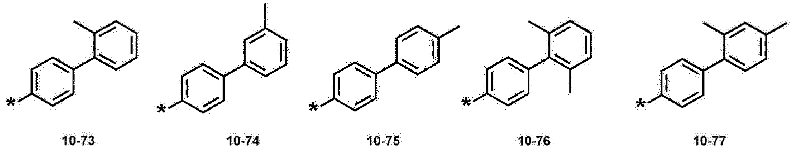 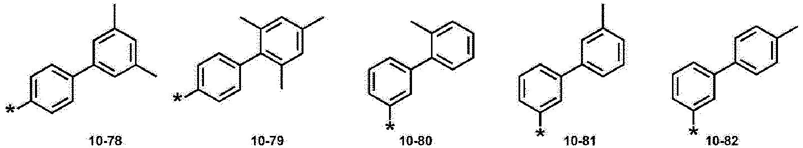 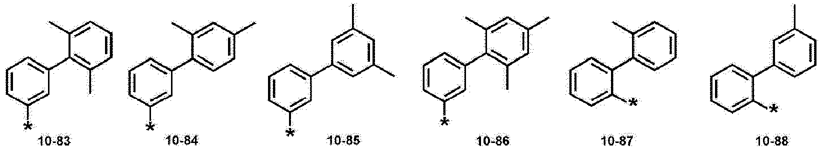 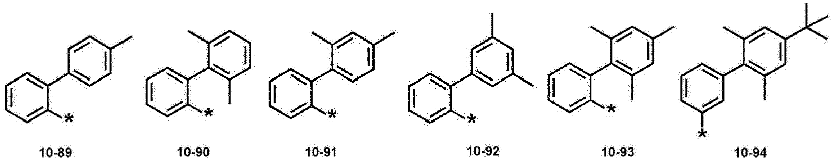 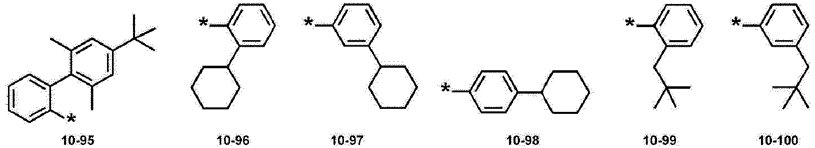 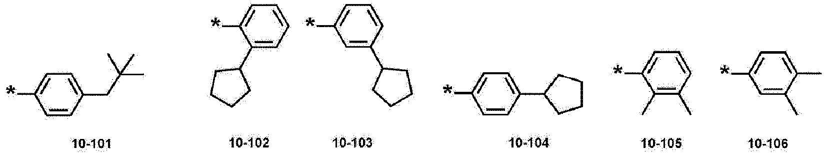 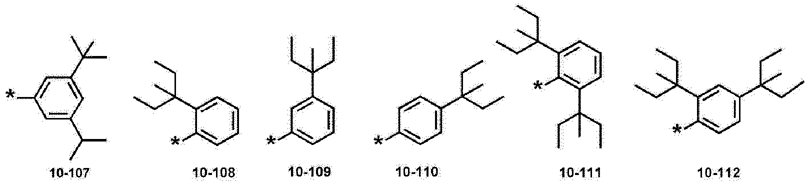 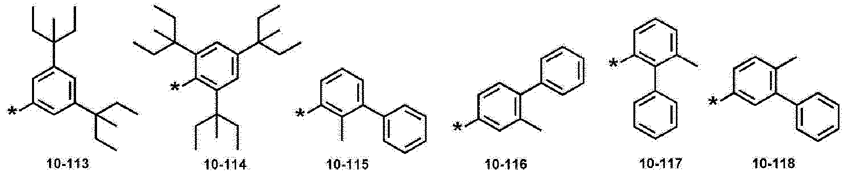 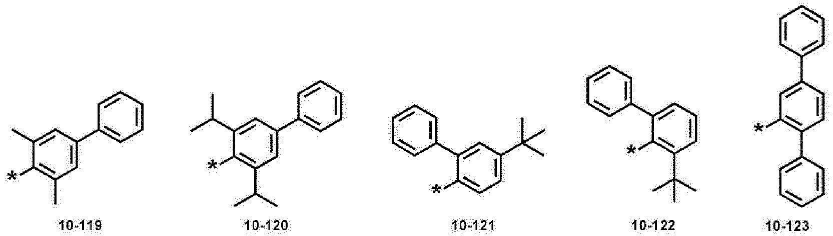 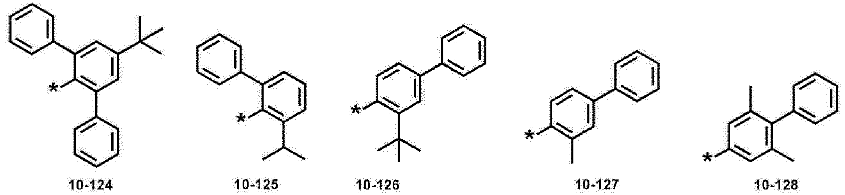 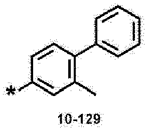 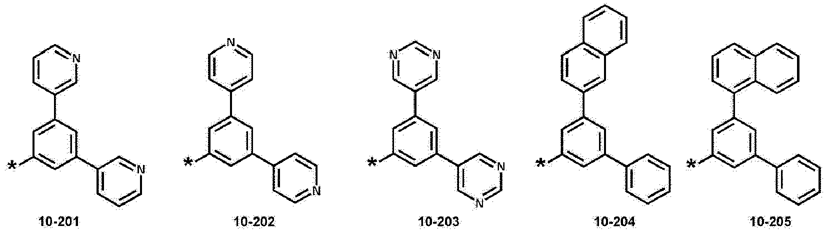 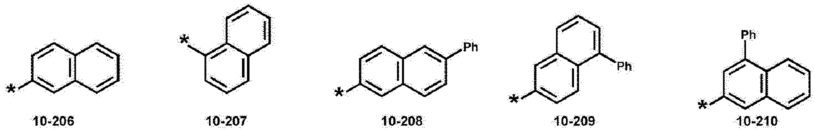 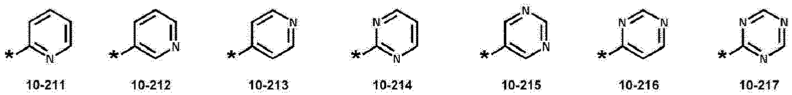 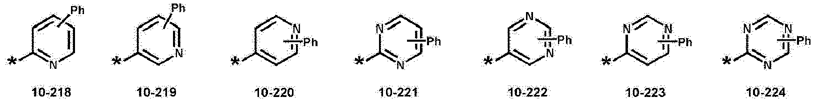 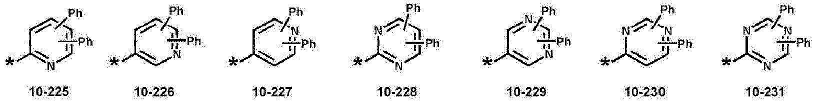 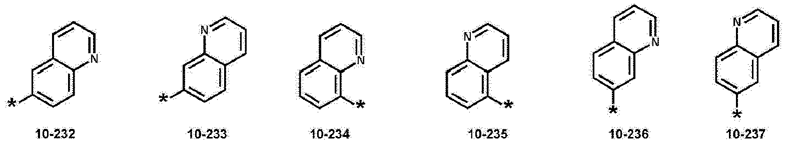 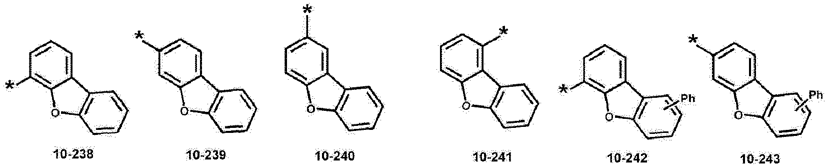 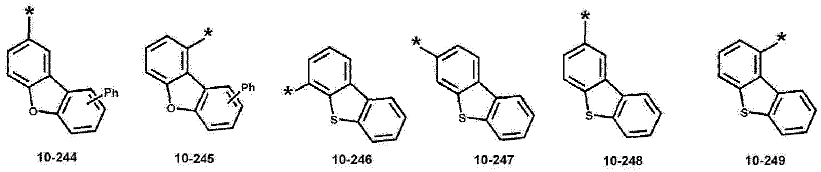 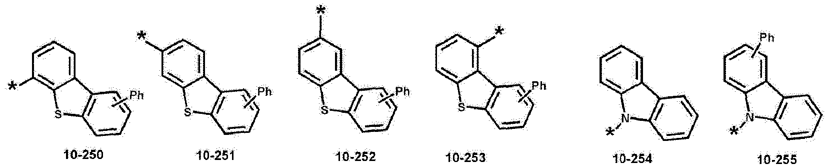 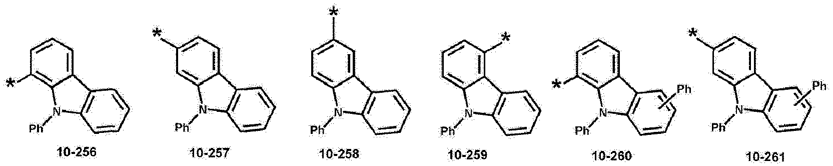 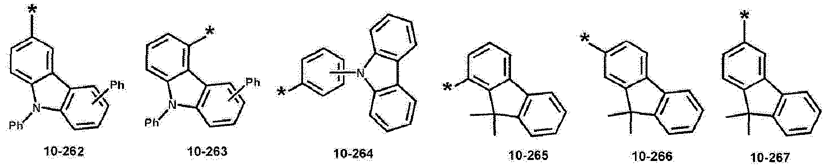 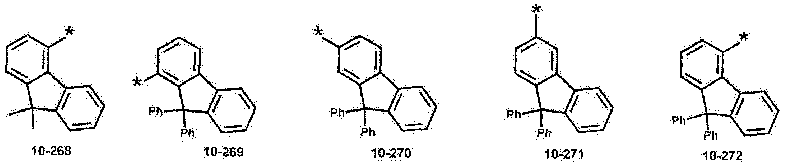 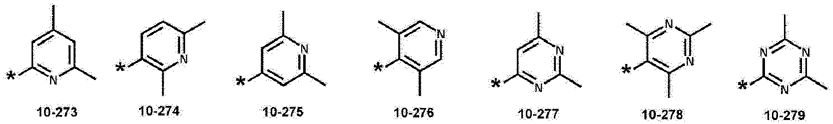 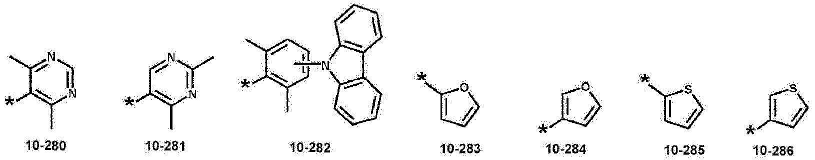 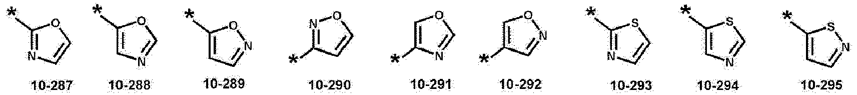 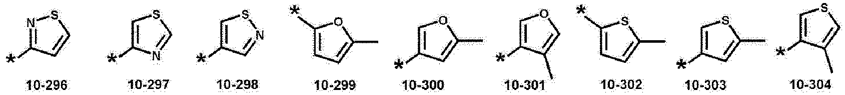 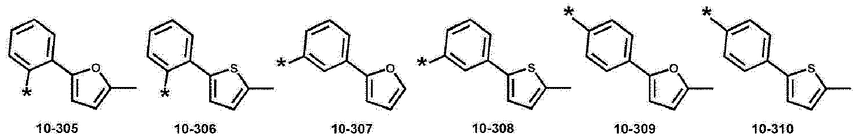 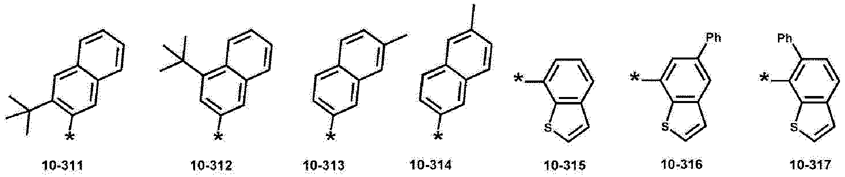 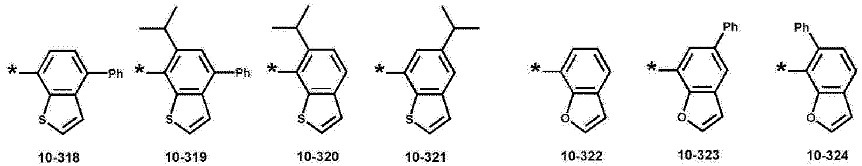 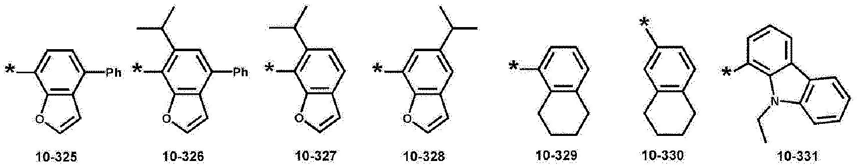 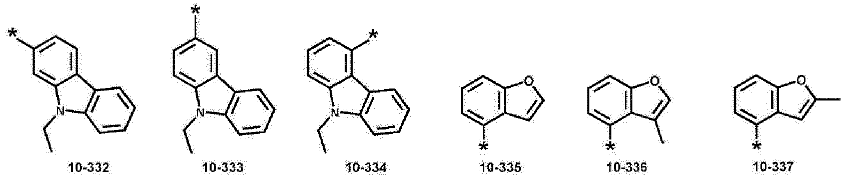 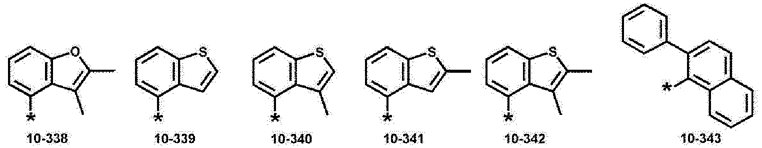 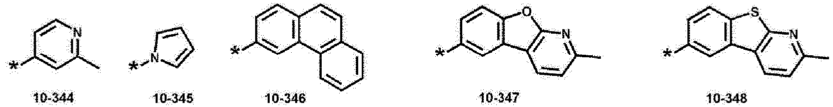 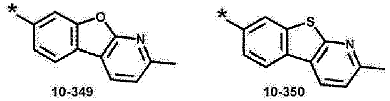 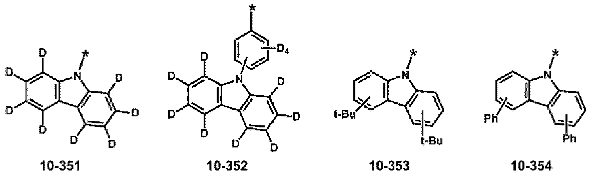 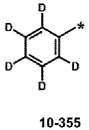
wherein, in Formulae 9-1 to 9-61, 9-201 to 9-237, 10-1 to 10-129, and 10-201 to 10-355, * indicates a binding site to a neighboring atom, "Ph" indicates a phenyl group, "TMS" indicates a trimethylsilyl group, and "TMG" indicates a trimethylgermyl group.

In one or more embodiments, a group represented by 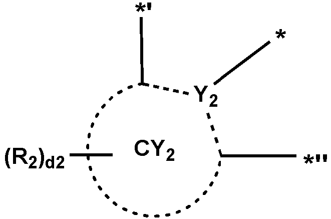 in Formula 1 may be a group represented by one of Formulae 2-1 to 2-3: 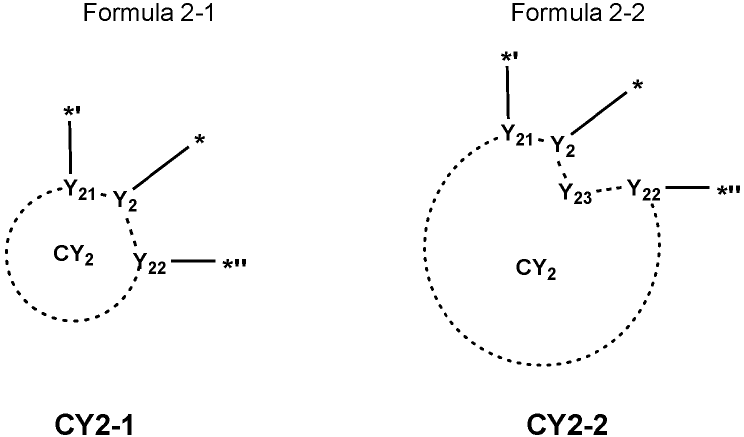 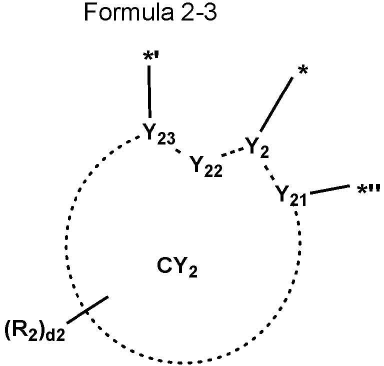 wherein, in Formulae 2-1 to 2-3,
Y₂₁ to Y₂₃ may each independently be C or N,
Y₂₁ and Y₂ may be linked to each other via a chemical bond, Y₂ and Y₂₁ are linked to each other via a chemical bond, Y₂ and Y₂₂ may be linked to each other via a chemical bond, Y₂ and Y₂₃ are linked to each other via a chemical bond, and Y₂₂ and Y₂₃ may be linked to each other via a chemical bond,
*' indicates a binding site to T₁, *" indicates a binding site to T₂, and * indicates a binding site to A₂ or M, and
ring CY₂, Y₂, R₂, and d2 are each as described herein.

In one or more embodiments, a group represented by 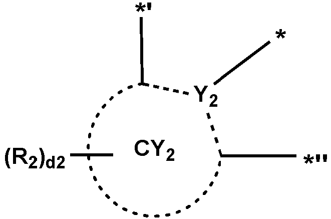 in Formula 1 may be a group represented by one of Formulae CY2-1 to CY2-35: 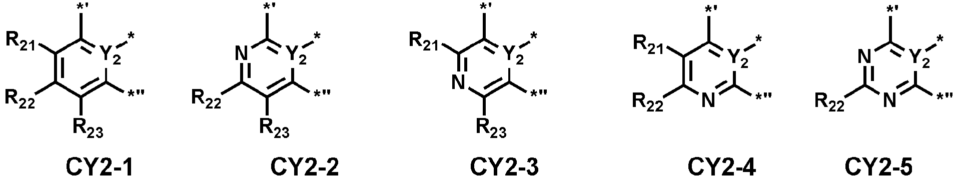 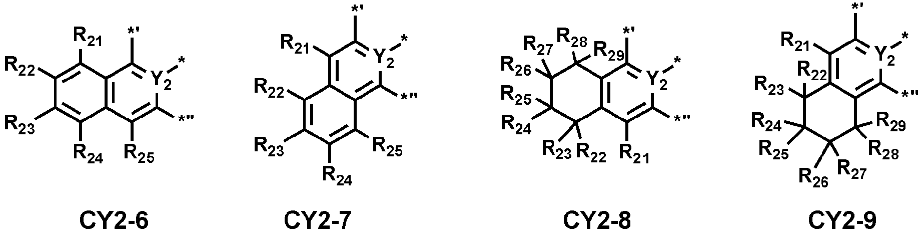 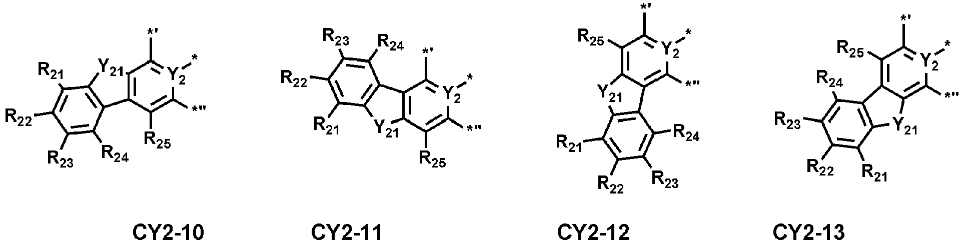 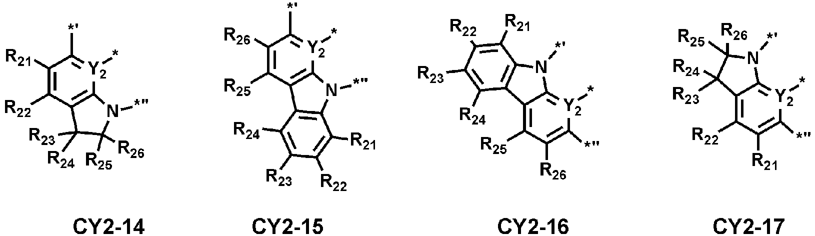 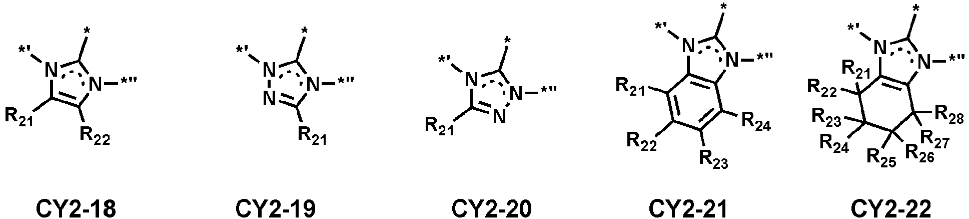 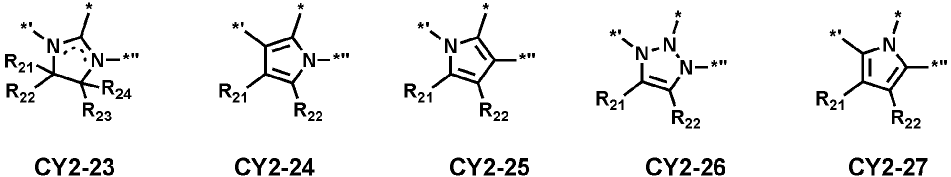 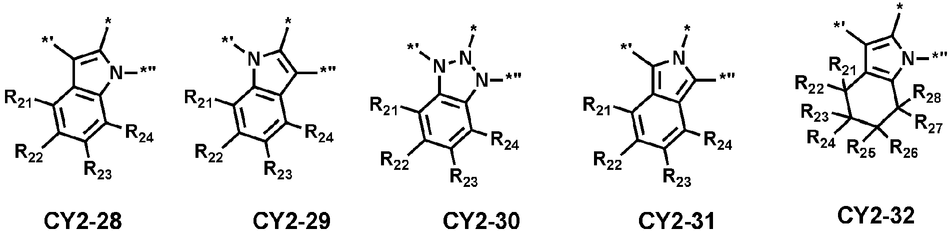 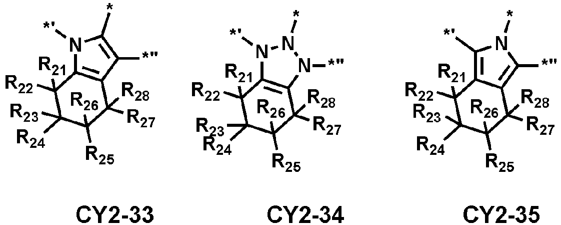 wherein, in Formulae CY2-1 to CY2-35,
Y₂ may be C or N,
R₂₁ to R₂₉ may each independently be as described in connection with R₂,
* indicates a binding site to M or A₂,
*' indicates a binding site to T₁, and
*" indicates a binding site to T₂.

In one or more embodiments, a group represented by 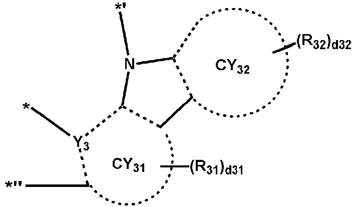 in Formula 1 may be a group represented by one of Formulae CY3-1 to CY3-9: 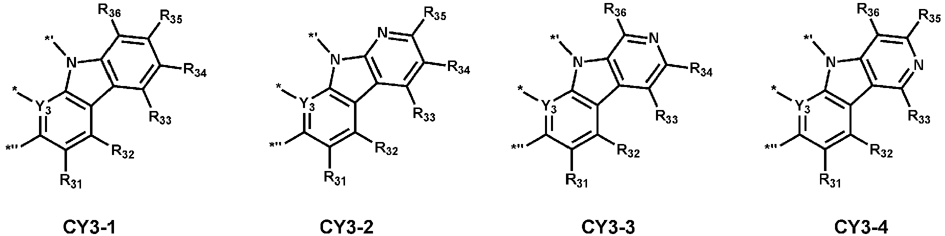 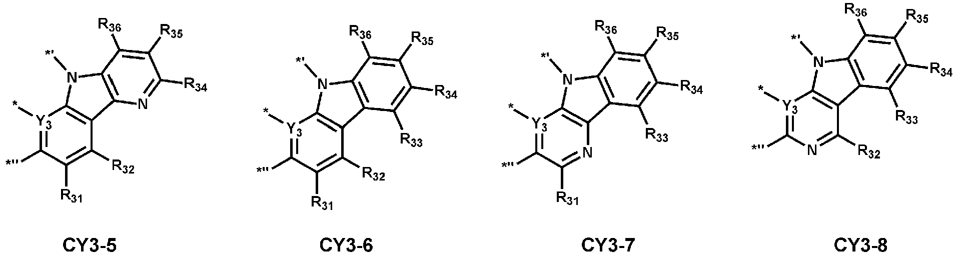 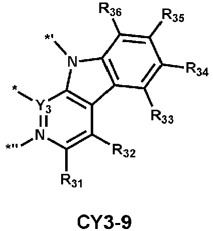 wherein, in Formulae CY3-1 to CY3-9,
Y₃ may be C or N,
R₃₁ to R₃₆ may each independently be as described in connection with R₃₁,
* indicates a binding site to M or A₃,
*' indicates a binding site to T₃, and
*" indicates a binding site to T₂.

In one or more embodiments, at least one of R₃₁ to R₃₆ in Formulae CY3-1 to CY3-9 may not be hydrogen. For example, in one or more embodiments, R₃₄ may not be hydrogen.

In one or more embodiments, a group represented by 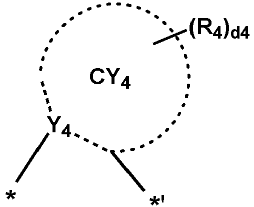 in Formula 1 may be a group represented by one of Formulae CY4-1 to CY4-29: 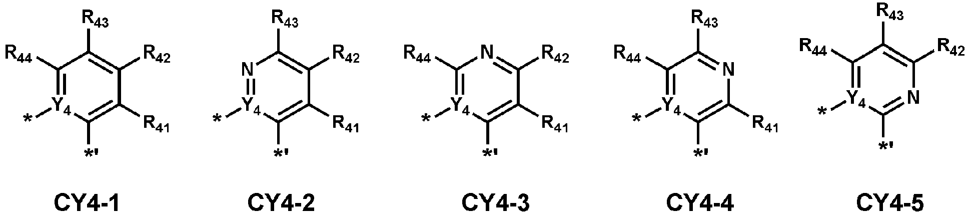 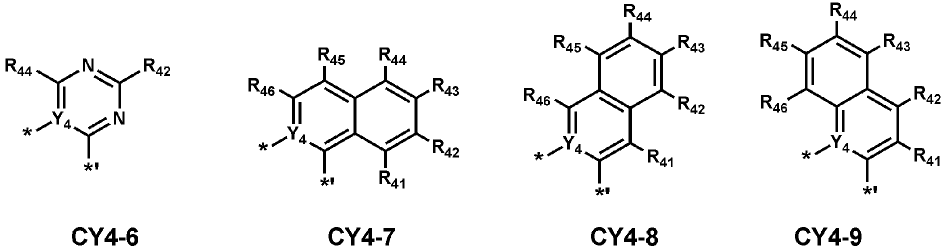 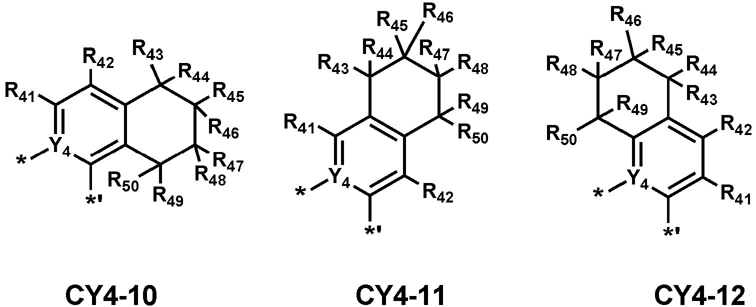 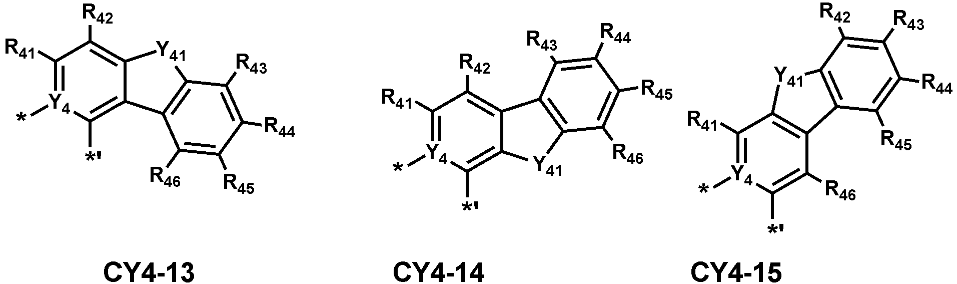 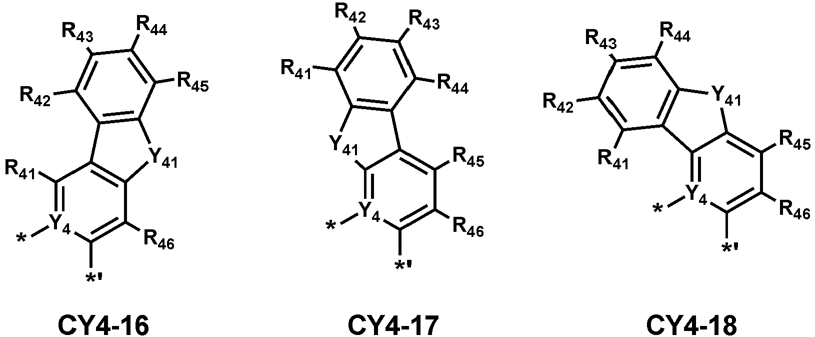 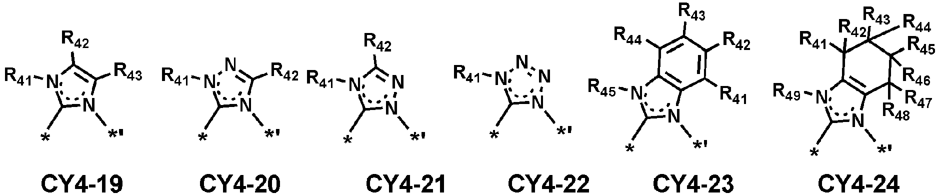 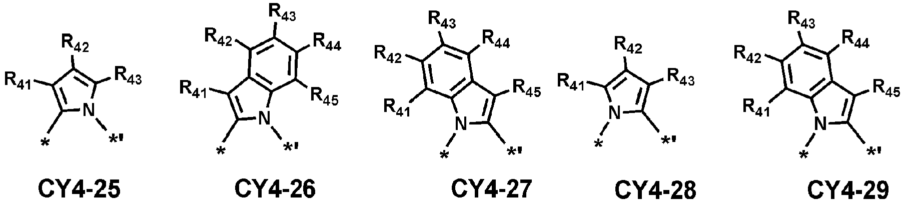 wherein, in Formulae CY4-1 to CY4-29,
Y₄ may be C or N,
Y₄₁ may be N(R₄₁ₐ), O, Se, C(R₄₁ₐ)(R_{41b}), or Si(R₄₁ₐ)(R_{41b}), and
R₄₁ to R₅₀, R₄₁ₐ, and R_{41b} may each independently be as described in connection with R₄,
* indicates a binding site to M or A₄, and
*' indicates a binding site to T₃.

In one or more embodiments, the organometallic compound represented by Formula 1 may be represented by one of Formulae 1-1 and 1-2: 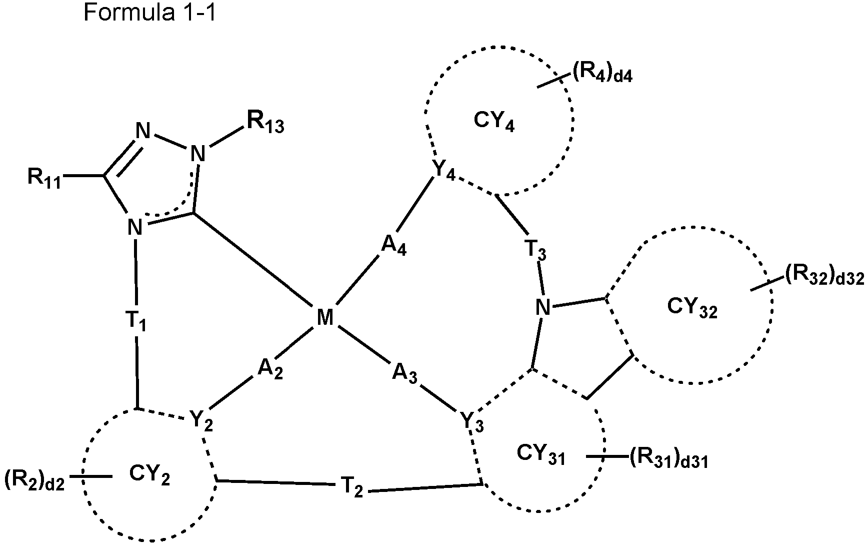 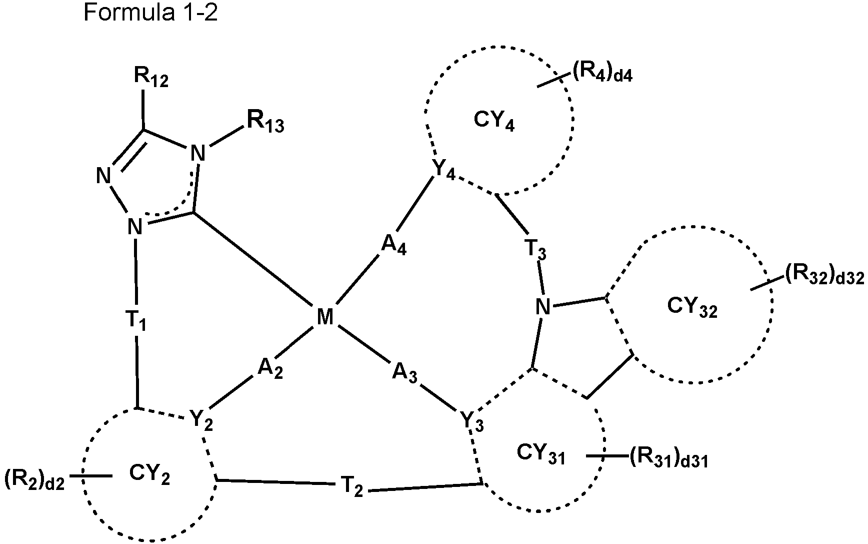 wherein, in Formulae 1-1 and 1-2:
M, ring CY₂, ring CY₃₁, ring CY₃₂, ring CY₄, Y₂ to Y₄, A₂ to A4, T₁ to T3, R₁₁ to R₁₃, R₂, R₃₁, R₃₂, R₄, d2, d31, d32, and d4 may each be as described herein.

In one or more embodiments, the organometallic compound represented by Formula 1 may be represented by one of Formulae 1-11 and 1-12: 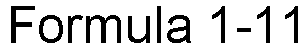 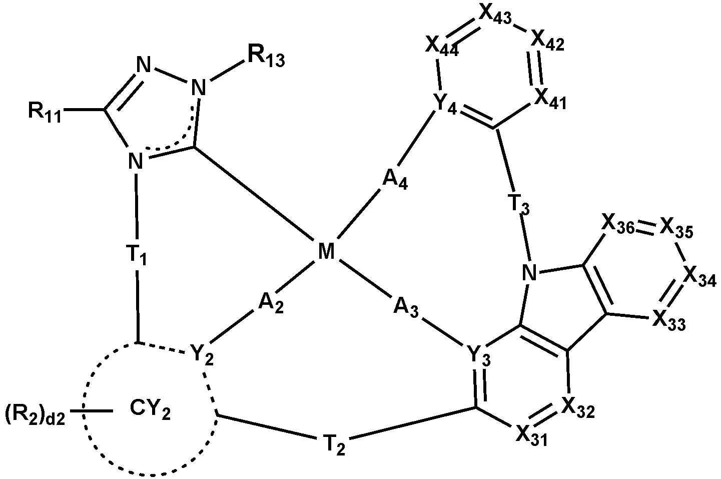 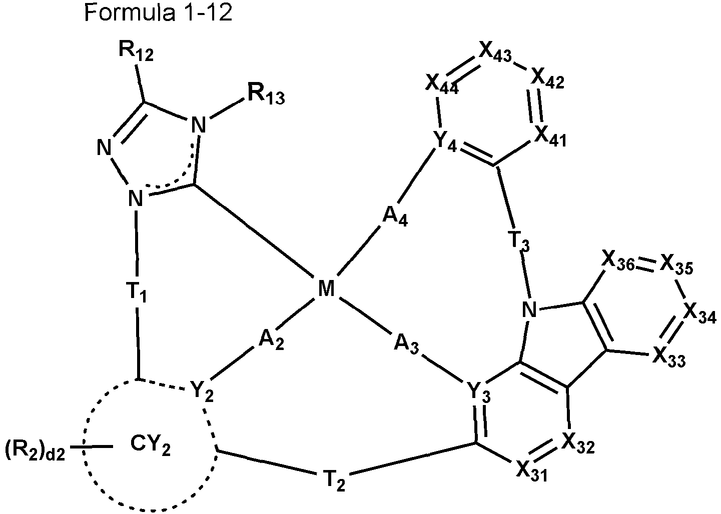 wherein, in Formulae 1-11 and 1-12,
X₃₁ may be C(R₃₁) or N, X₃₂ may be C(R₃₂) or N, X₃₃ may be C(R₃₃) or N, X₃₄ may be C(R₃₄) or N, X₃₅ may be C(R₃₅) or N, and X₃₆ may be C(R₃₆) or N,
X₄₁ may be C(R₄₁) or N, X₄₂ may be C(R₄₂) or N, X₄₃ may be C(R₄₃) or N, and X₄₄ may be C(R₄₄) or N,
R₃₁ to R₃₆ may each be as described in connection with R₃₁,
R₄₁ to R₄₄ may each be as described in connection with R₄, and
M, ring CY₂, Y₂ to Y₄, A₂ to A₄, T₁ to T₃, R₁₁ to R₁₃, R₂, and d2 may each be as described herein.

In one or more embodiments, the organometallic compound may be represented by at least one of Compounds 1 to 195, but embodiments are not limited thereto:

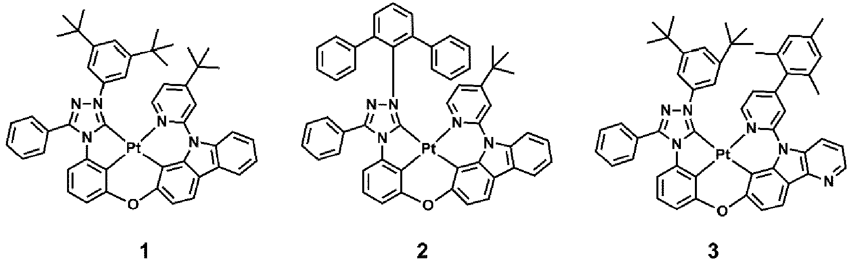

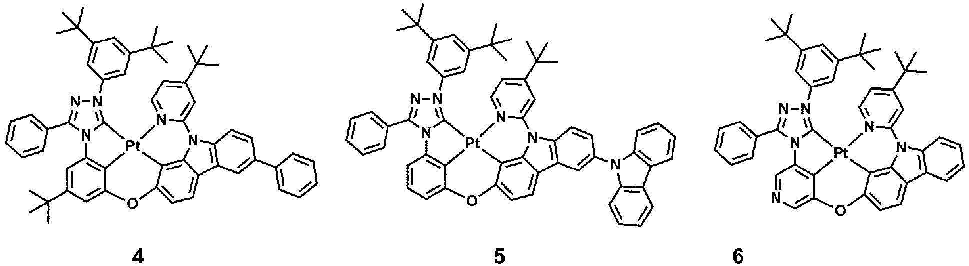

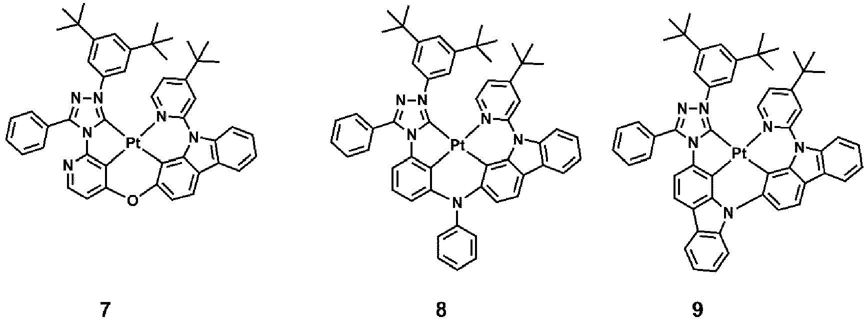

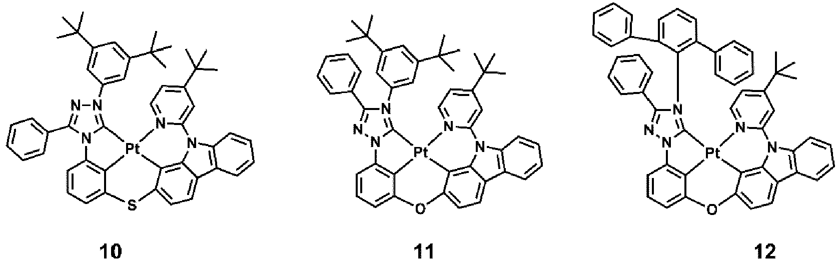

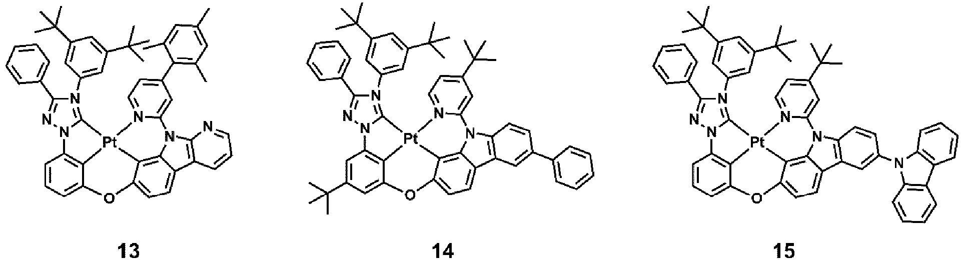

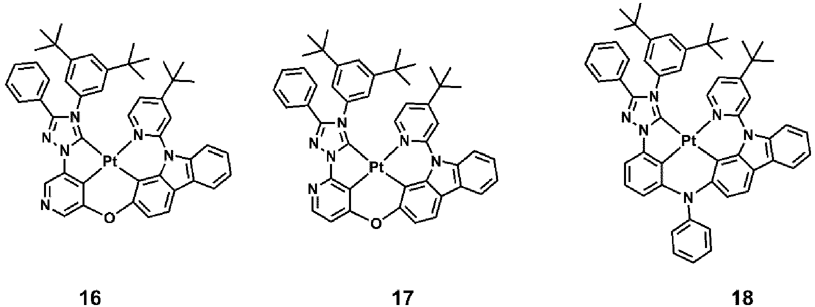

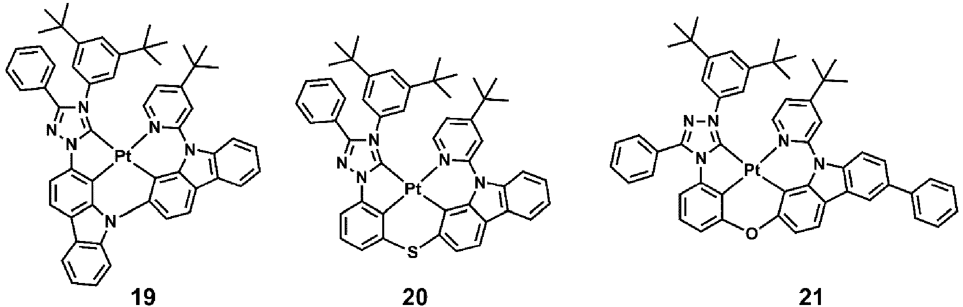

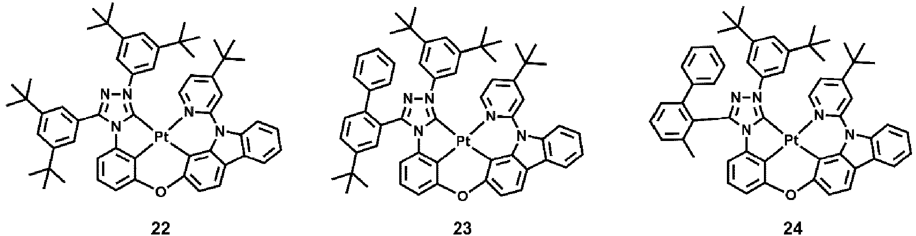

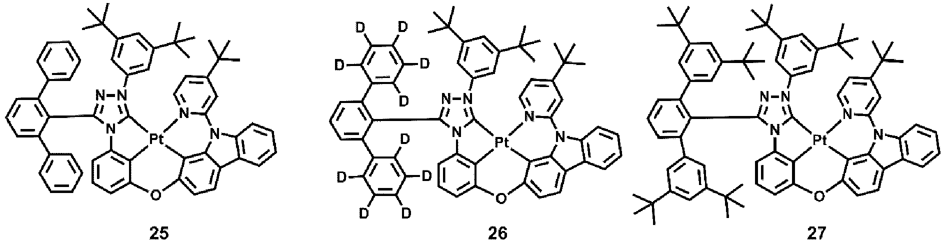

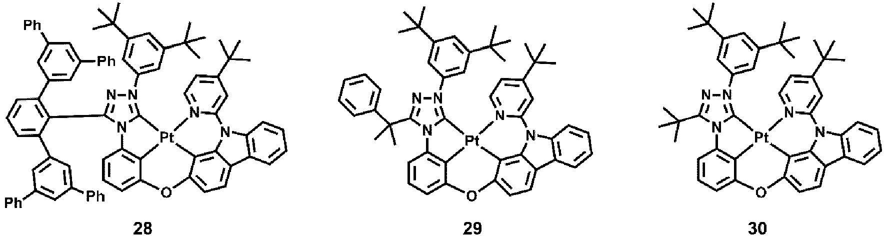

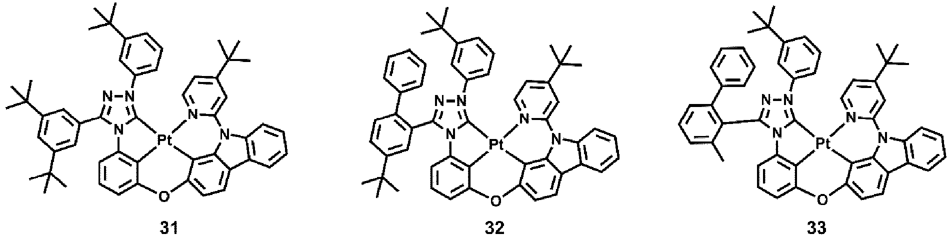

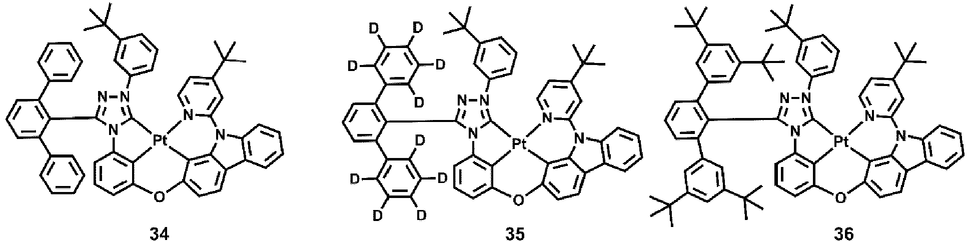

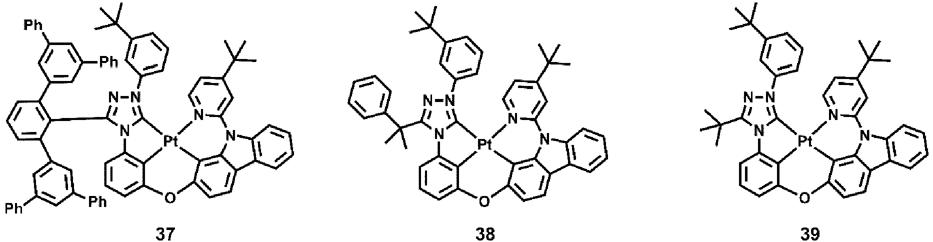

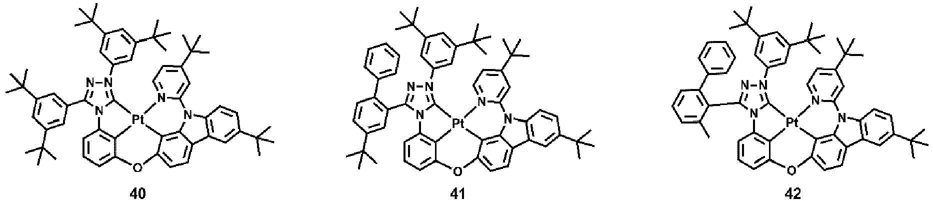

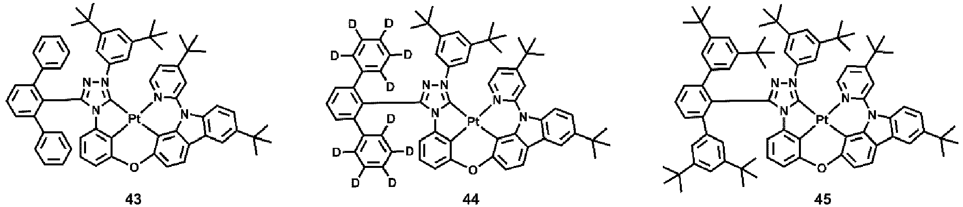

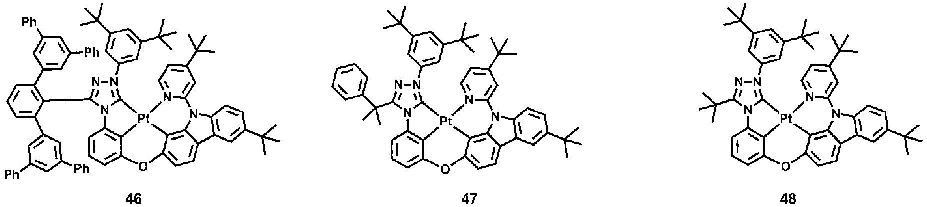

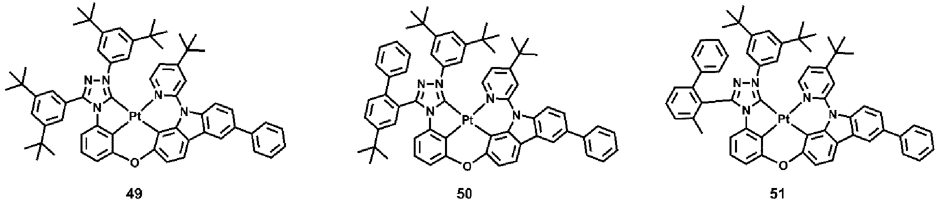

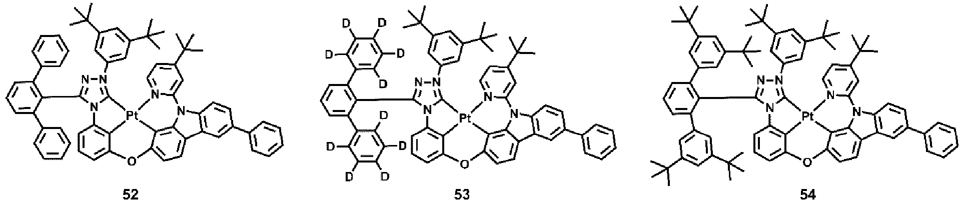

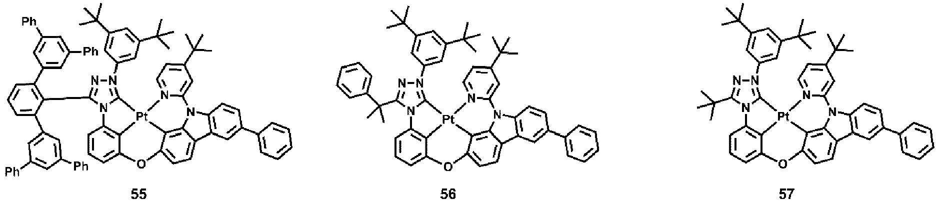

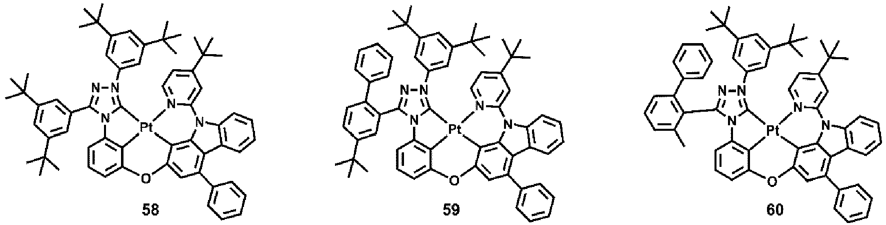

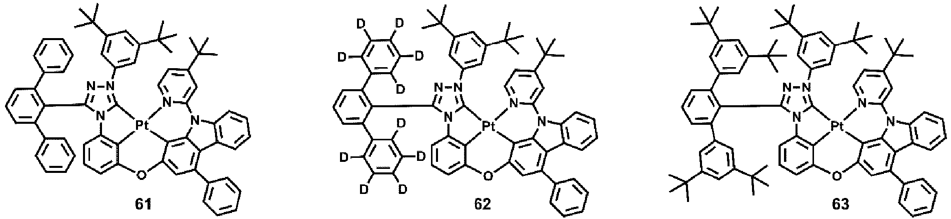

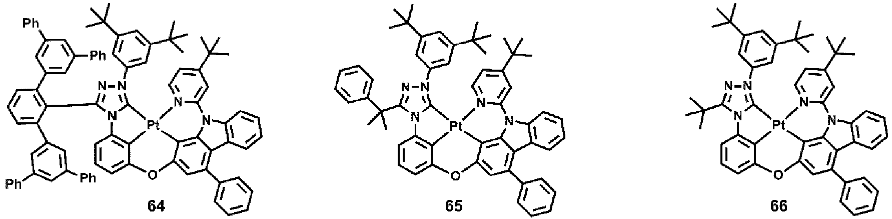

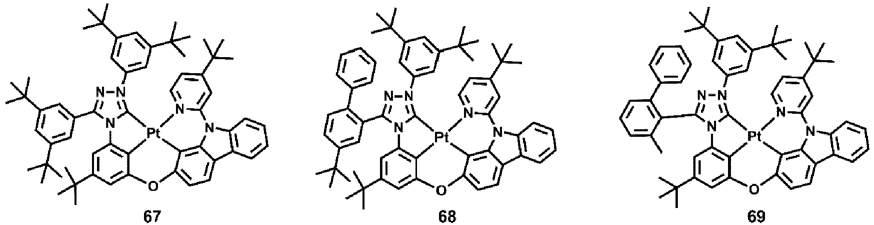

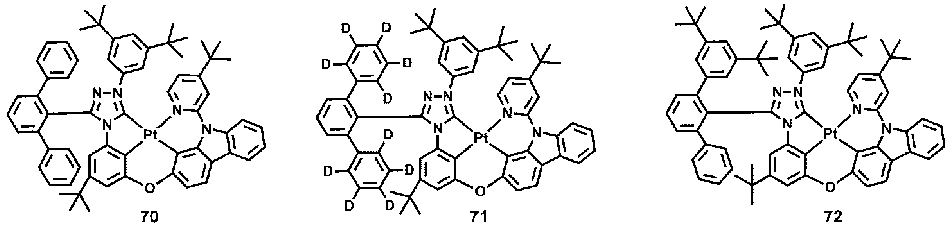

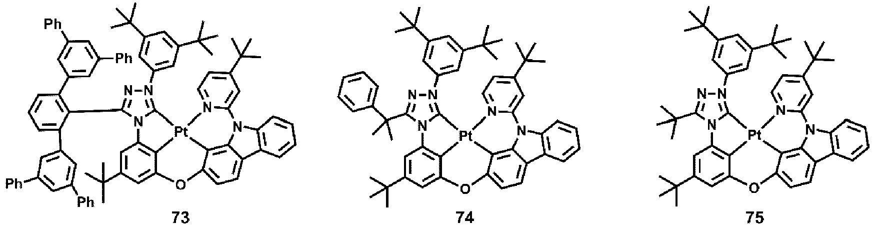

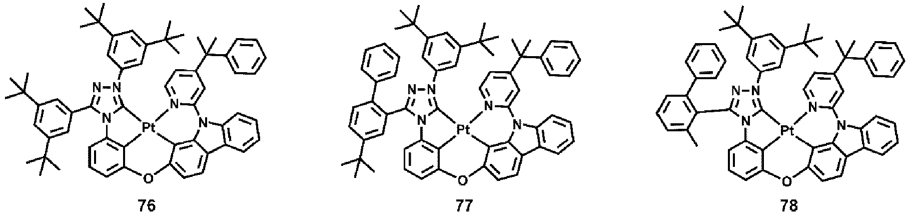

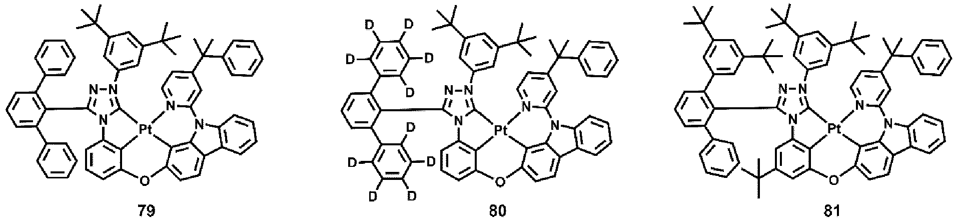

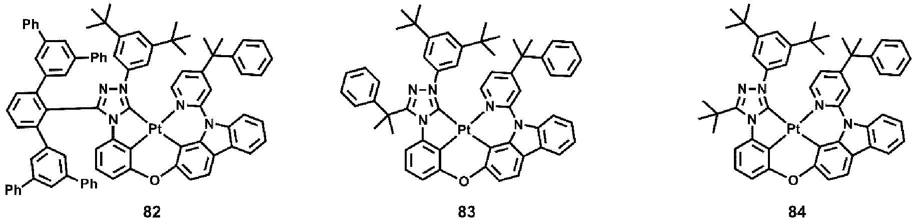

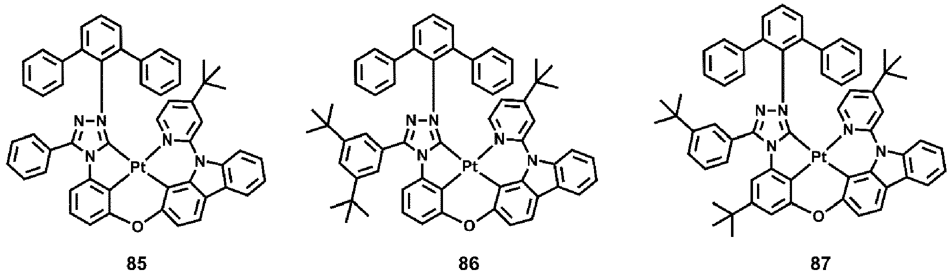

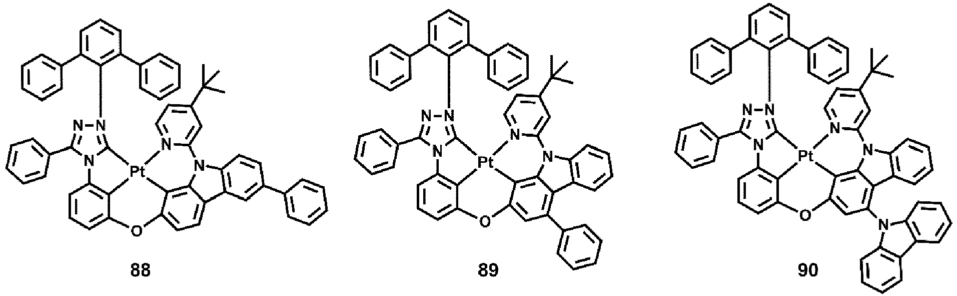

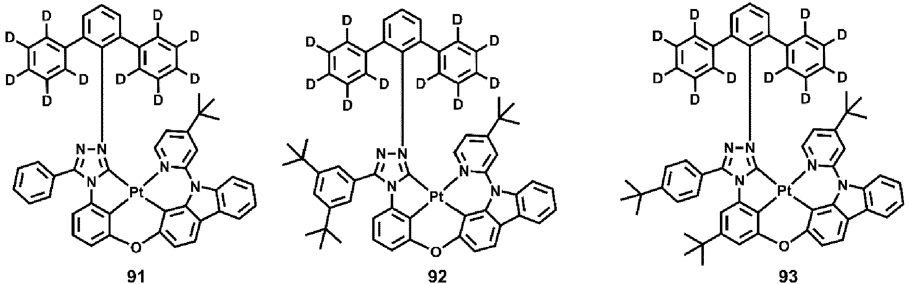

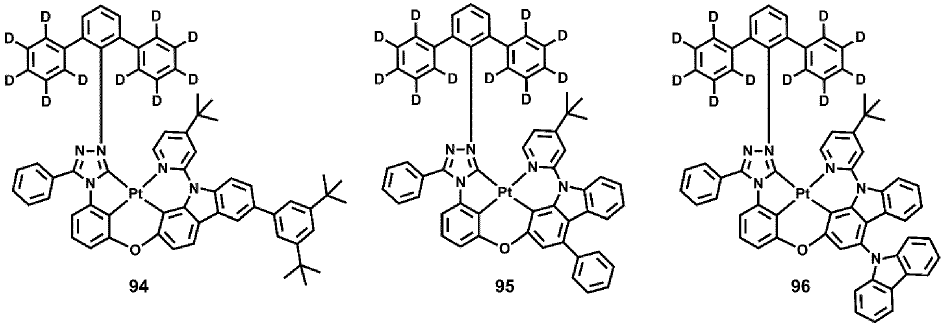

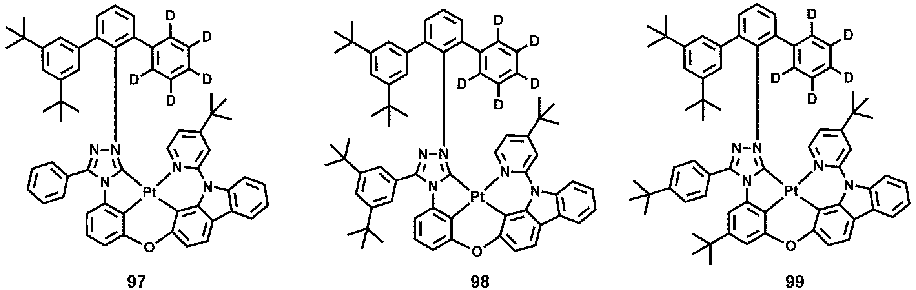

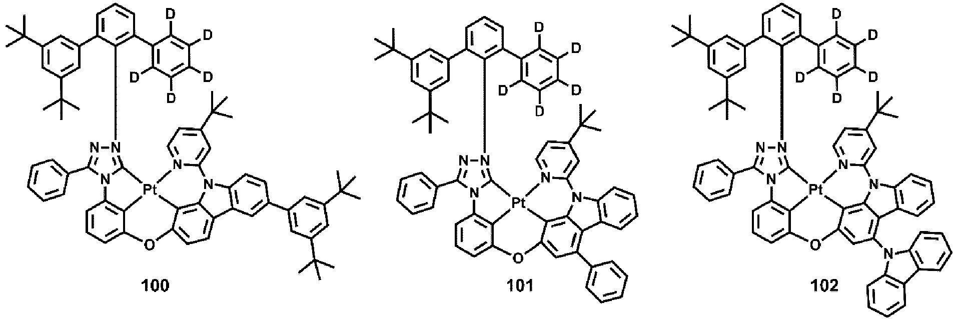

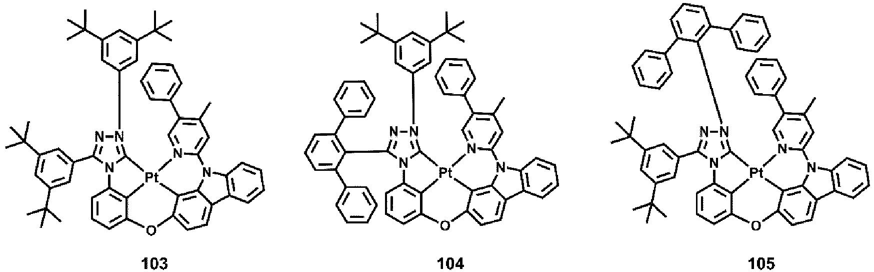

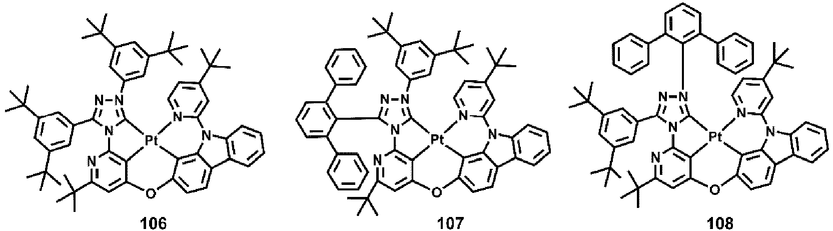

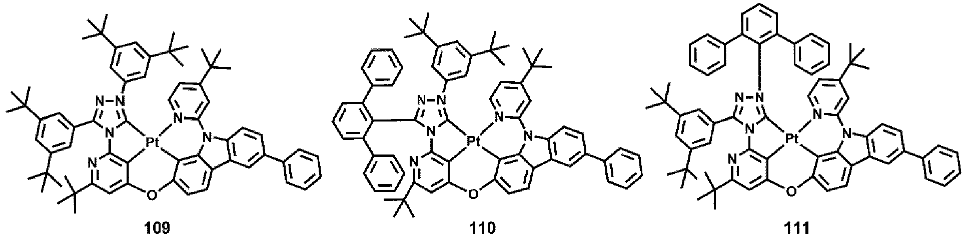

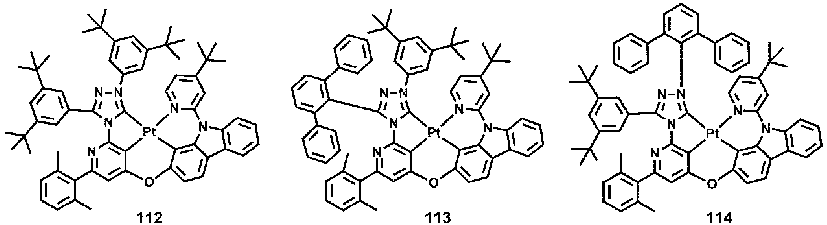

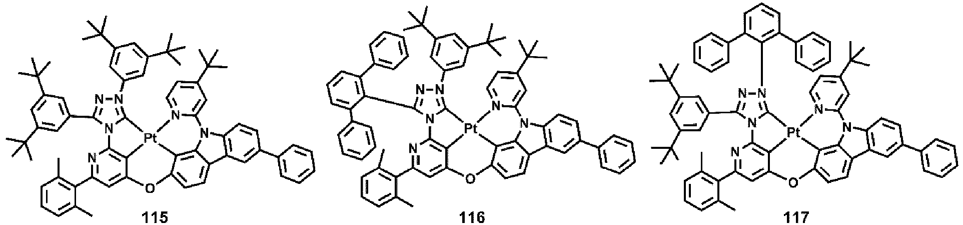

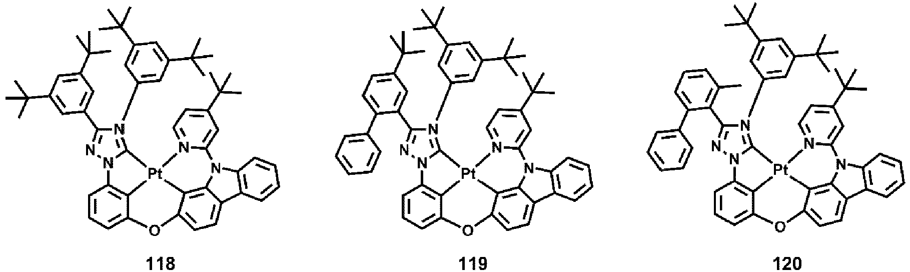

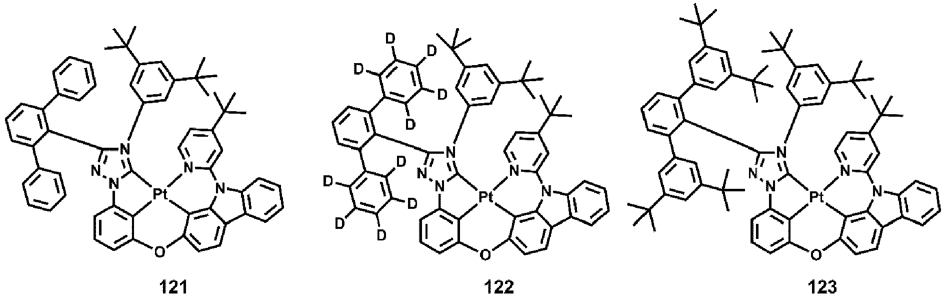

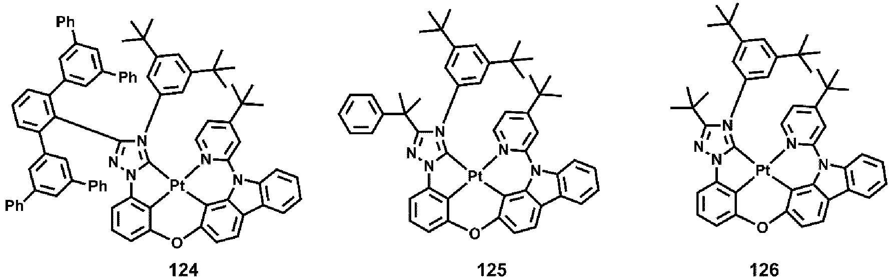

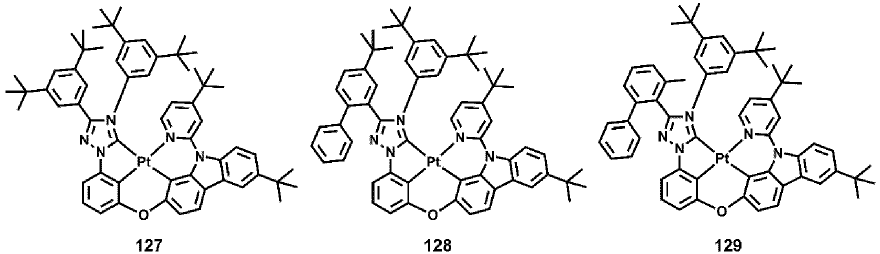

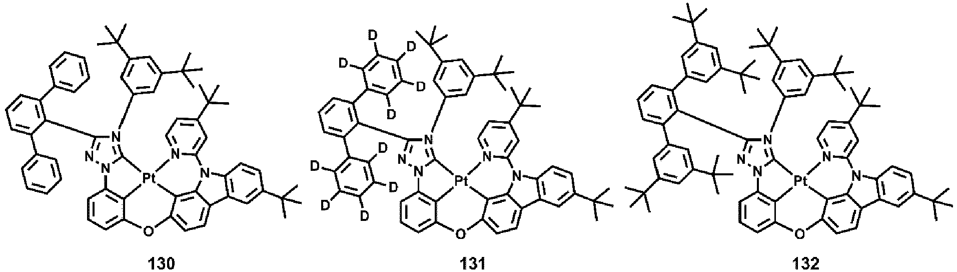

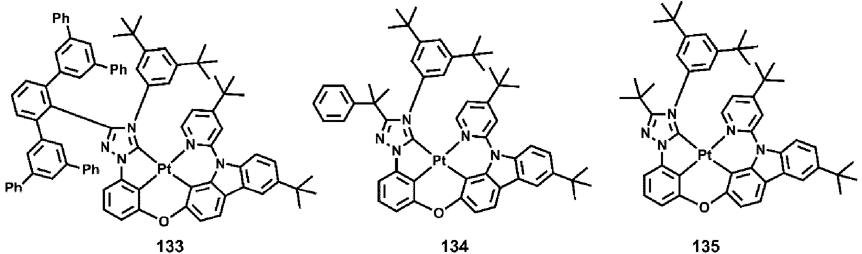

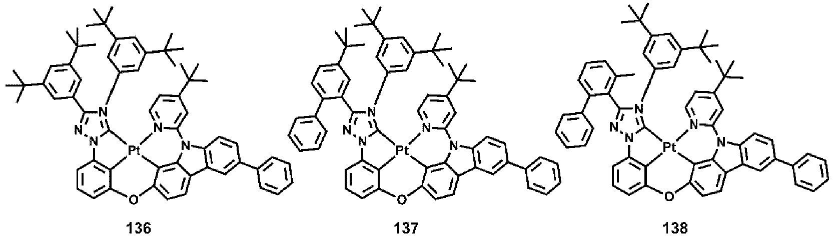

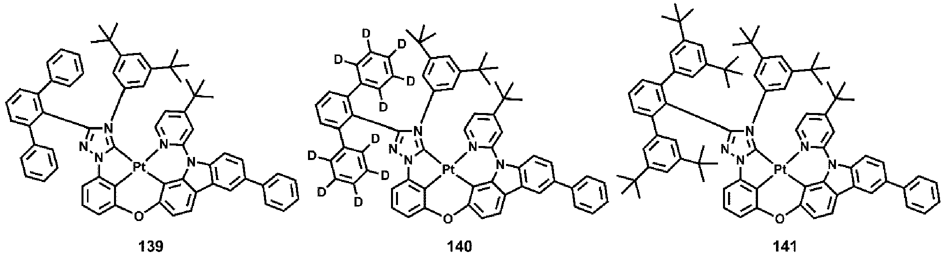

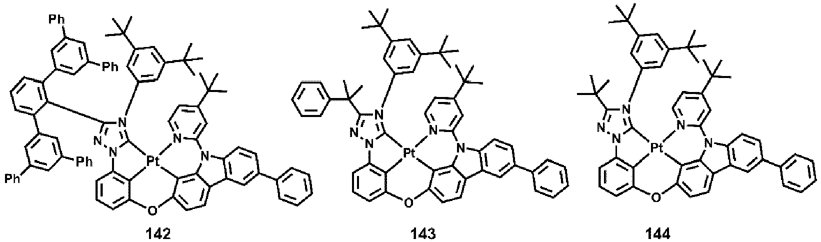

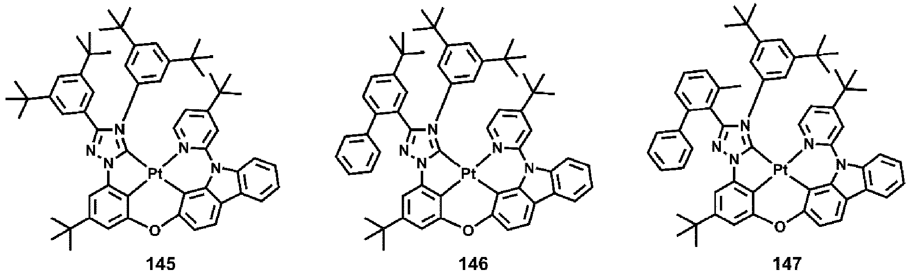

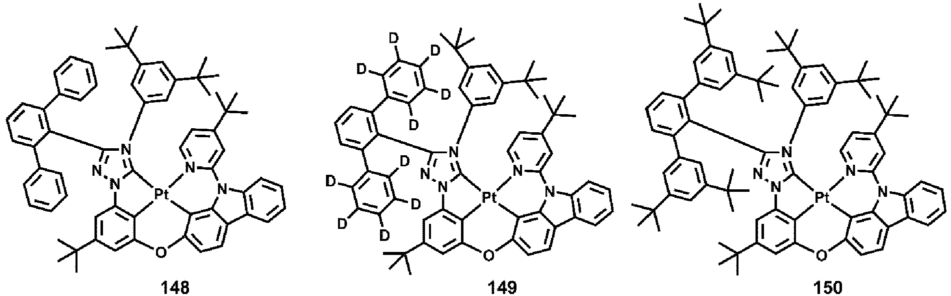

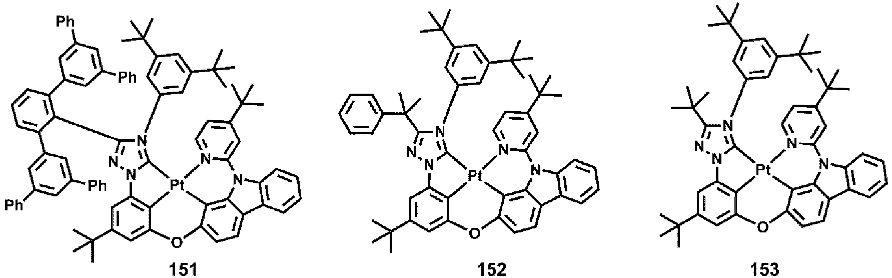

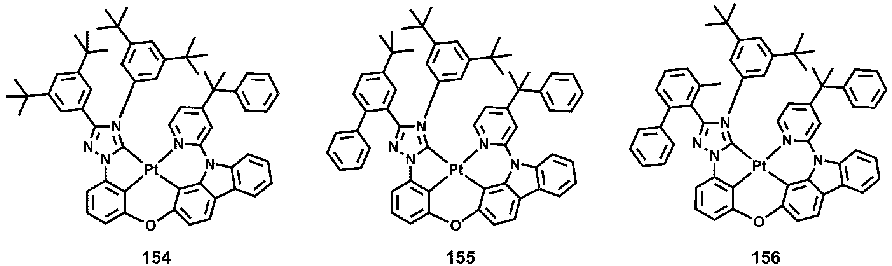

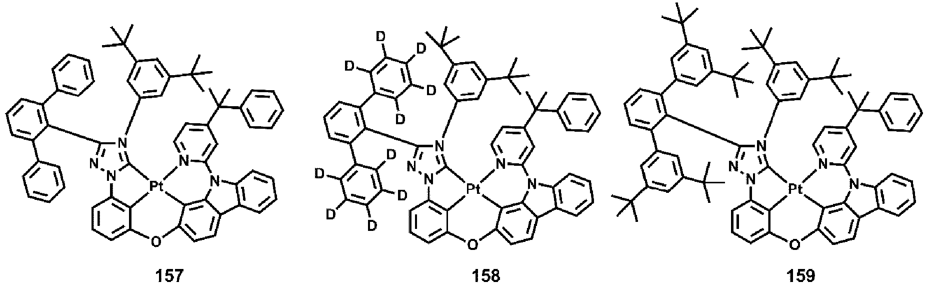

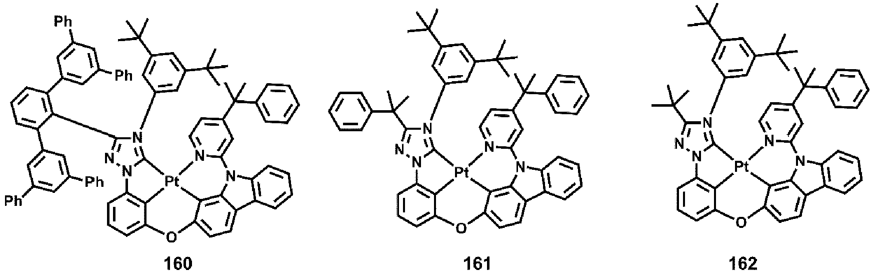

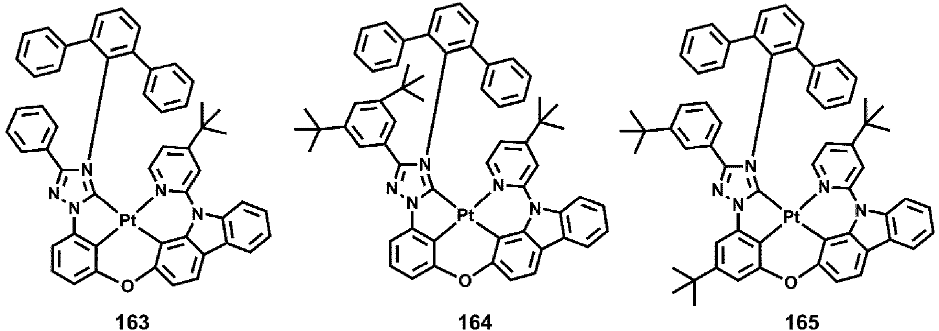

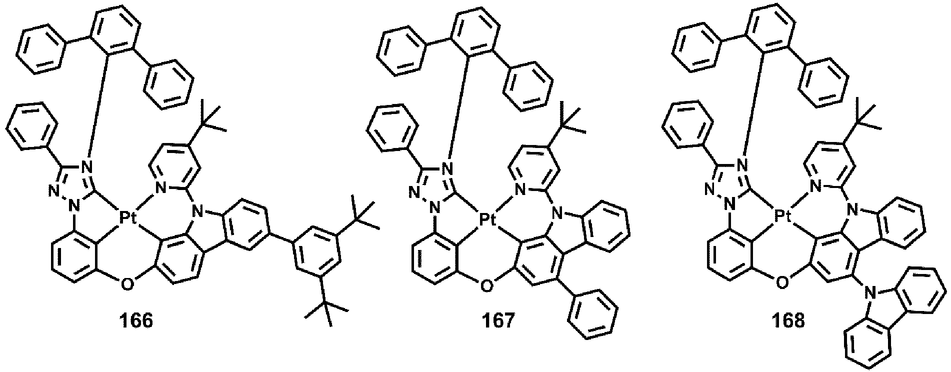

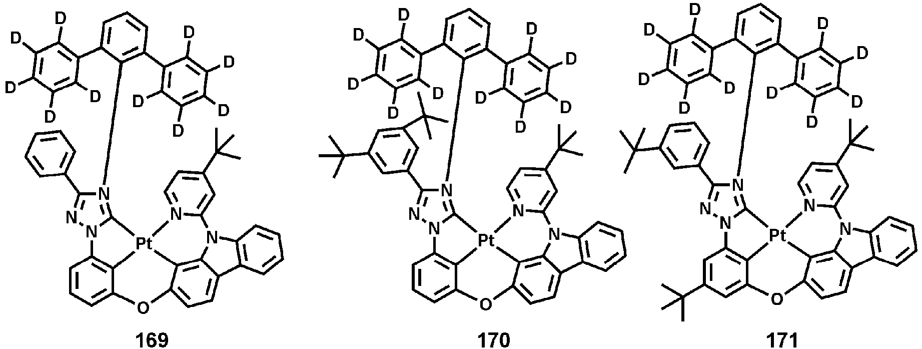

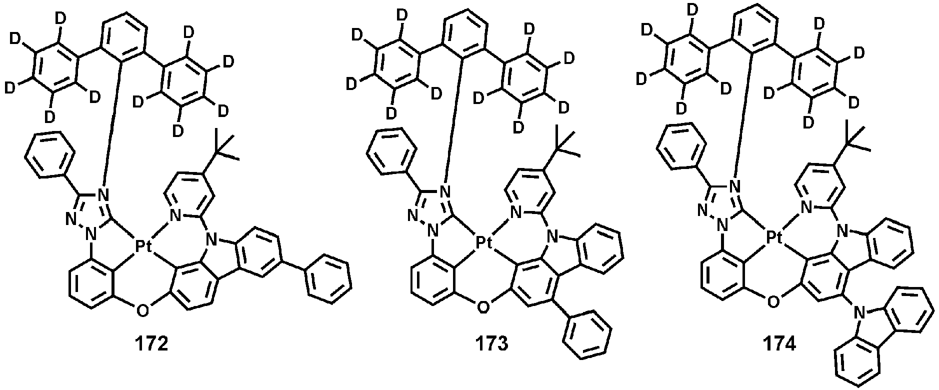

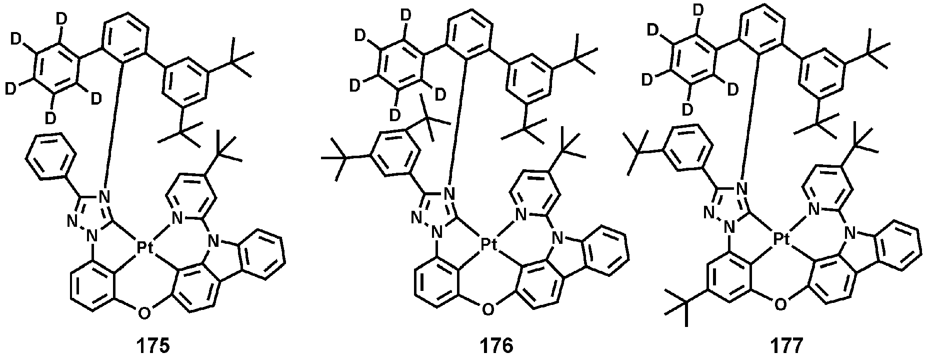

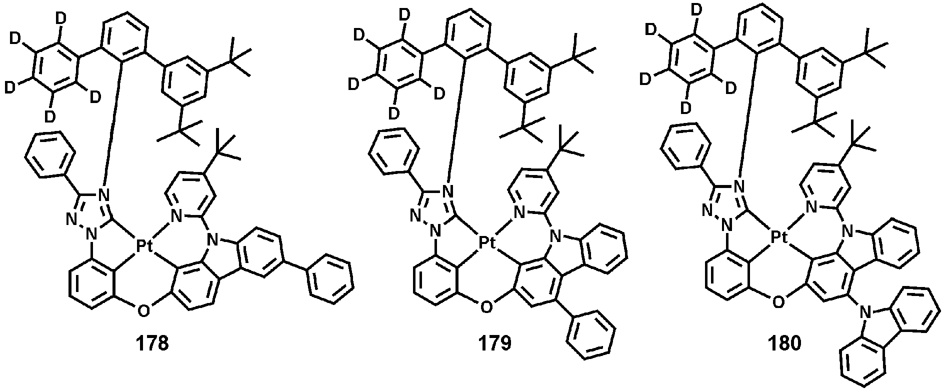

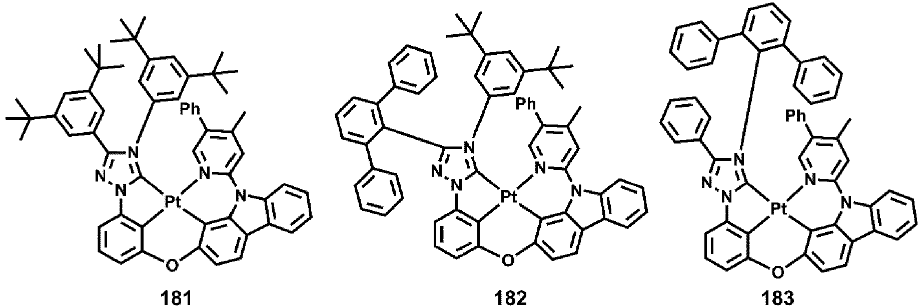

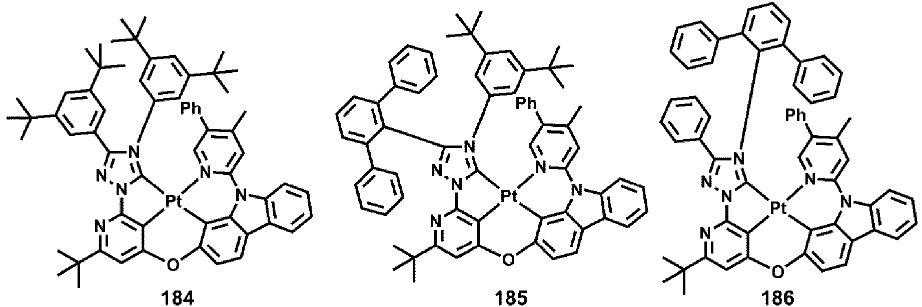

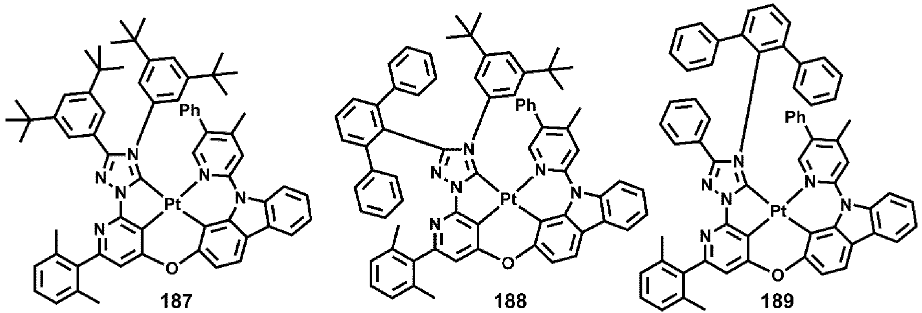

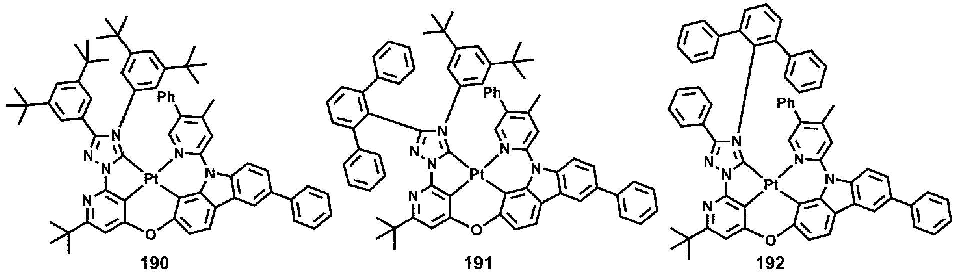

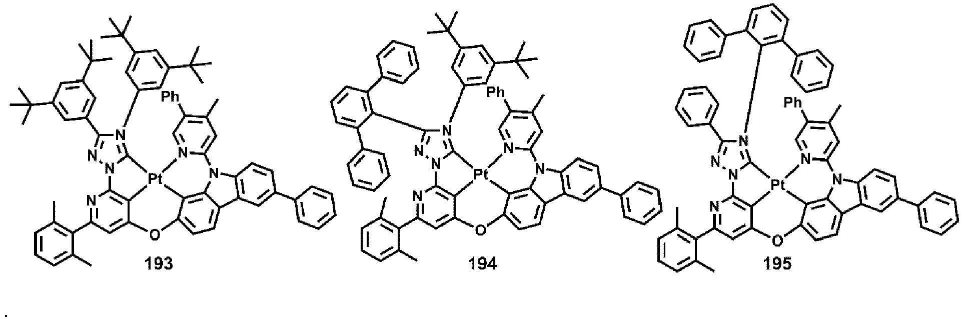

The organometallic compound represented by Formula 1 has a structure including at least three nitrogen atoms and a ligand including a carbazole moiety and a 5-membered ring moiety including a carbene structure.

Without wishing to be bound to theory, since the organometallic compound has at least three nitrogen atoms and a 5-membered ring moiety including a carbene structure, the organometallic compound may have a deep highest occupied molecular orbital (HOMO) energy level by introducing nitrogen with strong electronegativity, while maintaining a deep blue emission area. Thus, hole injection may be facilitated, so that the organometallic compound may have a low driving voltage.

Also, and without wishing to be bound to theory, since the organometallic compound includes a carbazole moiety, the organometallic compound may have increased stability against hole injection and light-emitting ability in a deep blue area. In addition, by controlling a three-dimensional structure, it is possible to reduce a bathochromic shift due to intermolecular interaction, which is observed mainly in a planar structure.

Synthesis methods of the organometallic compound represented by Formula 1 may be recognizable by one of ordinary skill in the art and by referring to Synthesis Examples provided below.

The HOMO energy level, lowest unoccupied molecular orbital (LUMO) energy level, T₁ energy level, and maximum emission wavelength (λₘₐₓ) some compounds of the organometallic compound represented by Formula 1 according one or more embodiments and Comparative Compounds C1 and C2 were calculated using a density functional theory (DFT) method of the Gaussian 09 program with the molecular structure optimized at the B3LYP level, and results thereof are shown in Table 1. The energy levels are expressed in electron volts (eV).

**Table 1**

| Compound No. | HOMO (eV) | LUMO (eV) | T₁ (eV) | Maximum emission wavelength (λₘₐₓ) (nm) |
|---|---|---|---|---|
| 1 | -4.68 | -1.19 | 2.72 | 456 |
| 11 | -4.64 | -1.17 | 2.70 | 460 |
| 21 | -4.71 | -1.22 | 2.72 | 452 |
| 5 | -4.82 | -1.31 | 2.77 | 450 |
| 16 | -4.84 | -1.31 | 2.72 | 452 |
| C1 | -4.58 | -1.21 | 2.68 | 463 |
| C2 | -4.94 | -1.52 | 2.46 | 491 |

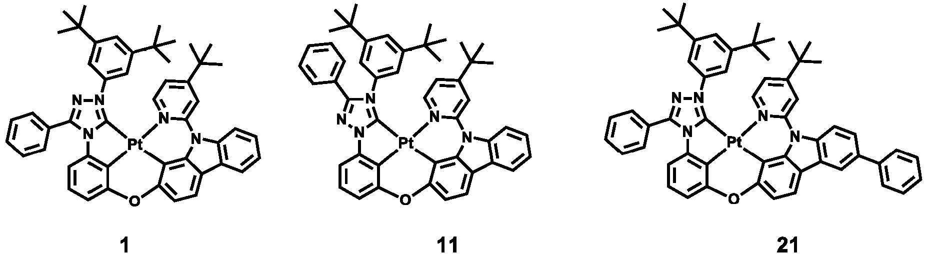

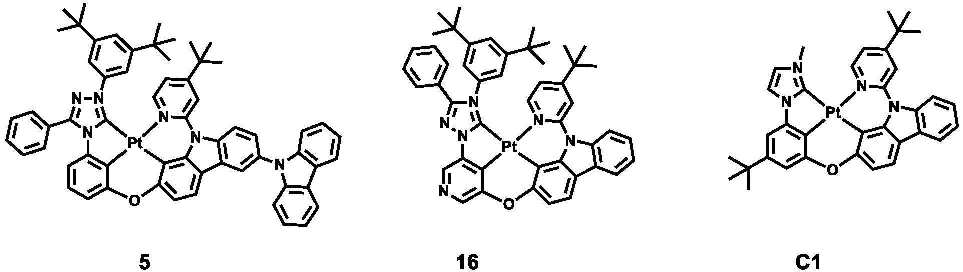

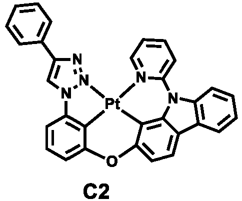

Referring to Table 1, the organometallic compounds according to one or more embodiments were found to have a higher T₁ energy level and a maximum emission wavelength that is blue-shifted, as compared with Comparative Compound C2. Thus, the organometallic compound may have suitable electrical characteristics for use as a material for an emission layer of an organic light-emitting device, for example, as a blue luminescent material. In addition, the organometallic compound had a deeper HOMO energy level, as compared with Compound C1. Thus, hole injection may be facilitated, so that the driving voltage of an organic light-emitting device may be lowered.

Accordingly, another aspect provides an organic light-emitting device including a first electrode; a second electrode; and an organic layer arranged between the first electrode and the second electrode, wherein the organic layer includes an emission layer, and wherein the organic layer further includes at least one organometallic compound described herein.

Since the organic light-emitting device has an organic layer including at least one of the organometallic compounds described herein, the organic light-emitting device may have a low driving voltage, a high efficiency, a high luminance, a high quantum efficiency, and/or a long lifespan.

The expression "(an organic layer) includes at least one organometallic compound" as used herein may include a case in which "(an organic layer) includes identical organometallic compounds represented by Formula 1" and a case in which "(an organic layer) includes two or more different organometallic compounds represented by Formula 1".

For example, the organic layer may include, as the at least one organometallic compound, only Compound 1. In this regard, Compound 1 may be present in the emission layer of the organic light-emitting device. In one or more embodiments, the organic layer may include, as the at least one organometallic compound, Compound 1 and Compound 2. In this regard, Compound 1 and Compound 2 may be present in an identical layer (for example, both Compound 1 and Compound 2 may be present in the emission layer).

In one or more embodiments, the at least one organometallic compound may be included in the emission layer of the organic light-emitting device.

The at least one organometallic compound included in the emission layer may serve as an emitter. For example, the emission layer including the at least one organometallic compound represented by Formula 1 may emit phosphorescent light that is generated by transition of triplet excitons of the organometallic compound to a ground state.

In one or more embodiments, the emission layer of the organic light-emitting device may further include a host, and an amount of the host in the emission layer may be greater than an amount of the organometallic compound in the emission layer, based on a total weight of the emission layer.

For example, the emission layer of the organic light-emitting device may include a host and a dopant, and the dopant may include the at least one organometallic compound. The host may be selected from suitable hosts. That is, the organometallic compound may serve as a dopant. The emission layer may emit light having a maximum emission wavelength of about 440 nm to about 480 nm, for example, about 440 nm to about 470 nm. For example, the emission layer may emit a blue light.

In one or more embodiments, the emission layer may include a host and a dopant, the host may be any suitable host, and the dopant may include at least one of the organometallic compounds represented by Formula 1, and the emission layer may further include a fluorescent dopant. The emission layer may emit a fluorescent light that is generated by transfer of the triplet excitons of the at least one organometallic compound to the fluorescent dopant, and then a resulting electronic transition thereof.

The first electrode may be an anode, which is a hole injection electrode, and the second electrode may be a cathode, which is an electron injection electrode. In one or more embodiments, the first electrode may be a cathode, which is an electron injection electrode, and the second electrode may be an anode, which is a hole injection electrode.

In one or more embodiments, the first electrode may be an anode, the second electrode may be a cathode, and the organic layer may include a hole transport region arranged between the first electrode and the emission layer, and an electron transport region arranged between the emission layer and the second electrode, wherein the hole transport region may include a hole injection layer, a hole transport layer, an electron blocking layer, or a combination thereof, and the electron transport region may include a hole blocking layer, an electron transport layer, an electron injection layer, or a combination thereof.

For example, the at least one organometallic compound may be included in at least one of the hole transport region and the electron transport region.

Another aspect provides an electronic apparatus including the organic light-emitting device as described herein.

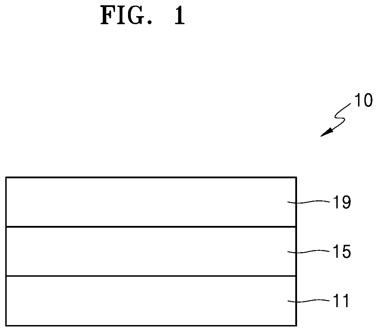

### Description of FIG. 1

FIG. 1 is a schematic cross-sectional view of an organic light-emitting device 10 according to one or more embodiments. Hereinafter, the structure and manufacturing method of the organic light-emitting device 10 according to one or more embodiments will be described in further detail with reference to FIG. 1.

The organic light-emitting device 10 of FIG. 1 includes a first electrode 11, an organic layer 15, and a second electrode 19, which are sequentially stacked in this stated order.

A substrate may be additionally arranged under the first electrode 11 or above the second electrode 19. For use as the substrate, any substrate that is used in organic light-emitting devices available in the art may be used, and the substrate may be a glass substrate or a transparent plastic substrate, each having excellent mechanical strength, thermal stability, transparency, surface smoothness, ease of handling, and/or water resistance.

The first electrode 11 may be, for example, formed by depositing or sputtering a material for forming the first electrode 11 on the substrate. The first electrode 11 may be an anode. The material for forming the first electrode 11 may be selected from materials with a high work function to facilitate hole injection.

The first electrode 11 may be a reflective electrode, a semi-transmissive electrode, or a transmissive electrode. The material for forming the first electrode 11 may be indium tin oxide (ITO), indium zinc oxide (IZO), tin oxide (SnO₂), or zinc oxide (ZnO). In one or more embodiments, the material for forming the first electrode 11 may be a metal, such as magnesium (Mg), aluminum (Al), silver (Ag), aluminum-lithium (Al-Li), calcium (Ca), magnesium-indium (Mg-In), or magnesium-silver (Mg-Ag).

The first electrode 11 may have a single-layered structure or a multi-layered structure including a plurality of layers. For example, the first electrode 11 may have a three-layered structure of ITO/Ag/ITO, but embodiments are not limited thereto.

The organic layer 15 is arranged on the first electrode 11.

The organic layer 15 may include a hole transport region, an emission layer, and an electron transport region.

The hole transport region may be arranged between the first electrode 11 and the emission layer.

The hole transport region may include at least one of a hole injection layer, a hole transport layer, an electron blocking layer, a buffer layer, or a combination thereof.

The hole transport region may include only a hole injection layer or only a hole transport layer. In one or more embodiments, the hole transport region may have a hole injection layer/hole transport layer structure or a hole injection layer/hole transport layer/electron blocking layer structure, wherein, for each structure, respective layers are sequentially stacked in this stated order from the first electrode 11.

When the hole transport region includes a hole injection layer, the hole injection layer may be formed on the first electrode 11 by using one or more suitable methods, such as vacuum deposition, spin coating, casting, Langmuir-Blodgett (LB) deposition, or the like.

When the hole injection layer is formed by vacuum deposition, the deposition conditions may vary according to a material that is used to form the hole injection layer, and the structure and thermal characteristics of the hole injection layer. For example, the deposition conditions may include a deposition temperature of about 100°C to about 500°C, a vacuum pressure in a range of about 1.33 x 10⁻⁵ Pa to about 1.33 (10⁻⁸ torr to about 10⁻³ torr), and a deposition rate in a range of about 0.01 angstroms per second (Å/sec) to about 100 Å/sec, but embodiments are not limited thereto.

When the hole injection layer is formed by spin coating, the coating conditions may vary according to a material that is used to form the hole injection layer, and the structure and thermal characteristics of the hole injection layer. For example, the coating conditions may include a coating speed in a range of about 2,000 revolutions per minute (rpm) to about 5,000 rpm and a heat treatment for removing a solvent after coating at a temperature of about 80°C to about 200°C, but embodiments are not limited thereto.

Conditions for forming the hole transport layer and the electron blocking layer may be similar to or the same as the conditions for forming the hole injection layer.

The hole transport region may include, for example, at least one of 4,4',4"-tris(3-methylphenylphenylamino)triphenylamine (m-MTDATA), 4,4',4"-tris(N,N-diphenylamino)triphenylamine (TDATA), 4,4',4"-tris{N-(2-naphthyl)-N-phenylamino}-triphenylamine (2-TNATA), N,N'-di(1-naphthyl)-N,N'-diphenylbenzidine (NPB), β-NPB, N,N'-bis(3-methylphenyl)-N,N'-diphenyl-[1,1-biphenyl]-4,4'-diamine (TPD), spiro-TPD, Spiro-NPB, methylated NPB, 4,4'-cyclohexylidene bis[N,N-bis(4-methylphenyl)benzenamine] (TAPC), 4,4'-bis[N,N'-(3-tolyl)amino]-3,3'-dimethylbiphenyl (HMTPD), 4,4',4"-tris(N-carbazolyl)triphenylamine (TCTA), polyaniline/dodecylbenzenesulfonic acid (PANI/DBSA), poly(3,4-ethylenedioxythiophene)/poly(4-styrenesulfonate) (PEDOT/PSS), polyaniline/camphor sulfonic acid (PANI/CSA), (polyaniline)/poly(4-styrenesulfonate) (PANI/PSS), a compound represented by Formula 201, or a compound represented by Formula 202, but embodiments are not limited thereto: 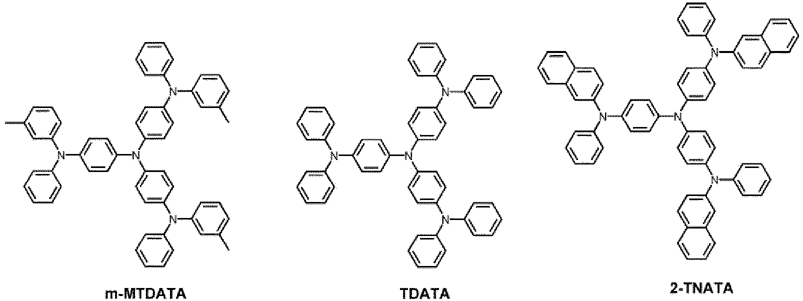 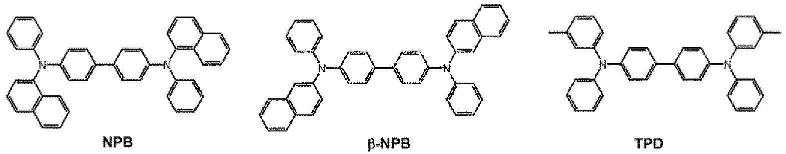 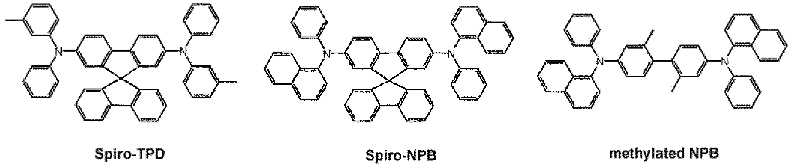 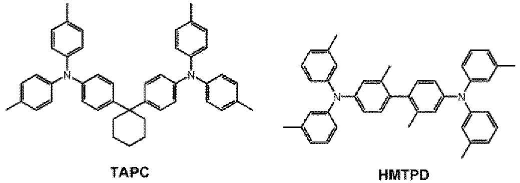 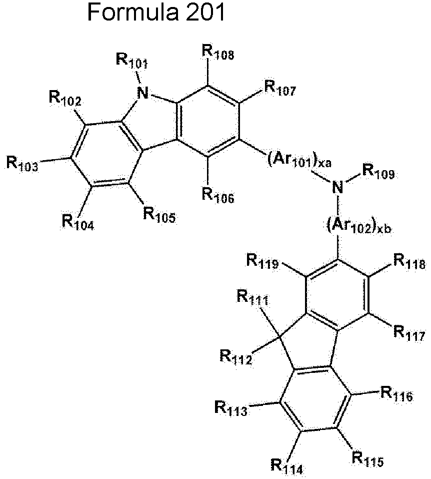 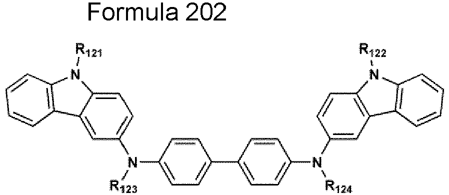 wherein, in Formula 201, Ar₁₀₁ and Ar₁₀₂ may each independently be a phenylene group, a pentalenylene group, an indenylene group, a naphthylene group, an azulenylene group, a heptalenylene group, an acenaphthylene group, a fluorenylene group, a phenalenylene group, a phenanthrenylene group, an anthracenylene group, a fluoranthenylene group, a triphenylenylene group, a pyrenylene group, a chrysenylenylene group, a naphthacenylene group, a picenylene group, a perylenylene group, or a pentacenylene group, each unsubstituted or substituted with at least one of deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₃-C₁₀ cycloalkenyl group, a C₁-C₁₀ heterocycloalkyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, a monovalent non-aromatic condensed heteropolycyclic group, or a combination thereof.

xa and xb in Formula 201 may each independently be an integer from 0 to 5, or may each independently be 0, 1, or 2. For example, xa may be 1 and xb may be 0, but embodiments are not limited thereto.

R₁₀₁ to R₁₀₈, R₁₁₁ to R₁₁₉, and R₁₂₁ to R₁₂₄ in Formulae 201 and 202 may each independently be:
hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group (for example, a methyl group, an ethyl group, a propyl group, a butyl group, pentyl group, a hexyl group, or the like), a C₁-C₁₀ alkoxy group (for example, a methoxy group, an ethoxy group, a propoxy group, a butoxy group, a pentoxy group, or the like), or a C₁-C₁₀ alkylthio group;
C₁-C₁₀ alkyl group, a C₁-C₁₀ alkoxy group, or a C₁-C₁₀ alkylthio group, each unsubstituted or substituted with at least one of deuterium, -F, -Cl, -Br, - I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, or a combination thereof; or
a phenyl group, a naphthyl group, an anthracenyl group, a fluorenyl group, or a pyrenyl group, each unsubstituted or substituted with at least one of deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group, a C₁-C₁₀ alkoxy group, a C₁-C₁₀ alkylthio group, or a combination thereof.

R₁₀₉ in Formula 201 may be a phenyl group, a naphthyl group, an anthracenyl group, or a pyridinyl group, each unsubstituted or substituted with at least one of deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a C₁-C₂₀ alkylthio group, a phenyl group, a naphthyl group, an anthracenyl group, a pyridinyl group, or a combination thereof.

In one or more embodiments, the compound represented by Formula 201 may be represented by Formula 201A: 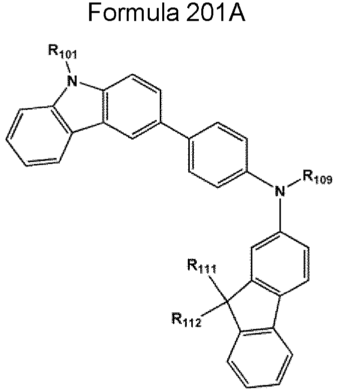 wherein, in Formula 201A, R₁₀₁, R₁₁₁, R₁₁₂, and R₁₀₉ may each be as described herein.

For example, the hole transport region may include one of Compounds HT1 to HT20, or a combination thereof, but embodiments are not limited thereto:

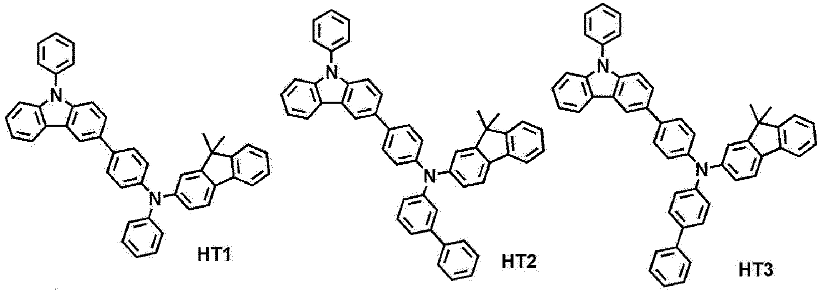

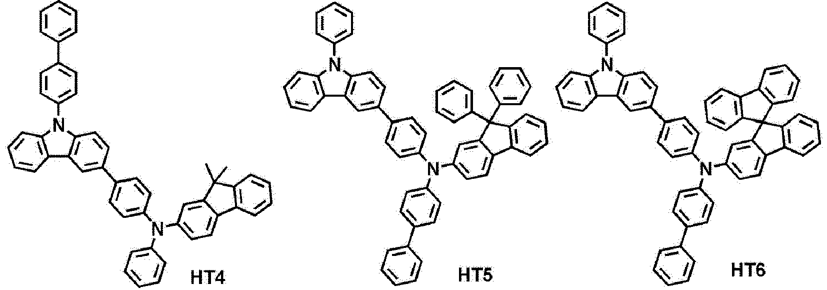

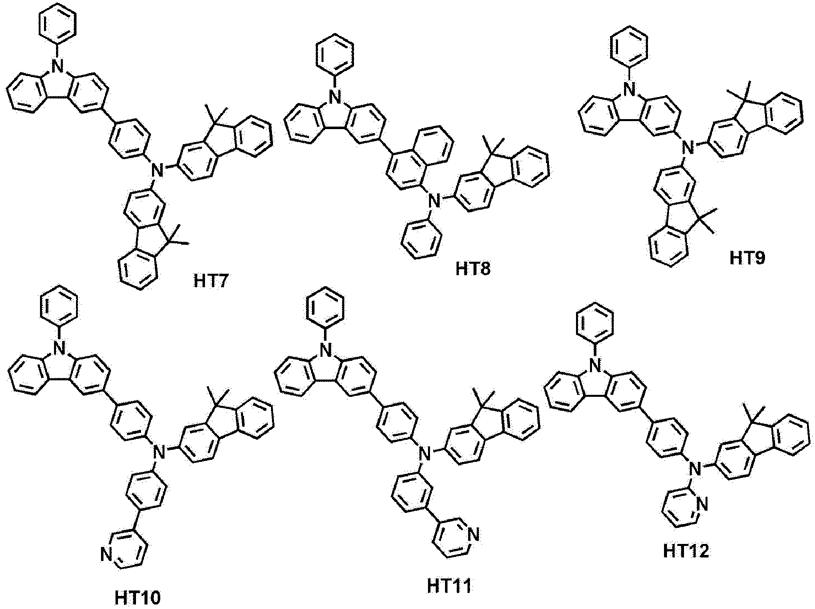

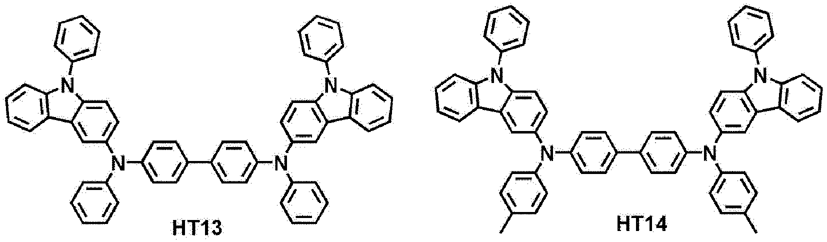

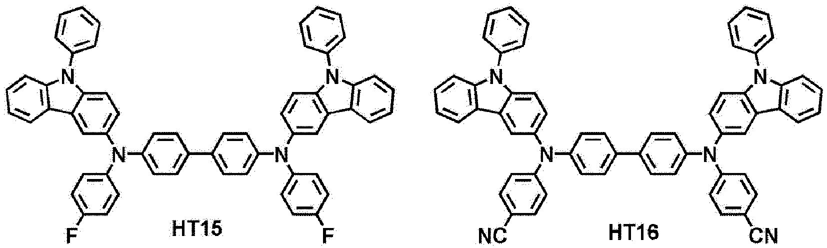

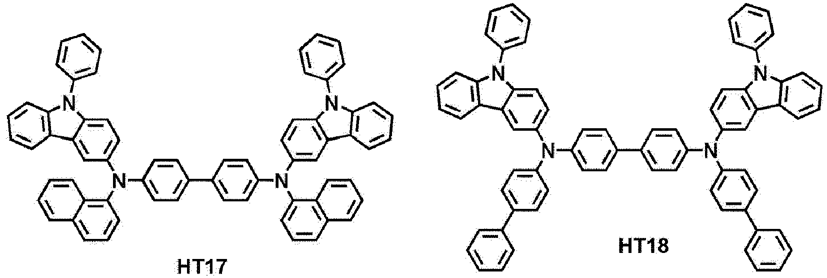

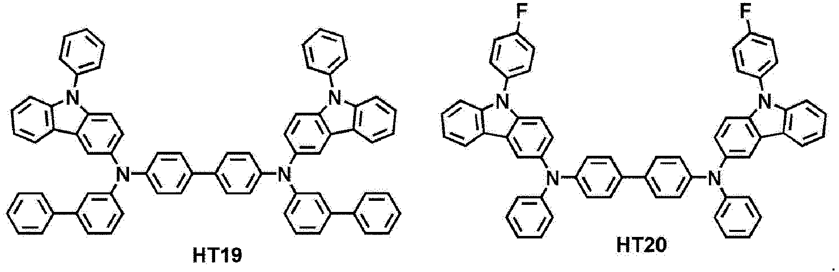

A thickness of the hole transport region may be about 100 angstroms (Å) to about 10,000 Å, for example, about 100 Å to about 1,000 Å. When the hole transport region includes at least one of a hole injection layer and a hole transport layer, a thickness of the hole injection layer may be about 100 Å to about 10,000 Å, for example, about 100 Å to about 1,000 Å, and a thickness of the hole transport layer may be about 50 Å to about 2,000 Å, for example, about 100 Å to about 1,500 Å. When the thicknesses of the hole transport region, the hole injection layer, and the hole transport layer are within these ranges, satisfactory hole transporting characteristics may be obtained without a substantial increase in driving voltage.

The hole transport region may further include, in addition to the materials described above, a charge-generation material for improving conductive properties. The charge-generation material may be homogeneously or non-homogeneously (heterogeneously) dispersed in the hole transport region.

The charge-generation material may be, for example, a p-dopant. The p-dopant may include a quinone derivative, a metal oxide, a cyano group-containing compound, or a combination thereof, but embodiments are not limited thereto. For example, non-limiting examples of the p-dopant may include a quinone derivative, such as tetracyanoquinodimethane (TCNQ), 2,3,5,6-tetrafluoro-tetracyano-1,4-benzoquinonedimethane (F4-TCNQ), 1,3,4,5,7,8-hexafluorotetracyanonaphthoquinodimethane (F6-TCNQ), or the like; a metal oxide, such as a tungsten oxide, a molybdenum oxide, or the like; or a cyano group-containing compound, such as Compound HT-D1 or Compound HT-D2, but embodiments are not limited thereto:

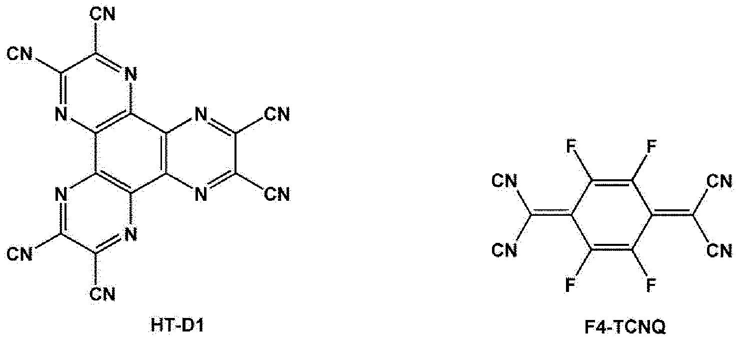

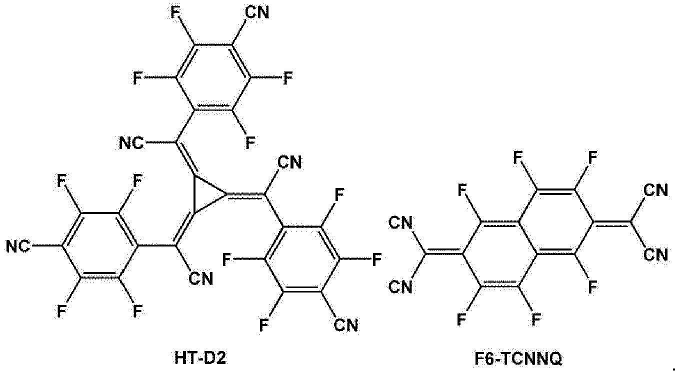

The hole transport region may further include a buffer layer.

The buffer layer may compensate for an optical resonance distance according to a wavelength of light emitted from the emission layer to increase efficiency.

The emission layer may be formed on the hole transport region by using one or more suitable methods, such as vacuum deposition, spin coating, casting, and/or LB deposition. When the emission layer is formed by vacuum deposition or spin coating, the deposition or coating conditions may be similar to those applied in forming the hole injection layer, though the deposition or coating conditions may vary according to a material that is used to form the emission layer.

The hole transport region may further include an electron blocking layer. The electron blocking layer may include any suitable material available in the art, for example, 1,3-bis(N-carbazolyl)benzene (mCP), but embodiments are not limited thereto:

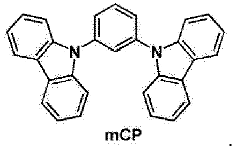

A thickness of the electron blocking layer may be about 50 Å to about 1,000 Å, for example, about 70 Å to about 500 Å. When the thickness of the electron blocking layer is within this range, satisfactory electron blocking characteristics may be obtained without a substantial increase in driving voltage.

When the organic light-emitting device 10 is a full-color organic light-emitting device, the emission layer may be patterned into a red emission layer, a green emission layer, and/or a blue emission layer. In one or more embodiments, due to a stacked structure including a red emission layer, a green emission layer, and/or a blue emission layer, the emission layer may emit a white light, and various modifications are possible.

The emission layer may include at least one of the organometallic compounds represented by Formula 1.

The emission layer may include a host and a dopant, and the dopant may include at least one of the organometallic compounds represented by Formula 1.

The host may include 1,3,5-tri(1-phenyl-1H-benzo[d]imidazol-2-yl)phenyl (TPBi), 3-tert-butyl-9,10-di(naphth-2-yl)anthracene (TBADN), 9,10-di(naphthalene-2-yl)anthracene (ADN) (also referred to as "DNA"), 4,4'-bis(N-carbazolyl)-1,1'-biphenyl (CBP), 4,4'-bis(9-carbazolyl)-2,2'-dimethyl-biphenyl (CDBP), 1,3,5-tris(carbazole-9-yl)benzene (tCP), 1,3-bis(N-carbazolyl)benzene (mCP), Compound H50, Compound H51, Compound H52, or a combination thereof, but embodiments are not limited thereto:

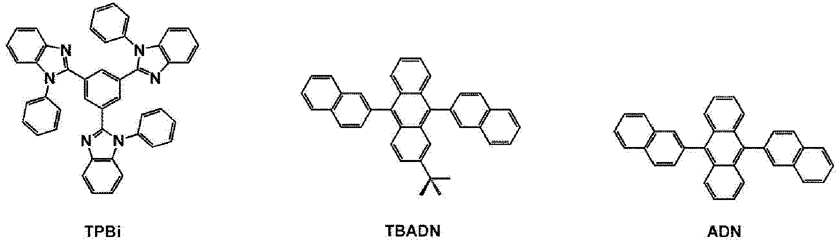

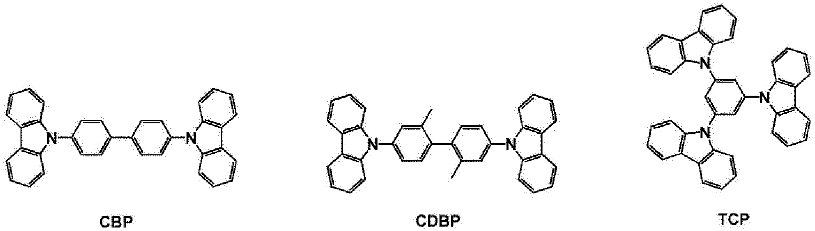

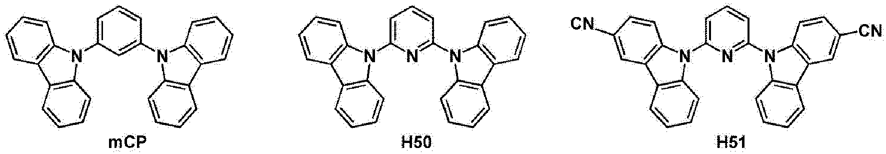

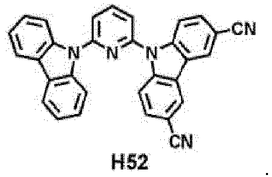

In one or more embodiments, the host may further include a compound represented by Formula 301: 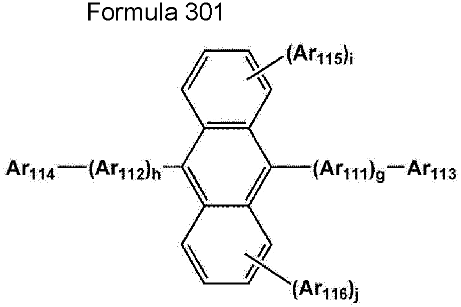 wherein, in Formula 301, Ar₁₁₁ and Ar₁₁₂ may each independently be:
a phenylene group, a naphthylene group, a phenanthrenylene group, or a pyrenylene group; or
a phenylene group, a naphthylene group, a phenanthrenylene group, or a pyrenylene group, each substituted with at least one of a phenyl group, a naphthyl group, an anthracenyl group, or a combination thereof.

Ar₁₁₃ to Ar₁₁₆ in Formula 301 may each independently be:
a C₁-C₁₀ alkyl group, a phenyl group, a naphthyl group, a phenanthrenyl group, or a pyrenyl group; or
a phenyl group, a naphthyl group, a phenanthrenyl group, or a pyrenyl group, each substituted with at least one of a phenyl group, a naphthyl group, an anthracenyl group, or a combination thereof.

g, h, i, and j in Formula 301 may each independently be 0, 1, 2, 3, or 4. For example, g, h, i, and j in Formula 301 may each independently be 0, 1, or 2.

Ar₁₁₃ to Ar₁₁₆ in Formula 301 may each independently be:
a C₁-C₁₀ alkyl group substituted with at least one of a phenyl group, a naphthyl group, an anthracenyl group, or a combination thereof;
a phenyl group, a naphthyl group, an anthracenyl group, a pyrenyl group, a phenanthrenyl group, or a fluorenyl group;
a phenyl group, a naphthyl group, an anthracenyl group, a pyrenyl group, a phenanthrenyl group, or a fluorenyl group, each substituted with at least one of deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a phenyl group, a naphthyl group, an anthracenyl group, a pyrenyl group, a phenanthrenyl group, a fluorenyl group, or a combination thereof; or
a compound represented by the formula: 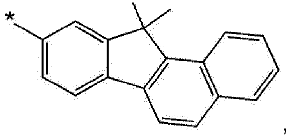
but embodiments are not limited thereto.

In one or more embodiments, the host may include a compound represented by Formula 302: 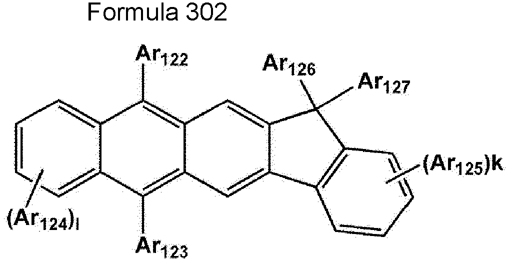 wherein, in Formula 302, Ar₁₂₂ to Ar₁₂₅ may each be as described in connection with Ar₁₁₃ in Formula 301.

Ar₁₂₆ and Ar₁₂₇ in Formula 302 may each independently be a C₁-C₁₀ alkyl group (for example, a methyl group, an ethyl group, a propyl group, or the like).

k and l in Formula 302 may each independently be an integer of 0, 1, 2, 3, or 4. For example, k and I in Formula 302 may each independently be 0, 1, or 2.

When the organic light-emitting device 10 is a full-color organic light-emitting device, the emission layer may be patterned into a red emission layer, a green emission layer, and/or a blue emission layer. In one or more embodiments, due to a stacked structure including a red emission layer, a green emission layer, and/or a blue emission layer, the emission layer may emit a white light, and various modifications are possible.

When the emission layer includes a host and a dopant, an amount of the dopant may be about 0.01 part by weight to about 20 parts by weight, based on 100 parts by weight of the emission layer, but embodiments are not limited thereto. When the amount of the dopant is within this range, light emission without quenching may be realized.

In one or more embodiments, the organic layer 15 of the organic light-emitting device 10 may further include, in addition to the at least one organometallic compound represented by Formula 1, at least one fluorescent dopant.

For example, the at least one fluorescent dopant may be a condensed polycyclic compound, a styryl-based compound, or a combination thereof.

In one or more embodiments, the fluorescent dopant may be a compound represented by Formula 501: 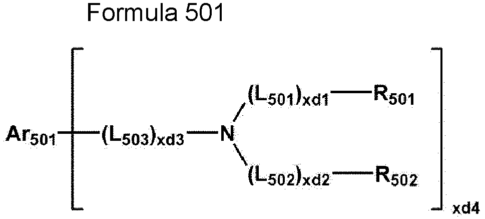 wherein, in Formula 501,
Ar₅₀₁ may be:
a naphthalene group, a fluorene group, a spiro-bifluorene group, a benzofluorene group, a dibenzofluorene group, a phenanthrene group, an anthracene group, a fluoranthene group, a triphenylene group, a pyrene group, a chrysene group, a naphthacene group, a picene group, a perylene group, a pentaphene group, an indenoanthracene group, a tetracene group, a bisanthracene group, or a group represented by one of Formulae 501-1 to 501-18; or
a naphthalene group, a fluorene group, a spiro-bifluorene group, a benzofluorene group, a dibenzofluorene group, a phenanthrene group, an anthracene group, a fluoranthene group, a triphenylene group, a pyrene group, a chrysene group, a naphthacene group, a picene group, a perylene group, a pentaphene group, an indenoanthracene group, a tetracene group, a bisanthracene group, or a group represented by one of Formulae 501-1 to 501-18, each substituted with at least one of deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -Si(Q₅₀₁)(Q₅₀₂)(Q₅₀₃) (wherein Q₅₀₁ to Q₅₀₃ may each independently be hydrogen, a C₁-C₆₀ alkyl group, a C₁-C₆₀ alkoxy group, a C₁-C₆₀ alkylthio group, a C₆-C₆₀ aryl group, a C₇-C₆₀ alkyl aryl group, a C₇-C₆₀ aryl alkyl group, a C₁-C₆₀ heteroaryl group, a C₂-C₆₀ alkyl heteroaryl group, a C₂-C₆₀ heteroaryl alkyl group, a monovalent non-aromatic condensed polycyclic group, or a monovalent non-aromatic condensed heteropolycyclic group), or a combination thereof,
L₅₀₁ to L₅₀₃ may each independently be a substituted or unsubstituted C₃-C₁₀ cycloalkylene group, a substituted or unsubstituted C₁-C₁₀ heterocycloalkylene group, a substituted or unsubstituted C₃-C₁₀ cycloalkenylene group, a substituted or unsubstituted C₁-C₁₀ heterocycloalkenylene group, a substituted or unsubstituted C₆-C₆₀ arylene group, a substituted or unsubstituted C₁-C₆₀ heteroarylene group, a substituted or unsubstituted divalent non-aromatic condensed polycyclic group, or a substituted or unsubstituted divalent non-aromatic condensed heteropolycyclic group,
R₅₀₁ and R₅₀₂ may each independently be:
   a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazole group, a triazinyl group, a dibenzofuranyl group, or a dibenzothiophenyl group; or
   a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazolyl group, a triazinyl group, a dibenzofuranyl group, or a dibenzothiophenyl group, each substituted with at least one of deuterium, -F, -Cl, -Br, -I, -SFs, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a C₁-C₂₀ alkylthio group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazolyl group, a triazinyl group, a dibenzofuranyl group, a dibenzothiophenyl group, or a combination thereof,
   xd1 to xd3 may each independently be 0, 1, 2, or 3, and
   xd4 may be 0, 1, 2, 3, 4, 5, or 6.

For example, in Formula 501,
Ar₅₀₁ may be:
a naphthalene group, a fluorene group, a spiro-bifluorene group, a benzofluorene group, a dibenzofluorene group, a phenanthrene group, an anthracene group, a fluoranthene group, a triphenylene group, a pyrene group, a chrysene group, a naphthacene group, a picene group, a perylene group, a pentaphene group, an indenoanthracene group, a tetracene group, a bisanthracene group, or a group represented by one of Formulae 501-1 to 501-18; or
a naphthalene group, a fluorene group, a spiro-bifluorene group, a benzofluorene group, a dibenzofluorene group, a phenanthrene group, an anthracene group, a fluoranthene group, a triphenylene group, a pyrene group, a chrysene group, a naphthacene group, a picene group, a perylene group, a pentaphene group, an indenoanthracene group, a tetracene group, a bisanthracene group, or a group represented by one of Formulae 501-1 to 501-18, each substituted with at least one of deuterium, -F, -Cl, -Br, -I, -SFs, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a C₁-C₂₀ alkylthio group, a phenyl group, a biphenyl group, a terphenyl group, a naphthyl group, a fluorenyl group, a dibenzofuranyl group, a dibenzothiophenyl group, a carbazolyl group, a pyridinyl group, a pyrimidinyl group, a triazinyl group, a quinolinyl group, an isoquinolinyl group, -Si(Q₅₀₁)(Q₅₀₂)(Q₅₀₃) (wherein Q₅₀₁ to Q₅₀₃ may each independently be hydrogen, a C₁-C₂₀ alkyl group, a C₁-C₂₀ alkoxy group, a C₁-C₂₀ alkylthio group, a phenyl group, a biphenyl group, a terphenyl group, or a naphthyl group), or a combination thereof, 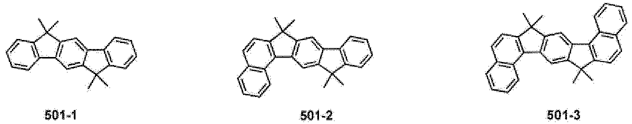 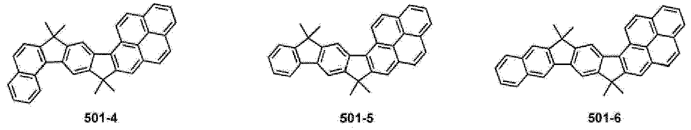 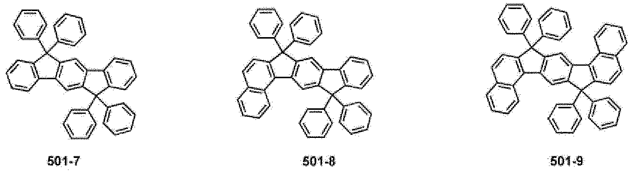 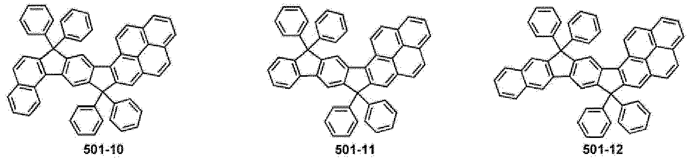 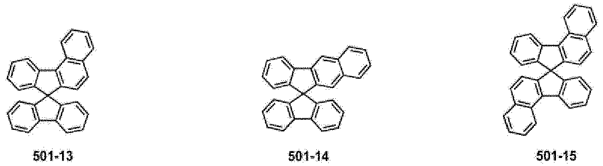 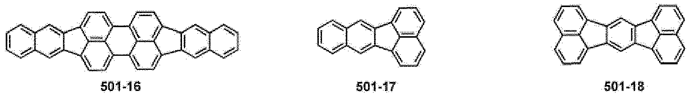
L₅₀₁ to L₅₀₃ are each as described in connection with L₂₁,
xd1 to xd3 may each independently be 0, 1, or 2, and
xd4 may be 0, 1, 2, or 3, but embodiments are not limited thereto.

The fluorescent dopant may include, for example, at least one of Compounds FD(1) to FD(16), Compounds FD1 to FD13, or a combination thereof, but embodiments are not limited thereto:

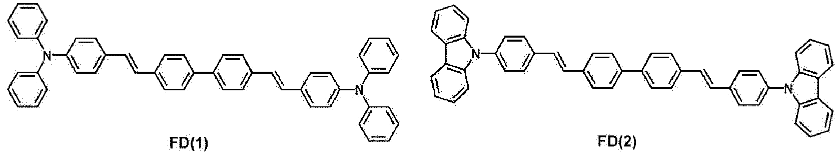

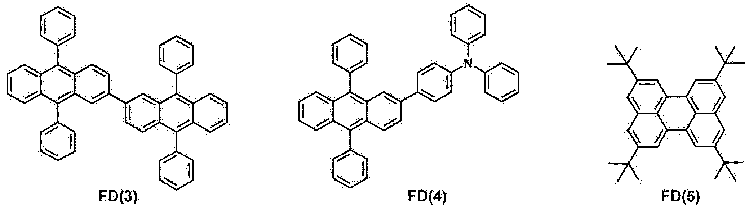

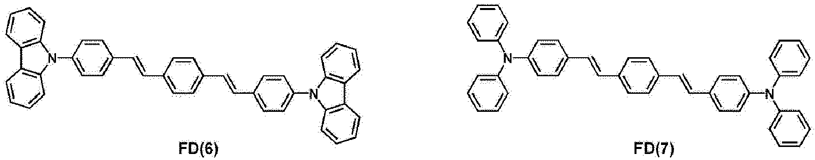

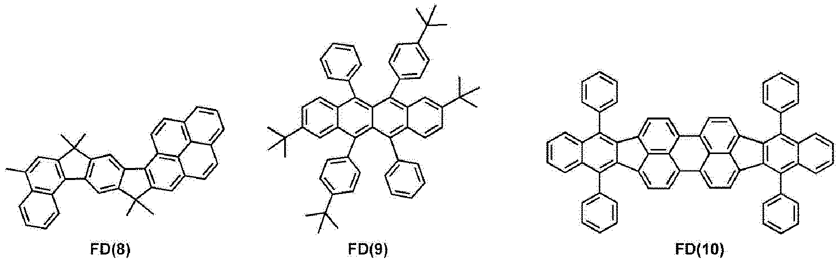

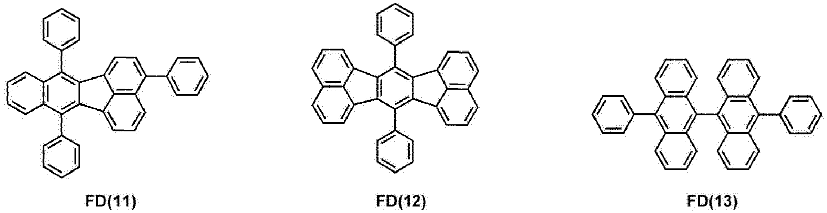

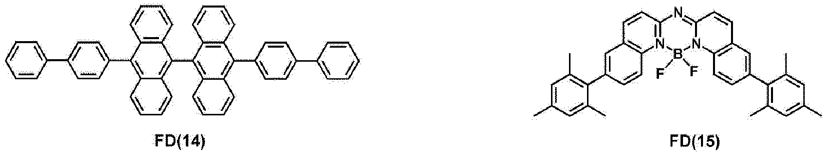

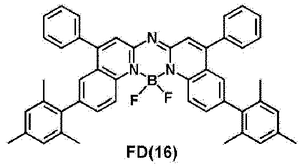

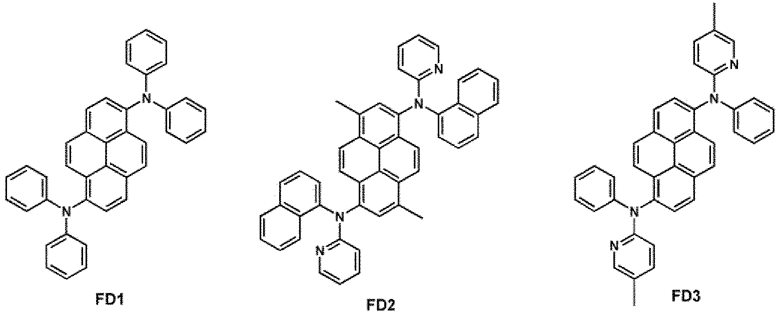

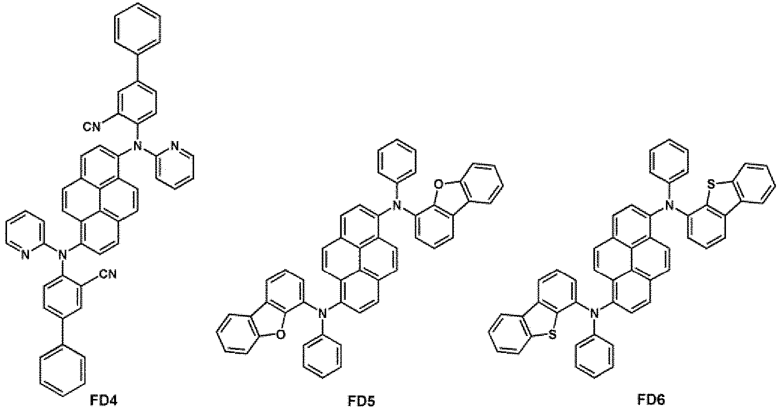

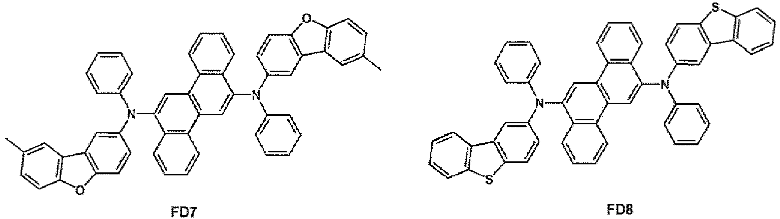

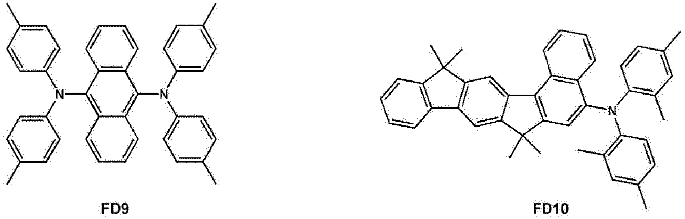

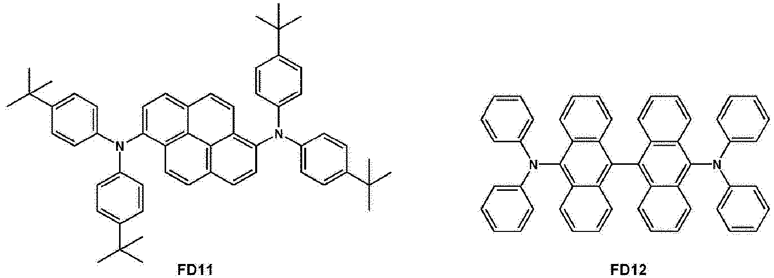

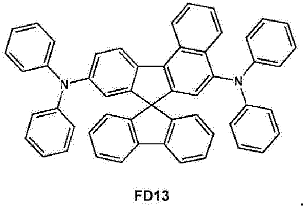

A thickness of the emission layer may be about 100 Å to about 1,000 Å, for example, about 200 Å to about 600 Å. When the thickness of the emission layer is within this range, excellent luminescence characteristics may be obtained without a substantial increase in driving voltage.

Next, the electron transport region may be arranged on the emission layer.

The electron transport region may include at least one of a hole blocking layer, an electron transport layer, an electron injection layer, or a combination thereof.

For example, the electron transport region may have a hole blocking layer/electron transport layer/electron injection layer structure or an electron transport layer/electron injection layer structure, but embodiments are not limited thereto. The electron transport layer may have a single-layered structure or a multi-layered structure including two or more different materials.

Conditions for forming the hole blocking layer, the electron transport layer, and the electron injection layer which constitute the electron transport region may be similar to or the same as the conditions for forming the hole injection layer.

When the electron transport region includes a hole blocking layer, the hole blocking layer may include, for example, at least one of 2,9-dimethyl-4,7-diphenyl-1,10-phenanthroline (BCP) or 4,7-diphenyl-1,10-phenanthroline (Bphen), but embodiments are not limited thereto:

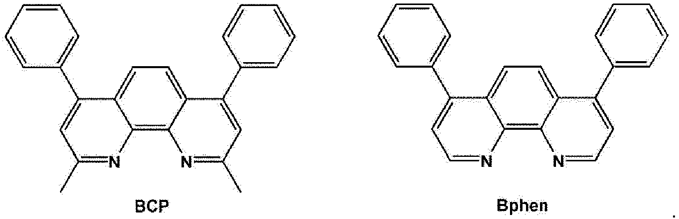

A thickness of the hole blocking layer may be about 20 Å to about 1,000 Å, for example, about 30 Å to about 300 Å. When the thickness of the hole blocking layer is within this range, excellent hole blocking characteristics may be obtained without a substantial increase in driving voltage.

The electron transport layer may include at least one of 2,9-dimethyl-4,7-diphenyl-1,10-phenanthroline (BCP), 4,7-diphenyl-1,10-phenanthroline (Bphen), tris(8-hydroxy-quinolinato)aluminum (Alq₃), bis(2-methyl-8-quinolinolato-N1,O8)-(1,1'-biphenyl-4-olato)aluminum (BAlq), 3-(4-biphenylyl)-4-phenyl-5-tert-butylphenyl-1,2,4-triazole (TAZ), or 4-(naphthalen-1-yl)-3,5-diphenyl-4H-1,2,4-triazole (NTAZ), but embodiments are not limited thereto:

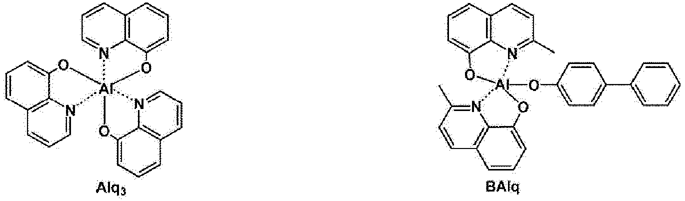

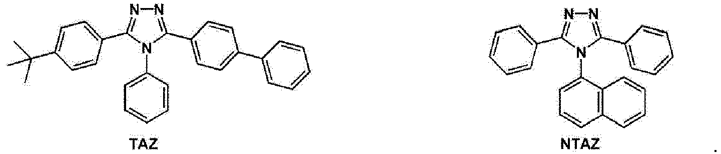

In one or more embodiments, the electron transport layer may include at least one of Compounds ET1 to ET25, but embodiments are not limited thereto:

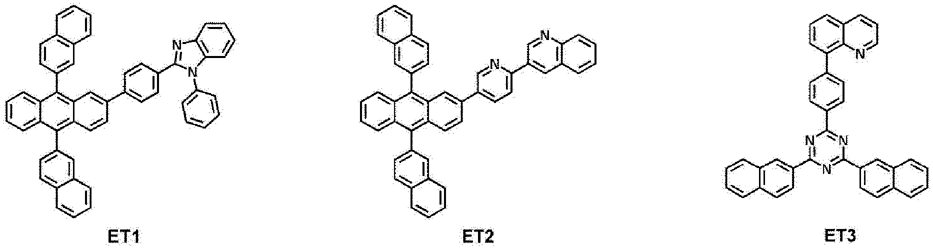

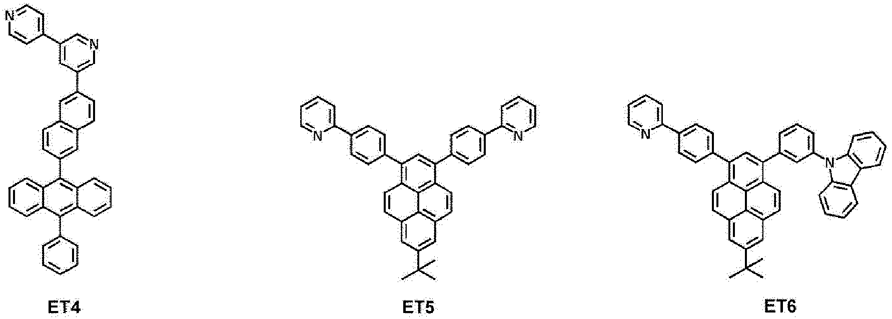

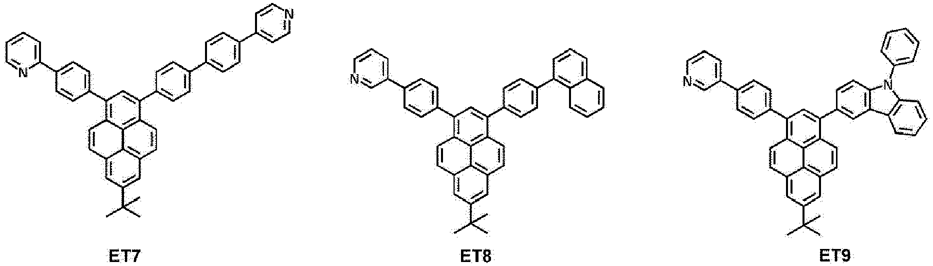

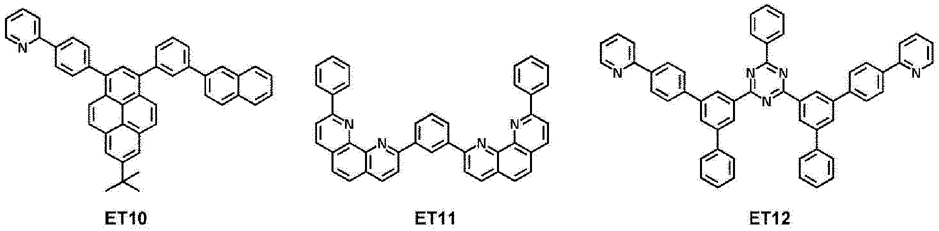

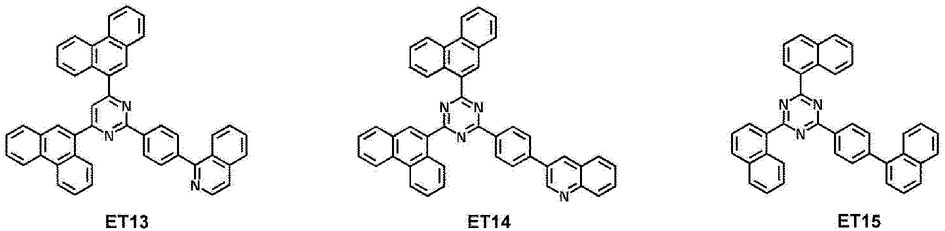

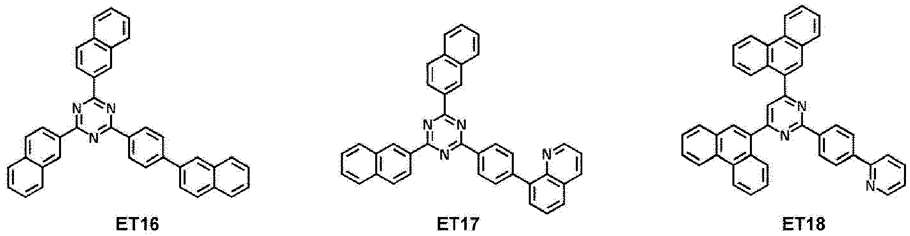

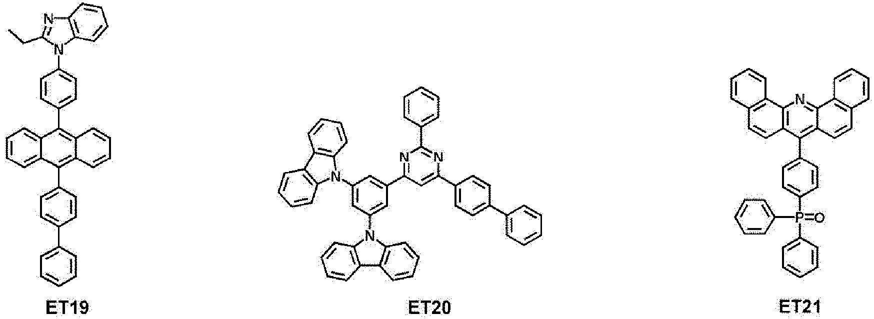

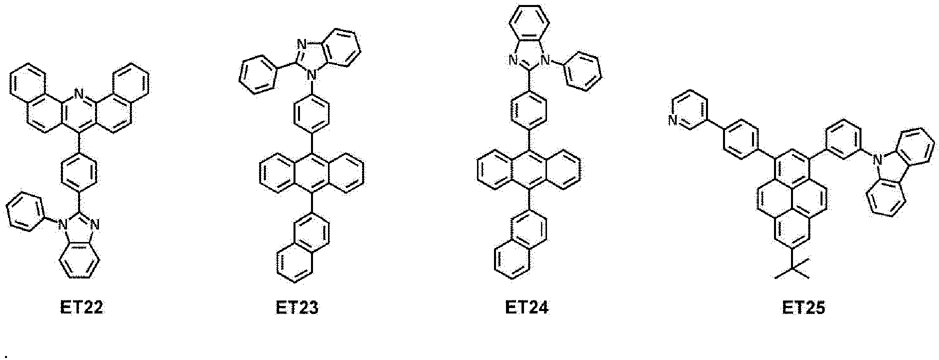

A thickness of the electron transport layer may be about 100 Å to about 1,000 Å, for example, about 150 Å to about 500 Å. When the thickness of the electron transport layer is within this range, satisfactory electron transporting characteristics may be obtained without a substantial increase in driving voltage.

The electron transport layer may include, in addition to the materials described herein, a metal-containing material.

The metal-containing material may include a Li complex. The Li complex may include, for example, Compound ET-D1 (lithium quinolate, LiQ) or ET-D2, but embodiments are not limited thereto:

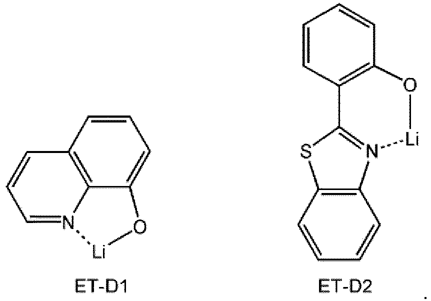

The electron transport region may include an electron injection layer that facilitates injection of electrons from the second electrode 19.

The electron injection layer may include at least one of LiQ, LiF, NaCl, CsF, Li₂O, or BaO, but embodiments are not limited thereto.

A thickness of the electron injection layer may be about 1 Å to about 100 Å, for example, about 3 Å to about 90 Å. When the thickness of the electron injection layer is within this range, satisfactory electron injection characteristics may be obtained without a substantial increase in driving voltage.

The second electrode 19 may be arranged on the organic layer 15. The second electrode 19 may be a cathode. A material for forming the second electrode 19 may be a metal, an alloy, an electrically conductive compound, or a combination thereof, each of which may have a relatively low work function. For example, the material for forming the second electrode 19 may be lithium (Li), magnesium (Mg), aluminum (Al), silver (Ag), aluminum-lithium (Al-Li), calcium (Ca), magnesium-indium (Mg-In), or magnesium-silver (Mg-Ag). In one or more embodiments, to manufacture a top-emission type light-emitting device, a transmissive electrode formed using ITO or IZO may be used as the second electrode 19.

Hereinbefore, the organic light-emitting device 10 has been described with reference to FIG. 1, but embodiments are not limited thereto.

According to another aspect, the organic light-emitting device may be included in an electronic apparatus. Thus, an electronic apparatus including the organic light-emitting device is provided. The electronic apparatus may include, for example, a display, an illumination, a sensor, or the like, but embodiments are not limited thereto.

### Explanation of terms

The term "C₁-C₆₀ alkyl group" as used herein refers to a linear or branched saturated aliphatic hydrocarbon monovalent group having 1 to 60 carbon atoms, and non-limiting examples thereof may include a methyl group, an ethyl group, a propyl group, an isobutyl group, a sec-butyl group, a tert-butyl group, a pentyl group, an isoamyl group, a hexyl group, or the like. The term "C₁-C₆₀ alkylene group" as used herein refers to a divalent group having the same structure as the C₁-C₆₀ alkyl group.

The term "C₁-C₆₀ alkoxy group" as used herein refers to a monovalent group represented by -OA₁₀₁ (wherein A₁₀₁ is the C₁-C₆₀ alkyl group), and non-limiting examples thereof may include a methoxy group, an ethoxy group, an isopropyloxy group, or the like.

The term "C₂-C₆₀ alkenyl group" as used herein refers to a hydrocarbon group formed by substituting at least one carbon-carbon double bond in the middle or at the terminus of the C₂-C₆₀ alkyl group, and non-limiting examples thereof may include an ethenyl group, a propenyl group, a butenyl group, or the like. The term "C₂-C₆₀ alkenylene group" as used herein refers to a divalent group having the same structure as the C₂-C₆₀ alkenyl group.

The term "C₂-C₆₀ alkynyl group" as used herein refers to a hydrocarbon group formed by substituting at least one carbon-carbon triple bond in the middle or at the terminus of the C₂-C₆₀ alkyl group, and non-limiting examples thereof may include an ethynyl group, a propynyl group, or the like. The term "C₂-C₆₀ alkynylene group" as used herein refers to a divalent group having the same structure as the C₂-C₆₀ alkynyl group.

The term "C₃-C₁₀ cycloalkyl group" as used herein refers to a monovalent saturated hydrocarbon monocyclic group having 3 to 10 carbon atoms, and non-limiting examples thereof may include a cyclopropyl group, a cyclobutyl group, a cyclopentyl group, a cyclohexyl group, a cycloheptyl group, or the like. The term "C₃-C₁₀ cycloalkylene group" as used herein refers to a divalent group having the same structure as the C₃-C₁₀ cycloalkyl group.

The term "C₁-C₁₀ heterocycloalkyl group" as used herein refers to a monovalent monocyclic group including at least one heteroatom selected from B, N, O, P, Si, Ge, Se, and S as a ring-forming atom and 1 to 10 carbon atoms as ring forming atom(s), and non-limiting examples thereof may include a tetrahydrofuranyl group, a tetrahydrothiophenyl group, or the like. The term "C₁-C₁₀ heterocycloalkylene group" as used herein refers to a divalent group having the same structure as the C₁-C₁₀ heterocycloalkyl group.

The term "C₃-C₁₀ cycloalkenyl group" as used herein refers to a monovalent monocyclic group that has 3 to 10 carbon atoms and at least one carbon-carbon double bond in the ring thereof and no aromaticity, and non-limiting examples thereof may include a cyclopentenyl group, a cyclohexenyl group, a cycloheptenyl group, or the like. The term "C₃-C₁₀ cycloalkenylene group" as used herein refers to a divalent group having the same structure as the C₃-C₁₀ cycloalkenyl group.

The term "C₁-C₁₀ heterocycloalkenyl group" as used herein refers to a monovalent monocyclic group that has at least one heteroatom selected from B, N, O, P, Si, Ge, Se, and S as a ring-forming atom, 1 to 10 carbon atoms as ring forming atom(s), and at least one double bond in the ring thereof. Non-limiting examples of the C₁-C₁₀ heterocycloalkenyl group may include a 2,3-dihydrofuranyl group, a 2,3-dihydrothiophenyl group, or the like. The term "C₁-C₁₀ heterocycloalkenylene group" as used herein refers to a divalent group having the same structure as the C₁-C₁₀ heterocycloalkenyl group.

The term "C₆-C₆₀ aryl group" as used herein refers to a monovalent group that includes a carbocyclic aromatic system having 6 to 60 carbon atoms, and the term "C₆-C₆₀ arylene group" as used herein refers to a divalent group that includes a carbocyclic aromatic system having 6 to 60 carbon atoms. Non-limiting examples of the C₆-C₆₀ aryl group may include a phenyl group, a naphthyl group, an anthracenyl group, a phenanthrenyl group, a pyrenyl group, a chrysenyl group, or the like. When the C₆-C₆₀ aryl group and the C₆-C₆₀ arylene group each include two or more rings, the two or more rings may be fused to each other.

The term "C₁-C₆₀ heteroaryl group" as used herein refers to a monovalent group having a carbocyclic aromatic system having at least one heteroatom selected from B, N, O, P, Si, Ge, Se, and S as a ring-forming atom and 1 to 60 carbon atoms as ring forming atom(s). The term "C₁-C₆₀ heteroarylene group" as used herein refers to a divalent group having a carbocyclic aromatic system having at least one heteroatom selected from B, N, O, P, Si, Ge, Se, and S as a ring-forming atom and 1 to 60 carbon atoms as ring forming atom(s). Non-limiting examples of the C₁-C₆₀ heteroaryl group may include a pyridinyl group, a pyrimidinyl group, a pyrazinyl group, a pyridazinyl group, a triazinyl group, a quinolinyl group, an isoquinolinyl group, or the like. When the C₁-C₆₀ heteroaryl group and the C₁-C₆₀ heteroarylene group each include two or more rings, the two or more rings may be fused to each other.

The term "C₇-C₆₀ alkyl aryl group" as used herein refers to a C₆-C₆₀ aryl group substituted with at least one C₁-C₆₀ alkyl group. The term "C₇-C₆₀ aryl alkyl group" as used herein refers to a C₁-C₆₀ alkyl group substituted with at least one C₆-C₆₀ aryl group.

The term "C₂-C₆₀ alkyl heteroaryl group" as used herein refers to a C₁-C₆₀ heteroaryl group substituted with at least one C₁-C₆₀ alkyl group. The term "C₂-C₆₀ heteroaryl alkyl group" as used herein refers to a C₁-C₆₀ alkyl group substituted with at least one C₁-C₆₀ heteroaryl group.

The term "C₆-C₆₀ aryloxy group" as used herein refers to -OA₁₀₂ (wherein A₁₀₂ is the C₆-C₆₀ aryl group), and the term "C₆-C₆₀ arylthio group" as used herein refers to -SA₁₀₃ (wherein A₁₀₃ is the C₆-C₆₀ aryl group).

The term "C₁-C₆₀ heteroaryloxy group" as used herein indicates -OA₁₀₄ (wherein A₁₀₄ is a C₁-C₆₀ heteroaryl group), and the term "C₁-C₆₀ heteroarylthio group" as used herein indicates -SA₁₀₅ (wherein A₁₀₅ is the C₁-C₆₀ heteroaryl group).

The term "monovalent non-aromatic condensed polycyclic group" as used herein refers to a monovalent group (for example, having 8 to 60 carbon atoms) having two or more rings condensed to each other, only carbon atoms as ring-forming atoms, and no aromaticity in its entire molecular structure. Non-limiting examples of the monovalent non-aromatic condensed polycyclic group may include a fluorenyl group or the like. The term "divalent non-aromatic condensed polycyclic group" as used herein refers to a divalent group having the same structure as the monovalent non-aromatic condensed polycyclic group.

The term "monovalent non-aromatic condensed heteropolycyclic group" as used herein refers to a monovalent group (for example, having 2 to 60 carbon atoms) having two or more rings condensed with each other, at least one heteroatom selected from B, N, O, P, Si, Ge, Se, and S, other than carbon atoms, as a ring-forming atom, and no aromaticity in its entire molecular structure. Non-limiting examples of the monovalent non-aromatic condensed heteropolycyclic group may include a carbazolyl group or the like. The term "divalent non-aromatic condensed heteropolycyclic group" as used herein refers to a divalent group having the same structure as the monovalent non-aromatic condensed heteropolycyclic group.

The term "C₅-C₃₀ carbocyclic group" as used herein refers to a saturated or unsaturated cyclic group having, as a ring-forming atom, 5 to 30 carbon atoms only. The C₅-C₃₀ carbocyclic group may be a monocyclic group or a polycyclic group.

The term "C₁-C₃₀ heterocyclic group" as used herein refers to a saturated or unsaturated cyclic group having, as a ring-forming atom, at least one heteroatom selected from N, O, Si, P, and S other than 1 to 30 carbon atoms as ring forming atom(s). The C₁-C₃₀ heterocyclic group may be a monocyclic group or a polycyclic group.

At least one substituent of the substituted C₅-C₃₀ carbocyclic group, the substituted C₁-C₃₀ heterocyclic group, the substituted C₁-C₆₀ alkyl group, the substituted C₂-C₆₀ alkenyl group, the substituted C₂-C₆₀ alkynyl group, the substituted C₁-C₆₀ alkoxy group, the substituted C₁-C₆₀ alkylthio group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₇-C₆₀ alkyl aryl group, the substituted C₇-C₆₀ aryl alkyl group, the substituted C₆-C₆₀ aryloxy group, the substituted C₆-C₆₀ arylthio group, the substituted C₁-C₆₀ heteroaryl group, the substituted C₂-C₆₀ alkyl heteroaryl group, the substituted C₂-C₆₀ heteroaryl alkyl group, the substituted C₁-C₆₀ heteroaryloxy group, the substituted C₁-C₆₀ heteroarylthio group, the substituted monovalent non-aromatic condensed polycyclic group, and the substituted monovalent non-aromatic condensed heteropolycyclic group may be:
deuterium, -F, -Cl, -Br, -I, -SFs, -CD₃, -CD₂H, -CDH₂, -CF₃, -CF₂H, - CFH₂, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, or a C₁-C₆₀ alkylthio group;
a C₁-C₆₀ alkyl group, a C₂-C₆₀ alkenyl group, a C₂-C₆₀ alkynyl group, a C₁-C₆₀ alkoxy group, or a C₁-C₆₀ alkylthio group, each substituted with at least one of deuterium, -F, -Cl, -Br, -I, -SFs, -CD₃, -CD₂H, -CDH₂, -CF₃, -CF₂H, - CFH₂, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -N(Q₁₁)(Q₁₂), -Si(Q₁₃)(Q₁₄)(Q₁₅), -Ge(Q₁₃)(Q₁₄)(Q₁₅), -B(Q₁₆)(Q₁₇), - P(Q₁₈)(Q₁₉), or -P(=O)(Q₁₈)(Q₁₉),
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, or a monovalent non-aromatic condensed heteropolycyclic group;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, and a monovalent non-aromatic condensed heteropolycyclic group, each substituted with at least one of deuterium, -F, -Cl, -Br, -I, -SF₅, - CD₃, -CD₂H, -CDH₂, -CF₃, -CF₂H, -CFH₂, a hydroxyl group, a cyano group, a nitro group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -N(Q₂₁)(Q₂₂), - Si(Q₂₃)(Q₂₄)(Q₂₅), -Ge(Q₂₃)(Q₂₄)(Q₂₅), -B(Q₂₆)(Q₂₇), -P(Q₂₈)(Q₂₉) or - P(=O)(Q₂₈)(Q₂₉), or
-N(Q₃₁)(Q₃₂), -Si(Q₃₃)(Q₃₄)(Q₃₅), -Ge(Q₃₃)(Q₃₄)(Q₃₅), -B(Q₃₆)(Q₃₇), - P(Q₃₈)(Q₃₉), or -P(=O)(Q₃₈)(Q₃₉), and
Q₁ to Q₉, Q₁₁ to Q₁₉, Q₂₁ to Q₂₉, and Q₃₁ to Q₃₉ may each independently be hydrogen, deuterium, -F, -Cl, -Br, -I, -SF₅, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a substituted or unsubstituted C₁-C₆₀ heteroaryloxy group, a substituted or unsubstituted C₁-C₆₀ heteroarylthio group, a substituted or unsubstituted monovalent non-aromatic condensed polycyclic group, or a substituted or unsubstituted monovalent non-aromatic condensed heteropolycyclic group.

For example, Q₁ to Q₉, Q₁₁ to Q₁₉, Q₂₁ to Q₂₉, and Q₃₁ to Q₃₉ as used herein may each independently be:
-CH₃, -CD₃, -CD₂H, -CDH₂, -CH₂CH₃, -CH₂CD₃, -CH₂CD₂H, -CH₂CDH₂, -CHDCH₃, -CHDCD₂H, -CHDCDH₂, -CHDCD₃, -CD₂CD₃, -CD₂CD₂H, or - CD₂CDH₂; or
an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, a phenyl group, a biphenyl group, or a naphthyl group, each unsubstituted or substituted with at least one of deuterium, a C₁-C₁₀ alkyl group, a phenyl group, or a combination thereof.

The term "room temperature" as used herein refers to a temperature of about 25°C.

The terms "a biphenyl group, a terphenyl group, and a tetraphenyl group" as used herein each refer to a monovalent group having two, three, and four phenyl groups linked to each other via a single bond, respectively.

Hereinafter, a compound and an organic light-emitting device according to one or more exemplary embodiments will be described in further detail with reference to Synthesis Examples and Examples. However, embodiments are not limited thereto. The wording "'B' was used instead of 'A'" as used in describing Synthesis Examples means that an amount of 'A' used was identical to an amount of 'B' used, in terms of a molar equivalent.

### EXAMPLES

### Synthesis Example 1: Synthesis of Compound 1

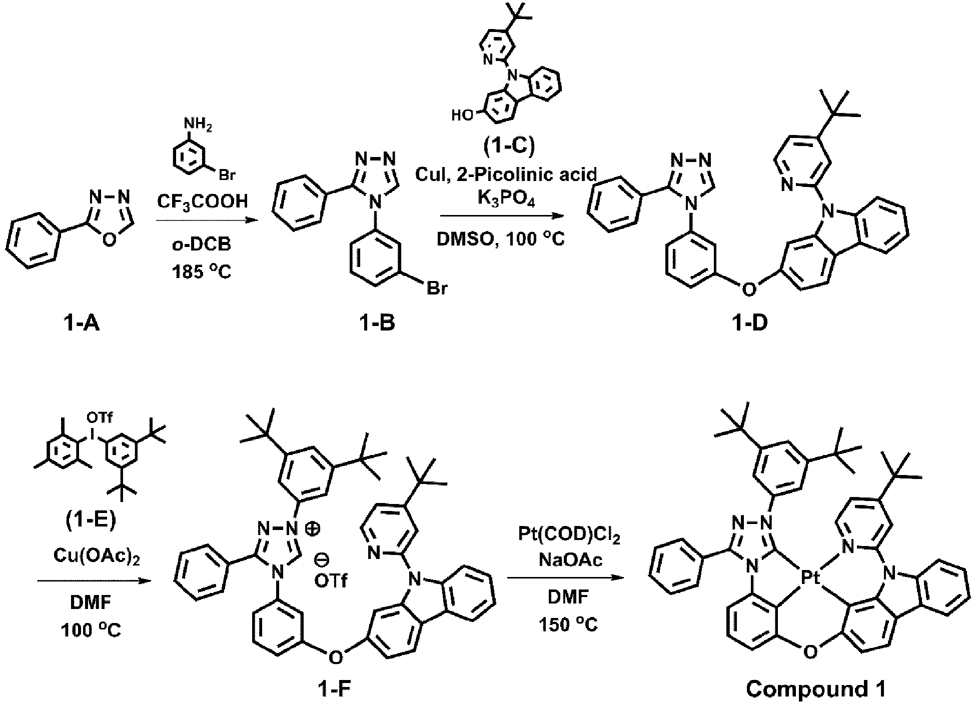

### Synthesis of [Compound 1-B]

Compound 1-A (11.5 grams (g), 78.7 millimoles (mmol)), 3-bromoaniline (7.71 milliliters (mL), 70.8 mmol), and trifluoroacetic acid (6.00 mL, 78.7 mmol) were placed in a round-bottom flask, and then mixed with o-dichlorobenzene (75 mL). The resultant reaction solution was stirred and heated under reflux at 185°C for 12 hours. After completion of the reaction, the temperature was allowed to lower to room temperature, and then, ethyl acetate and a saturated aqueous Na₂CO₃ solution were added to the reaction solution. An organic solution layer was extracted therefrom using ethyl acetate, the organic layer was dried using anhydrous MgSO₄, and then the product was filtered. The filtrate was concentrated and purified through silica gel column chromatography to obtain 5.0 g (yield of 21%) of Compound 1-B.
High performance liquid chromatography-mass spectrometry (HPLC-MS): 301.99 [M+H]⁺.

### Synthesis of [Compound 1-D]

Compound 1-B (5.00 g, 16.6 mmol), Compound 1-C (5.80 g, 18.3 mmol), Cul (0.634 g, 3.33 mmol), 2-picolinic acid (0.902 g, 7.33 mmol), and K₃PO₄ (10.6 g, 50.0 mmol) were placed in a round-bottom flask, and then mixed with dimethyl sulfoxide (DMSO) (110 mL). The resultant reaction solution was stirred and heated under reflux at 100°C for 12 hours. After completion of the reaction, the temperature was allowed to lower to room temperature, and then, ethyl acetate and a saturated aqueous ammonium chloride solution were added to the reaction solution. An organic solution layer was extracted therefrom using ethyl acetate, the organic layer was dried using anhydrous MgSO₄, and then the product was filtered. The filtrate was concentrated under a reduced pressure and purified through silica gel column chromatography to obtain 5.4 g (yield of 49%) of Compound 1-D.

HPLC-MS: 536.21 [M+H]⁺.

### Synthesis of [Compound 1-F]

Compound 1-D (4.2 g, 7.80 mmol), Compound 1-E (6.84 g, 11.7 mmol), and copper(II) acetate (Cu(Oac)₂) (0.14 g, 0.780 mmol) were placed in a round-bottom flask, and then mixed with dimethylformamide (DMF) (40 mL). The resultant reaction solution was stirred and heated under reflux at 100°C for 12 hours. After completion of the reaction, the temperature was allowed to lower to room temperature, and then, ethyl acetate and a saturated aqueous ammonium chloride solution were added to the reaction solution. An organic solution layer was extracted therefrom using ethyl acetate, the organic layer was dried using anhydrous MgSO₄, and then the product was filtered. The filtrate was concentrated under a reduced pressure and purified through silica gel column chromatography to obtain 6.0 g (yield of 88 %) of Compound 1-F.

HPLC-MS: 724.36 [M-OTf]⁺.

### Synthesis of [Compound 1]

Compound 1-F (6.00 g, 6.86 mmol), dichloro(1,5-cyclooctadiene)platinum(II) (Pt(COD)Cl₂) (2.82 g, 7.55 mmol), and sodium acetate (NaOAc) (1.69 g, 20.6 mmol) were placed in a round-bottom flask, and then mixed with DMF (100 mL). The resultant reaction solution was stirred and heated under reflux at 160°C for 12 hours. After completion of the reaction, the temperature was allowed to lower to room temperature, and then, the reaction solution was diluted with dichloromethane. The precipitate was filtered using celite/silica, and then, deionized (DI) water was added to the filtrate. An organic solution layer was extracted therefrom using dichloromethane, the organic layer was dried using anhydrous MgSO₄, and then the product was filtered. The filtrate was concentrated under a reduced pressure and purified through silica gel column chromatography to obtain 2.00 g (yield of 32%) of Compound 1.

HPLC-MS: 917.29 [M+H]⁺.

### Synthesis Example 2: Synthesis of Compound 11

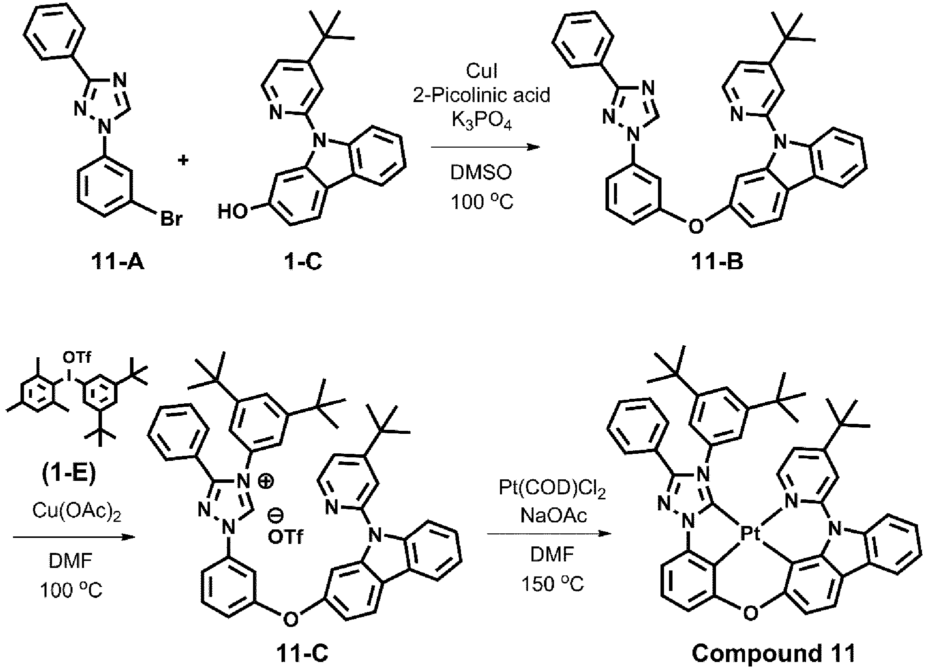

### Synthesis of [Compound 11-B]

Compound 2-A (6.70 g, 22.3 mmol), Compound 1-C (7.77 g, 24.6 mmol), Cul (0.850 g, 4.46 mmol), 2-picolinic acid (1.21 g, 9.82 mmol), and K₃PO₄ (14.2 g, 67.0 mmol) were placed in a round-bottom flask, and then mixed with DMSO (150 mL). The resultant reaction solution was stirred and heated under reflux at 100°C for 12 hours. After completion of the reaction, the temperature was allowed to lower to room temperature, and then, ethyl acetate and a saturated aqueous ammonium chloride solution were added to the reaction solution. An organic solution layer was extracted therefrom using ethyl acetate, the organic layer was dried using anhydrous MgSO₄, and then the product was filtered. The filtrate was concentrated under a reduced pressure and purified through silica gel column chromatography to obtain 6.3 g (yield of 53%) of Compound 11-B.

HPLC-MS: 536.23 [M+H]⁺.

### Synthesis of [Compound 11-C]

Compound 11-B (3.8 g, 7.09 mmol), Compound 1-E (6.22 g, 10.6 mmol), and Cu(OAc)₂ (0.135 g, 0.710 mmol) were placed in a round-bottom flask, and then mixed with DMF (30 mL). The resultant reaction solution was stirred and heated under reflux at 100°C for 12 hours. After completion of the reaction, the temperature was allowed to lower to room temperature, and then, ethyl acetate and a saturated aqueous ammonium chloride solution were added to the reaction solution. An organic solution layer was extracted therefrom using ethyl acetate, the organic layer was dried using anhydrous MgSO₄, and then the product was filtered. The filtrate was concentrated under a reduced pressure and purified through silica gel column chromatography to obtain 4.0 g (yield of 65%) of Compound 11-C.

HPLC-MS: 724.38 [M-OTf]⁺.

### Synthesis of [Compound 11]

Compound 11-C (6.00 g, 6.86 mmol), Pt(COD)Cl₂ (2.82 g, 7.55 mmol), and NaOAc (1.69 g, 20.6 mmol) were placed in a round-bottom flask, and then mixed with DMF (100 mL). The resultant reaction solution was stirred and heated under reflux at 160°C for 12 hours. After completion of the reaction, the temperature was allowed to lower to room temperature, and then, the reaction solution was diluted with dichloromethane. The precipitate was filtered using celite/silica, and then, DI water was added to the filtrate. An organic solution layer was extracted therefrom using dichloromethane, the organic layer was dried using anhydrous MgSO₄, and then the product was filtered. The filtrate was concentrated and purified through silica gel column chromatography to obtain 2.00 g (yield of 32%) of Compound 11.

HPLC-MS: 917.29 [M+H]⁺.

### Evaluation Example 1: Evaluation of photoluminescence (PL) spectrum

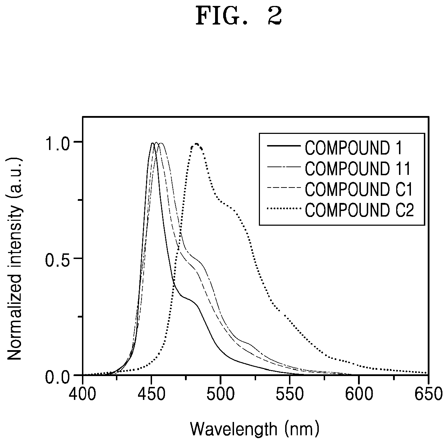

Compound 1, Compound 11, Comparative Compound C1, and Comparative Compound C2 were each diluted in toluene at a concentration of 10⁻⁴ molar (M). Then, the photoluminescence (PL) spectrum of each compound was measured using an ISC PC1 spectrofluorometer, in which a xenon lamp was mounted, and the results are shown in FIG. 2. The maximum emission wavelength value (λₘₐₓ, nm) and T₁ energy (eV) of each compound were obtained from the PL spectrum thereof, and the results are shown in Table 2.

In detail, the T₁ energy was converted into an energy level value at the maximum emission wavelength. In addition, the HOMO and LUMO energy levels of each compound were measured by differential pulse voltammetry (DPV). The solvent used for the measurement was DMF, and tetrabutylammonium fluoride (TBAF) was used as an electrolyte. In addition, the reference electrode Ag/Ag+ was used, and the counter electrode Pt and the working electrode Pt were used. During the measurement, ferrocene (Fc) was used as a reference material, and the HOMO of Fc is known to be -4.8 eV. Accordingly, the HOMO and LUMO energy levels of each compound were calculated by applying the potential value measured by DPV to the data calculation method below. The reference data is shown in Table 1A, below.

**Table 1A**

| | | |
|---|---|---|
| | Measurement potential | Energy level (eV) |
| Ref. | α | -4.8 |
| HOMO | β | -4.8-(β-α) |
| LUMO | γ | -4.8-(-γ-α) |

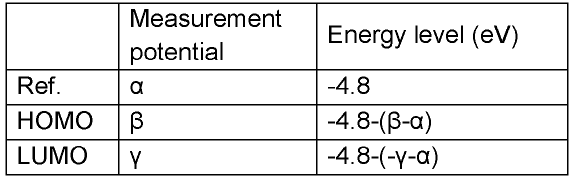

**Table 2**

| Compound | HOMO (eV) | LUMO (eV) | T₁ (eV) | λₘₐₓ (nm) |
|---|---|---|---|---|
| 1 | -5.32 | -2.01 | 2.75 | 451 |
| 11 | -5.31 | -1.98 | 2.71 | 458 |
| C1 | -5.20 | -2.01 | 2.73 | 454 |
| C2 | -5.18 | -2.37 | 2.57 | 482 |

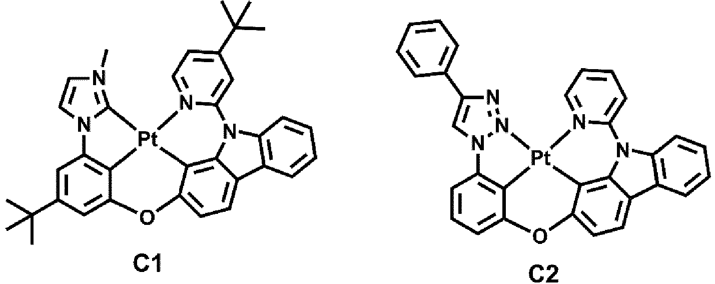

Referring to Table 2, Compounds 1 and 11 according to one or more embodiments were found to emit a deep blue light and have deeper HOMO energy values than Comparative Compounds C1 and C2.

### Example 1

An ITO glass substrate was cut to a size of 50 millimeters (mm) x 50 mm x 0.5 mm, sonicated in acetone, isopropyl alcohol, and DI water, each for 15 minutes, and then washed by exposure to UV ozone for 30 minutes each.

Then, m-MTDATA was deposited on an ITO electrode (anode) on the glass substrate at a deposition rate of 1 Å/sec to form a hole injection layer having a thickness of 600 Å, and then, α-NPD was deposited on the hole injection layer at a deposition rate of 1 Å/sec to form a hole transport layer having a thickness of 250 Å.

Compound 1 (dopant) and CBP (host) were co-deposited on the hole transport layer at a deposition rate of 0.1 Å/sec and a deposition rate of 1 Å/sec, respectively, to form an emission layer having a thickness of 400 Å.

BAlq was deposited on the emission layer at a deposition rate of 1 Å/sec to form a hole blocking layer having a thickness of 50 Å, Alq₃ was deposited on the hole blocking layer to form an electron transport layer having a thickness of 300 Å, LiF was deposited on the electron transport layer to form an electron injection layer having a thickness of 10 Å, and then, Al was vacuum-deposited on the electron injection layer to form a second electrode (cathode) having a thickness of 1,200 Å, thereby completing the manufacture of an organic light-emitting device having a structure of ITO / m-MTDATA (600 Å) / α-NPD (250 Å) / CBP + Compound 1 (10 wt%) (400 Å) / BAlq (50 Å) / Alq₃ (300 Å) / LiF (10 Å) / Al (1,200 Å).

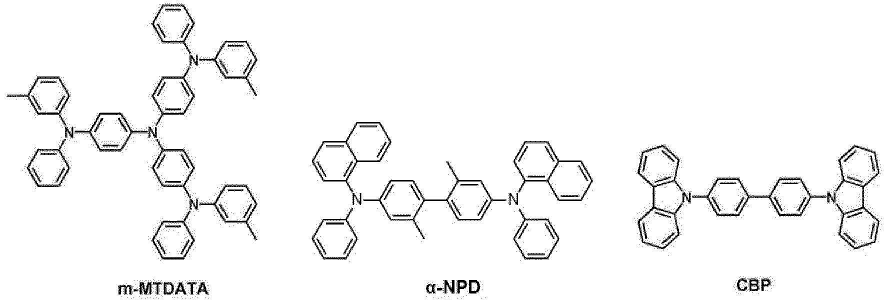

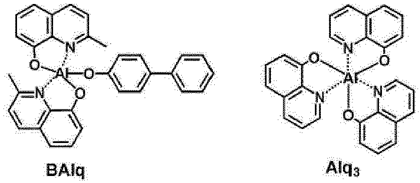

### Example 2

An organic light-emitting device was manufactured in a similar manner as in Example 1, except that Compound 11 was used instead of Compound 1 to form an emission layer.

### Comparative Example 1

An organic light-emitting device was manufactured in a similar manner as in Example 1, except that Compound C1 was used instead of Compound 1 to form an emission layer.

### Comparative Example 2

An organic light-emitting device was manufactured in a similar manner as in Example 1, except that Compound C3 was used instead of Compound 1 to form an emission layer.

### Evaluation Example 2: Evaluation of characteristics of organic light-emitting devices

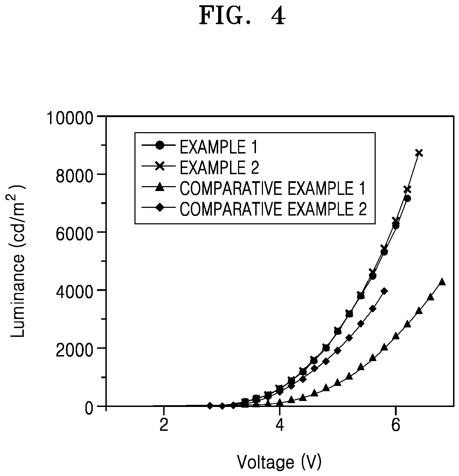

The electroluminescence (EL) spectrum of each of the organic light-emitting devices manufactured according to Examples 1 and 2 and Comparative Examples 1 and 2 were measured, and the results are shown in Table 3. Also, a graph of luminance according to voltage of each device is shown in FIG. 4. The maximum emission wavelength (nm), driving voltage (relative value, %), and external quantum luminescence efficiency (EQE, relative value, %, at 1,000 cd/m²) of each device were evaluated from the EL spectrum thereof, and the results are shown in Table 3. The maximum emission wavelength of the EL spectrum was evaluated from the EL spectrum (at 1,000 cd/m²) measured using a luminance meter (Minolta Cs-1000A) for each of the organic light-emitting devices. The driving voltage and external quantum luminescence efficiency were evaluated using a current-voltmeter (Keithley 2400) and a luminance meter (Minolta Cs-1000A), and were expressed as relative values (%) based on the lowest values.

**Table 3**

| | Dopant compound No. | Maximum emission wavelength (nm) | Driving voltage (%, relative value) | External quantum luminescence efficiency (%, relative value) |
|---|---|---|---|---|
| Example 1 | 1 | 454 | 83 | 233 |
| Example 2 | 11 | 458 | 83 | 274 |
| Comparative Example 1 | C1 | 456 | 100 | 154 |
| Comparative Example 2 | C3 | 461 | 87 | 100 |

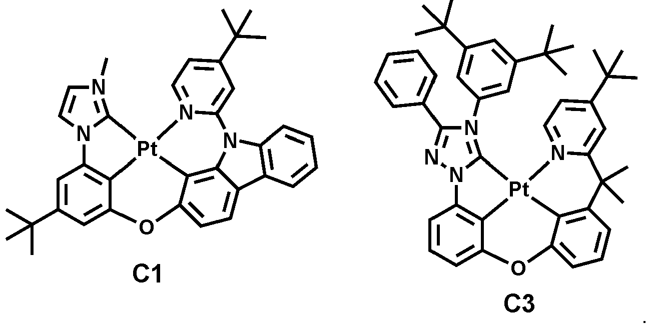

Referring to Table 3, the organic light-emitting devices of Examples 1 and 2 were found to have lower driving voltages and higher external quantum luminescence efficiencies, as compared with the organic light-emitting devices of Comparative Examples 1 and 2.

By using at least one of the organometallic compounds represented by Formula 1, an organic light-emitting device having excellent luminescence efficiency, and an electronic apparatus including the same was provided.

It should be understood that exemplary embodiments described herein should be considered in a descriptive sense only and not for purposes of limitation. Descriptions of features or aspects within each exemplary embodiment should typically be considered as available for other similar features or aspects in other exemplary embodiments. While one or more exemplary embodiments have been described with reference to the figures, it will be understood by those of ordinary skill in the art that various changes in form and details may be made therein without departing from the scope as defined by the following claims.

## Claims

1. An organometallic compound represented by Formula 1: 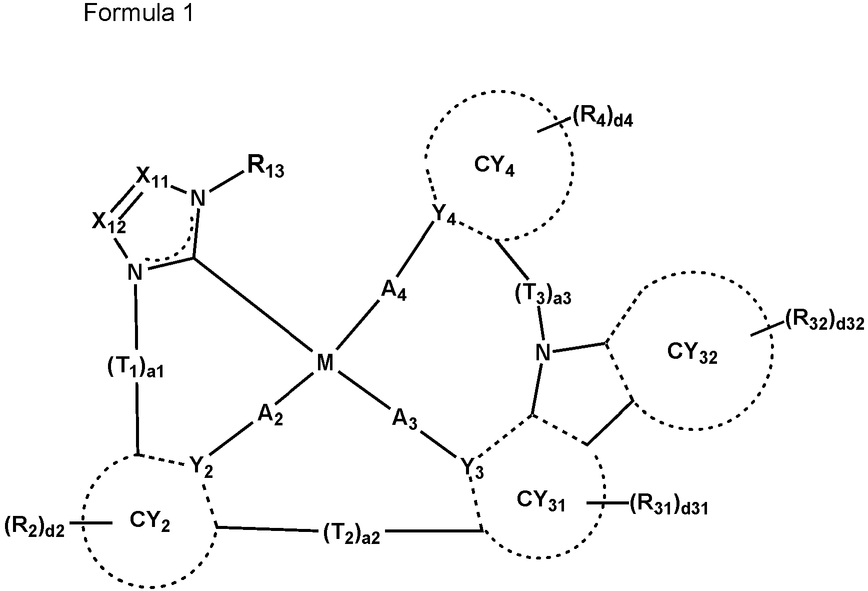 wherein, in Formula 1,
M is a transition metal,
X₁₁ is N and X₁₂ is C(R₁₂), or X₁₁ is C(R₁₁) and X₁₂ is N;
ring CY₂, ring CY₃₁, ring CY₃₂, and ring CY₄ are each independently a C₃-C₆₀ carbocyclic group or a C₁-C₆₀ heterocyclic group,
Y₂ to Y₄ are each independently C or N,
A₂ to A₄ are each independently a chemical bond, O, or S,
T₁ is a single bond, a double bond, *-N[(L₁)_{b1}-(R₁ₐ)]-*', *-B(R₁ₐ)-*', *-P(R₁ₐ)-*', *-C(R₁ₐ)(R_{1b})-*', *-Si(R₁ₐ)(R_{1b})-*', *-Ge(R₁ₐ)(R_{1b})-*', *-S-*', *-Se-*', *-O-*', *-C(=O)-*', *-S(=O)-*', *-S(=O)₂-*', *-C(R₁ₐ)=*', *=C(R₁ₐ)-*', *-C(R₁ₐ)=C(R_{1b})-*', *-C(=S)-*', or *-C≡C-*',
T₂ is a single bond, a double bond, *-N[(L₂)_{b2}-(R₂ₐ)]-*', *-B(R₂ₐ)-*', *-P(R₂ₐ)-*', *-C(R₂ₐ)(R_{2b})-*', *-Si(R₂ₐ)(R_{2b})-*', *-Ge(R₂ₐ)(R_{2b})-*', *-S-*', *-Se-*', *-O-*', *-C(=O)-*', *-S(=O)-*', *-S(=O)₂-*', *-C(R₂ₐ)=*', *=C(R₂ₐ)-*', *-C(R₂ₐ)=C(R_{2b})-*', *-C(=S)-*', or *-C≡C-*',
T₃ is a single bond, a double bond, *-N[(L₃)_{b3}-(R₃ₐ)]-*', *-B(R₃ₐ)-*', *-P(R₃ₐ)-*', *-C(R₃ₐ)(R_{3b})-*', *-Si(R₃ₐ)(R_{3b})-*', *-Ge(R₃ₐ)(R_{3b})-*', *-S-*', *-Se-*', *-O-*', *-C(=O)-*', *-S(=O)-*', *-S(=O)₂-*', *-C(R₃ₐ)=*', *=C(R₃ₐ)-*', *-C(R₃ₐ)=C(R_{3b})-*', *-C(=S)-*', or *-C≡C-*',
a1 to a3 are each independently an integer from 1 to 3,
* and *' each indicate a binding site to a neighboring atom,
L₁ to L₃ are each independently a single bond, a C₅-C₃₀ carbocyclic group unsubstituted or substituted with at least one R₁₀ₐ, or a C₁-C₃₀ heterocyclic group unsubstituted or substituted with at least one R₁₀ₐ,
b1 to b3 are each independently an integer from 1 to 3,
R₁ₐ, R_{1b}, R₂, R₂ₐ, R_{2b}, R₃ₐ, R_{3b}, R₄, R₁₀ₐ, R₁₁ to R₁₃, R₃₁, and R₃₂ are each independently hydrogen, deuterium, -F, -Cl, -Br, -I, -SFs, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₂-C₁₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₆-C₆₀ aryloxy group, a substituted or unsubstituted C₆-C₆₀ arylthio group, a substituted or unsubstituted C₁-C₆₀ heteroaryl group, a C₂-C₆₀ alkyl heteroaryl group, a C₂-C₆₀ heteroaryl alkyl group, a substituted or unsubstituted C₁-C₆₀ heteroaryloxy group, a substituted or unsubstituted C₁-C₆₀ heteroarylthio group, a substituted or unsubstituted monovalent non-aromatic condensed polycyclic group, a substituted or unsubstituted monovalent non-aromatic condensed heteropolycyclic group, - Si(Q₁)(Q₂)(Q₃), -Ge(Q₁)(Q₂)(Q₃), -N(Q₄)(Q₅), -B(Q₆)(Q₇), -P(Q₈)(Q₉), or -P(=O)(Q₈)(Q₉),
d2, d31, d32, and d4 are each independently an integer from 0 to 10,
at least one substituent of the substituted C₅-C₃₀ carbocyclic group, the substituted C₁-C₃₀ heterocyclic group, the substituted C₁-C₆₀ alkyl group, the substituted C₂-C₆₀ alkenyl group, the substituted C₂-C₆₀ alkynyl group, the substituted C₁-C₆₀ alkoxy group, the substituted C₁-C₆₀ alkylthio group, the substituted C₃-C₁₀ cycloalkyl group, the substituted C₁-C₁₀ heterocycloalkyl group, the substituted C₃-C₁₀ cycloalkenyl group, the substituted C₁-C₁₀ heterocycloalkenyl group, the substituted C₆-C₆₀ aryl group, the substituted C₇-C₆₀ alkyl aryl group, the substituted C₇-C₆₀ aryl alkyl group, the substituted C₆-C₆₀ aryloxy group, the substituted C₆-C₆₀ arylthio group, the substituted C₁-C₆₀ heteroaryl group, the substituted C₂-C₆₀ alkyl heteroaryl group, the substituted C₂-C₆₀ heteroaryl alkyl group, the substituted C₁-C₆₀ heteroaryloxy group, the substituted C₁-C₆₀ heteroarylthio group, the substituted monovalent non-aromatic condensed polycyclic group, and the substituted monovalent non-aromatic condensed heteropolycyclic group is:
deuterium, -F, -Cl, -Br, -I, -SFs, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, or a C₁-C₆₀ alkylthio group;
a C₁-C₆₀ alkyl group, a C₂-C₆₀ alkenyl group, a C₂-C₆₀ alkynyl group, a C₁-C₆₀ alkoxy group, or a C₁-C₆₀ alkylthio group, each substituted with at least one of deuterium, -F, -Cl, -Br, -I, -SFs, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -Si(Q₁₁)(Q₁₂)(Q₁₃), -Ge(Q₁₁)(Q₁₂)(Q₁₃), - N(Q₁₄)(Q₁₅), -B(Q₁₆)(Q₁₇), -P(Q₁₈)(Q₁₉), -P(=O)(Q₁₈)(Q₁₉), or a combination thereof;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, or a monovalent non-aromatic condensed heteropolycyclic group;
a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₆-C₆₀ aryloxy group, a C₆-C₆₀ arylthio group, a C₁-C₆₀ heteroaryl group, a C₂-C₆₀ alkyl heteroaryl group, a C₁-C₆₀ heteroaryloxy group, a C₁-C₆₀ heteroarylthio group, a monovalent non-aromatic condensed polycyclic group, or a monovalent non-aromatic condensed heteropolycyclic group, each substituted with at least one of deuterium, -F, -Cl, -Br, -I, -SFs, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₆₀ alkyl group, a C₂-C₆₀ alkenyl group, a C₂-C₆₀ alkynyl group, a C₁-C₆₀ alkoxy group, a C₁-C₆₀ alkylthio group, a C₃-C₁₀ cycloalkyl group, a C₁-C₁₀ heterocycloalkyl group, a C₃-C₁₀ cycloalkenyl group, a C₁-C₁₀ heterocycloalkenyl group, a C₆-C₆₀ aryl group, a C₇-C₆₀ alkyl aryl group, a C₇-C₆₀ aryl alkyl group, a C₆-C₆₀ aryloxy group, a C₆-C₆₀ arylthio group, a C₁-C₆₀ heteroaryl group, a C₂-C₆₀ alkyl heteroaryl group, a C₂-C₆₀ heteroaryl alkyl group, a C₁-C₆₀ heteroaryloxy group, a C₁-C₆₀ heteroarylthio group, a monovalent non-aromatic condensed polycyclic group, a monovalent non-aromatic condensed heteropolycyclic group, -Si(Q₂₁)(Q₂₂)(Q₂₃), -Ge(Q₂₁)(Q₂₂)(Q₂₃), - N(Q₂₄)(Q₂₅), -B(Q₂₆)(Q₂₇), -P(Q₂₈)(Q₂₉), -P(=O)(Q₂₈)(Q₂₉), or a combination thereof; or
-Si(Q₃₁)(Q₃₂)(Q₃₃), -Ge(Q₃₁)(Q₃₂)(Q₃₃), -N(Q₃₄)(Q₃₅), -B(Q₃₆)(Q₃₇), -P(Q₃₈)(Q₃₉), or -P(=O)(Q₃₈)(Q₃₉), and
Q₁ to Q₉, Q₁₁ to Q₁₉, Q₂₁ to Q₂₉, and Q₃₁ to Q₃₉ are each independently hydrogen, deuterium, -F, -Cl, -Br, -I, -SFs, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted C₁-C₆₀ alkyl group, a substituted or unsubstituted C₂-C₆₀ alkenyl group, a substituted or unsubstituted C₂-C₆₀ alkynyl group, a substituted or unsubstituted C₁-C₆₀ alkoxy group, a substituted or unsubstituted C₁-C₆₀ alkylthio group, a substituted or unsubstituted C₃-C₁₀ cycloalkyl group, a substituted or unsubstituted C₁-C₁₀ heterocycloalkyl group, a substituted or unsubstituted C₃-C₁₀ cycloalkenyl group, a substituted or unsubstituted C₁-C₁₀ heterocycloalkenyl group, a substituted or unsubstituted C₆-C₆₀ aryl group, a substituted or unsubstituted C₇-C₆₀ alkyl aryl group, a substituted or unsubstituted C₇-C₆₀ aryl alkyl group, a substituted or unsubstituted C₆-C₆₀ aryloxy group, a substituted or unsubstituted C₆-C₆₀ arylthio group, a substituted or unsubstituted C₁-C₆₀ heteroaryl group, a substituted or unsubstituted C₂-C₆₀ alkyl heteroaryl group, a substituted or unsubstituted C₂-C₆₀ heteroaryl alkyl group, a substituted or unsubstituted C₁-C₆₀ heteroaryloxy group, a substituted or unsubstituted C₁-C₆₀ heteroarylthio group, a substituted or unsubstituted monovalent non-aromatic condensed polycyclic group, or a substituted or unsubstituted monovalent non-aromatic condensed heteropolycyclic group.

2. The organometallic compound of claim 1, wherein M is iridium (Ir), platinum (Pt), osmium (Os), titanium (Ti), zirconium (Zr), hafnium (Hf), europium (Eu), terbium (Tb), thulium (Tm), rhodium (Rh), palladium (Pd), or gold (Au).

3. The organometallic compound of claims 1 or 2, wherein ring CY₂, ring CY₃₁, ring CY₃₂, and ring CY₄ are each independently a benzene group, a naphthalene group, an anthracene group, a phenanthrene group, a triphenylene group, a pyrene group, a chrysene group, a cyclopentadiene group, a 1,2,3,4-tetrahydronaphthalene group, a thiophene group, a furan group, an indole group, a benzoborole group, a benzophosphole group, an indene group, a benzosilole group, a benzogermole group, a benzothiophene group, a benzoselenophene group, a benzofuran group, a carbazole group, a dibenzoborole group, a dibenzophosphole group, a fluorene group, a dibenzosilole group, a dibenzogermole group, a dibenzothiophene group, a dibenzoselenophene group, a dibenzofuran group, a dibenzothiophene 5-oxide group, a 9H-fluoren-9-one group, a dibenzothiophene 5,5-dioxide group, an azaindole group, an azabenzoborole group, an azabenzophosphole group, an azaindene group, an azabenzosilole group, an azabenzogermole group, an azabenzothiophene group, an azabenzoselenophene group, an azabenzofuran group, an azacarbazole group, an azadibenzoborole group, an azadibenzophosphole group, an azafluorene group, an azadibenzosilole group, an azadibenzogermole group, an azadibenzothiophene group, an azadibenzoselenophene group, an azadibenzofuran group, an azadibenzothiophene 5-oxide group, an aza-9H-fluoren-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a phenanthroline group, a pyrrole group, a pyrazole group, an imidazole group, a triazole group, an oxazole group, an isoxazole group, a thiazole group, an isothiazole group, an oxadiazole group, a thiadiazole group, a benzopyrazole group, a benzimidazole group, a benzotriazole, a benzoxazole group, a benzothiazole group, a benzoxadiazole group, a benzothiadiazole group, a 5,6,7,8-tetrahydroisoquinoline group, or a 5,6,7,8-tetrahydroquinoline group; and/or
wherein at least one of Y₂ to Y₄ is N.

4. The organometallic compound of any of claims 1-3, wherein R₁ₐ, R_{1b}, R₂, R₂ₐ, R_{2b}, R₃ₐ, R_{3b}, R₄, R₁₀ₐ, R₁₁ to R₁₃, R₃₁, and R₃₂ are each independently:
hydrogen, deuterium, -F, -Cl, -Br, -I, -SFs, -CD₃, -CD₂H, -CDH₂, -CF₃, -CF₂H, - CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, or a C₁-C₂₀ alkylthio group;
a C₁-C₂₀ alkyl group, a C₁-C₂₀ alkoxy group, or a C₁-C₆₀ alkylthio group, each substituted with at least one of deuterium, -F, -Cl, -Br, -I, -SF₅, -CD₃, -CD₂H, -CDH₂, - CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₁₀ alkyl group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a pyridinyl group, a pyrimidinyl group, or a combination thereof;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, an isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, or an imidazopyrimidinyl group;
a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzoisothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, or an imidazopyrimidinyl group, each substituted with at least one of deuterium, -F, -Cl, -Br, -I, -SFs, -CD₃, -CD₂H, -CDH₂, -CF₃, -CF₂H, -CFH₂, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a C₁-C₂₀ alkyl group, a C₁-C₂₀ alkoxy group, a C₁-C₂₀ alkylthio group, a cyclopentyl group, a cyclohexyl group, a cycloheptyl group, a cyclooctyl group, an adamantanyl group, a norbornanyl group, a norbornenyl group, a cyclopentenyl group, a cyclohexenyl group, a cycloheptenyl group, a phenyl group, a naphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzoisothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, -Si(Q₃₁)(Q₃₂)(Q₃₃), or a combination thereof; or
-Si(Q₁)(Q₂)(Q₃), -Ge(Q₁)(Q₂)(Q₃), -N(Q₄)(Q₅), -B(Q₆)(Q₇), -P(Q₈)(Q₉), or - P(=O)(Q₈)(Q₉), and
Q₁ to Q₉ and Q₃₁ to Q₃₃ are each independently:
-CH₃, -CD₃, -CD₂H, -CDH₂, -CH₂CH₃, -CH₂CD₃, -CH₂CD₂H, -CH₂CDH₂, - CHDCH₃, -CHDCD₂H, -CHDCDH₂, -CHDCD₃, -CD₂CD₃, -CD₂CD₂H, or -CD₂CDH₂;
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, or a naphthyl group; or
an n-propyl group, an isopropyl group, an n-butyl group, an isobutyl group, a sec-butyl group, a tert-butyl group, an n-pentyl group, an isopentyl group, a sec-pentyl group, a tert-pentyl group, a phenyl group, or a naphthyl group, each substituted with at least one of deuterium, a C₁-C₁₀ alkyl group, a phenyl group, or a combination thereof.

5. The organometallic compound of any of claims 1-4, wherein R₁ₐ, R_{1b}, R₂, R₂ₐ, R_{2b}, R₃ₐ, R_{3b}, R₄, R₁₀ₐ, R₁₁ to R₁₃, R₃₁, and R₃₂ are each independently:
hydrogen, deuterium, -F, -Cl, -Br, -I, -SFs, -CD₃, -CD₂H, -CDH₂, -CF₃, -CF₂H, - CFH₂, a cyano group, a C₁-C₆₀ alkyl group, a C₂-C₆₀ alkenyl group, a C₂-C₆₀ alkynyl group, a C₁-C₆₀ alkoxy group, or a C₁-C₆₀ alkylthio group;
a group represented by one of Formulae 9-1 to 9-61, 9-201 to 9-237, 10-1 to 10-129, or 10-201 to 10-355;
a group represented by one of Formulae 9-1 to 9-61, 9-201 to 9-237, 10-1 to 10-129, or 10-201 to 10-350 in which at least one hydrogen is substituted with deuterium, -F, or a cyano group; or
-Si(Q₁)(Q₂)(Q₃), -Ge(Q₁)(Q₂)(Q₃), or -N(Q₄)(Q₅), and
Q₁ to Q₅ are respectively as defined for Q₁ to Q₅ in claim 1: 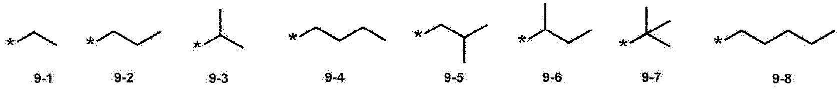 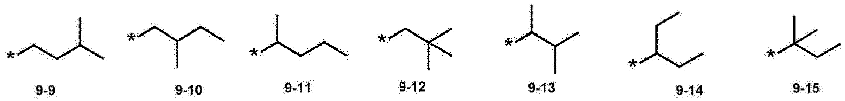 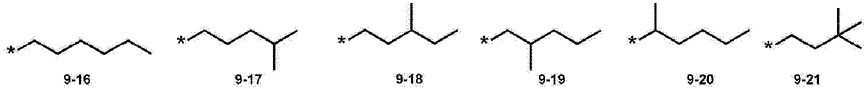 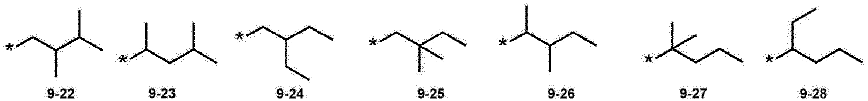 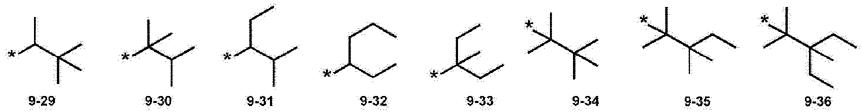 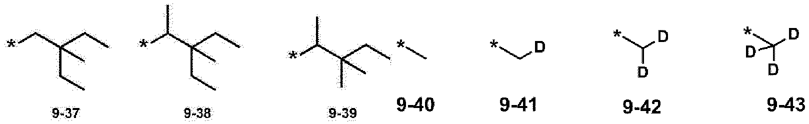 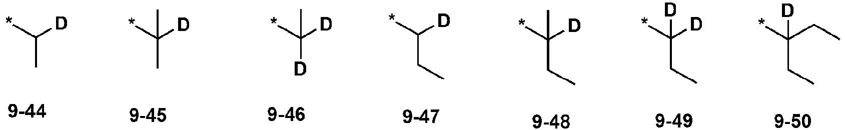 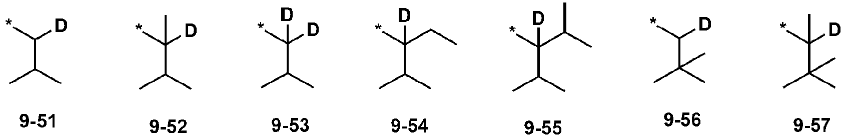 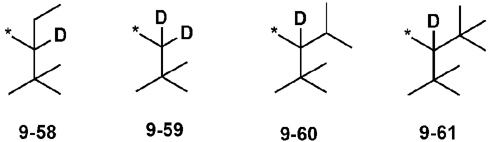 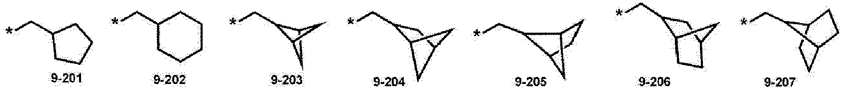 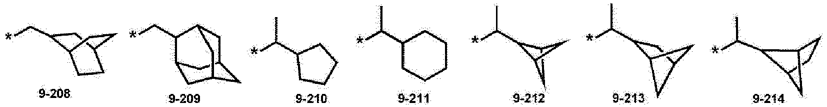 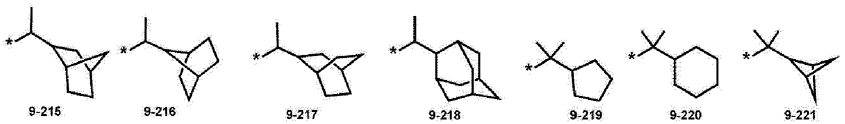 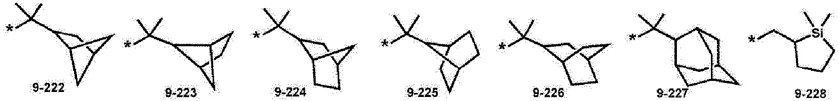 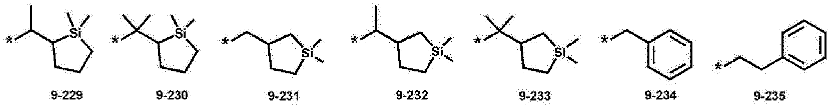 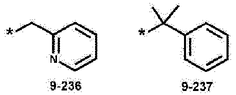 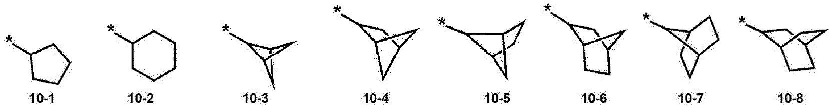 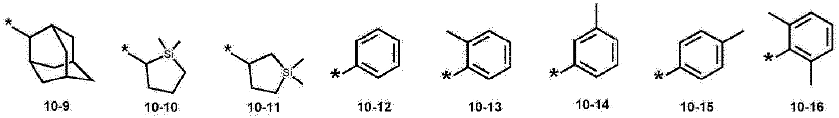 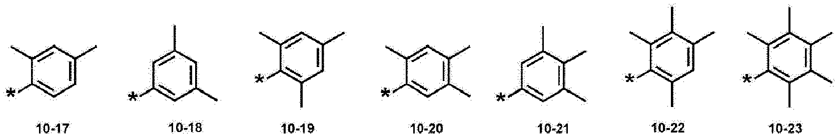 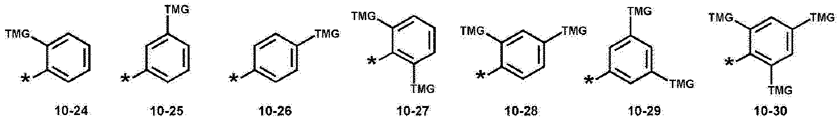 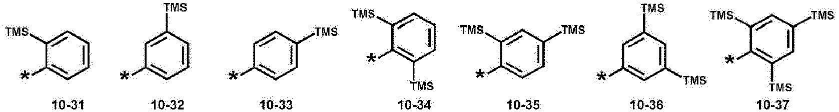 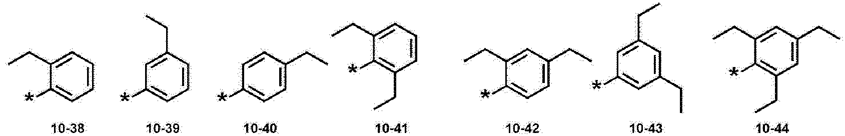 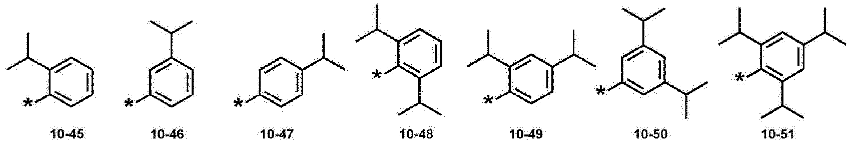 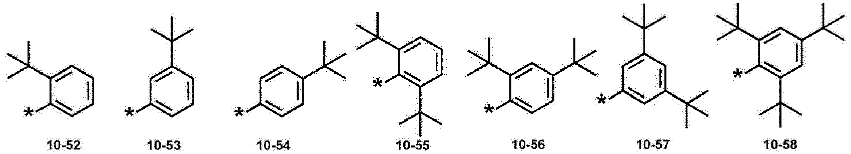 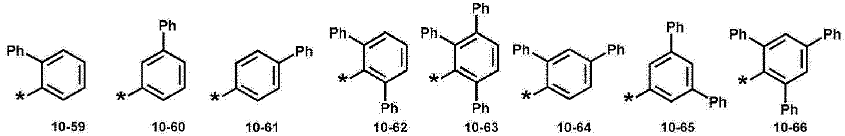 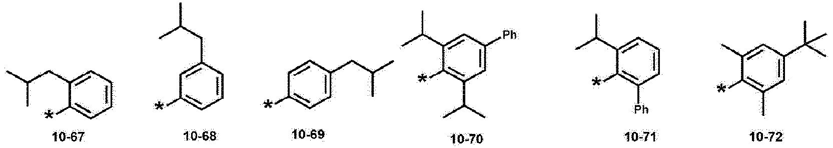 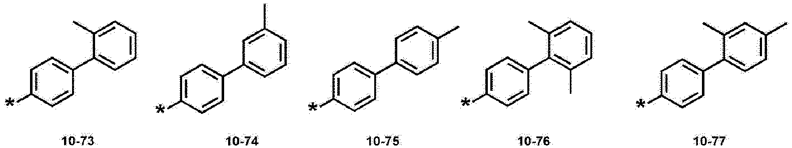 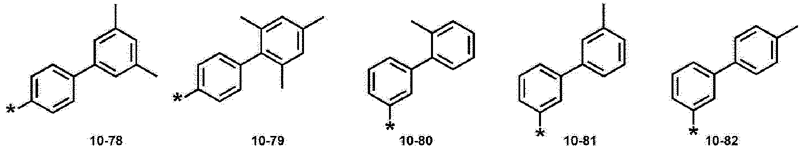 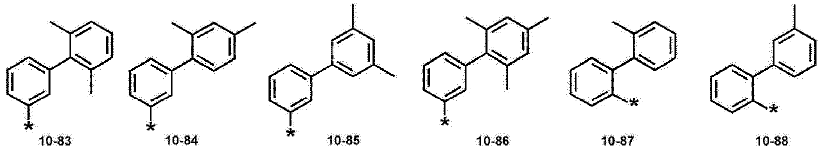 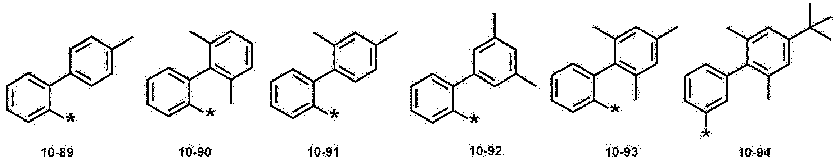 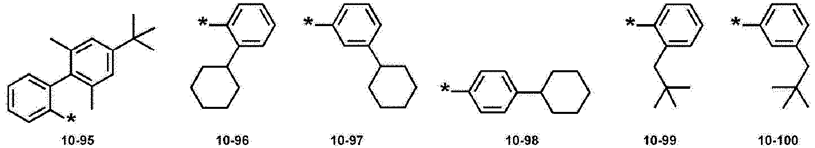 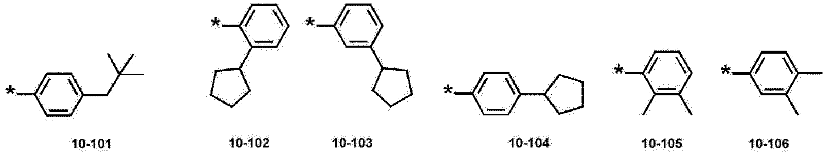 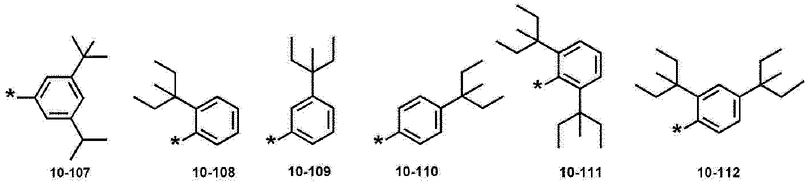 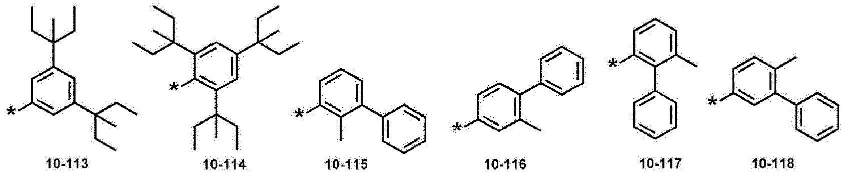 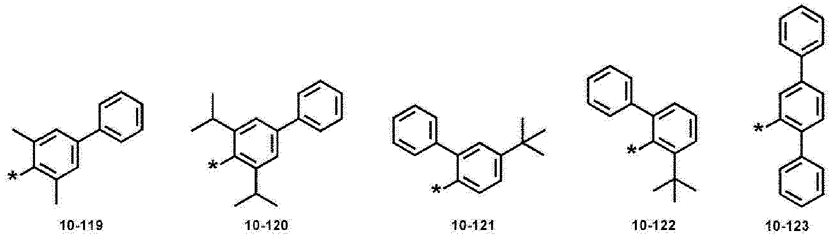 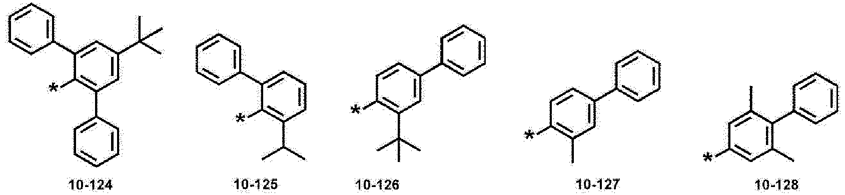 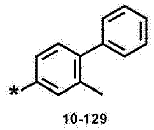 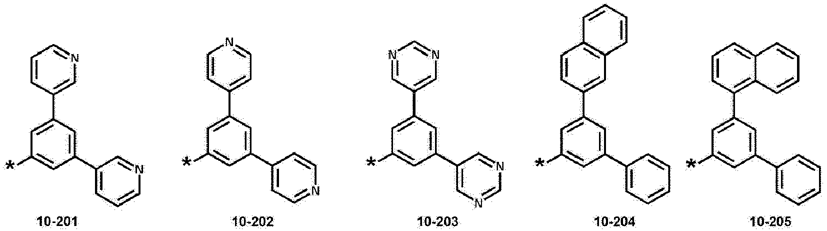 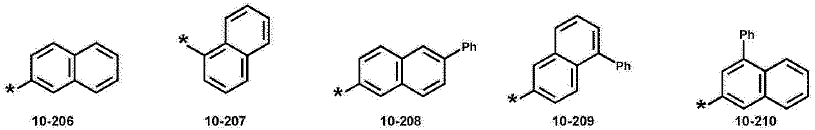 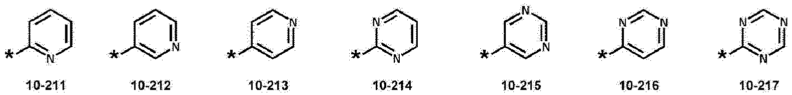 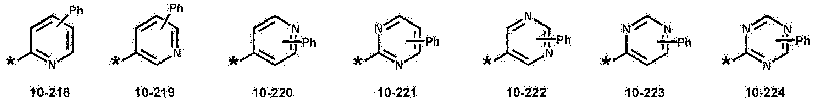 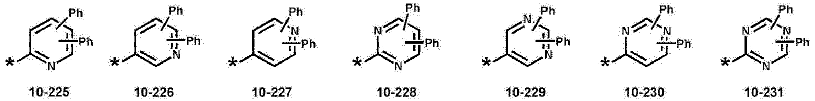 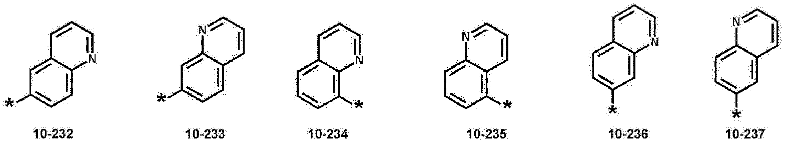 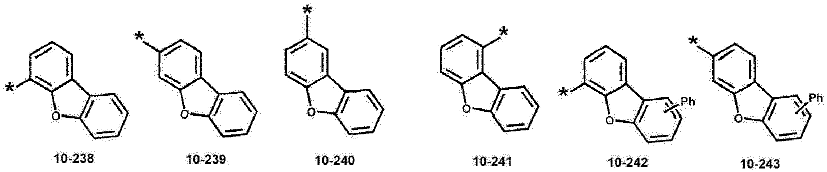 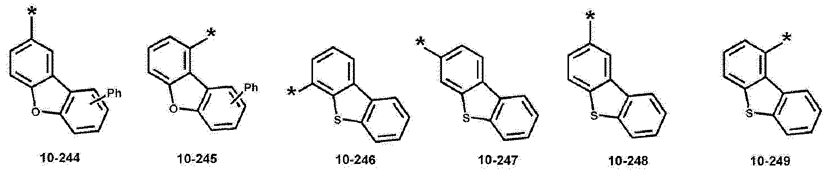 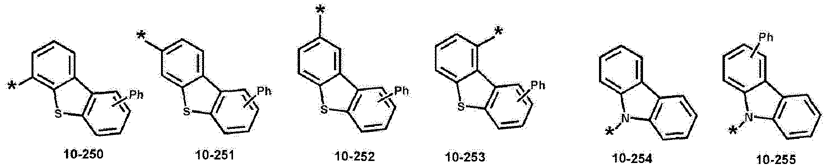 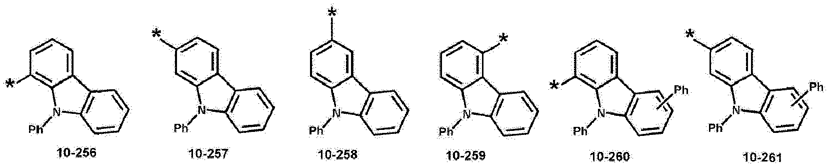 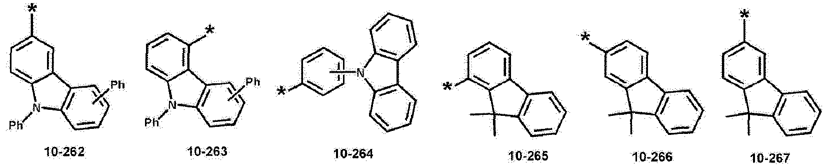 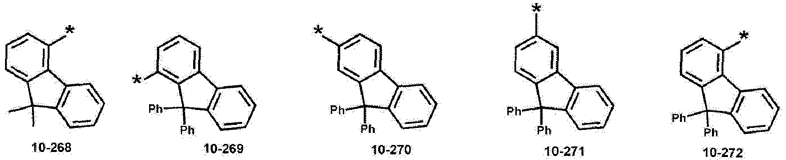 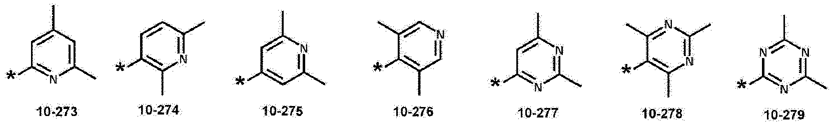 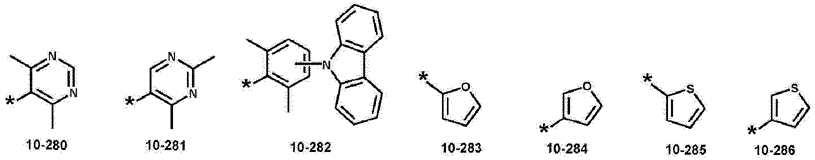 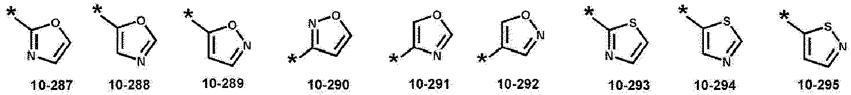 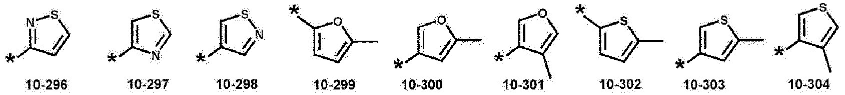 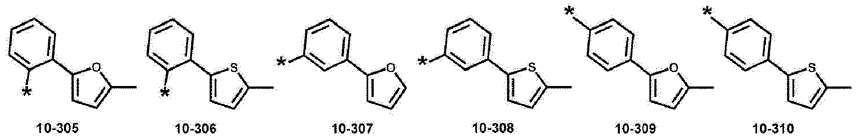 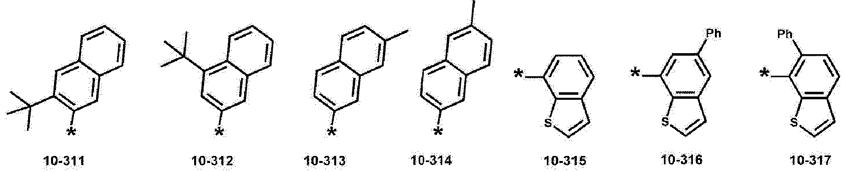 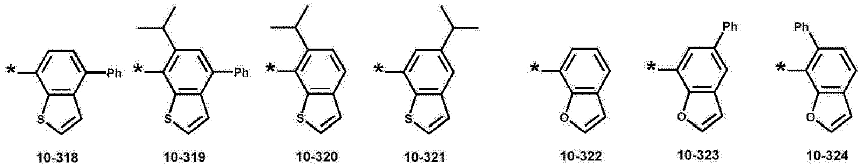 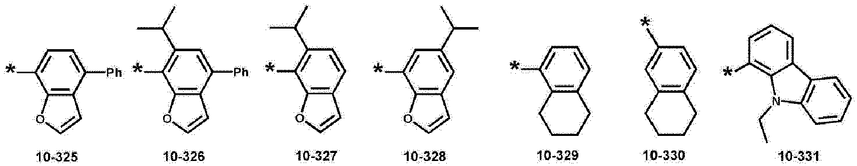 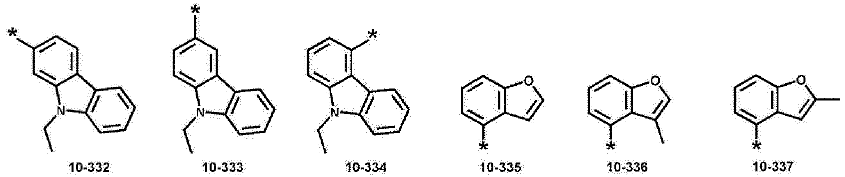 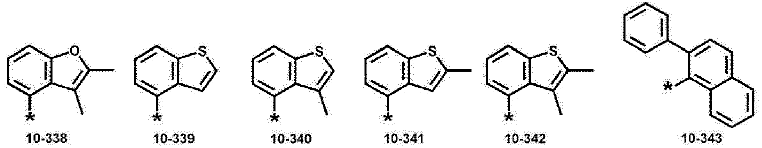 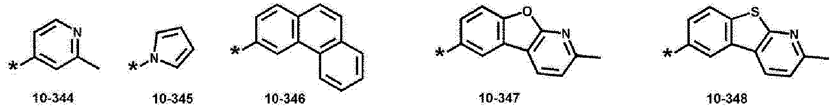 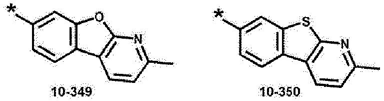 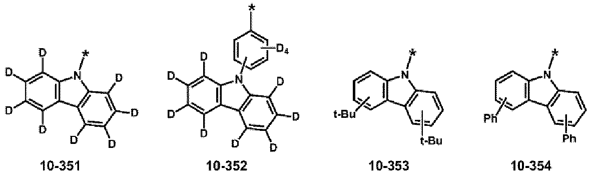 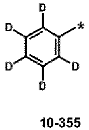
wherein, in Formulae 9-1 to 9-61, 9-201 to 9-237, 10-1 to 10-129, and 10-201 to 10-355, * indicates a binding site to a neighboring atom, "Ph" indicates a phenyl group, "TMS" indicates a trimethylsilyl group, and "TMG" indicates a trimethylgermyl group.

6. The organometallic compound of any of claims 1-5, wherein a group represented by 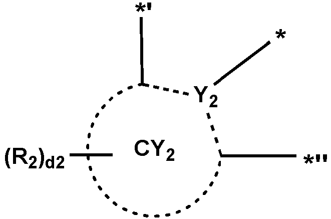
in Formula 1 is a group represented by one of Formulae 2-1 to 2-3: 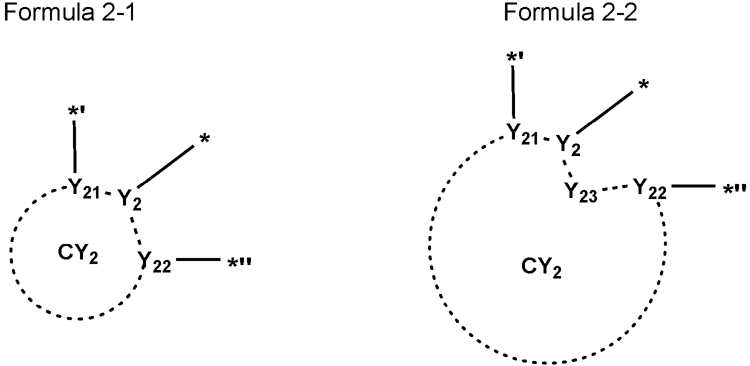 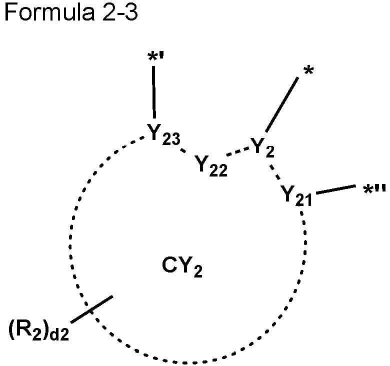 wherein, in Formulae 2-1 to 2-3,
Y₂₁ to Y₂₃ are each independently C or N,
Y₂₁ and Y₂ are linked to each other via a chemical bond, Y₂ and Y₂₂ are linked to each other via a chemical bond, Y₂ and Y₂₃ are linked to each other via a chemical bond, and Y₂₂ and Y₂₃ are linked to each other via a chemical bond,
*' indicates a binding site to T₁, *" indicates a binding site to T₂, and * indicates a binding site to A₂ or M, and
ring CY₂, Y₂, R₂, and d2 are respectively as defined for ring CY₂, Y₂, R₂, and d2 in claim 1; or
wherein a group represented by 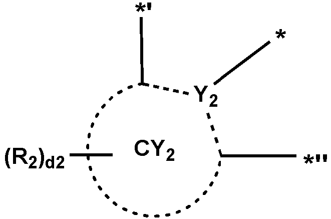
in Formula 1 is a group represented by one of Formulae CY2-1 to CY2-35: 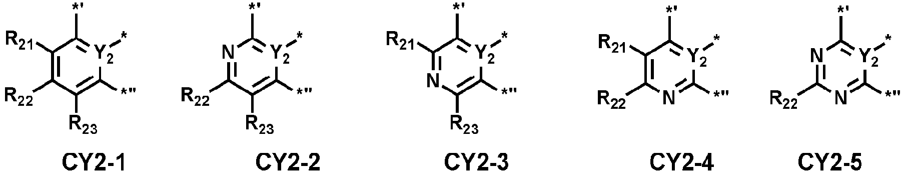 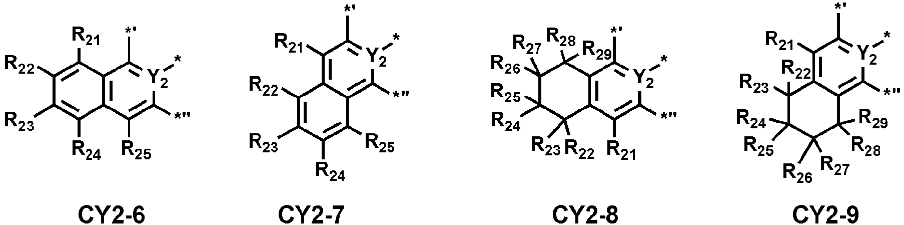 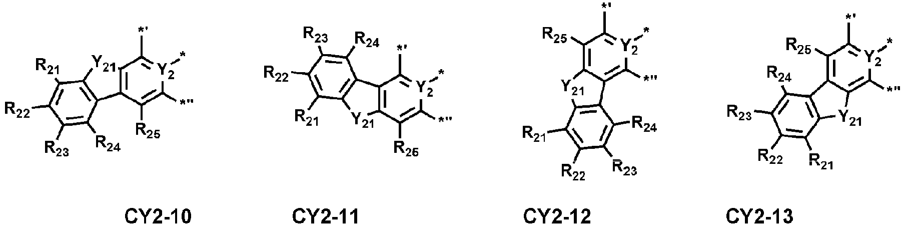 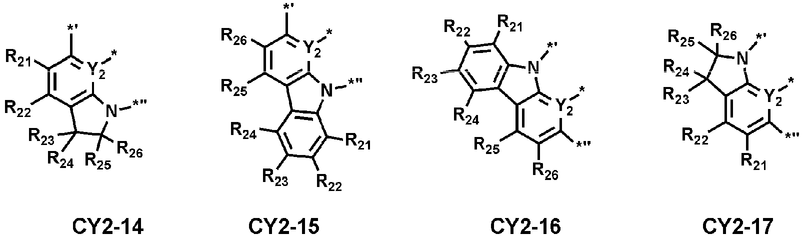 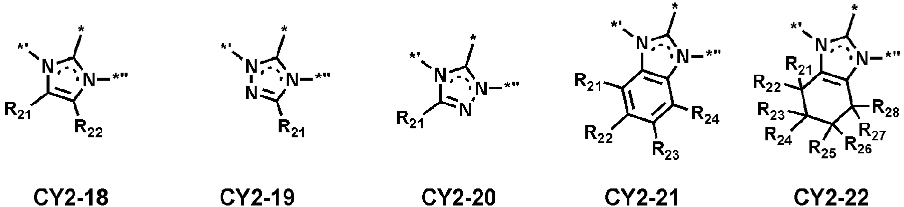 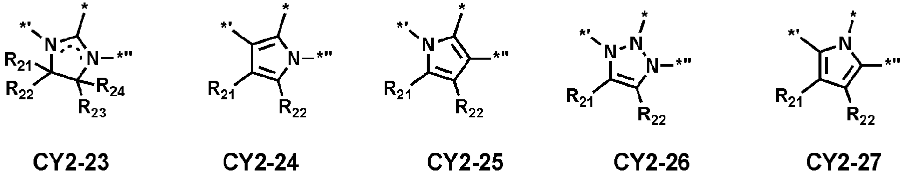 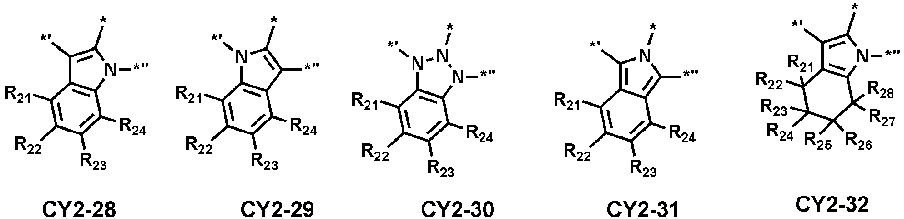 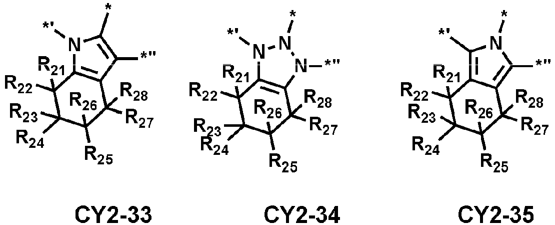 wherein, in Formulae CY2-1 to CY2-35,
Y₂ is C or N,
R₂₁ to R₂₉ are each independently as described for R₂ in claim 1, and
* indicates a binding site to M or A₂, *' indicates a binding site to T₁, and *" indicates a binding site to T₂.

7. The organometallic compound of any of claims 1-6, wherein a group represented by 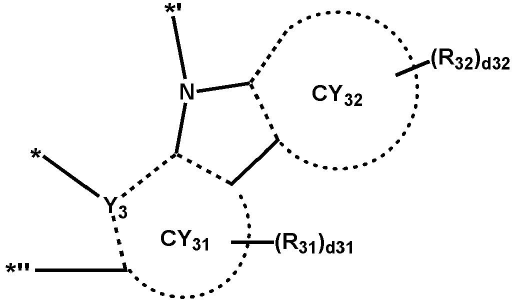
in Formula 1 is a group represented by one of Formulae CY3-1 to CY3-9: 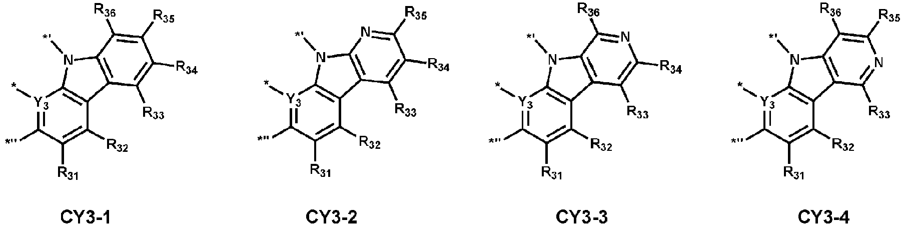 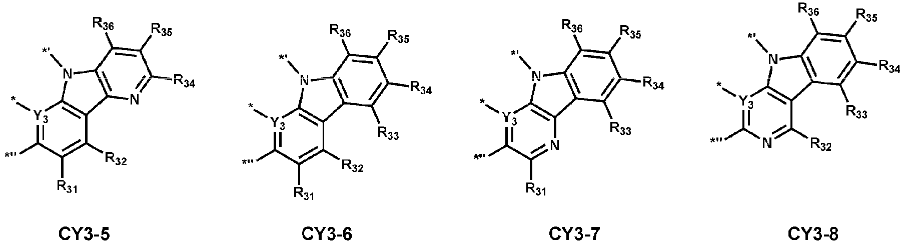 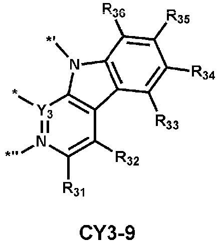 wherein, in Formulae CY3-1 to CY3-9,
Y₃ is C or N,
R₃₁ to R₃₆ are each independently as described for R₃₁ in claim 1, and
* indicates a binding site to M or A₃, *' indicates a binding site to T₃, and *" indicates a binding site to T₂; and/or
wherein a group represented by 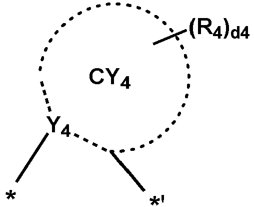
in Formula 1 is a group represented by one of Formulae CY4-1 to CY4-29: 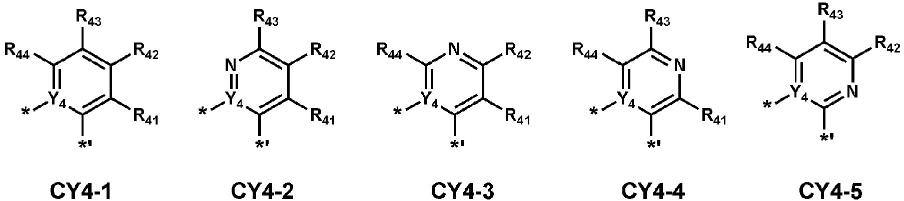 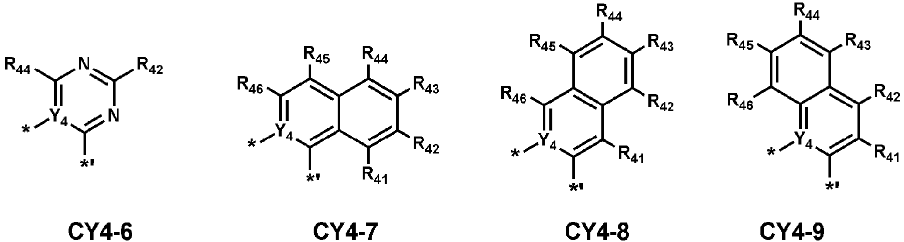 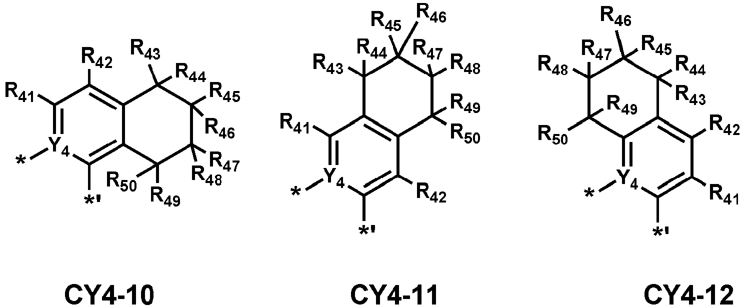 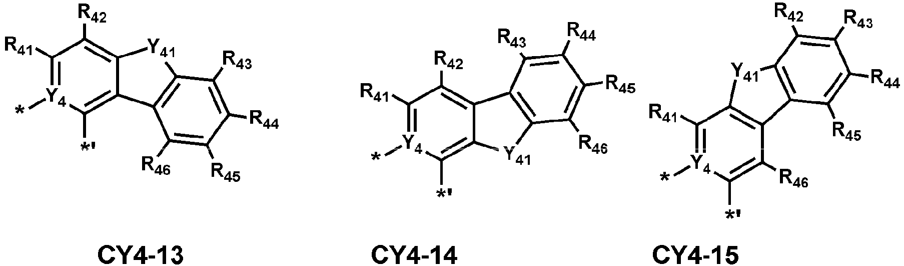 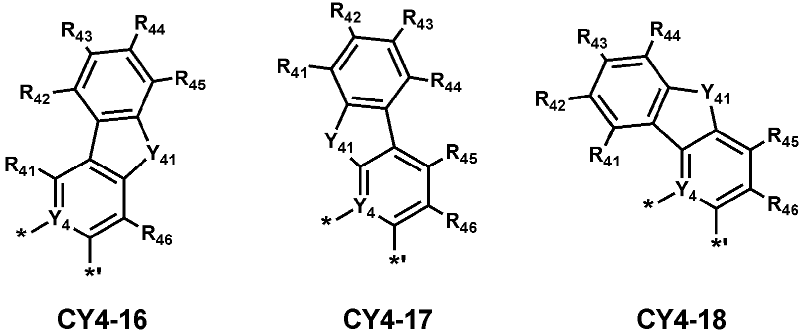 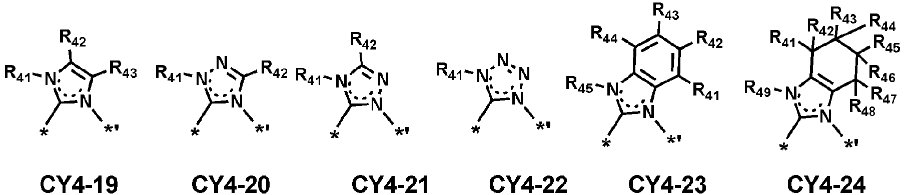 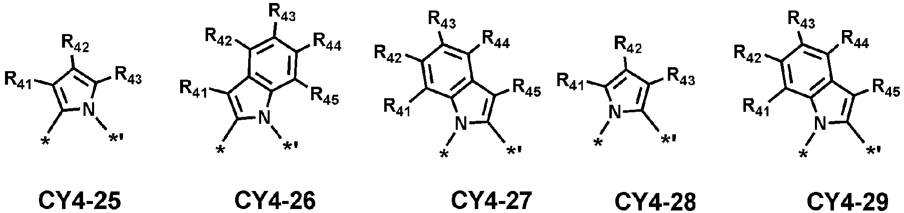 wherein, in Formulae CY4-1 to CY4-29,
Y₄ is C or N,
Y₄₁ is N(R₄₁ₐ), O, Se, C(R₄₁ₐ)(R_{41b}), or Si(R₄₁ₐ)(R_{41b}), and
R₄₁ to R₅₀, R₄₁ₐ, and R_{41b} are each independently as described for R₄ in claim 1,
* indicates a binding site to M or A₄, and
*' indicates a binding site to T₃.

8. The organometallic compound of any of claims 1-7, wherein the organometallic compound is represented by one of Formulae 1-1 and 1-2: 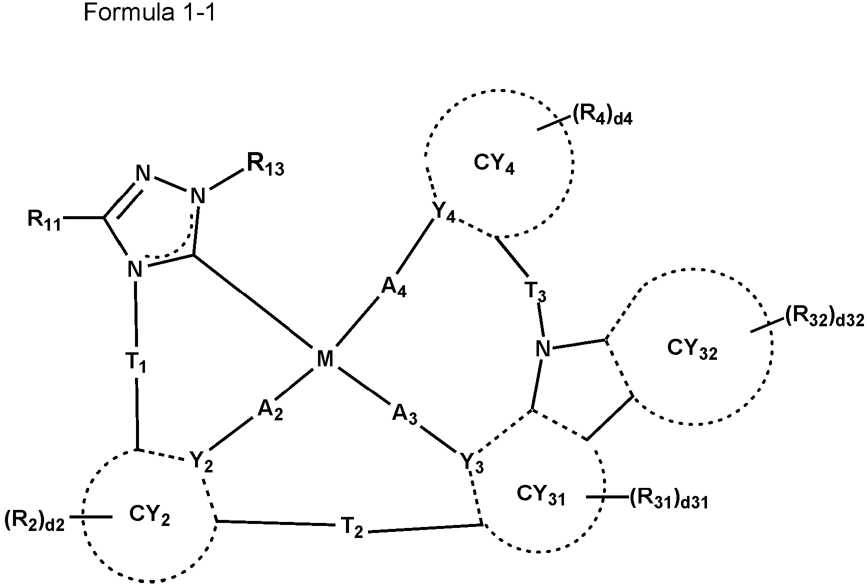 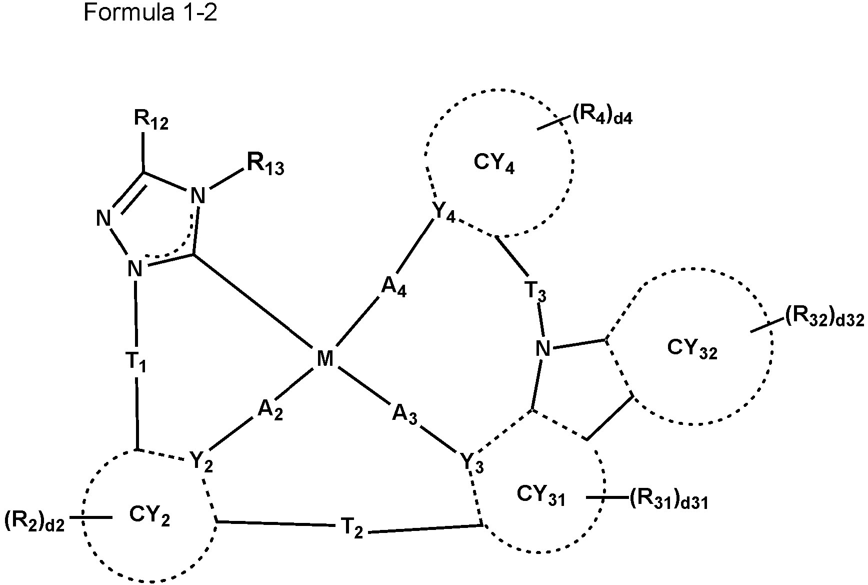 wherein, in Formulae 1-1 and 1-2,
M, ring CY₂, ring CY₃₁, ring CY₃₂, ring CY₄, Y₂ to Y₄, A₂ to A₄, T₁ to T₃, R₁₁ to R₁₃, R₂, R₃₁, R₃₂, R₄, d2, d31, d32, and d4 are respectively as define for M, ring CY₂, ring CY₃₁, ring CY₃₂, ring CY₄, Y₂ to Y₄, A₂ to A₄, T₁ to T₃, R₁₁ to R₁₃, R₂, R₃₁, R₃₂, R₄, d2, d31, d32, and d4 in claim 1.

9. The organometallic compound of any of claims 1-8, wherein the organometallic compound is represented by one of Formulae 1-11 and 1-12: 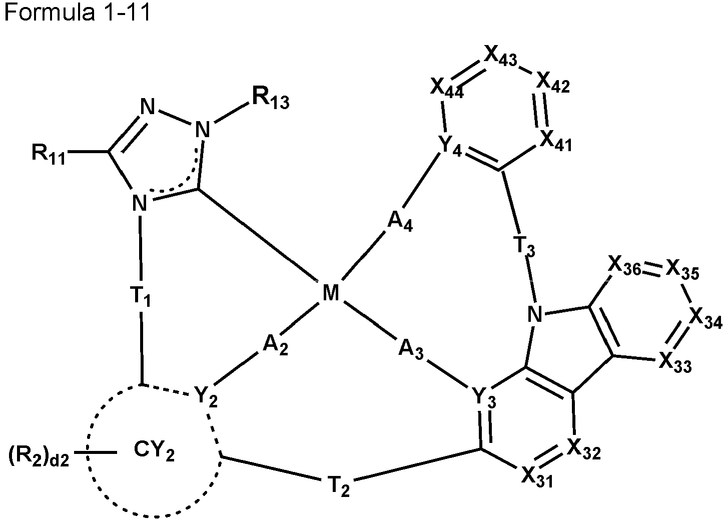 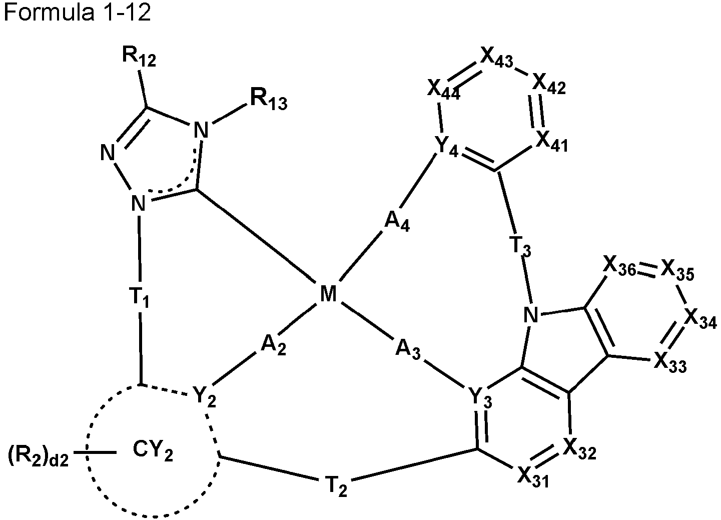 wherein, in Formulae 1-11 and 1-12,
X₃₁ is C(R₃₁) or N, X₃₂ is C(R₃₂) or N, X₃₃ is C(R₃₃) or N, X₃₄ is C(R₃₄) or N, X₃₅ is C(R₃₅) or N, and X₃₆ is C(R₃₆) or N,
X₄₁ is C(R₄₁) or N, X₄₂ is C(R₄₂) or N, X₄₃ is C(R₄₃) or N, and X₄₄ is C(R₄₄) or N,
R₃₁ to R₃₆ are each independently as described for R₃₁ in claim 1,
R₄₁ to R₄₄ are each independently as described for R₄ in claim 1, and
M, ring CY₂, Y₂ to Y₄, A₂ to A₄, T₁ to T₃, R₁₁ to R₁₃, R₂, and d2 are respectively as defined for M, ring CY₂, Y₂ to Y₄, A₂ to A₄, T₁ to T₃, R₁₁ to R₁₃, R₂, and d2 in claim 1.

10. The organometallic compound of any of claims 1-9, wherein a highest occupied molecular orbital (HOMO) energy level of the organometallic compound is - 5.25 electron Volts or less.

11. An organic light-emitting device, comprising:
a first electrode;
a second electrode; and
an organic layer arranged between the first electrode and the second electrode,
wherein the organic layer comprises an emission layer, and
wherein the organic layer further comprises at least one of the organometallic compound of any one of claims 1 to 10.

12. The organic light-emitting device of claim 11, wherein the emission layer comprises the at least one of the organometallic compound;
preferably wherein the emission layer emits light having a maximum emission wavelength of 440 nanometer to 470 nanometer.

13. The organic light-emitting device of claims 11 or 12, wherein
the first electrode is an anode,
the second electrode is a cathode,
the organic layer further comprises a hole transport region arranged between the first electrode and the emission layer, and an electron transport region arranged between the emission layer and the second electrode,
the hole transport region comprises a hole injection layer, a hole transport layer, an electron blocking layer, a buffer layer, or a combination thereof, and
the electron transport region comprises a hole blocking layer, an electron transport layer, an electron injection layer, or a combination thereof.

14. An electronic apparatus, comprising the organic light-emitting device of any of claims 11-13.

## Patentansprüche

1. Organometallische Verbindung dargestellt durch Formel 1: 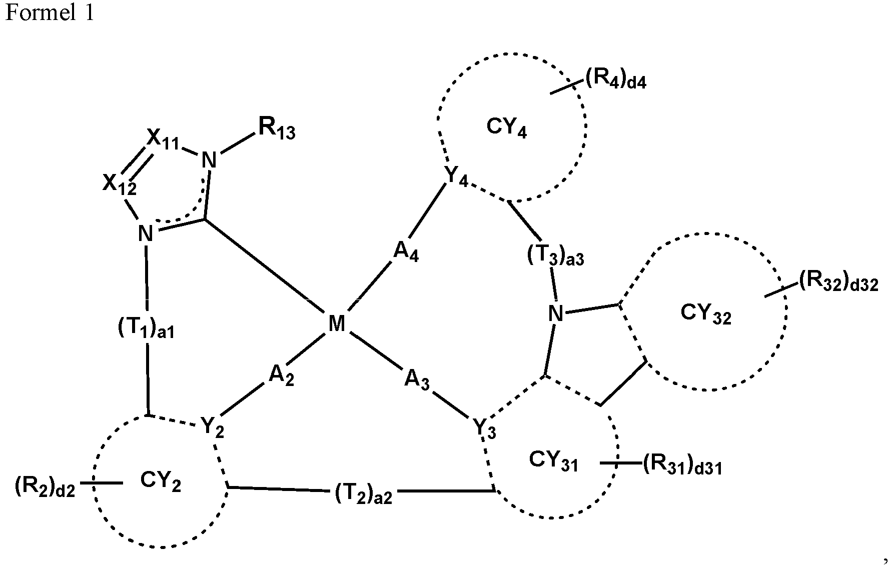 wobei in Formel 1
M ein Übergangsmetall ist,
X₁₁ N ist und X₁₂ C(R₁₂) ist oder X₁₁ C(R₁₁) ist und X₁₂ N ist;
Ring CY₂, Ring CY₃₁, Ring CY₃₂ und Ring CY₄ jeweils unabhängig eine carbocyclische C₃-C₆₀-Gruppe oder eine heterocyclische C₁-C₆₀-Gruppe sind,
Y₂ bis Y₄ jeweils unabhängig C oder N sind,
A₂ bis A₄ jeweils unabhängig eine chemische Bindung, O oder S sind,
T₁ eine Einfachbindung, eine Doppelbindung, *-N[(L₁)_{b1}-(R₁ₐ)]-*', *-B(R₁ₐ)-*', *-P(R₁ₐ)-*', *-C(R₁ₐ)(R_{1b})-*', *-Si(R₁ₐ)(R_{1b})-*', *-Ge(R₁ₐ)(R_{1b})-*', *-S-*', *-Se-*', *-O-*', *-C(=O)-*', *-S(=O)-*', *-S(=O)₂-*', *-C(R₁ₐ)=*', *=C(R₁ₐ)-*', *-C(R₁ₐ)=C(R_{1b})-*', *-C(=S)-*' oder *-C≡C-*' ist,
T₂ eine Einfachbindung, eine Doppelbindung, *-N[(L₂)_{b2}-(R₂ₐ)]-*', *-B(R₂ₐ)-*', *-P(R₂ₐ)-*', *-C(R₂ₐ)(R_{2b})-*', *-Si(R₂ₐ)(R_{2b})-*', *-Ge(R₂ₐ)(R_{2b})-*', *-S-*', *-Se-*', *-O-*', *-C(=O)-*', *-S(=O)-*', *-S(=O)₂-*', *-C(R₂ₐ)=*', *=C(R₂a)-*', *-C(R₂ₐ)=C(R_{2b})-*', *-C(=S)-*' oder *-C≡C-*' ist,
T₃ eine Einfachbindung, eine Doppelbindung, *-N[(L₃)_{b3}-(R₃ₐ)]-*', *-B(R₃ₐ)-*', *-P(R₃ₐ)-*', *-C(R₃ₐ)(R_{3b})-*', *-Si(R₃ₐ)(R_{3b})-*', *-Ge(R₃ₐ)(R_{3b})-*', *-S-*', *-Se-*', *-O-*', *-C(=O)-*', *-S(=O)-*', *-S(=O)₂-*', *-C(R₃ₐ)=*', *=C(R₃ₐ)-*', *-C(R₃ₐ)=C(R_{3b})-*', *-C(=S)-*' oder *-C≡C-*' ist,
a1 bis a3 jeweils unabhängig eine ganze Zahl von 1 bis 3 sind,
* und *' jeweils eine Bindungsstelle zu einem benachbarten Atom angeben,
L₁ bis L₃ jeweils unabhängig eine Einfachbindung, eine carbocyclische C₅-C₃₀-Gruppe, unsubstituiert oder substituiert mit zumindest einem R₁₀ₐ, oder eine heterocyclische C₁-C₃₀-Gruppe, unsubstituiert oder substituiert mit zumindest einem R₁₀ₐ, sind,
b1 bis b3 jeweils unabhängig eine ganze Zahl von 1 bis 3 sind,
R₁ₐ, R_{1b}, R₂, R₂ₐ, R_{2b}, R₃ₐ, R_{3b}, R₄, R₁₀ₐ, R₁₁ bis R₁₃, R₃₁ und R₃₂ jeweils unabhängig Wasserstoff, Deuterium, -F, -Cl, -Br, -I, -SF₅, eine Hydroxylgruppe, eine Cyanogruppe, eine Nitrogruppe, eine Aminogruppe, eine Amidinogruppe, eine Hydrazingruppe, eine Hydrazongruppe, eine Carbonsäuregruppe oder ein Salz davon, eine Sulfonsäuregruppe oder ein Salz davon, eine Phosphorsäuregruppe oder ein Salz davon, eine substituierte oder unsubstituierte C₁-C₆₀-Alkylgruppe, eine substituierte oder unsubstituierte C₂-C₆₀-Alkenylgruppe, eine substituierte oder unsubstituierte C₂-C₆₀-Alkinylgruppe, eine substituierte oder unsubstituierte C₁-C₆₀-Alkoxygruppe, eine substituierte oder unsubstituierte C₁-C₆₀-Alkylthiogruppe, eine substituierte oder unsubstituierte C₃-C₁₀-Cycloalkylgruppe, eine substituierte oder unsubstituierte C₁-C₁₀-Heterocycloalkylgruppe, eine substituierte oder unsubstituierte C₃-C₁₀-Cycloalkenylgruppe, eine substituierte oder unsubstituierte C₂-C₁₀-Heterocycloalkenylgruppe, eine substituierte oder unsubstituierte C₆-C₆₀-Arylgruppe, eine substituierte oder unsubstituierte C₇-C₆₀-Alkylarylgruppe, eine substituierte oder unsubstituierte C₇-C₆₀-Arylalkylgruppe, eine substituierte oder unsubstituierte C₆-C₆₀-Aryloxygruppe, eine substituierte oder unsubstituierte C₆-C₆₀-Arylthiogruppe, eine substituierte oder unsubstituierte C₁-C₆₀-Heteroarylgruppe, eine C₂-C₆₀-Alkylheteroarylgruppe, eine C₂-C₆₀-Heteroarylalkylgruppe, eine substituierte oder unsubstituierte C₁-C₆₀-Heteroaryloxygruppe, eine substituierte oder unsubstituierte C₁-C₆₀-Heteroarylthiogruppe, eine substituierte oder unsubstituierte einwertige nichtaromatische kondensierte polycyclische Gruppe, eine substituierte oder unsubstituierte einwertige nichtaromatische kondensierte heteropolycyclische Gruppe, -Si(Q₁)(Q₂)(Q₃), -Ge(Q₁)(Q₂)(Q₃), -N(Q₄)(Q₅), -B(Q₆)(Q₇), - P(Q₈)(Q₉) oder-P(=O)(Q₈)(Q₉) sind,
d2, d31, d32 und d4 jeweils unabhängig eine ganze Zahl von 0 bis 10 sind,
zumindest ein Substituent der substituierten carbocyclischen C₅-C₃₀-Gruppe, der substituierten heterocyclischen C₁-C₃₀-Gruppe, der substituierten C₁-C₆₀-Alkylgruppe, der substituierten C₂-C₆₀-Alkenylgruppe, der substituierten C₂-C₆₀-Alkinylgruppe, der substituierten C₁-C₆₀-Alkoxygruppe, der substituierten C₁-C₆₀-Alkylthiogruppe, der substituierten C₃-C₁₀-Cycloalkylgruppe, der substituierten C₁-C₁₀-Heterocycloalkylgruppe, der substituierten C₃-C₁₀-Cycloalkenylgruppe, der substituierten C₁-C₁₀-Heterocycloalkenylgruppe, der substituierten C₆-C₆₀-Arylgruppe, der substituierten C₇-C₆₀-Alkylarylgruppe, der substituierten C₇-C₆₀-Arylalkylgruppe, der substituierten C₆-C₆₀-Aryloxygruppe, der substituierten C₆-C₆₀-Arylthiogruppe, der substituierten C₁-C₆₀-Heteroarylgruppe, der substituierten C₂-C₆₀-Alkylheteroarylgruppe, der substituierten C₂-C₆₀-Heteroarylalkylgruppe, der substituierten C₁-C₆₀-Heteroaryloxygruppe, der substituierten C₁-C₆₀-Heteroarylthiogruppe, der substituierten einwertigen nichtaromatischen kondensierten polycyclischen Gruppe und der substituierten einwertigen nichtaromatischen kondensierten heteropolycyclischen Gruppe wie folgt ist:
Deuterium, -F, -Cl, -Br, -I, -SF₅, -CD₃, -CD₂H, -CDH₂, -CF₃, -CF₂H, -CFH₂, eine Hydroxylgruppe, eine Cyanogruppe, eine Nitrogruppe, eine Aminogruppe, eine Amidinogruppe, eine Hydrazingruppe, eine Hydrazongruppe, eine Carbonsäuregruppe oder ein Salz davon, eine Sulfonsäuregruppe oder ein Salz davon, eine Phosphorsäuregruppe oder ein Salz davon, eine C₁-C₆₀-Alkylgruppe, eine C₂-C₆₀-Alkenylgruppe, eine C₂-C₆₀-Alkinylgruppe, eine C₁-C₆₀-Alkoxygruppe oder eine C₁-C₆₀-Alkylthiogruppe;
eine C₁-C₆₀-Alkylgruppe, eine C₂-C₆₀-Alkenylgruppe, eine C₂-C₆₀-Alkinylgruppe, eine C₁-C₆₀-Alkoxygruppe oder eine C₁-C₆₀-Alkylthiogruppe, jeweils substituiert mit zumindest einem von Deuterium, -F, -Cl, -Br, -I, -SF₅, -CD₃, -CD₂H, -CDH₂, -CF₃, -CF₂H, -CFH₂, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₇-C₆₀-Alkylarylgruppe, einer C₆-C₆₀-Aryloxygruppe, einer C₆-C₆₀-Arylthiogruppe, einer C₁-C₆₀-Heteroarylgruppe, einer C₂-C₆₀-Alkylheteroarylgruppe, einer C₁-C₆₀-Heteroaryloxygruppe, einer C₁-C₆₀-Heteroarylthiogruppe, einer einwertigen nichtaromatischen kondensierten polycyclischen Gruppe, einer einwertigen nichtaromatischen kondensierten heteropolycyclischen Gruppe, -Si(Q₁₁)(Q₁₂)(Q₁₃), -Ge(Q₁₁)(Q₁₂)(Q₁₃), - N(Q₁₄)(Q₁₅), -B(Q₁₆)(Q₁₇), -P(Q₁₈)(Q₁₉), -P(=O)(Q₁₈)(Q₁₉) oder einer Kombination davon;
eine C₃-C₁₀-Cycloalkylgruppe, eine C₁-C₁₀-Heterocycloalkylgruppe, eine C₃-C₁₀-Cycloalkenylgruppe, eine C₁-C₁₀-Heterocycloalkenylgruppe, eine C₆-C₆₀-Arylgruppe, eine C₇-C₆₀-Alkylarylgruppe, eine C₆-C₆₀-Aryloxygruppe, eine C₆-C₆₀-Arylthiogruppe, eine C₁-C₆₀-Heteroarylgruppe, eine C₂-C₆₀-Alkylheteroarylgruppe, eine C₁-C₆₀-Heteroaryloxygruppe, eine C₁-C₆₀-Heteroarylthiogruppe, eine einwertige nichtaromatische kondensierte polycyclische Gruppe oder eine einwertige nichtaromatische kondensierte heteropolycyclische Gruppe;
eine C₃-C₁₀-Cycloalkylgruppe, eine C₁-C₁₀-Heterocycloalkylgruppe, eine C₃-C₁₀-Cycloalkenylgruppe, eine C₁-C₁₀-Heterocycloalkenylgruppe, eine C₆-C₆₀-Arylgruppe, eine C₇-C₆₀-Alkylarylgruppe, eine C₆-C₆₀-Aryloxygruppe, eine C₆-C₆₀-Arylthiogruppe, eine C₁-C₆₀-Heteroarylgruppe, eine C₂-C₆₀-Alkylheteroarylgruppe, eine C₁-C₆₀-Heteroaryloxygruppe, eine C₁-C₆₀-Heteroarylthiogruppe, eine einwertige nichtaromatische kondensierte polycyclische Gruppe oder eine einwertige nichtaromatische kondensierte heteropolycyclische Gruppe, jeweils substituiert mit zumindest einem von Deuterium, -F, -Cl, -Br, -I, -SF₅, -CD₃, -CD₂H, -CDH₂, -CF₃, -CF₂H, -CFH₂, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer C₁-C₆₀-Alkylgruppe, einer C₂-C₆₀-Alkenylgruppe, einer C₂-C₆₀-Alkinylgruppe, einer C₁-C₆₀-Alkoxygruppe, einer C₁-C₆₀-Alkylthiogruppe, einer C₃-C₁₀-Cycloalkylgruppe, einer C₁-C₁₀-Heterocycloalkylgruppe, einer C₃-C₁₀-Cycloalkenylgruppe, einer C₁-C₁₀-Heterocycloalkenylgruppe, einer C₆-C₆₀-Arylgruppe, einer C₇-C₆₀-Alkylarylgruppe, einer C₇-C₆₀-Arylalkylgruppe, einer C₆-C₆₀-Aryloxygruppe, einer C₆-C₆₀-Arylthiogruppe, einer C₁-C₆₀-Heteroarylgruppe, einer C₂-C₆₀-Alkylheteroarylgruppe, einer C₂-C₆₀-Heteroarylalkylgruppe, einer C₁-C₆₀-Heteroaryloxygruppe, einer C₁-C₆₀-Heteroarylthiogruppe, einer einwertigen nichtaromatischen kondensierten polycyclischen Gruppe, einer einwertigen nichtaromatischen kondensierten heteropolycyclischen Gruppe, - Si(Q₂₁)(Q₂₂)(Q₂₃), -Ge(Q₂₁)(Q₂₂)(Q₂₃), -N(Q₂₄)(Q₂₅), -B(Q₂₆)(Q₂₇), -P(Q₂₈)(Q₂₉), - P(=O)(Q₂₈)(Q₂₉) oder einer Kombination davon; oder
-Si(Q₃₁)(Q₃₂)(Q₃₃), -Ge(Q₃₁)(Q₃₂)(Q₃₃), -N(Q₃₄)(Q₃₅), -B(Q₃₆)(Q₃₇), -P(Q₃₈)(Q₃₉) oder - P(=O)(Q₃₈)(Q₃₉) und
Q₁ bis Q₉, Q₁₁ bis Q₁₉, Q₂₁ bis Q₂₉ und Q₃₁ bis Q₃₉ jeweils unabhängig Wasserstoff, Deuterium, -F, -Cl, -Br, -I, -SF₅, eine Hydroxylgruppe, eine Cyanogruppe, eine Nitrogruppe, eine Aminogruppe, eine Amidinogruppe, eine Hydrazingruppe, eine Hydrazongruppe, eine Carbonsäuregruppe oder ein Salz davon, eine Sulfonsäuregruppe oder ein Salz davon, eine Phosphorsäuregruppe oder ein Salz davon, eine substituierte oder unsubstituierte C₁-C₆₀-Alkylgruppe, eine substituierte oder unsubstituierte C₂-C₆₀-Alkenylgruppe, eine substituierte oder unsubstituierte C₂-C₆₀-Alkinylgruppe, eine substituierte oder unsubstituierte C₁-C₆₀-Alkoxygruppe, eine substituierte oder unsubstituierte C₁-C₆₀-Alkylthiogruppe, eine substituierte oder unsubstituierte C₃-C₁₀-Cycloalkylgruppe, eine substituierte oder unsubstituierte C₁-C₁₀-Heterocycloalkylgruppe, eine substituierte oder unsubstituierte C₃-C₁₀-Cycloalkenylgruppe, eine substituierte oder unsubstituierte C₁-C₁₀-Heterocycloalkenylgruppe, eine substituierte oder unsubstituierte C₆-C₆₀-Arylgruppe, eine substituierte oder unsubstituierte C₇-C₆₀-Alkylarylgruppe, eine substituierte oder unsubstituierte C₇-C₆₀-Arylalkylgruppe, eine substituierte oder unsubstituierte C₆-C₆₀-Aryloxygruppe, eine substituierte oder unsubstituierte C₆-C₆₀-Arylthiogruppe, eine substituierte oder unsubstituierte C₁-C₆₀-Heteroarylgruppe, eine substituierte oder unsubstituierte C₂-C₆₀-Alkylheteroarylgruppe, eine substituierte oder unsubstituierte C₂-C₆₀-Heteroarylalkylgruppe, eine substituierte oder unsubstituierte C₁-C₆₀-Heteroaryloxygruppe, eine substituierte oder unsubstituierte C₁-C₆₀-Heteroarylthiogruppe, eine substituierte oder unsubstituierte einwertige nichtaromatische kondensierte polycyclische Gruppe oder eine substituierte oder unsubstituierte einwertige nichtaromatische kondensierte heteropolycyclische Gruppe sind.

2. Organometallische Verbindung nach Anspruch 1, wobei M Iridium (Ir), Platin (Pt), Osmium (Os), Titan (Ti), Zirkonium (Zr), Hafnium (Hf), Europium (Eu), Terbium (Tb), Thulium (Tm), Rhodium (Rh), Palladium (Pd) oder Gold (Au) ist.

3. Organometallische Verbindung nach Anspruch 1 oder 2, wobei Ring CY₂, Ring CY₃₁, Ring CY₃₂ und Ring CY₄ jeweils unabhängig eine Benzolgruppe, eine Naphthalengruppe, eine Anthracengruppe, eine Phenanthrengruppe, eine Triphenylengruppe, eine Pyrengruppe, eine Chrysengruppe, eine Cyclopentadiengruppe, eine 1,2,3,4-Tetrahydronaphthalengruppe, eine Thiophengruppe, eine Furangruppe, eine Indolgruppe, eine Benzoborolgruppe, eine Benzophospholgruppe, eine Indengruppe, eine Benzosilolgruppe, eine Benzogermolgruppe, eine Benzothiophengruppe, eine Benzoselenophengruppe, eine Benzofurangruppe, eine Carbazolgruppe, eine Dibenzoborolgruppe, eine Dibenzophospholgruppe, eine Fluorengruppe, eine Dibenzosilolgruppe, eine Dibenzogermolgruppe, eine Dibenzothiophengruppe, eine Dibenzoselenophengruppe, eine Dibenzofurangruppe, eine Dibenzothiophen-5-oxid-Gruppe, eine 9H-Fluoren-9-on-Gruppe, eine Dibenzothiophen-5,5-dioxid-Gruppe, eine Azaindolgruppe, eine Azabenzoborolgruppe, eine Azabenzophospholgruppe, eine Azaindengruppe, eine Azabenzosilolgruppe, eine Azabenzogermolgruppe, eine Azabenzothiophengruppe, eine Azabenzoselenophengruppe, eine Azabenzofurangruppe, eine Azacarbazolgruppe, eine Azadibenzoborolgruppe, eine Azadibenzophospholgruppe, eine Azafluorengruppe, eine Azadibenzosilolgruppe, eine Azadibenzogermolgruppe, eine Azadibenzothiophengruppe, eine Azadibenzoselenophengruppe, eine Azadibenzofurangruppe, eine Azadibenzothiophen-5-oxid-Gruppe, eine Aza-9H-fluoren-9-on-Gruppe, eine Azadibenzothiophen-5,5-dioxid-Gruppe, eine Pyridingruppe, eine Pyrimidingruppe, eine Pyrazingruppe, eine Pyridazingruppe, eine Triazingruppe, eine Chinolingruppe, eine Isochinolingruppe, eine Chinoxalingruppe, eine Chinazolingruppe, eine Phenanthrolingruppe, eine Pyrrolgruppe, eine Pyrazolgruppe, eine Imidazolgruppe, eine Triazolgruppe, eine Oxazolgruppe, eine Isoxazolgruppe, eine Thiazolgruppe, eine Isothiazolgruppe, eine Oxadiazolgruppe, eine Thiadiazolgruppe, eine Benzopyrazolgruppe, eine Benzimidazolgruppe, eine Benzotriazol-, eine Benzoxazolgruppe, eine Benzothiazolgruppe, eine Benzoxadiazolgruppe, eine Benzothiadiazolgruppe, eine 5,6,7,8-Tetrahydroisochinolingruppe oder eine 5,6,7,8-Tetrahydrochinolingruppe sind; und/oder
wobei zumindest eines von Y₂ bis Y₄ N ist.

4. Organometallische Verbindung nach einem der Ansprüche 1-3, wobei R₁ₐ, R_{1b}, R₂, R₂ₐ, R_{2b}, R₃ₐ, R_{3b}, R₄, R₁₀ₐ, R₁₁ bis R₁₃, R₃₁ und R₃₂ jeweils unabhängig wie folgt sind:
Wasserstoff, Deuterium, -F, -Cl, -Br, -I, -SF₅, -CD₃, -CD₂H, -CDH₂, -CF₃, -CF₂H, -CFH₂, eine Hydroxylgruppe, eine Cyanogruppe, eine Nitrogruppe, eine Aminogruppe, eine Amidinogruppe, eine Hydrazingruppe, eine Hydrazongruppe, eine Carbonsäuregruppe oder ein Salz davon, eine Sulfonsäuregruppe oder ein Salz davon, eine Phosphorsäuregruppe oder ein Salz davon, eine C₁-C₂₀-Alkylgruppe, eine C₁-C₂₀-Alkoxygruppe oder eine C₁-C₂₀-Alkylthiogruppe,
eine C₁-C₂₀-Alkylgruppe, eine C₁-C₂₀-Alkoxygruppe oder eine C₁-C₆₀-Alkylthiogruppe, jeweils substituiert mit zumindest einem von Deuterium, -F, -Cl, -Br, -I, -SF₅, -CD₃, -CD₂H, - CDH₂, -CF₃, -CF₂H, -CFH₂, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer C₁-C₁₀-Alkylgruppe, einer Cyclopentylgruppe, einer Cyclohexylgruppe, einer Cycloheptylgruppe, einer Cyclooctylgruppe, einer Adamantanylgruppe, einer Norbomanylgruppe, einer Norbornenylgruppe, einer Cyclopentenylgruppe, einer Cyclohexenylgruppe, einer Cycloheptenylgruppe, einer Phenylgruppe, einer Naphthylgruppe, einer Pyridinylgruppe, einer Pyrimidinylgruppe oder einer Kombination davon;
eine Cyclopentylgruppe, eine Cyclohexylgruppe, eine Cycloheptylgruppe, eine Cyclooctylgruppe, eine Adamantanylgruppe, eine Norbornanylgruppe, eine Norbornenylgruppe, eine Cyclopentenylgruppe, eine Cyclohexenylgruppe, eine Cycloheptenylgruppe, eine Phenylgruppe, eine Naphthylgruppe, eine Fluorenylgruppe, eine Phenanthrenylgruppe, eine Anthracenylgruppe, eine Fluoranthenylgruppe, eine Triphenylenylgruppe, eine Pyrenylgruppe, eine Chrysenylgruppe, eine Pyrrolylgruppe, eine Thiophenylgruppe, eine Furanylgruppe, eine Imidazolylgruppe, eine Pyrazolylgruppe, eine Thiazolylgruppe, eine Isothiazolylgruppe, eine Oxazolylgruppe, eine Isoxazolylgruppe, eine Pyridinylgruppe, eine Pyrazinylgruppe, eine Pyrimidinylgruppe, eine Pyridazinylgruppe, eine Isoindolylgruppe, eine Indolylgruppe, eine Indazolylgruppe, eine Purinylgruppe, eine Chinolinylgruppe, eine Isochinolinylgruppe, eine Benzochinolinylgruppe, eine Chinoxalinylgruppe, eine Chinazolinylgruppe, eine Cinnolinylgruppe, eine Carbazolylgruppe, eine Phenanthrolinylgruppe, eine Benzimidazolylgruppe, eine Benzofuranylgruppe, eine Benzothiophenylgruppe, eine Isobenzothiazolylgruppe, eine Benzoxazolylgruppe, eine Isobenzoxazolylgruppe, eine Triazolylgruppe, eine Tetrazolylgruppe, eine Oxadiazolylgruppe, eine Triazinylgruppe, eine Dibenzofuranylgruppe, eine Dibenzothiophenylgruppe, eine Benzocarbazolylgruppe, eine Dibenzocarbazolylgruppe, eine Imidazopyridinylgruppe oder eine Imidazopyrimidinylgruppe,
eine Cyclopentylgruppe, eine Cyclohexylgruppe, eine Cycloheptylgruppe, eine Cyclooctylgruppe, eine Adamantanylgruppe, eine Norbornanylgruppe, eine Norbornenylgruppe, eine Cyclopentenylgruppe, eine Cyclohexenylgruppe, eine Cycloheptenylgruppe, eine Phenylgruppe, eine Naphthylgruppe, eine Fluorenylgruppe, eine Phenanthrenylgruppe, eine Anthracenylgruppe, eine Fluoranthenylgruppe, eine Triphenylenylgruppe, eine Pyrenylgruppe, eine Chrysenylgruppe, eine Pyrrolylgruppe, eine Thiophenylgruppe, eine Furanylgruppe, eine Imidazolylgruppe, eine Pyrazolylgruppe, eine Thiazolylgruppe, eine Isothiazolylgruppe, eine Oxazolylgruppe, eine Isoxazolylgruppe, eine Pyridinylgruppe, eine Pyrazinylgruppe, eine Pyrimidinylgruppe, eine Pyridazinylgruppe, eine Isoindolylgruppe, eine Indolylgruppe, eine Indazolylgruppe, eine Purinylgruppe, eine Chinolinylgruppe, eine Isochinolinylgruppe, eine Benzochinolinylgruppe, eine Chinoxalinylgruppe, eine Chinazolinylgruppe, eine Cinnolinylgruppe, eine Carbazolylgruppe, eine Phenanthrolinylgruppe, eine Benzimidazolylgruppe, eine Benzofuranylgruppe, eine Benzothiophenylgruppe, eine Benzoisothiazolylgruppe, eine Benzoxazolylgruppe, eine Isobenzoxazolylgruppe, eine Triazolylgruppe, eine Tetrazolylgruppe, eine Oxadiazolylgruppe, eine Triazinylgruppe, eine Dibenzofuranylgruppe, eine Dibenzothiophenylgruppe, eine Benzocarbazolylgruppe, eine Dibenzocarbazolylgruppe, eine Imidazopyridinylgruppe oder eine Imidazopyrimidinylgruppe, jeweils substituiert mit zumindest einem von Deuterium, -F, -Cl, -Br, -I, -SF₅, -CD₃, -CD₂H, - CDH₂, -CF₃, -CF₂H, -CFH₂, einer Hydroxylgruppe, einer Cyanogruppe, einer Nitrogruppe, einer Aminogruppe, einer Amidinogruppe, einer Hydrazingruppe, einer Hydrazongruppe, einer Carbonsäuregruppe oder einem Salz davon, einer Sulfonsäuregruppe oder einem Salz davon, einer Phosphorsäuregruppe oder einem Salz davon, einer C₁-C₂₀-Alkylgruppe, einer C₁-C₂₀-Alkoxygruppe, einer C₁-C₂₀-Alkylthiogruppe, einer Cyclopentylgruppe, einer Cyclohexylgruppe, einer Cycloheptylgruppe, einer Cyclooctylgruppe, einer Adamantanylgruppe, einer Norbomanylgruppe, einer Norbornenylgruppe, einer Cyclopentenylgruppe, einer Cyclohexenylgruppe, einer Cycloheptenylgruppe, einer Phenylgruppe, einer Naphthylgruppe, einer Fluorenylgruppe, einer Phenanthrenylgruppe, einer Anthracenylgruppe, einer Fluoranthenylgruppe, einer Triphenylenylgruppe, einer Pyrenylgruppe, einer Chrysenylgruppe, einer Pyrrolylgruppe, einer Thiophenylgruppe, einer Furanylgruppe, einer Imidazolylgruppe, einer Pyrazolylgruppe, einer Thiazolylgruppe, einer Isothiazolylgruppe, einer Oxazolylgruppe, einer Isoxazolylgruppe, einer Pyridinylgruppe, einer Pyrazinylgruppe, einer Pyrimidinylgruppe, einer Pyridazinylgruppe, einer Isoindolylgruppe, einer Indolylgruppe, einer Indazolylgruppe, einer Purinylgruppe, einer Chinolinylgruppe, einer Isochinolinylgruppe, einer Benzochinolinylgruppe, einer Chinoxalinylgruppe, einer Chinazolinylgruppe, einer Cinnolinylgruppe, einer Carbazolylgruppe, einer Phenanthrolinylgruppe, einer Benzimidazolylgruppe, einer Benzofuranylgruppe, einer Benzothiophenylgruppe, einer Benzoisothiazolylgruppe, einer Benzoxazolylgruppe, einer Isobenzoxazolylgruppe, einer Triazolylgruppe, einer Tetrazolylgruppe, einer Oxadiazolylgruppe, einer Triazinylgruppe, einer Dibenzofuranylgruppe, einer Dibenzothiophenylgruppe, einer Benzocarbazolylgruppe, einer Dibenzocarbazolylgruppe, einer Imidazopyridinylgruppe, einer Imidazopyrimidinylgruppe, -Si(Q₃₁)(Q₃₂)(Q₃₃) oder einer Kombination davon; oder
-Si(Q₁)(Q₂)(Q₃), -Ge(Q₁)(Q₂)(Q₃), -N(Q₄)(Q₅), -B(Q₆)(Q₇), -P(Q₈)(Q₉) oder - P(=O)(Q₈)(Q₉) und
Q₁ bis Q₉ und Q₃₁ bis Q₃₃ jeweils unabhängig wie folgt sind:
-CH₃, -CD₃, -CD₂H, -CDH₂, -CH₂CH₃, -CH₂CD₃, -CH₂CD₂H, -CH₂CDH₂, - CHDCH₃, - CHDCD₂H, -CHDCDH₂, -CHDCD₃, -CD₂CD₃, -CD₂CD₂H oder -CD₂CDH₂;
eine n-Propylgruppe, eine Isopropylgruppe, eine n-Butylgruppe, eine Isobutylgruppe, eine sec-Butylgruppe, eine tert-Butylgruppe, eine n-Pentylgruppe, eine Isopentylgruppe, eine sec-Pentylgruppe, eine tert-Pentylgruppe, eine Phenylgruppe oder eine Naphthylgruppe; oder
eine n-Propylgruppe, eine Isopropylgruppe, eine n-Butylgruppe, eine Isobutylgruppe, eine sec-Butylgruppe, eine tert-Butylgruppe, eine n-Pentylgruppe, eine Isopentylgruppe, eine sec-Pentylgruppe, eine tert-Pentylgruppe, eine Phenylgruppe oder eine Naphthylgruppe, jeweils substituiert mit zumindest einem von Deuterium, einer C₁-C₁₀-Alkylgruppe, einer Phenylgruppe oder einer Kombination davon.

5. Organometallische Verbindung nach einem der Ansprüche 1-4, wobei R₁ₐ, R_{1b}, R₂, R₂ₐ, R_{2b}, R₃ₐ, R_{3b}, R₄, R₁₀ₐ, R₁₁ bis R₁₃, R₃₁ und R₃₂ jeweils unabhängig wie folgt sind:
Wasserstoff, Deuterium, -F, -Cl, -Br, -I, -SF₅, -CD₃, -CD₂H, -CDH₂, -CF₃, -CF₂H, -CFH₂, eine Cyanogruppe, eine C₁-C₆₀-Alkylgruppe, eine C₂-C₆₀-Alkenylgruppe, eine C₂-C₆₀-Alkinylgruppe, eine C₁-C₆₀-Alkoxygruppe oder eine C₁-C₆₀-Alkylthiogruppe;
eine Gruppe dargestellt durch eine der Formeln 9-1 bis 9-61, 9-201 bis 9-237, 10-1 bis 10-129 oder 10-201 bis 10-355;
eine Gruppe dargestellt durch eine der Formeln 9-1 bis 9-61, 9-201 bis 9-237, 10-1 bis 10-129 oder 10-201 bis 10-350, wobei zumindest ein Wasserstoff mit Deuterium, -F oder einer Cyanogruppe substituiert ist; oder
-Si(Q₁)(Q₂)(Q₃), -Ge(Q₁)(Q₂)(Q₃) oder -N(Q₄)(Q₅) und
Q₁ bis Q₅ jeweils wie für Q₁ bis Q₅ in Anspruch 1 definiert sind: 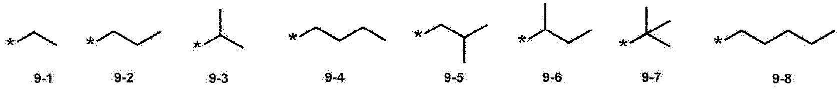 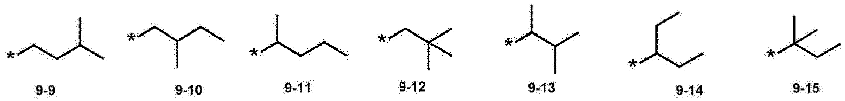 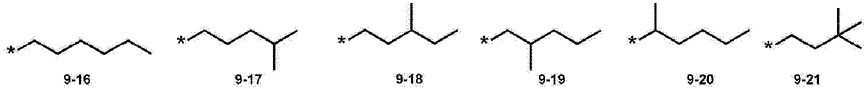 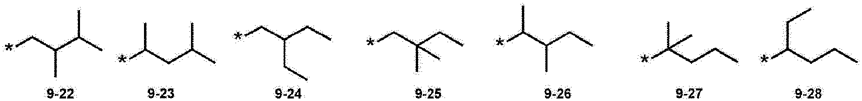 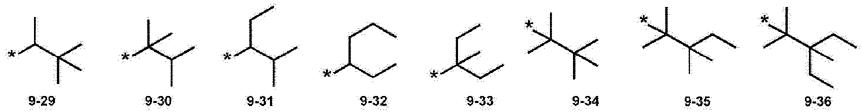 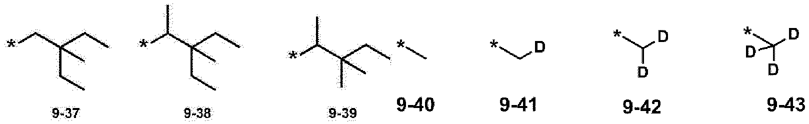 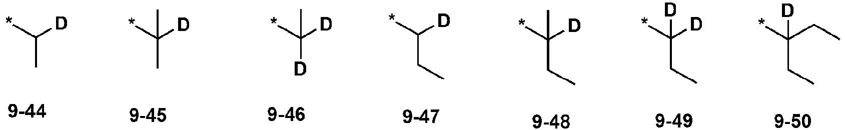 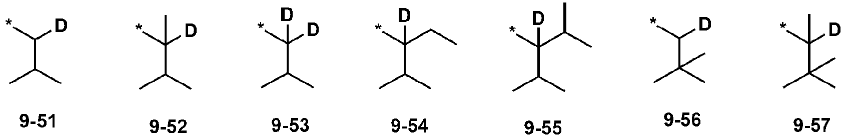 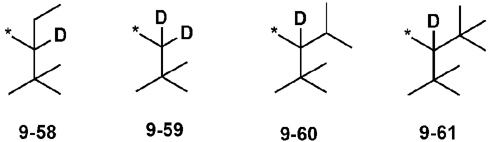 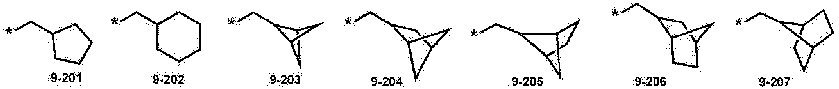 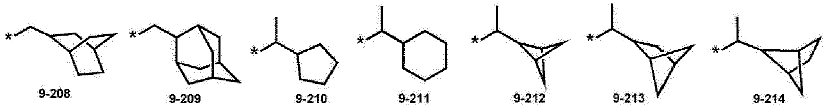 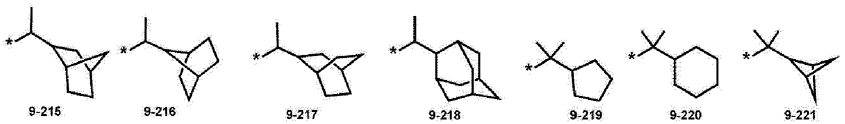 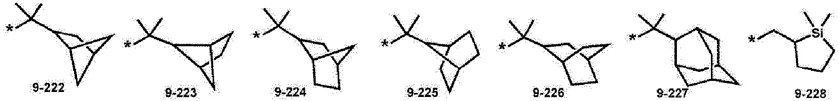 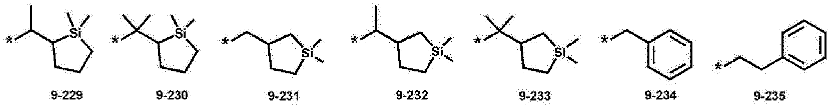 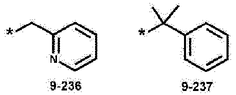 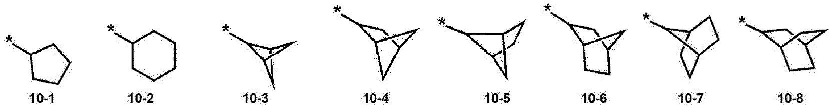 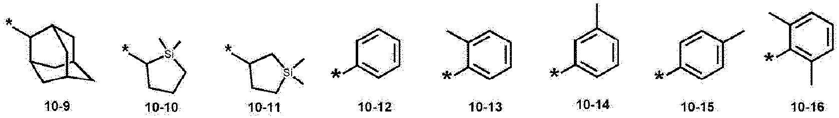 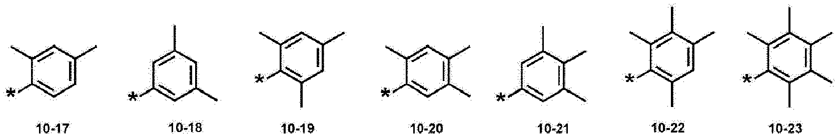 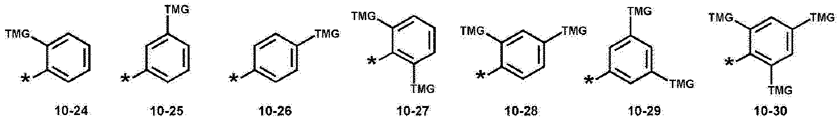 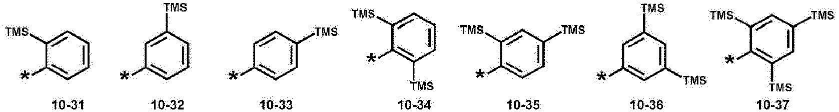 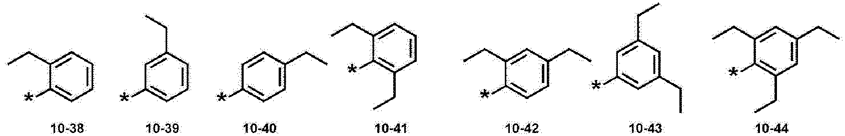 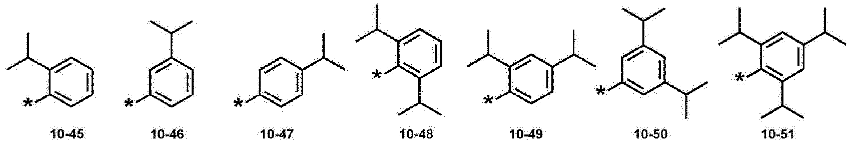 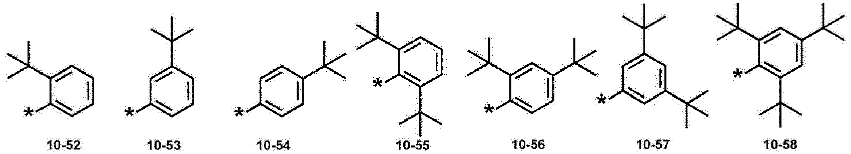 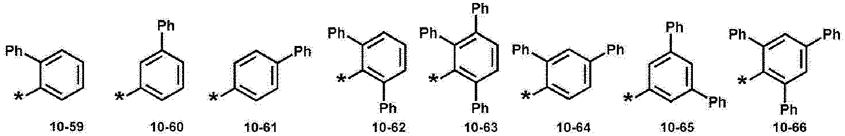 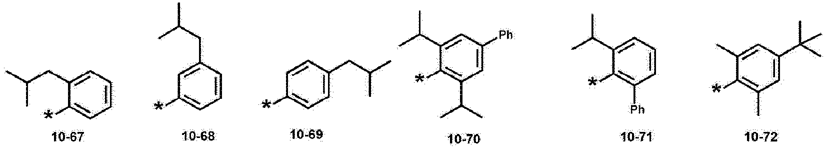 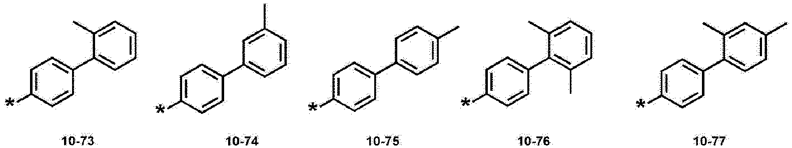 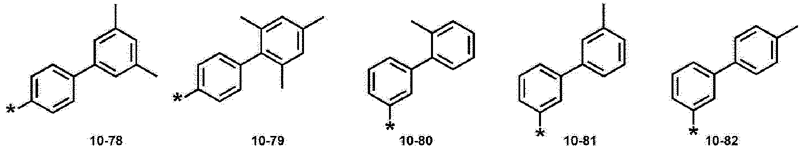 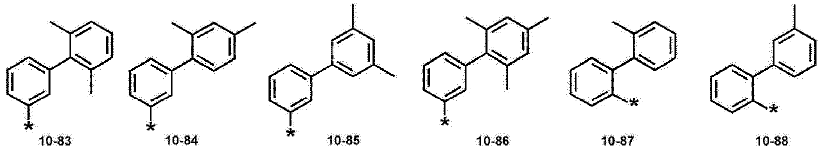 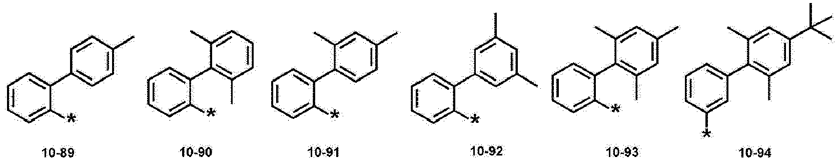 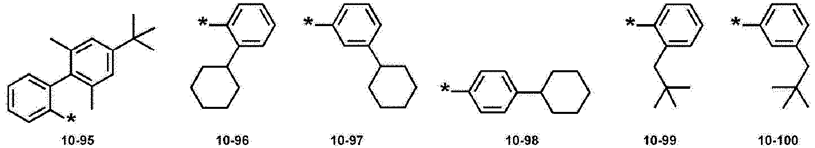 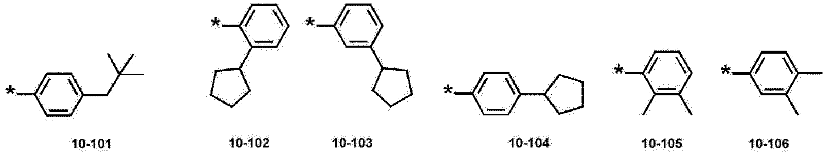 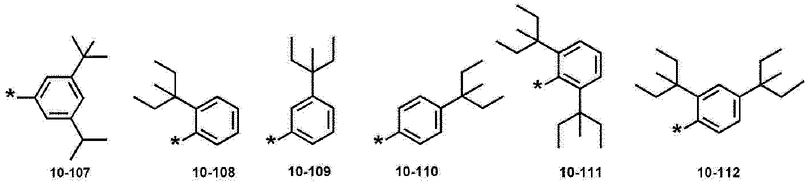 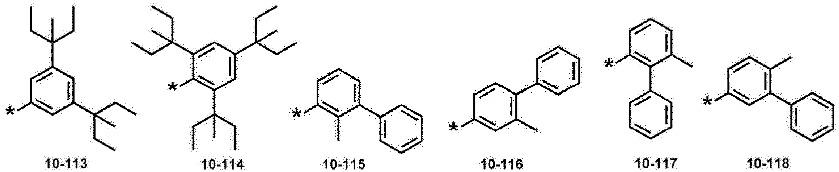 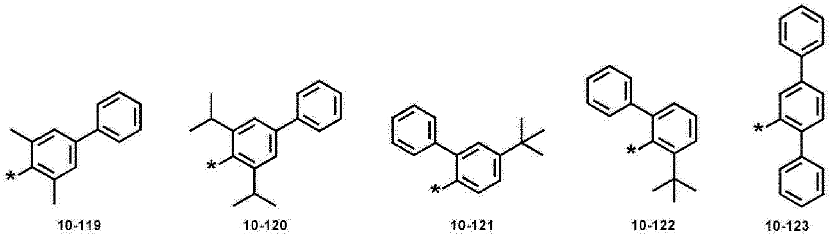 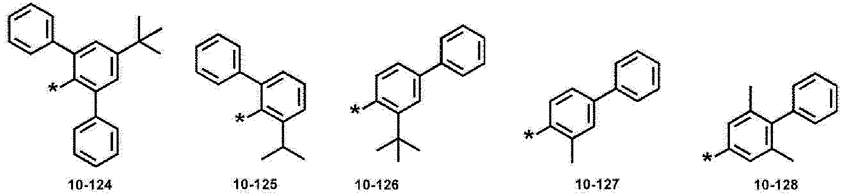 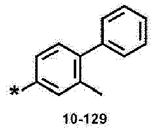 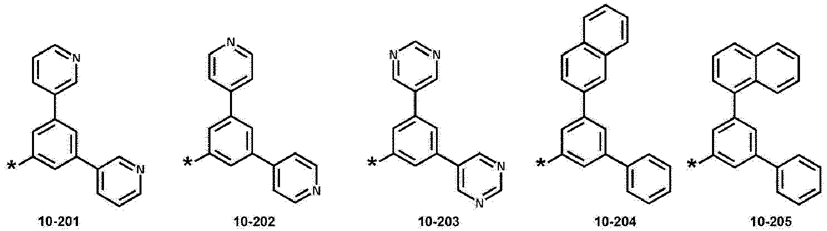 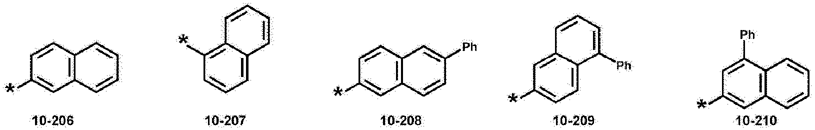 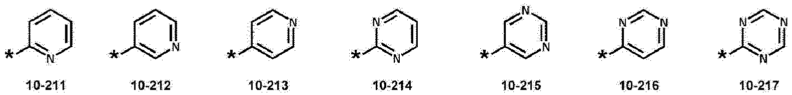 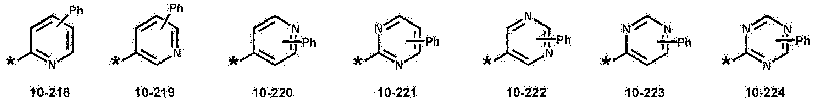 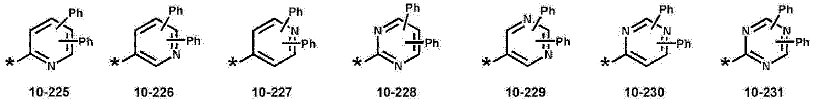 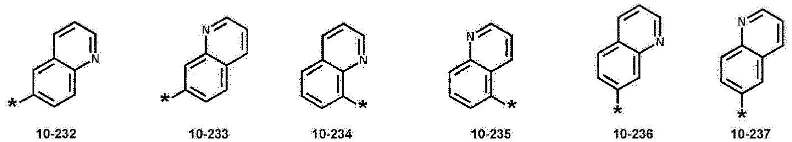 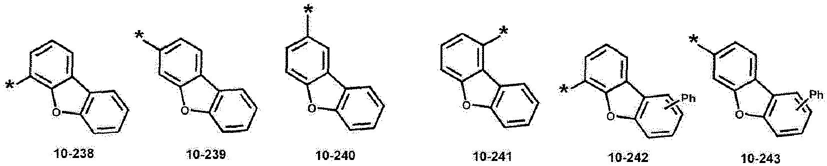 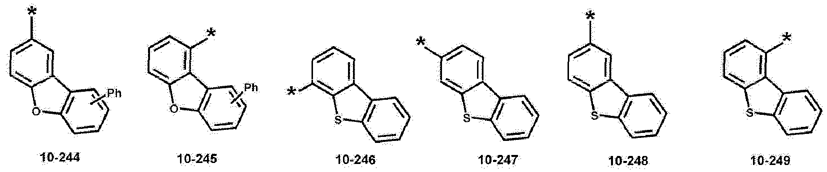 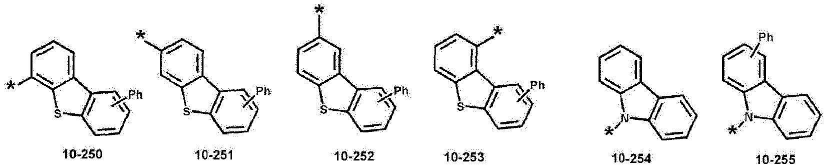 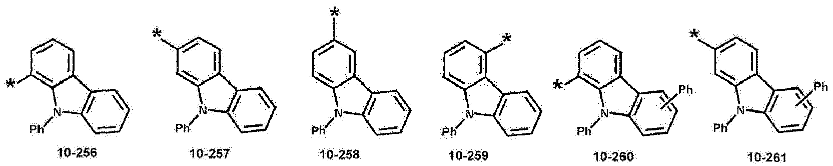 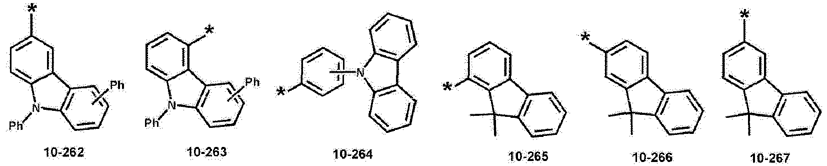 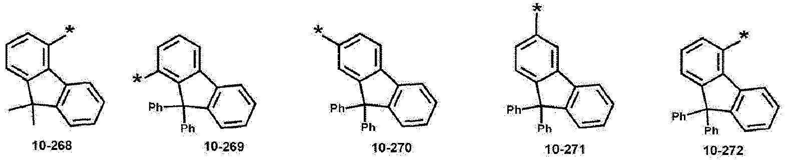 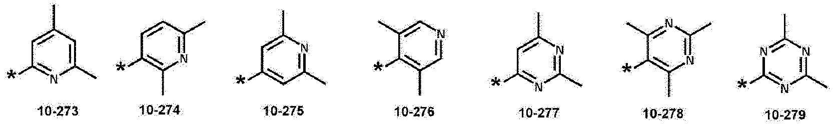 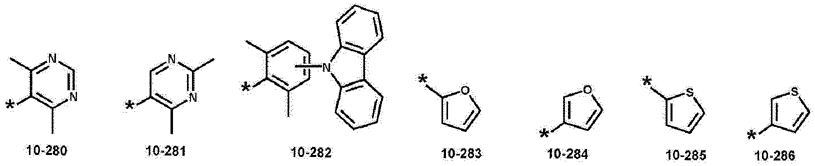 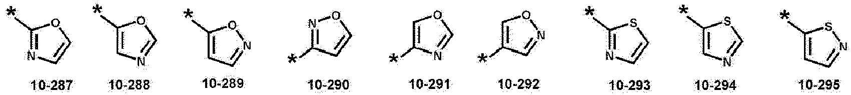 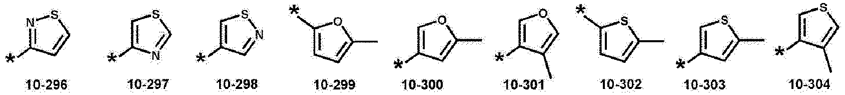 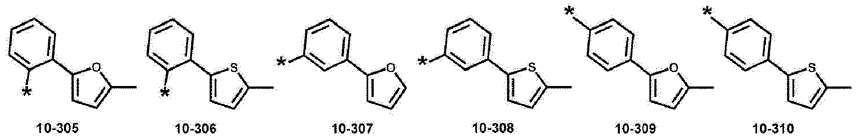 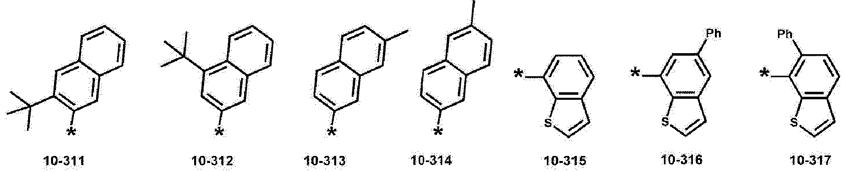 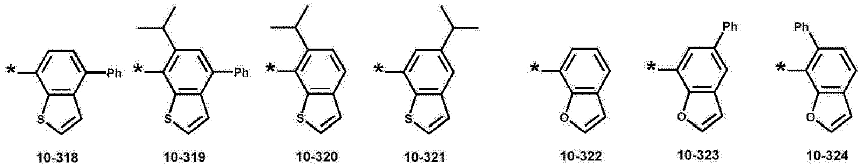 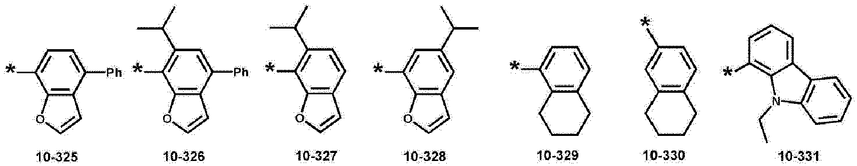 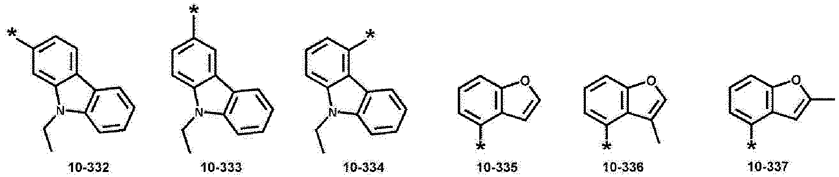 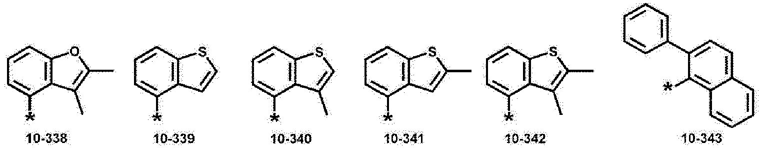 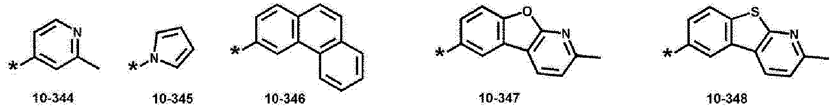 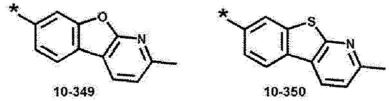 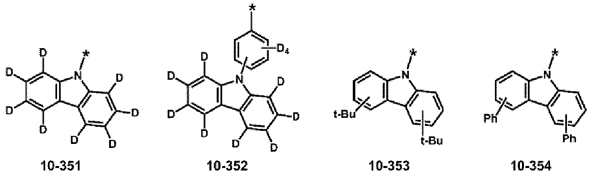 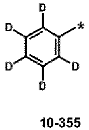
wobei in den Formeln 9-1 bis 9-61, 9-201 bis 9-237, 10-1 bis 10-129 und 10-201 bis 10-355 * eine Bindungsstelle zu einem benachbarten Atom angibt, "Ph" eine Phenylgruppe angibt, "TMS" eine Trimethylsilylgruppe angibt und "TMG" eine Trimethylgermylgruppe angibt.

6. Organometallische Verbindung nach einem der Ansprüche 1-5, wobei eine Gruppe dargestellt durch 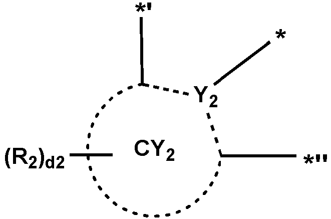 in Formel 1 eine Gruppe dargestellt durch eine der Formeln 2-1 bis 2-3 ist: 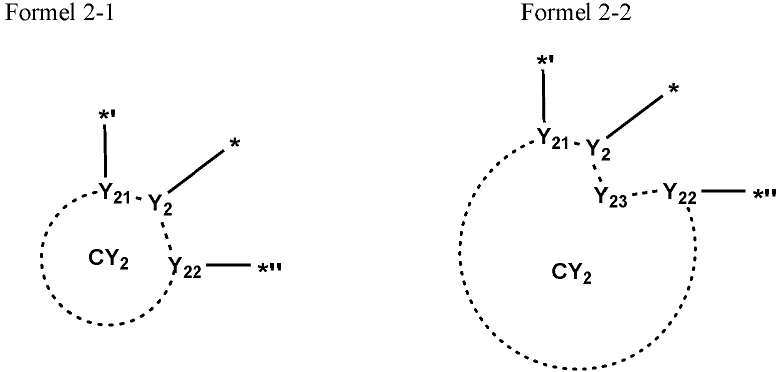 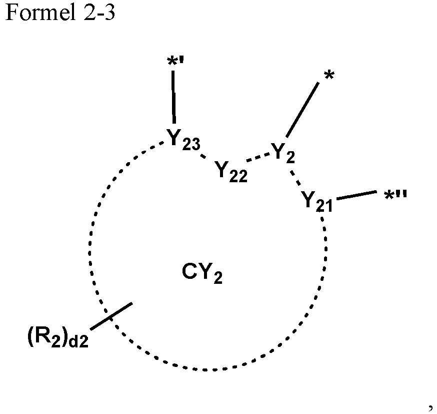 wobei in den Formeln 2-1 bis 2-3
Y₂₁ bis Y₂₃ jeweils unabhängig C oder N sind,
Y₂₁ und Y₂ über eine chemische Bindung miteinander verbunden sind, Y₂ und Y₂₂ über eine chemische Bindung miteinander verbunden sind, Y₂ und Y₂₃ über eine chemische Bindung miteinander verbunden sind und Y₂₂ und Y₂₃ über eine chemische Bindung miteinander verbunden sind,
*' eine Bindungsstelle zu T₁ angibt, *" eine Bindungsstelle zu T₂ angibt und * eine Bindungsstelle zu A₂ oder M angibt und
Ring CY₂, Y₂, R₂ und d2 jeweils wie für Ring CY₂, Y₂, R₂ und d2 in Anspruch 1 definiert sind; oder
wobei eine Gruppe dargestellt durch 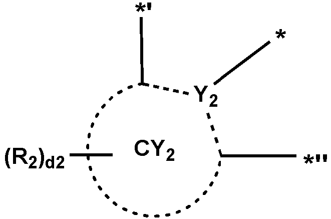
in Formel 1 eine Gruppe dargestellt durch eine der Formeln CY2-1 bis CY2-35 ist: 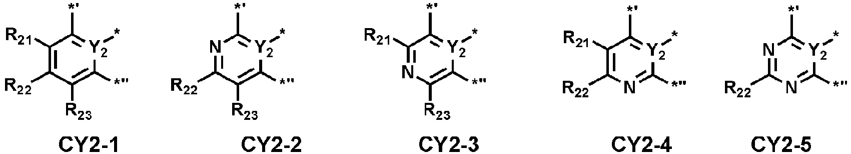 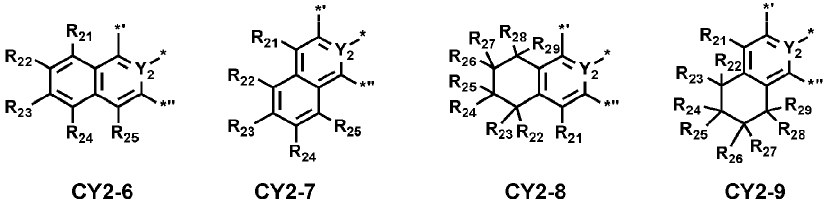 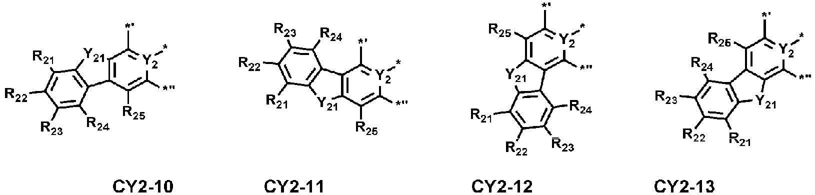 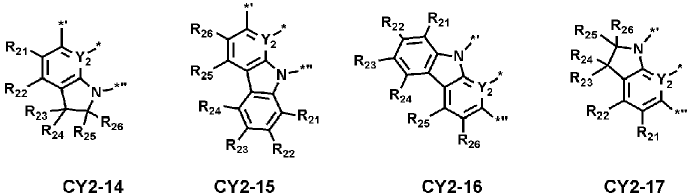 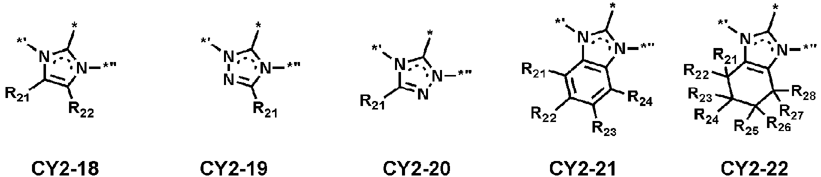 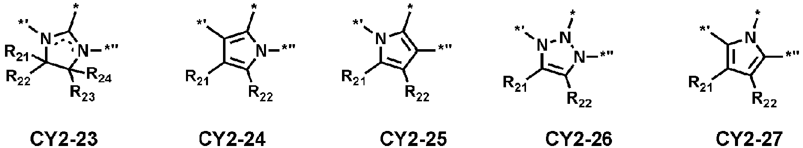 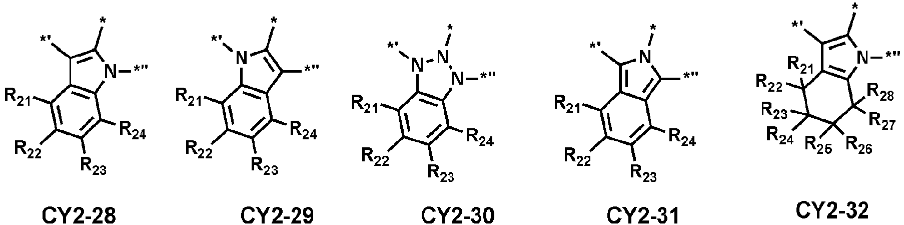 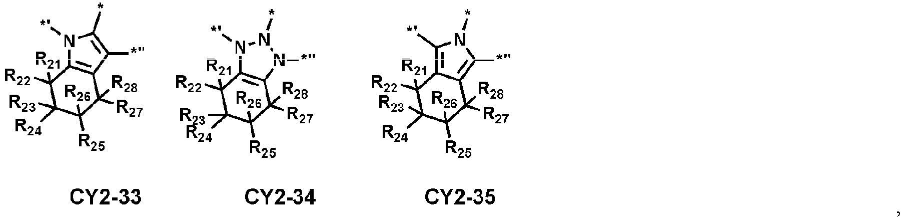
wobei in den Formeln CY2-1 bis CY2-35
Y₂ C oder N ist,
R₂₁ bis R₂₉ jeweils unabhängig wie für R₂ in Anspruch 1 beschrieben sind und
* eine Bindungsstelle zu M oder A₂ angibt, *' eine Bindungsstelle zu T₁ angibt und *" eine Bindungsstelle zu T₂ angibt.

7. Organometallische Verbindung nach einem der Ansprüche 1-6, wobei eine Gruppe dargestellt durch 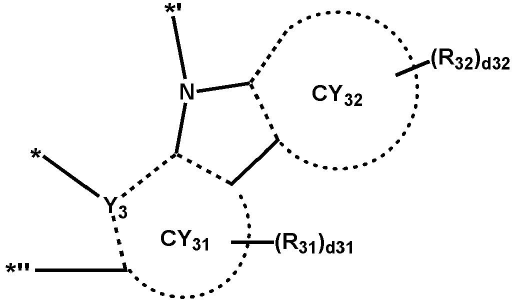 in Formel 1 eine Gruppe dargestellt durch eine der Formeln CY3-1 bis CY3-9 ist: 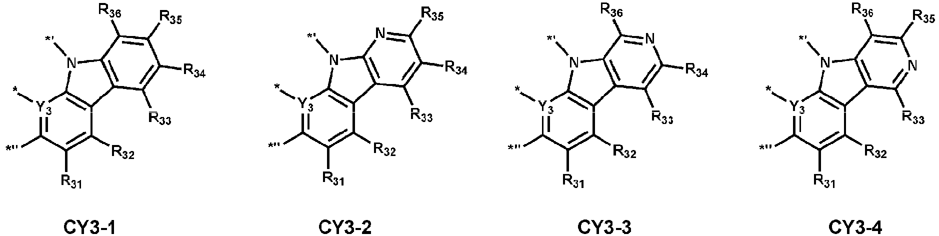 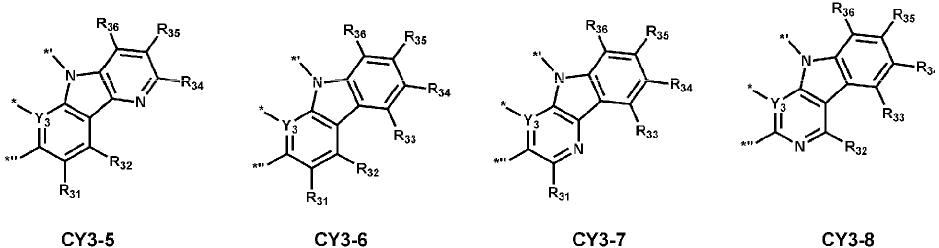 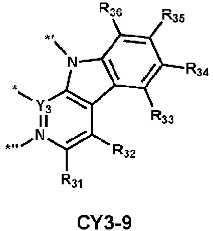 wobei in den Formeln CY3-1 bis CY3-9
Y₃ C oder N ist,
R₃₁ bis R₃₆ jeweils unabhängig wie für R₃₁ in Anspruch 1 beschrieben sind und
* eine Bindungsstelle zu M oder A₃ angibt, *' eine Bindungsstelle zu T₃ angibt und *" eine Bindungsstelle zu T₂ angibt; und/oder
wobei eine Gruppe dargestellt durch 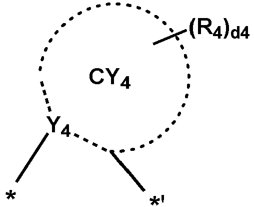
in Formel 1 eine Gruppe dargestellt durch eine der Formeln CY4-1 bis CY4-29 ist: 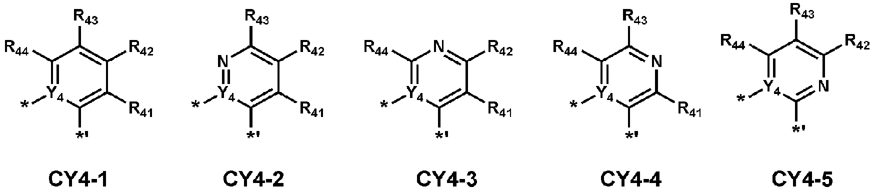 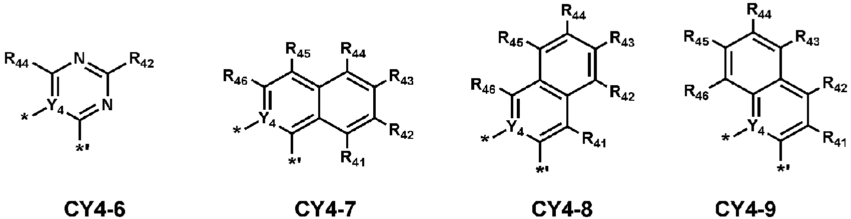 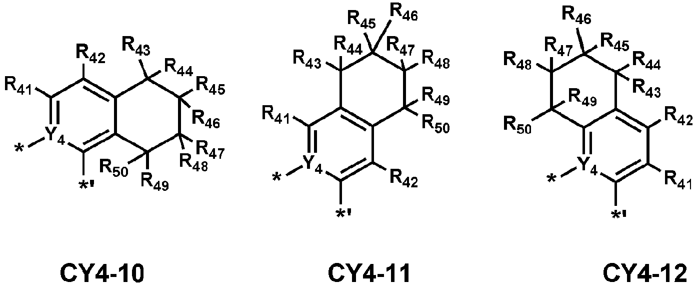 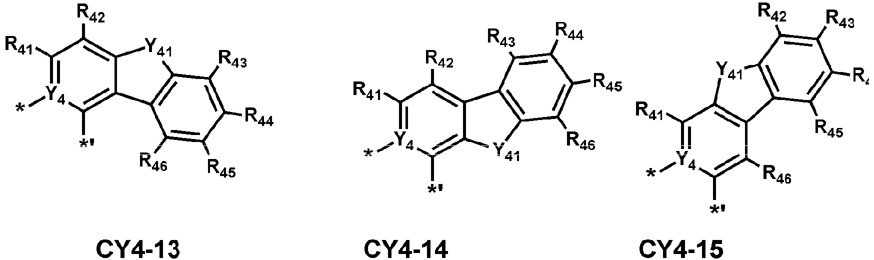 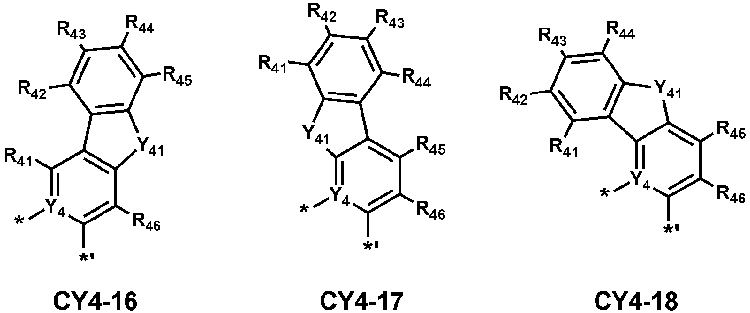 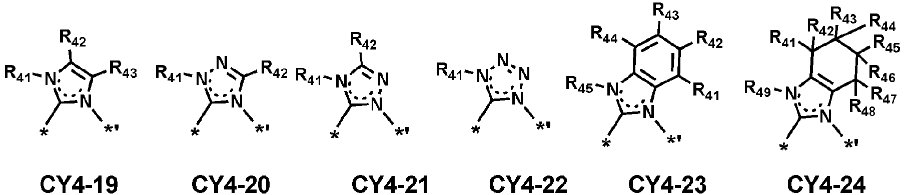 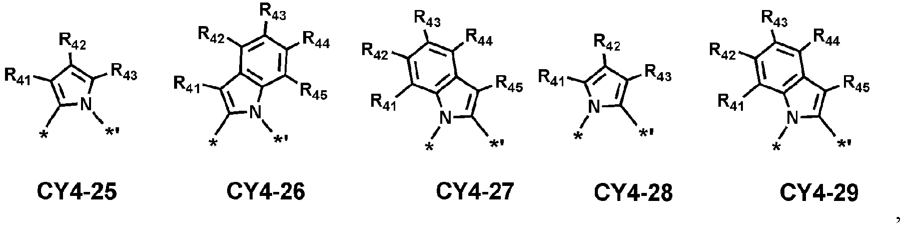
wobei in den Formeln CY4-1 bis CY4-29
Y₄ C oder N ist,
Y₄₁ N(R₄₁ₐ), O, Se, C(R₄₁ₐ)(R_{41b}) oder Si(R₄₁ₐ)(R_{41b}) ist und
R₄₁ bis R₅₀, R₄₁ₐ und R_{41b} jeweils unabhängig wie für R₄ in Anspruch 1 beschrieben sind,
* eine Bindungsstelle zu M oder A₄ angibt und
*' eine Bindungsstelle zu T₃ angibt.

8. Organometallische Verbindung nach einem der Ansprüche 1-7, wobei die organometallische Verbindung durch eine der Formeln 1-1 und 1-2 dargestellt ist: 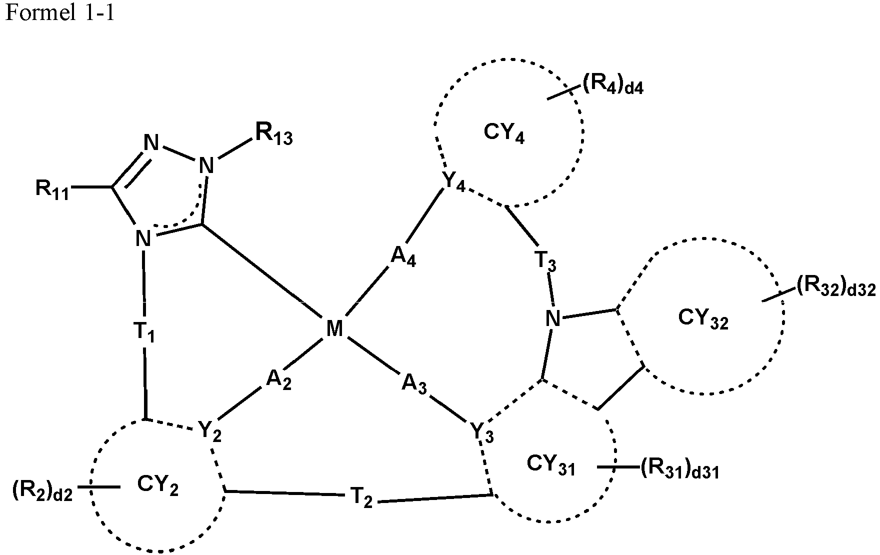 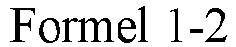 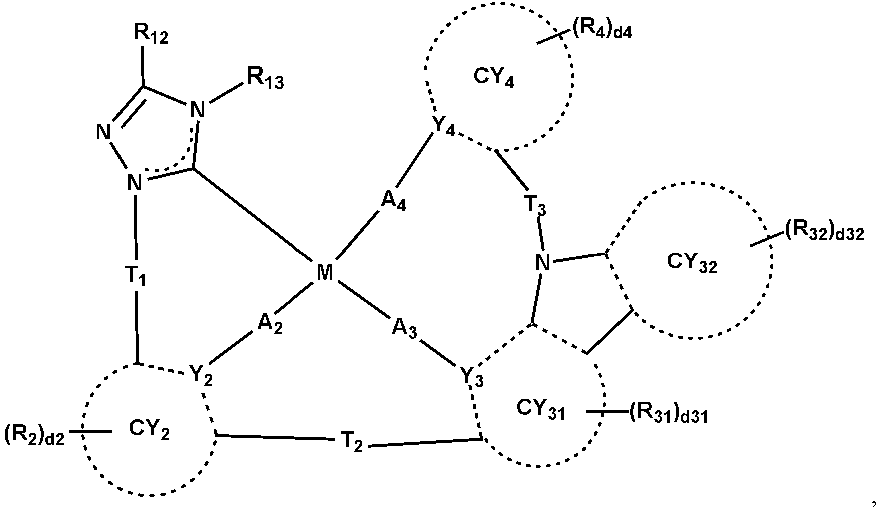 wobei in den Formeln 1-1 und 1-2
M, Ring CY₂, Ring CY₃₁, Ring CY₃₂, Ring CY₄, Y₂ bis Y₄, A₂ bis A₄, T₁ bis T₃, R₁₁ bis R₁₃, R₂, R₃₁, R₃₂, R₄, d2, d31, d32 und d4 jeweils wie für M, Ring CY₂, Ring CY₃₁, Ring CY₃₂, Ring CY₄, Y₂ bis Y₄, A₂ bis A₄, T₁ bis T₃, R₁₁ bis R₁₃, R₂, R₃₁, R₃₂, R₄, d2, d31, d32 und d4 in Anspruch 1 definiert sind.

9. Organometallische Verbindung nach einem der Ansprüche 1-8, wobei die organometallische Verbindung durch eine der Formeln 1-11 und 1-12 dargestellt ist: 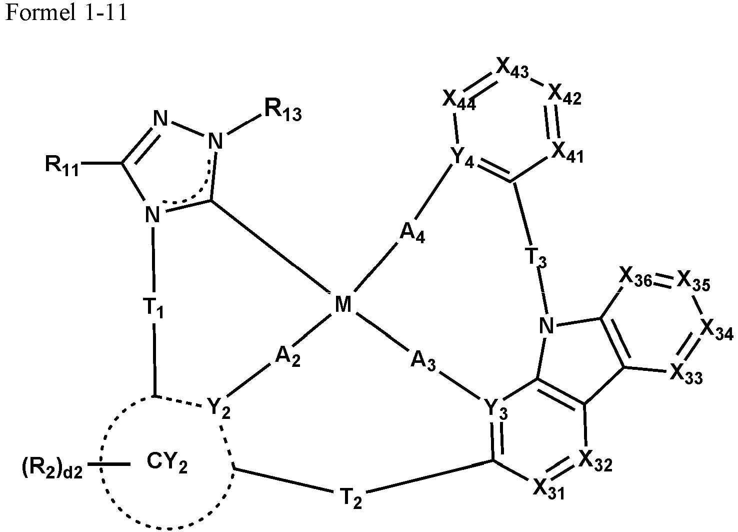 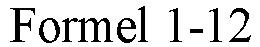 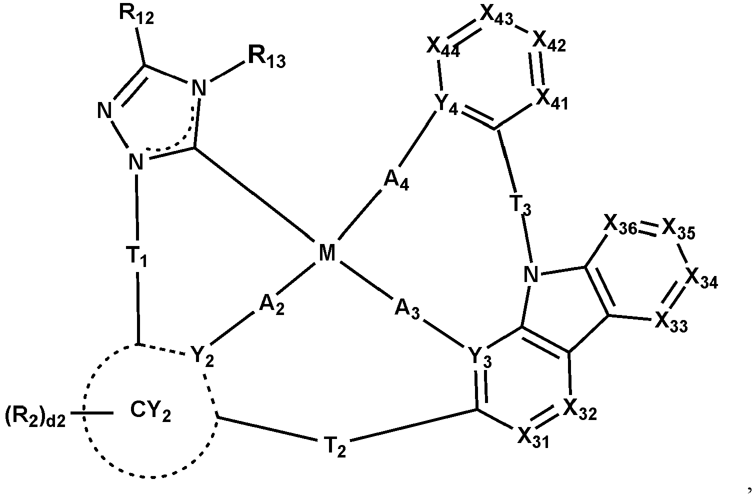 wobei in Formel 1-11 und 1-12
X₃₁ C(R₃₁) oder N ist, X₃₂ C(R₃₂) oder N ist, X₃₃ C(R₃₃) oder N ist, X₃₄ C(R₃₄) oder N ist, X₃₅ C(R₃₅) oder N ist und X₃₆ C(R₃₆) oder N ist,
X₄₁ C(R₄₁) oder N ist, X₄₂ C(R₄₂) oder N ist, X₄₃ C(R₄₃) oder N ist und X₄₄ C(R₄₄) oder N ist,
R₃₁ bis R₃₆ jeweils unabhängig wie für R₃₁ in Anspruch 1 beschrieben sind,
R₄₁ bis R₄₄ jeweils unabhängig wie für R₄ in Anspruch 1 beschrieben sind und
M, Ring CY₂, Y₂ bis Y₄, A₂ bis A₄, T₁ bis T₃, R₁₁ bis R₁₃, R₂ und d2 jeweils wie für M, Ring CY₂, Y₂ bis Y₄, A₂ bis A₄, T₁ bis T₃, R₁₁ bis R₁₃, R₂ und d2 in Anspruch 1 definiert sind.

10. Organometallische Verbindung nach einem der Ansprüche 1-9, wobei ein Energieniveau des höchsten besetzten Molekülorbitals (HOMO) der organometallischen Verbindung -5,25 Elektronenvolt oder weniger ist.

11. Organische lichtemittierende Vorrichtung, umfassend:
eine erste Elektrode;
eine zweite Elektrode; und
eine organische Schicht, die zwischen der ersten Elektrode und der zweiten Elektrode angeordnet ist,
wobei die organische Schicht eine Emissionsschicht umfasst und
wobei die organische Schicht ferner zumindest eine von der organometallischen Verbindung nach einem der Ansprüche 1 bis 10 umfasst.

12. Organische lichtemittierende Vorrichtung nach Anspruch 11, wobei die Emissionsschicht die zumindest eine der organometallische Verbindung umfasst;
wobei bevorzugt die Emissionsschicht Licht mit einer maximalen Emissionswellenlänge von 440 Nanometern bis 470 Nanometern emittiert.

13. Organische lichtemittierende Vorrichtung nach Anspruch 11 oder 12, wobei
die erste Elektrode eine Anode ist,
die zweite Elektrode eine Kathode ist,
die organische Schicht ferner eine Lochtransportregion, die zwischen der ersten Elektrode und der Emissionsschicht angeordnet ist, und eine Elektronentransportregion, die zwischen der Emissionsschicht und der zweiten Elektrode angeordnet ist, umfasst,
die Lochtransportregion eine Locheinspritzschicht, eine Lochtransportschicht, eine Elektronenblockierschicht, eine Pufferschicht oder eine Kombination davon umfasst und
die Elektronentransportregion eine Lochblockierschicht, eine Elektronentransportschicht, eine Elektroneneinspritzschicht oder eine Kombination davon umfasst.

14. Elektronische Einrichtung, umfassend die organische lichtemittierende Vorrichtung nach einem der Ansprüche 11-13.

## Revendications

1. Composé organométallique représenté par la Formule 1 : 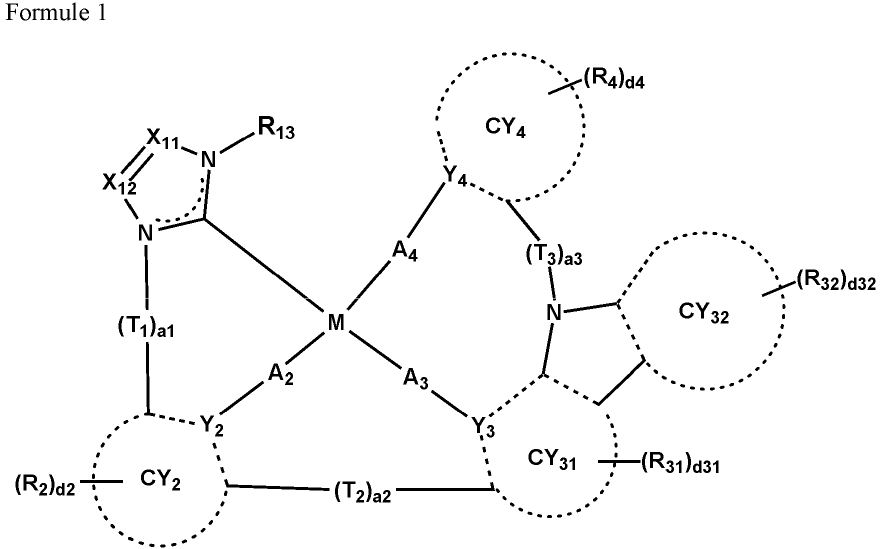 dans lequel, dans la Formule 1,
M est un métal de transition ;
X₁₁ est N et X₁₂ est C(R₁₂), ou X₁₁ est C(R₁₁) et X₁₂ est N ;
le cycle CY₂, le cycle CY₃₁, le cycle CY₃₂ et le cycle CY₄ sont chacun indépendamment un groupe carbocyclique en C₃ à C₆₀ ou un groupe hetérocyclique en C₁ à C₆₀,
Y₂ à Y₄ sont chacun indépendamment C ou N,
A₂ à A₄ sont chacun indépendamment une liaison chimique, O ou S,
T₁ est une liaison simple, une double liaison, *-N[(L₁)_{b1}-(R₁ₐ)]-*", *-B(R₁ₐ)-*', *-P(R₁ₐ)-*', *-C(R₁ₐ)(R_{1b})-*', *-Si(R₁ₐ)(R_{1b})-*', *-Ge(R₁ₐ)(R₁₀)-*', *-S-*', *-Se-*', *-O-*', *-C(=O)-*', *-S(=O)-*', *-S(=O)₂-*', *-C(R₁ₐ)=*', *=C(R₁ₐ)-*', *-C(R₁ₐ)=C(R_{1b})-*', *-C(=S)-*', ou *-C≡C-*',
T₂ est une simple liaison, une double liaison, *-N[(L₂)_{b2}-(R₂ₐ)]-*', *-B(R₂ₐ)-*', *-P(R₂ₐ)-*', *-C(R₂ₐ)(R_{2b})-*', *-Si(R₂ₐ)(R_{2b})-*', *-Ge(R₂ₐ)(R_{2b})-*', *-S-*', *-Se-*', *-O-*', *-C(=O)-*', *-S(=O)-*', *-S(=O)₂-*', *-C(R₂ₐ)=*', *=C(R₂ₐ)-*', *-C(R₂ₐ)=C(R_{2b})-*', *-C(=S)-*' ou *-C≡C-*',
T₃ est une simple liaison, une double liaison, *-N[(L₃)_{b3}-(R₃ₐ)]-*', *-B(R₃ₐ)-*', *-P(R₃ₐ)-*', *-C(R₃ₐ)(R_{3b})-*', *-Si(R₃ₐ)(R_{3b})-*', *-Ge(R₃ₐ)(R_{3b})-*', *-S-*', *-Se-*', *-O-*', *-C(=O)-*', *-S(=O)-*', *-S(=O)₂-*', *-C(R₃ₐ)=*', *=C(R₃ₐ)-*', *-C(R₃ₐ)=C(R_{3b})-*', *-C(=S)-*' ou *-C≡C-*',
a1 à a3 sont chacun indépendamment un nombre entier de 1 à 3,
* et *' indiquent chacun un site de liaison à un atome voisin,
L₁ à L₃ sont chacun indépendamment une liaison simple, un groupe carbocyclique en C₅ à C₃₀ non substitué ou substitué par au moins un R₁₀ₐ, ou un groupe hétérocyclique en C₁ à C₃₀ non substitué ou substitué par au moins un R₁₀ₐ,
b1 à b3 sont chacun indépendamment un nombre entier de 1 à 3,
R₁ₐ, R_{1b}, R₂, R₂ₐ, R_{2b}, R₃ₐ, R_{3b}, R₄, R₁₀ₐ, R₁₁ à R₁₃, R₃₁, et R₃₂ sont chacun indépendamment un hydrogène, un deutérium, -F, -Cl, -Br, -I, -SF₅, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle en C₁ à C₆₀ substitué ou non substitué, un groupe alcényle en C₂ à C₆₀ substitué ou non substitué, un groupe alcynyle en C₂ à C₆₀ substitué ou non substitué, un groupe alcoxy en C₁ à C₆₀ substitué ou non substitué, un groupe alkylthio en C₁ à C₆₀ substitué ou non substitué, un groupe cycloalkyle en C₃ à C₁₀ substitué ou non substitué, un groupe hétérocycloalkyle en C₁ à C₁₀ substitué ou non substitué, un groupe cycloalcényle en C₃ à C₁₀ substitué ou non substitué, un groupe hétérocycloalcényle en C₂ à C₁₀ substitué ou non substitué, un groupe aryle en C₆ à C₆₀ substitué ou non substitué, un groupe alkylaryle en C₇ à C₆₀ substitué ou non substitué, un groupe arylalkyl en C₇ à C₆₀ substitué ou non substitué, un groupe aryloxy en C₆ à C₆₀ substitué ou non substitué, un groupe arylthio en C₆ à C₆₀ substitué ou non substitué, un groupe hétéroaryle en C₁ à C₆₀ substitué ou non substitué, un groupe alkylhétéroaryle en C₂ à C₆₀, un groupe hétéroarylalkyle en C₂ à C₆₀, un groupe hétéroaryloxy en C₁ à C₆₀ substitué ou non substitué, un groupe hétéroarylthio en C₁ à C₆₀ substitué ou non substitué, un groupe polycyclique condensé non-aromatique monovalent substitué ou non substitué, un groupe hétéropolycyclique condensé non-aromatique monovalent substitué ou non substitué, - Si(Q₁)(Q₂)(Q₃), -Ge(Q₁)(Q₂)(Q₃), -N(Q₄)(Q₅), -B(Q₆)(Q₇), -P(Q₈)(Q₉), ou -P(=O)(Q₈)(Q₉),
d2, d31, d32, et d4 sont chacun indépendamment un nombre entier de 0 à 10,
au moins un substituant du groupe carbocyclique en C₅ à C₃₀ substitué, du groupe hétérocyclique en C₁ à C₃₀ substitué, du groupe alkyle en C₁ à C₆₀ substitué, du groupe alcényle en C₂ à C₆₀ substitué, du groupe alcynyle en C₂ à C₆₀ substitué, du groupe alcoxy en C₁ à C₆₀ substitué, du groupe alkylthio en C₁ à C₆₀ substitué, du groupe cycloalkyle en C₃ à C₁₀ substitué, du groupe hétérocycloalkyle en C₁ à C₁₀ substitué, du groupe cycloalcényle en C₃ à C₁₀ substitué, du groupe hétérocycloalcényle en C₁ à C₁₀ substitué, du groupe aryle en C₆ à C₆₀ substitué, du groupe alkylaryle en C₇ à C₆₀ substitué, du groupe arylalkyle en C₇ à C₆₀ substitué, du groupe aryloxy en C₆ à C₆₀ substitué, du groupe arylthio en C₆ à C₆₀ substitué, du groupe hétéroaryle en C₁ à C₆₀ substitué, du groupe alkylhétéroaryle en C₂ à C₆₀ substitué, du groupe hétéroarylalkyle en C₂ à C₆₀ substitué, du groupe hétéroaryloxy en C₁ à C₆₀ substitué, du groupe hétéroarylthio en C₁ à C₆₀ substitué, du groupe polycyclique condensé non aromatique monovalent substitué et du groupe hétéropolycyclique condensé non aromatique monovalent substitué est :
un deutérium, -F, -Cl, -Br, -I, -SF₅, -CD₃, -CD₂H, -CDH₂, -CF₃, -CF₂H, -CFH₂, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle en C₁ à C₆₀, un groupe alcényle en C₂ à C₆₀, un groupe alcynyle en C₂ à C₆₀, un groupe alcoxy en C₁ à C₆₀ ou un groupe alkylthio en C₁ à C₆₀ ;
un groupe alkyle en C₁ à C₆₀, un groupe alcényle en C₂ à C₆₀, un groupe alcynyle en C₂ à C₆₀, un groupe alcoxy en C₁ à C₆₀, ou un groupe alkylthio en C₁ à C₆₀, chacun étant substitué par au moins l'un parmi un deutérium, -F, -Cl, -Br, -I, -SF₅, -CD₃, -CD₂H, -CDH₂, -CF₃, -CF₂H, - CFH₂, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe cycloalkyle en C₃ à C₁₀, un groupe hétérocycloalkyle en C₁ à C₁₀, un groupe cycloalcényle en C₃ à C₁₀, un groupe hétérocycloalcényle en C₁ à C₁₀, un groupe aryle en C₆ à C₆₀, un groupe alkylaryle en C₇ à C₆₀, un groupe aryloxy en C₆ à C₆₀, un groupe arylthio en C₆ à C₆₀, un groupe hétéroaryle en C₁ à C₆₀, un groupe alkylhétéroaryle en C₂ à C₆₀, un groupe hétéroaryloxy en C₁ à C₆₀, un groupe hétéroarylthio en C₁ à C₆₀, un groupe polycyclique condensé non aromatique monovalent, un groupe hétéropolycyclique condensé non aromatique monovalent, - Si(Q₁₁)(Q₁₂)(Q₁₃), -Ge(Q₁₁)(Q₁₂)(Q₁₃), -N(Q₁₄)(Q₁₅), -B(Q₁₆)(Q₁₇), -P(Q₁₈)(Q₁₉), - P(=O)(Q₁₈)(Q₁₉) ou une combinaison de ceux-ci ;
un groupe cycloalkyle en C₃ à C₁₀, un groupe hétérocycloalkyle en C₁ à C₁₀, un groupe cycloalcényle en C₃ à C₁₀, un groupe hétérocycloalcényle en C₁ à C₁₀, un groupe aryle en C₆ à C₆₀, un groupe alkylaryle en C₇ à C₆₀, un groupe aryloxy en C₆ à C₆₀, un groupe arylthio en C₆ à C₆₀, un groupe hétéroaryle en C₁ à C₆₀, un groupe alkylhétéroaryle en C₂ à C₆₀, un groupe hétéroaryloxy en C₁ à C₆₀, un groupe hétéroarylthio en C₁ à C₆₀, un groupe polycyclique condensé non aromatique monovalent ou un groupe hétéropolycyclique condensé non aromatique monovalent ;
un groupe cycloalkyle en C₃ à C₁₀, un groupe hétérocycloalkyle en C₁ à C₁₀, un groupe cycloalcényle en C₃ à C₁₀, un groupe hétérocycloalcényle en C₁ à C₁₀, un groupe aryle en C₆ à C₆₀, un groupe alkylaryle en C₇ à C₆₀, un groupe aryloxy en C₆ à C₆₀, un groupe arylthio en C₆ à C₆₀, un groupe hétéroaryle en C₁ à C₆₀, un groupe alkylhétéroaryle en C₂ à C₆₀, un groupe hétéroaryloxy en C₁ à C₆₀, un groupe hétéroarylthio en C₁ à C₆₀, un groupe polycyclique condensé non aromatique monovalent, ou un groupe hétéropolycyclique condensé non aromatique monovalent, chacun étant substitué par au moins l'un parmi un deutérium, -F, -Cl, -Br, -I, -SF₅, -CD₃, -CD₂H, -CDH₂, -CF₃, -CF₂H, -CFH₂, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle en C₁ à C₆₀, un groupe alcényle en C₂ à C₆₀, un groupe alcynyle en C₂ à C₆₀, un groupe alcoxy en C₁ à C₆₀, un groupe alkylthio en C₁ à C₆₀, un groupe cycloalkyle en C₃ à C₁₀, un groupe hétérocycloalkyle en C₁ à C₁₀, un groupe cycloalcényle en C₃ à C₁₀, un groupe hétérocycloalcényle en C₁ à C₁₀, un groupe aryle en C₆ à C₆₀, un groupe alkylaryle en C₇ à C₆₀, un groupe arylalkyle en C₇ à C₆₀, un groupe aryloxy en C₆ à C₆₀, un groupe arylthio en C₆ à C₆₀, un groupe hétéroaryle en C₁ à C₆₀, un groupe alkylhétéroaryle en C₂ à C₆₀, un groupe hétéroarylalkyle en C₂ à C₆₀, un groupe hétéroaryloxy en C₁ à C₆₀, un groupe hétéroarylthio en C₁ à C₆₀, un groupe polycyclique condensé non aromatique monovalent, un groupe hétéropolycyclique condensé non aromatique monovalent, -Si(Q₂₁)(Q₂₂)(Q₂₃), - Ge(Q₂₁)(Q₂₂)(Q₂₃), -N(Q₂₄)(Q₂₅), -B(Q₂₆)(Q₂₇), -P(Q₂₈)(Q₂₉), -P(=O)(Q₂₈)(Q₂₉) ou une combinaison de ceux-ci ; ou
-Si(Q₃₁)(Q₃₂)(Q₃₃), -Ge(Q₃₁)(Q₃₂)(Q₃₃), -N(Q₃₄)(Q₃₅), -B(Q₃₆)(Q₃₇), -P(Q₃₈)(Q₃₉) ou - P(=O)(Q₃₈)(Q₃₉), et
Q₁ à Q₉, Q₁₁ à Q₁₉, Q₂₁ à Q₂₉, et Q₃₁ à Q₃₉ sont chacun indépendamment un hydrogène, un deutérium, -F, -Cl, -Br, -I, -SF₅, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle en C₁ à C₆₀ substitué ou non substitué, un groupe alcényle en C₂ à C₆₀ substitué ou non substitué, un groupe alcynyle en C₂ à C₆₀ substitué ou non substitué, un groupe alcoxy en C₁ à C₆₀ substitué ou non substitué, un groupe alkylthio en C₁ à C₆₀ substitué ou non substitué, un groupe cycloalkyle en C₃ à C₁₀ substitué ou non substitué, un groupe hétérocycloalkyle en C₁ à C₁₀ substitué ou non substitué, un groupe cycloalcényle en C₃ à C₁₀ substitué ou non substitué, un groupe hétérocycloalcényle en C₁ à C₁₀ substitué ou non substitué, un groupe aryle en C₆ à C₆₀ substitué ou non substitué, un groupe alkylaryle en C₇ à C₆₀ substitué ou non substitué, un groupe arylalkyle en C₇ à C₆₀ substitué ou non substitué, un groupe aryloxy en C₆ à C₆₀ substitué ou non substitué, un groupe arylthio en C₆ à C₆₀ substitué ou non substitué, un groupe hétéroaryle en C₁ à C₆₀ substitué ou non substitué, un groupe alkylhétéroaryle en C₂ à C₆₀ substitué ou non substitué, un groupe hétéroarylalkyle en C₂ à C₆₀ substitué ou non substitué, un groupe hétéroaryloxy en C₁ à C₆₀ substitué ou non substitué, un groupe hétéroarylthio en C₁ à C₆₀ substitué ou non substitué, un groupe polycyclique condensé non aromatique monovalent substitué ou non substitué ou un groupe hétéropolycyclique condensé non aromatique monovalent substitué ou non substitué.

2. Composé organométallique de la revendication 1, dans lequel M est l'iridium (Ir), le platine (Pt), l'osmium (Os), le titane (Ti), le zirconium (Zr), le hafnium (Hf), l'europium (Eu), le terbium (Tb), le thulium (Tm), le rhodium (Rh), le palladium (Pd) ou l'or (Au).

3. Composé organométallique de l'une des revendications 1 ou 2, dans lequel le cycle CY₂, le cycle CY₃₁, le cycle CY₃₂ et le cycle CY₄ sont chacun indépendamment un groupe benzène, un groupe naphtalène, un groupe anthracène, un groupe phénanthrène, un groupe triphénylène, un groupe pyrène, un groupe chrysène, un groupe cyclopentadiène, un groupe 1,2,3,4-tétrahydronaphtalène, un groupe thiophène, un groupe furane, un groupe indole, un groupe benzoborole, un groupe benzophosphole, un groupe indène, un groupe benzosilole, un groupe benzogermole, un groupe benzothiophène, un groupe benzosélénophène, un groupe benzofurane, un groupe carbazole, un groupe dibenzoborole, un groupe dibenzophosphole, un groupe fluorène, un groupe dibenzosilole, un groupe dibenzogermole, un groupe dibenzothiophène, un groupe dibenzosélénophène, un groupe dibenzofurane, un groupe dibenzothiophène 5-oxyde, un groupe 9H-fluorène-9-one, un groupe dibenzothiophène 5,5-dioxyde, un groupe azaindole, un groupe azabenzoborole, un groupe azabenzophosphole, un groupe azaindène, un groupe azabenzosilole, un groupe azabenzogermole, un groupe azabenzothiophène, un groupe azabenzosélénophène, un groupe azabenzofurane, un groupe azacarbazole, un groupe azadibenzoborole, un groupe azadibenzophosphole, un groupe azafluorène, un groupe azadibenzosilole, un groupe azadibenzogermole, un groupe azadibenzothiophène, un groupe azadibenzosélénophène, un groupe azadibenzofurane, un groupe azadibenzothiophène 5-oxyde, un groupe aza-9H-fluorène-9-one, un groupe azadibenzothiophène 5,5-dioxyde, un groupe pyridine, un groupe pyrimidine, un groupe pyrazine, un groupe pyridazine, un groupe triazine, un groupe quinoléine, un groupe isoquinoléine, un groupe quinoxaline, un groupe quinazoline, un groupe phénanthroline, un groupe pyrrole, un groupe pyrazole, un groupe imidazole, un groupe triazole, un groupe oxazole, un groupe isoxazole, un groupe thiazole, un groupe isothiazole, un groupe oxadiazole, un groupe thiadiazole, un groupe benzopyrazole, un groupe benzimidazole, un groupe benzotriazole, un groupe benzoxazole, un groupe benzothiazole, un groupe benzoxadiazole, un groupe benzothiadiazole, un groupe 5,6,7,8-tétrahydroisoquinoléine ou un groupe 5,6,7,8-tétrahydroquinoléine ; et/ou
dans lequel au moins l'un de Y₂ à Y₄ est N.

4. Composé organométallique de l'une quelconque des revendications 1 à 3, dans lequel R₁ₐ, R_{1b}, R₂, R₂ₐ, R_{2b}, R₃ₐ, R_{3b}, R₄, R₁₀ₐ, R₁₁ à R₁₃, R₃₁ et R₃₂ sont chacun indépendamment :
un hydrogène, un deutérium, -F, -Cl, -Br, -I, -SF₅, -CD₃, -CD₂H, -CDH₂, -CF₃, -CF₂H, - CFH₂ un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle en C₁ à C₂₀, un groupe alcoxy en C₁ à C₂₀ ou un groupe alkylthio en C₁ à C₂₀ ;
un groupe alkyle en C₁ à C₂₀ et un groupe alcoxy en C₁ à C₂₀ ou un groupe alkylthio en C₁ à C₆₀, chacun étant substitué par au moins l'un parmi un deutérium, -F, -Cl, -Br, -I, -SF₅, -CD₃, - CD₂H, -CDH₂, -CF₃, -CF₂H, -CFH₂, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle en C₁ à C₁₀, un groupe cyclopentyle, un groupe cyclohexyle, un groupe cycloheptyle, un groupe cyclooctyle, un groupe adamantanyle, un groupe norbornanyle, un groupe norbornényle, un groupe cyclopentényle, un groupe cyclohexényle, un groupe cycloheptényle, un groupe phényle, un groupe naphtyle, un groupe pyridinyle, un groupe pyrimidinyle, ou une combinaison de ceux-ci ;
un groupe cyclopentyle, un groupe cyclohexyle, un groupe cycloheptyle, un groupe cyclooctyle, un groupe adamantanyle, un groupe norbornanyle, un groupe norbornényle, un groupe cyclopentényle, un groupe cyclohexényle, un groupe cycloheptényle, un groupe phényle, un groupe naphtyle, un groupe fluorényle, un groupe phénanthrényle, un groupe anthracényle, un groupe fluoranthényle, un groupe triphénylényle, un groupe pyrényle, un groupe chrysényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe isoindolyle, un groupe indolyle, un groupe indazolyle, un groupe purinyle, un groupe quinolinyle, un groupe isoquinolinyle, un groupe benzoquinolinyle, un groupe quinoxalinyle, un groupe quinazolinyle, un groupe cinnolinyle, un groupe carbazolyle, un groupe phénanthrolinyle, un groupe benzimidazolyle, un groupe benzofuranyle, un groupe benzothiophényle, un groupe isobenzothiazolyle, un groupe benzoxazolyle, un groupe isobenzoxazolyle, un groupe triazolyle, un groupe tétrazolyle, un groupe oxadiazolyle, un groupe triazinyle, un groupe dibenzofuranyle, un groupe dibenzothiophényle, un groupe benzocarbazolyle, un groupe dibenzocarbazolyle, un groupe imidazopyridinyle ou un groupe imidazopyrimidinyle ;
un groupe cyclopentyle, un groupe cyclohexyle, un groupe cycloheptyle, un groupe cyclooctyle, un groupe adamantanyle, un groupe norbornanyle, un groupe norbornényle, un groupe cyclopentényle, un groupe cyclohexényle, un groupe cycloheptényle, un groupe phényle, un groupe naphtyle, un groupe fluorényle, un groupe phénanthrényle, un groupe anthracényle, un groupe fluoranthényle, un groupe triphénylényle, un groupe pyrényle, un groupe chrysényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe isoindolyle, un groupe indolyle, un groupe indazolyle, un groupe purinyle, un groupe quinolinyle, un groupe isoquinolinyle, un groupe benzoquinolinyle, un groupe quinoxalinyle, un groupe quinazolinyle, un groupe cinnolinyle, un groupe carbazolyle, un groupe phénanthrolinyle, un groupe benzimidazolyle, un groupe benzofuranyle, un groupe benzothiophényle, un groupe benzoisothiazolyle, un groupe benzoxazolyle, un groupe isobenzoxazolyle, un groupe triazolyle, un groupe tétrazolyle, un groupe oxadiazolyle, un groupe triazinyle, un groupe dibenzofuranyle, un groupe dibenzothiophényle, un groupe benzocarbazolyle, un groupe dibenzocarbazolyle, un groupe imidazopyridinyle ou un groupe imidazopyrimidinyle, chacun étant substitué par au moins l'un parmi un deutérium, -F, -Cl, -Br, - I, -SF₅, -CD₃, -CD₂H, -CDH₂, -CF₃, -CF₂H, -CFH₂, un groupe hydroxyle, un groupe cyano, un groupe nitro, un groupe amino, un groupe amidino, un groupe hydrazine, un groupe hydrazone, un groupe acide carboxylique ou un sel de celui-ci, un groupe acide sulfonique ou un sel de celui-ci, un groupe acide phosphorique ou un sel de celui-ci, un groupe alkyle en C₁ à C₂₀, un groupe alcoxy en C₁ à C₂₀, un groupe alkylthio en C₁ à C₂₀, un groupe cyclopentyle, un groupe cyclohexyle, un groupe cycloheptyle, un groupe cyclooctyle, un groupe adamantanyle, un groupe norbornanyle, un groupe norbornényle, un groupe cyclopentényle, un groupe cyclohexényle, un groupe cycloheptényle, un groupe phényle, un groupe naphtyle, un groupe fluorényle, un groupe phénanthrényle, un groupe anthracényle, un groupe fluoranthényle, un groupe triphénylényle, un groupe pyrényle, un groupe chrysényle, un groupe pyrrolyle, un groupe thiophényle, un groupe furanyle, un groupe imidazolyle, un groupe pyrazolyle, un groupe thiazolyle, un groupe isothiazolyle, un groupe oxazolyle, un groupe isoxazolyle, un groupe pyridinyle, un groupe pyrazinyle, un groupe pyrimidinyle, un groupe pyridazinyle, un groupe isoindolyle, un groupe indolyle, un groupe indazolyle, un groupe purinyle, un groupe quinolinyle, un groupe isoquinolinyle, un groupe benzoquinolinyle, un groupe quinoxalinyle, un groupe quinazolinyle, un groupe cinnolinyle, un groupe carbazolyle, un groupe phénanthrolinyle, un groupe benzimidazolyle, un groupe benzofuranyle, un groupe benzothiophényle, un groupe benzoisothiazolyle, un groupe benzoxazolyle, un groupe isobenzoxazolyle, un groupe triazolyle, un groupe tétrazolyle, un groupe oxadiazolyle, un groupe triazinyle, un groupe dibenzofuranyle, un groupe dibenzothiophényle, un groupe benzocarbazolyle, un groupe dibenzocarbazolyle, un groupe imidazopyridinyle, un groupe imidazopyrimidinyle, -Si(Q₃₁)(Q₃₂)(Q₃₃), ou une combinaison de ceux-ci : ou
-Si(Q₁)(Q₂(Q₃), -Ge(Q₁)(Q₂)(Q₃), -N(Q₄)(Q₅), -B(Q₆)(Q₇), -P(Q₈)(Q₉), ou - P(=O)(Q₈)(Q₉), et
Q₁ à Q₉ et Q₃₁ à Q₃₃ sont chacun indépendamment :
-CH₃, -CD₃, -CD₂H, -CDH₂, -CH₂CH₃, -CH₂CD₃, -CH₂CD₂H, -CH₂CDH₂, -CHDCH₃, - CHDCD₂H, -CHDCDH₂, -CHDCD₃, -CD₂CD₃, -CD₂CD₂H ou -CD₂CDH₂ ;
un groupe n-propyle, un groupe isopropyle, un groupe n-butyle, un groupe isobutyle, un groupe sec-butyle, un groupe tert-butyle, un groupe n-pentyle, un groupe isopentyle, un groupe sec-pentyle, un groupe tert-pentyle, un groupe phényle ou un groupe naphtyle ; ou
un groupe n-propyle, un groupe isopropyle, un groupe n-butyle, un groupe isobutyle, un groupe sec-butyle, un groupe tert-butyle, un groupe n-pentyle, un groupe isopentyle, un groupe sec-pentyle, un groupe tert-pentyle, un groupe phényle ou un groupe naphtyle, chacun étant substitué par au moins l'un parmi un deutérium, un groupe alkyle en C₁ à C₁₀, un groupe phényle, ou une combinaison de ceux-ci.

5. Composé organométallique de l'une quelconque des revendications 1 à 4, dans lequel R₁ₐ, R_{1b}, R₂, R₂ₐ, R_{2b}, R₃ₐ, R_{3b}, R₄, R₁₀ₐ, R₁₁ à R₁₃, R₃₁ et R₃₂ sont chacun indépendamment :
un hydrogène, un deutérium, -F, -Cl, -Br, -I, -SF₅, -CD₃, -CD₂H, -CDH₂, -CF₃, -CF₂H, - CFH₂, un groupe cyano, un groupe alkyle en C₁ à C₆₀, un groupe alcényle en C₂ à C₆₀, un groupe alcynyle en C₂ à C₆₀, un groupe alcoxy en C₁ à C₆₀ ou un groupe alkylthio en C₁ à C₆₀ ;
un groupe représenté par l'une des Formules 9-1 à 9-61, 9-201 à 9-237, 10-1 à 10-129 ou 10-201 à 10-355 ;
un groupe représenté par l'une des Formules 9-1 à 9-61, 9-201 à 9-237, 10-1 à 10-129 ou 10-201 à 10-350 dans lesquelles au moins un hydrogène est substitué par un deutérium, -F ou un groupe cyano ; ou
-Si(Q₁)(Q₂)(Q₃), -Ge(Q₁)(Q₂)(Q₃) ou -N(Q₄)(Q₅), et
Q₁ à Q₅ sont respectivement tels que définis pour Q₁ à Q₅ dans la revendication 1 : 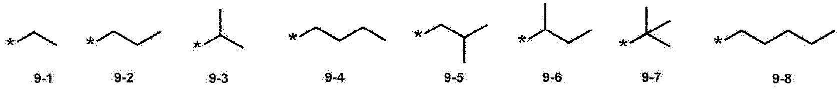 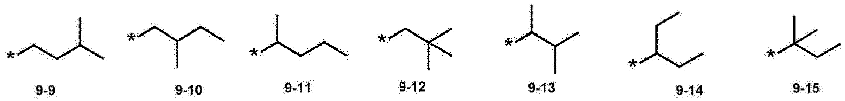 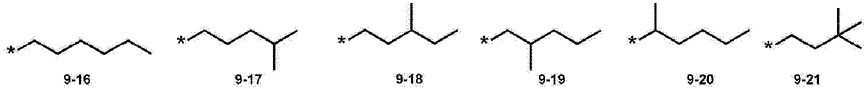 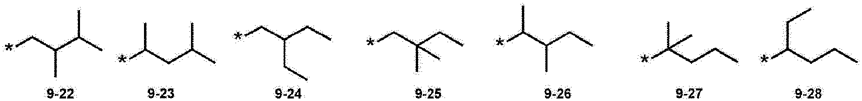 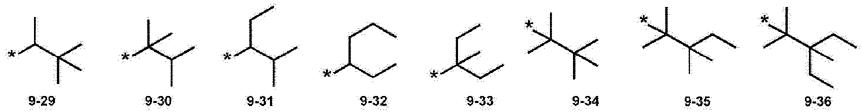 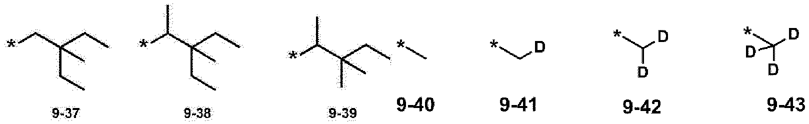 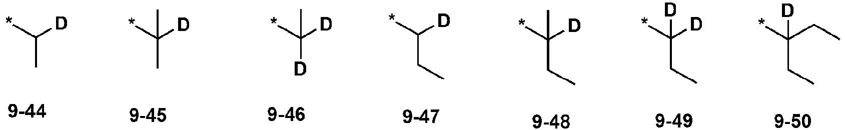 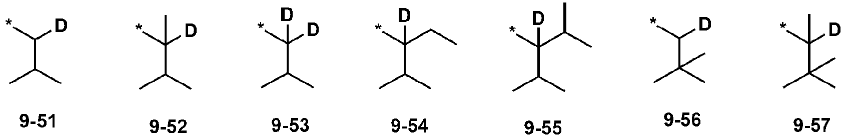 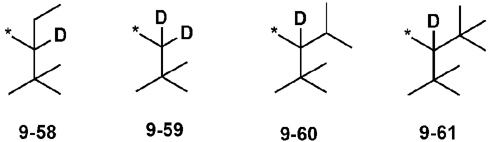 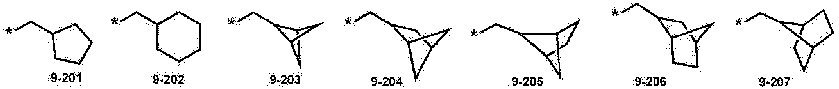 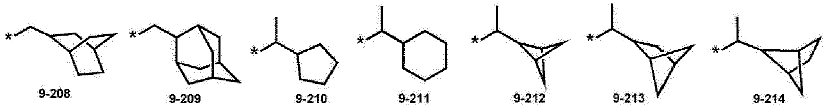 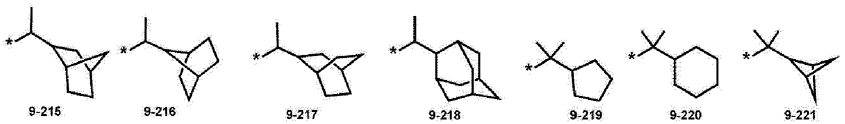 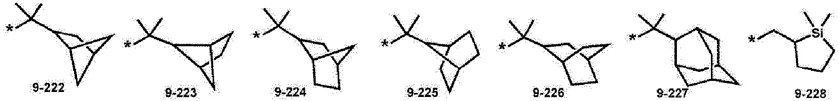 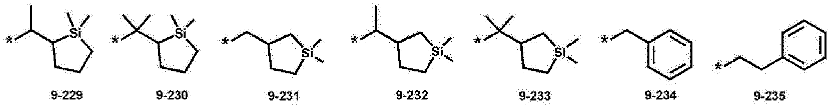 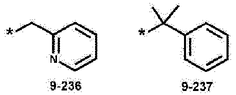 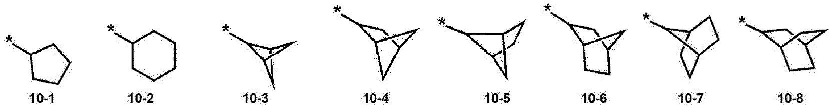 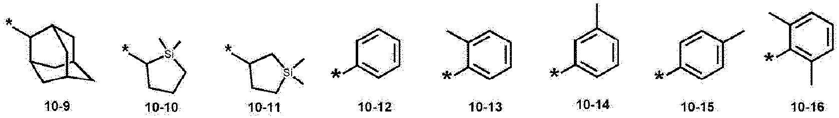 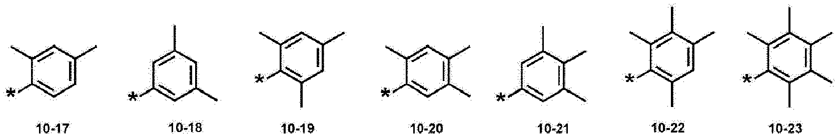 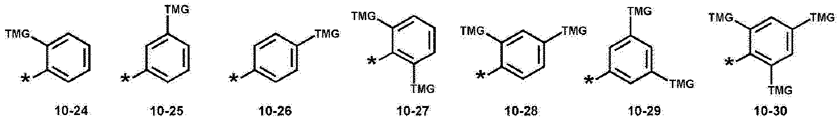 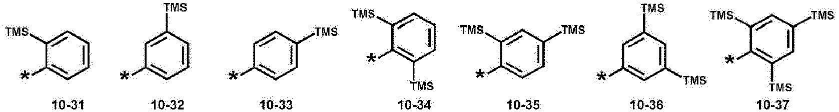 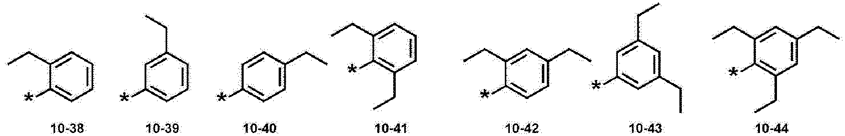 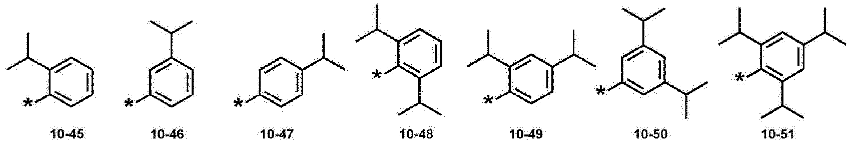 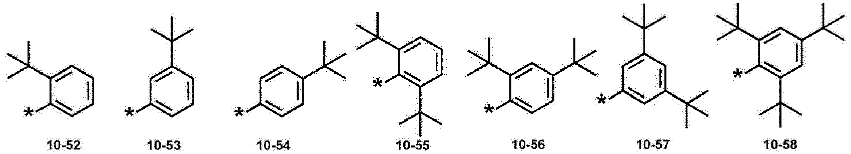 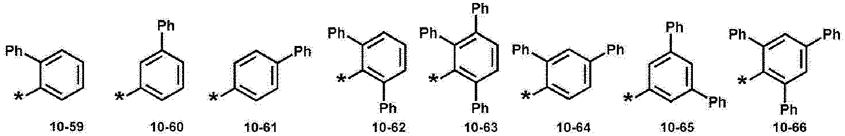 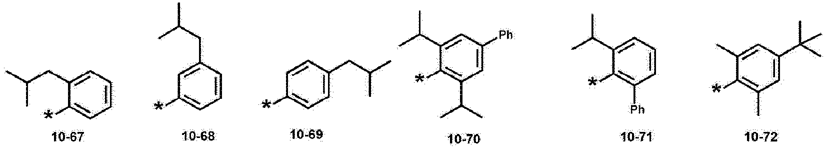 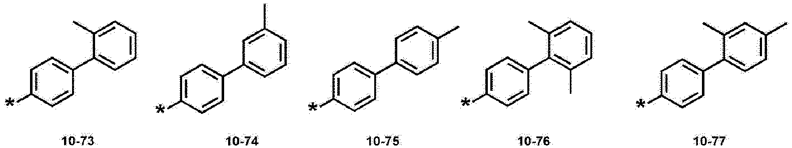 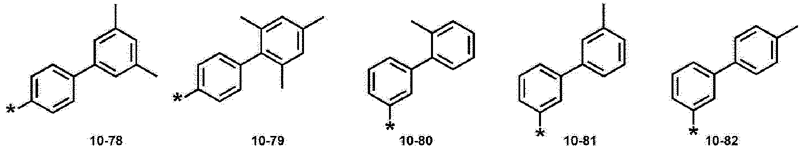 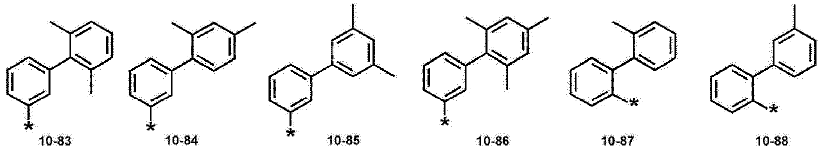 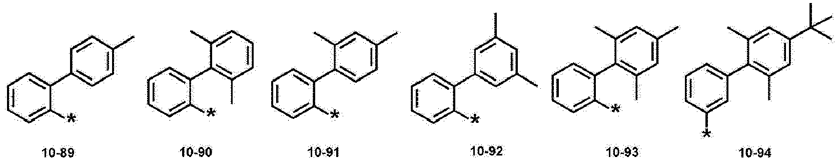 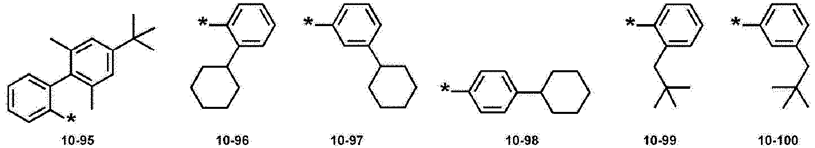 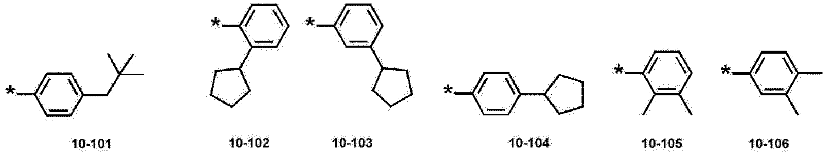 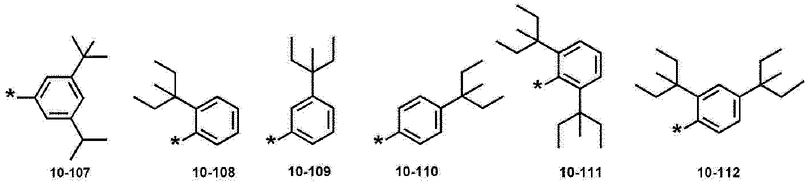 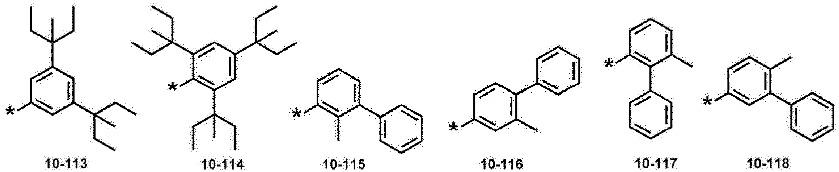 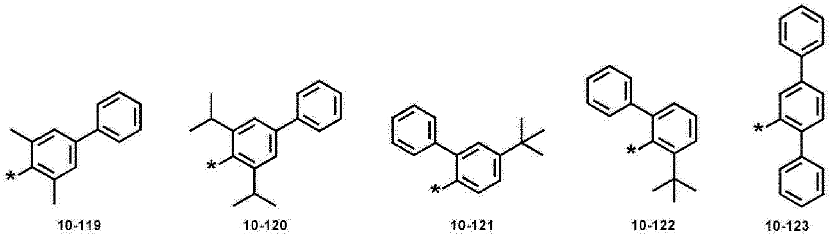 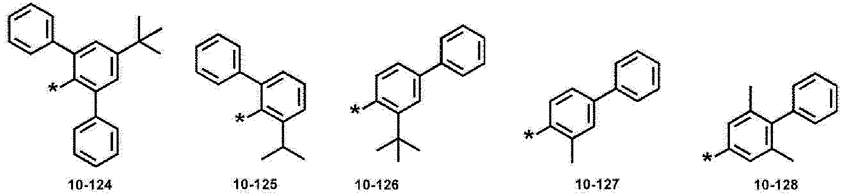 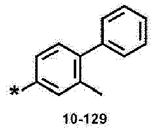 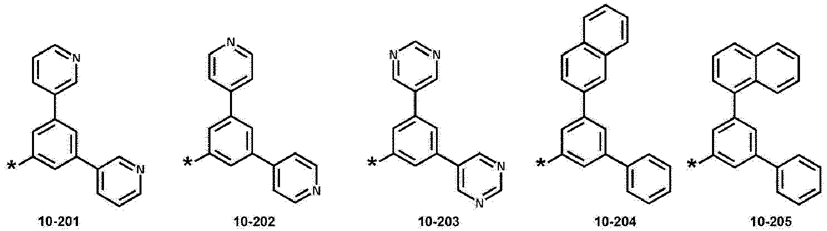 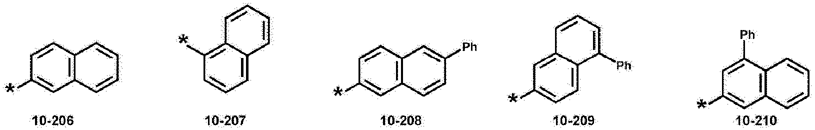 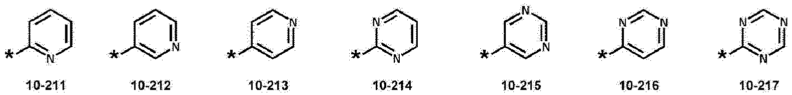 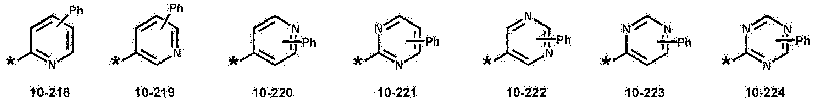 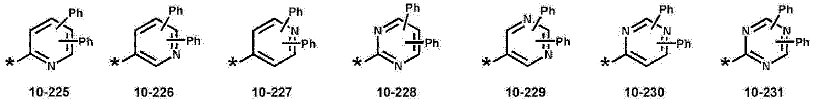 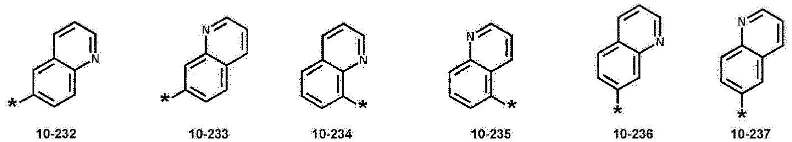 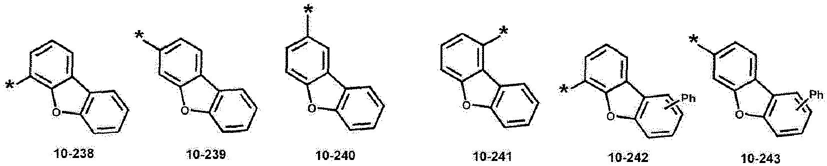 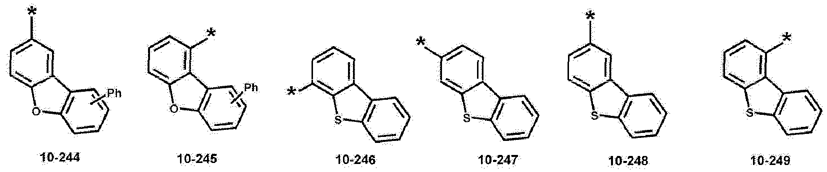 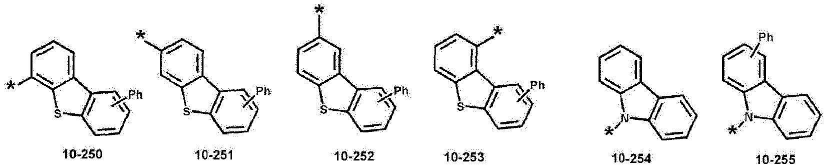 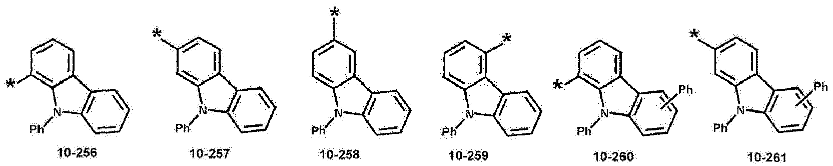 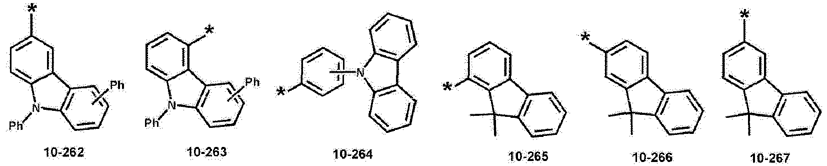 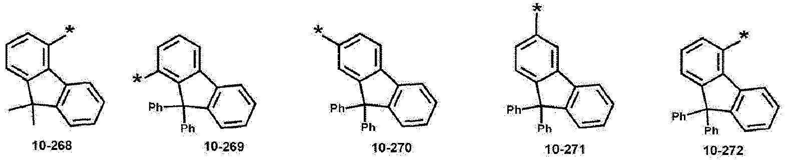 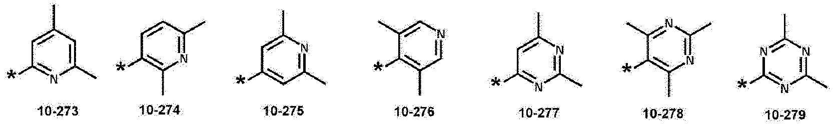 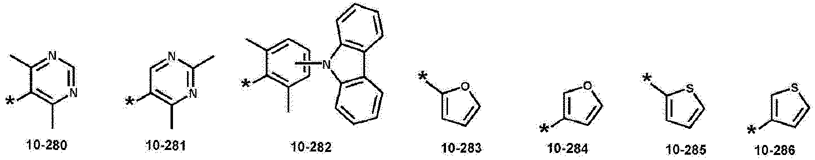 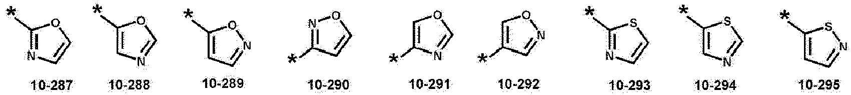 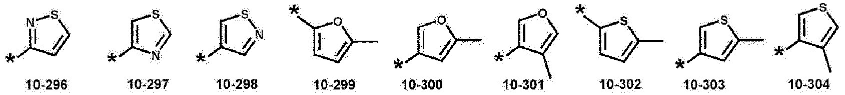 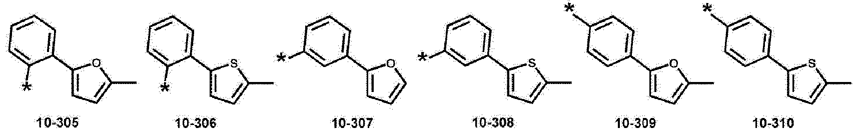 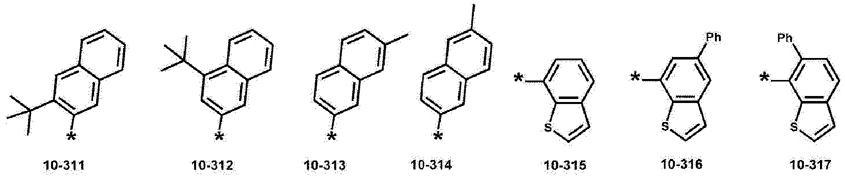 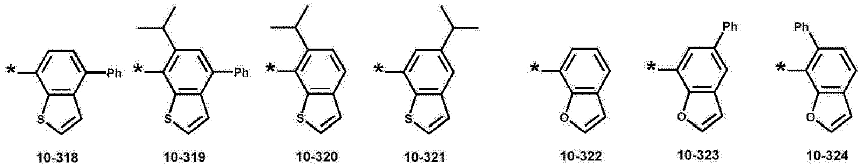 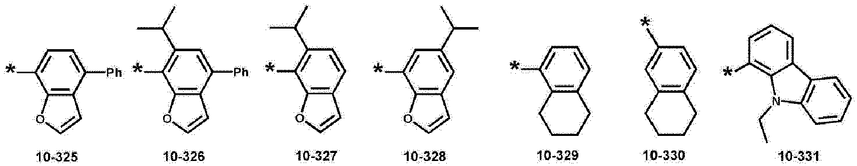 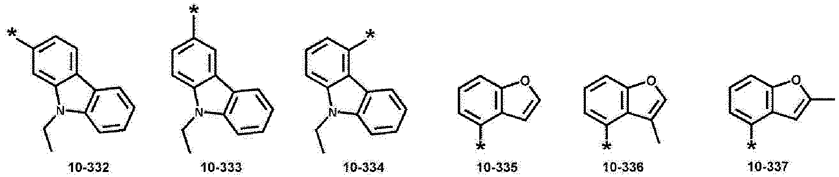 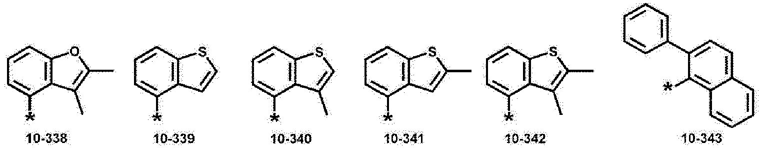 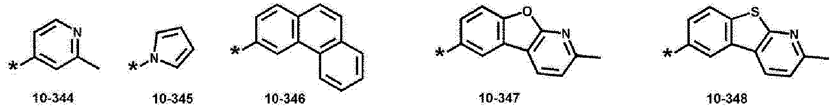 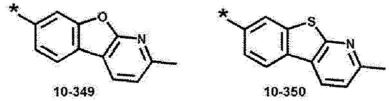 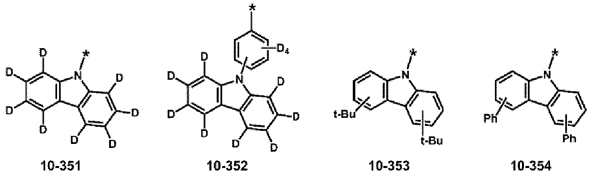 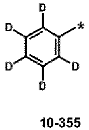
dans lequel, dans les Formules 9-1 à 9-61, 9-201 à 9-237, 10-1 à 10-129 et 10-201 à 10-355, * indique un site de liaison à un atome voisin, « Ph » indique un groupe phényle, « TMS » indique un groupe triméthylsilyle et « TMG » indique un groupe triméthylgermyle.

6. Composé organométallique de l'une quelconque des revendications 1 à 5, dans lequel un groupe représenté par 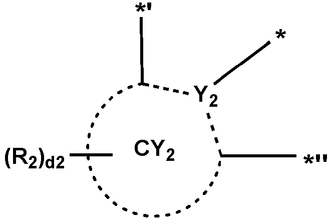 dans la Formule 1 est un groupe représenté par l'une des Formules 2-1 à 2-3 : 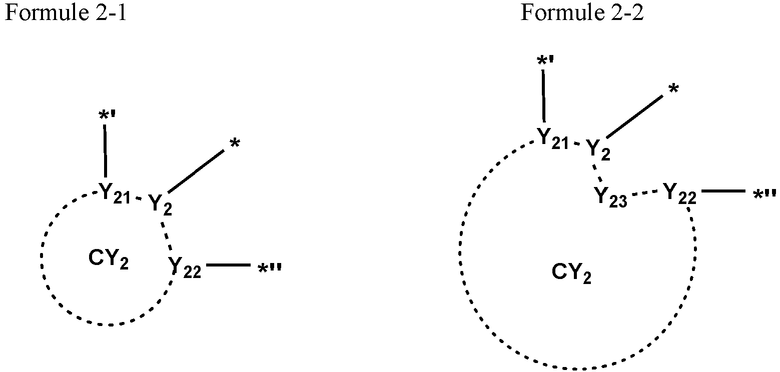 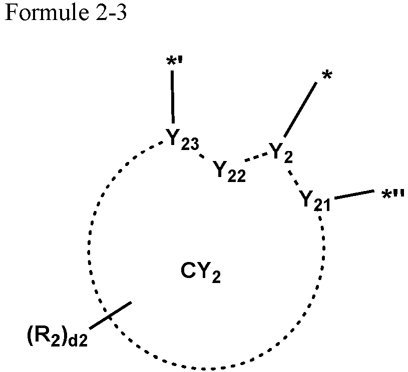 dans lequel, dans les Formules 2-1 à 2-3,
Y₂₁ à Y₂₃ sont chacun indépendamment C ou N,
Y₂₁ et Y₂ sont liés l'un à l'autre par une liaison chimique, Y₂ et Y₂₂ sont liés l'un à l'autre par une liaison chimique, Y₂ et Y₂₃ sont liés l'un à l'autre par une liaison chimique, et Y₂₂ et Y₂₃ sont liés l'un à l'autre par une liaison chimique,
*' indique un site de liaison à T₁, *" indique un site de liaison à T₂, et * indique un site de liaison à A₂ ou M, et
le cycle CY₂, Y₂, R₂ et d2 sont respectivement tels que définis pour le cycle CY₂, Y₂, R₂ et d2 dans la revendication 1 ; ou
dans lequel un groupe représenté par 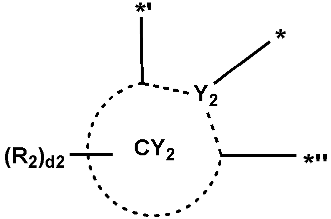
dans la Formule 1 est un groupe représenté par l'une des Formules CY2-1 à CY2-35 : 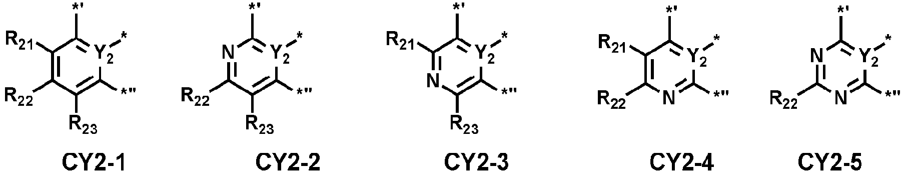 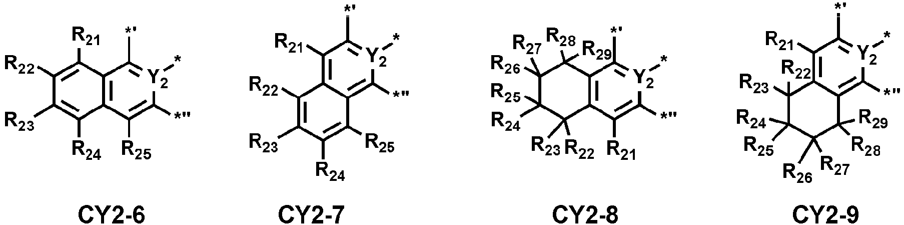 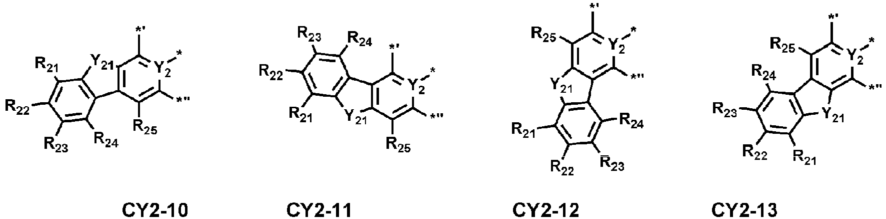 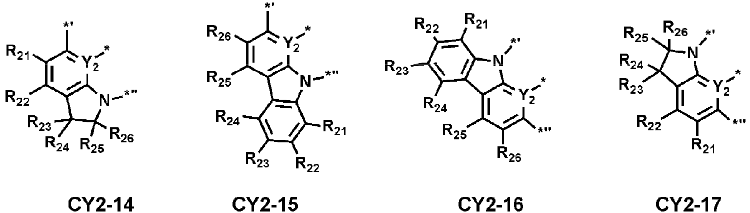 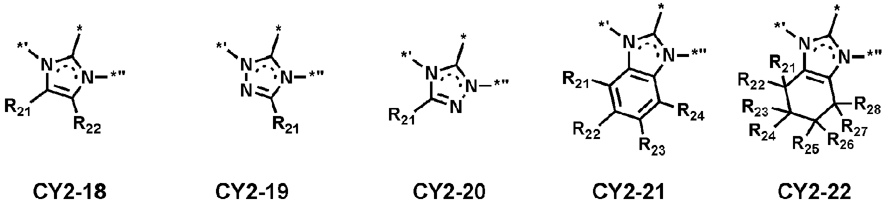 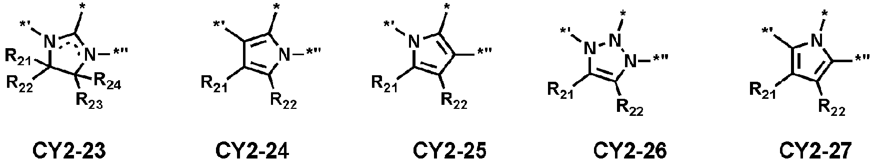 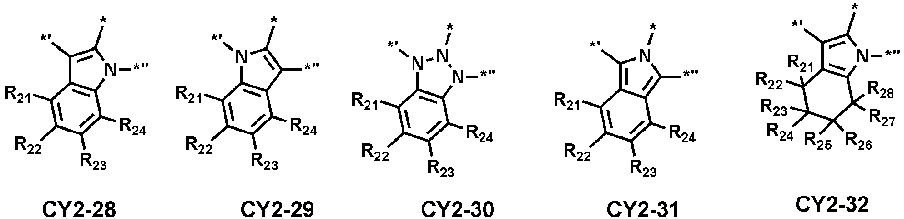 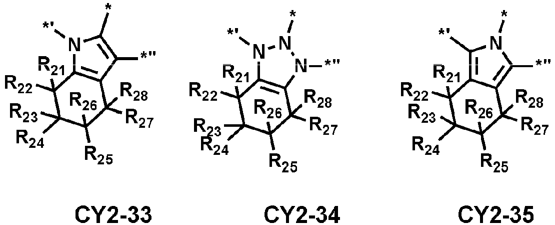
dans lequel, dans les Formules CY2-1 à CY2-35,
Y₂ est C ou N,
R₂₁ à R₂₉ sont chacun indépendamment tels que décrits pour R₂ dans la revendication 1, et
* indique un site de liaison à M ou A₂, *' indique un site de liaison à T₁, et *" indique un site de liaison à T₂.

7. Composé organométallique de l'une quelconque des revendications 1 à 6, dans lequel un groupe représenté par 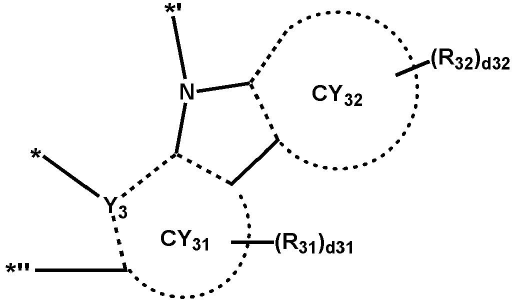 dans la Formule 1 est un groupe représenté par l'une des Formules CY3-1 à CY3-9 : 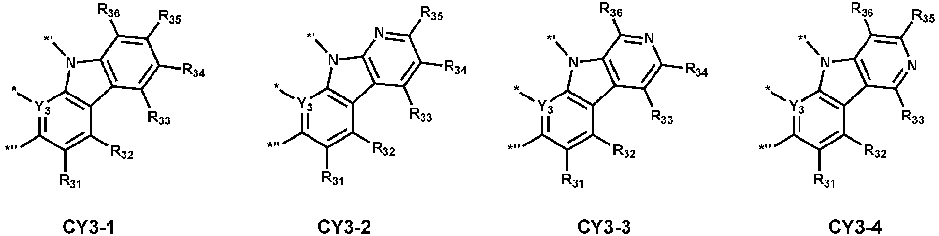 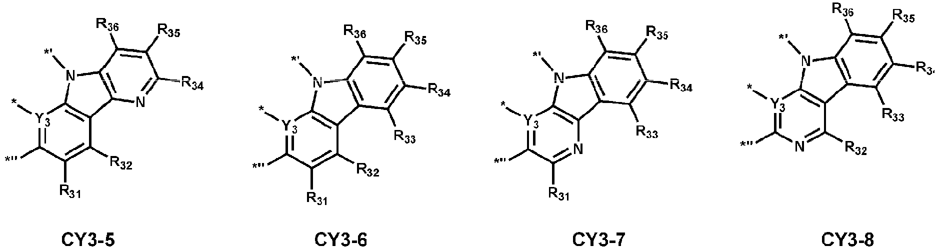 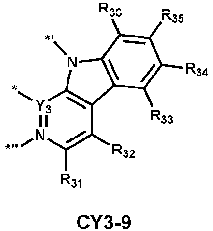 dans lequel, dans les Formules CY3-1 à CY3-9,
Y₃ est C ou N,
R₃₁ à R₃₆ sont chacun indépendamment tels que décrits pour R₃₁ dans la revendication 1, et
* indique un site de liaison à M ou A₃, *' indique un site de liaison à T₃, et *" indique un site de liaison à T₂ ; et/ou
dans lequel un groupe représenté par 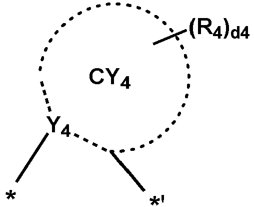
dans la Formule 1 est un groupe représenté par l'une des Formules CY4-1 à CY4-29 : 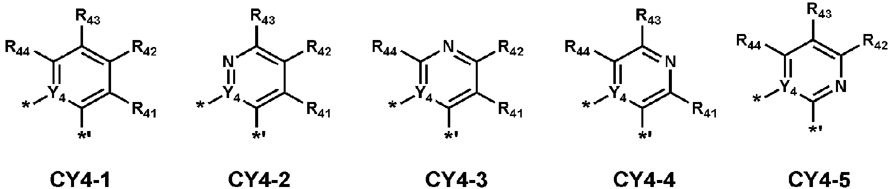 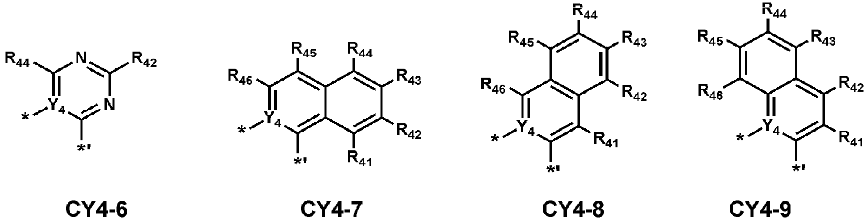 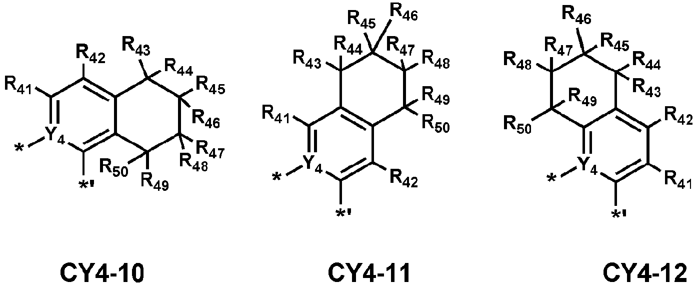 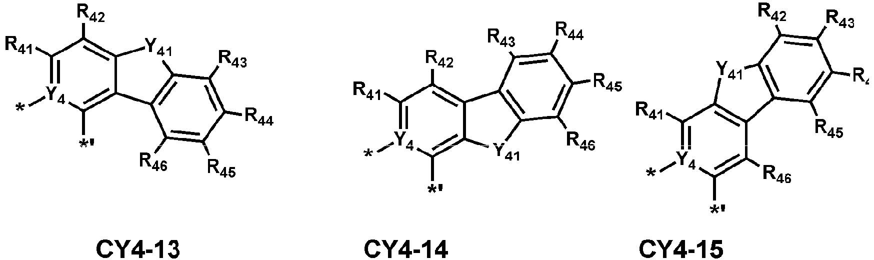 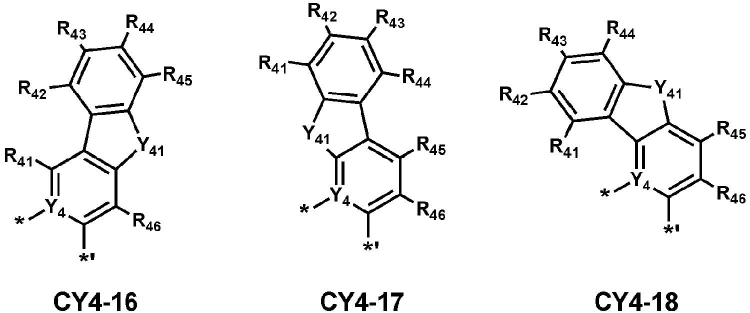 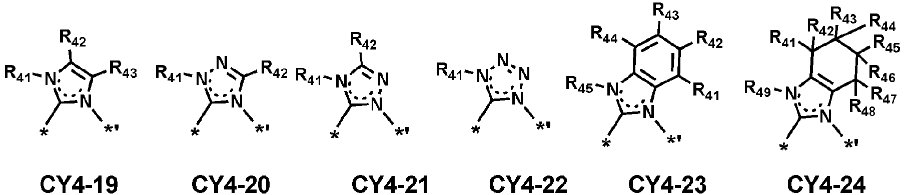 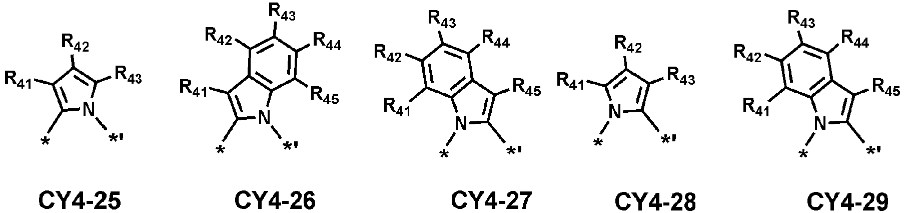
dans lequel, dans les Formules CY4-1 à CY4-29,
Y₄ est C ou N,
Y₄₁ est N(R₄₁ₐ), O, Se, C(R₄₁ₐ)(R₄₁₅) ou Si(R₄₁ₐ)(R₄₁₆), et
R₄₁ à R₅₀, R₄₁ₐ et R_{41b} sont chacun indépendamment tels que décrits pour R₄ dans la revendication 1,
* indique un site de liaison à M ou A₄, et
*' indique un site de liaison à T₃.

8. Composé organométallique de l'une quelconque des revendications 1 à 7, dans lequel le composé organométallique est représenté par les Formules 1-1 et 1-2 : 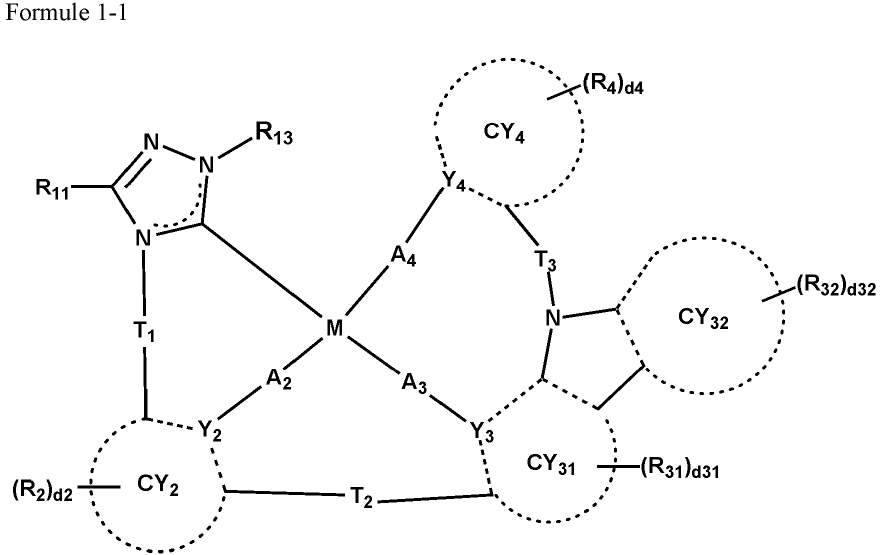 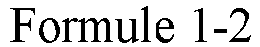 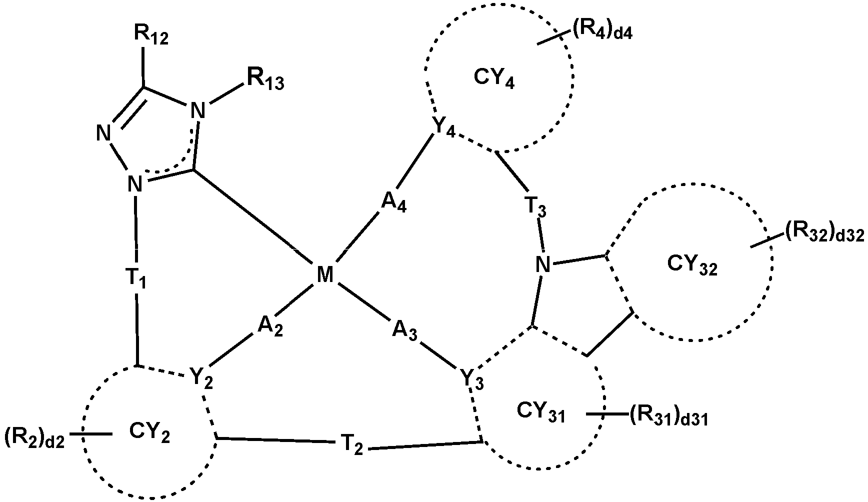 dans lequel, dans les Formules 1-1 et 1-2,
M, le cycle CY₂, le cycle CY₃₁, le cycle CY₃₂, le cycle CY₄, Y₂ à Y₄, A₂ à A₄, T₁ à T₃, R₁₁ à R₁₃, R₂, R₃₁, R₃₂, R₄, d2, d31, d32 et d4 sont respectivement tels que définis pour M, le cycle CY₂, le cycle CY₃₁, le cycle CY₃₂, le cycle CY₄, Y₂ à Y₄, A₂ à A₄, T₁ à T₃, R₁₁ à R₁₃, R₂, R₃₁, R₃₂, R₄, d2, d31, d32 et d4 dans la revendication 1.

9. Composé organométallique de l'une quelconque des revendications 1 à 8, dans lequel le composé organométallique est représenté par l'une des Formules 1-11 et 1-12 : 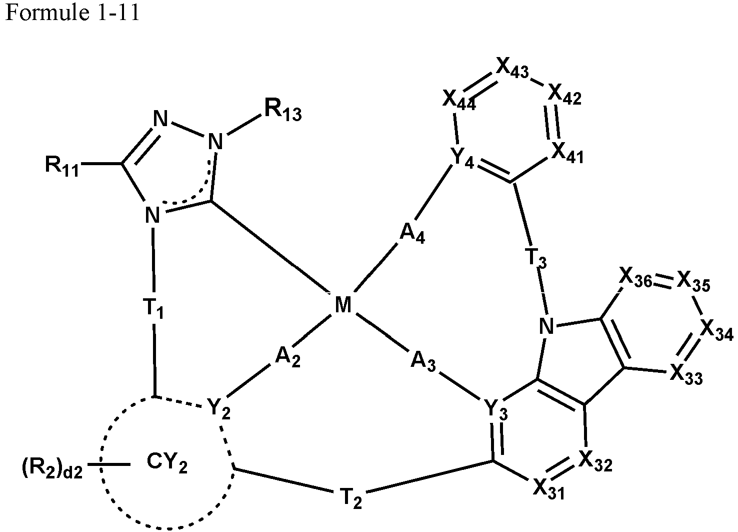 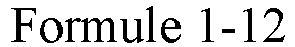 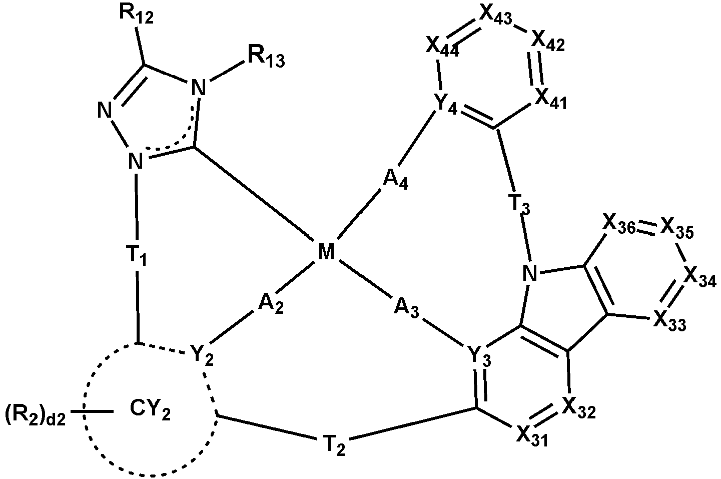 dans lequel, dans les Formules 1-11 et 1-12,
X₃₁ est C(R₃₁) ou N, X₃₂ est C(R₃₂) ou N, X₃₃ est C(R₃₃) ou N, X₃₄ est C(R₃₄) ou N, X₃₅ est C(R₃₅) ou N, et X₃₆ est C(R₃₆) ou N,
X₄₁ est C(R₄₁) ou N, X₄₂ est C(R₄₂) ou N, X₄₃ est C(R₄₃) ou N, et X₄₄ est C(R₄₄) ou N,
R₃₁ à R₃₆ sont chacun indépendamment tels que décrits pour R₃₁ dans la revendication 1,
R₄₁ à R₄₄ sont chacun indépendamment tels que décrits pour R₄ dans la revendication 1, et
M, le cycle CY₂, Y₂ à Y₄, A₂ à A₄, T₁ à T₃, R₁₁ à R₁₃, R₂ et d2 sont respectivement tels que définis pour M, le cycle CY₂, Y₂ à Y₄, A₂ à A₄, T₁ à T₃, R₁₁ à R₁₃, R₂ et d2 dans la revendication 1.

10. Composé organométallique de l'une quelconque des revendications 1 à 9, dans lequel un niveau d'énergie de la plus haute orbitale moléculaire occupée (HOMO) du composé organométallique est de -5,25 électron-volts ou moins.

11. Dispositif électroluminescent organique, comprenant :
une première électrode ;
une seconde électrode ; et
une couche organique agencée entre la première électrode et la seconde électrode,
dans lequel la couche organique comprend une couche d'émission, et
dans lequel la couche organique comprend en outre au moins l'un du composé organométallique de l'une quelconque des revendications 1 à 10.

12. Dispositif électroluminescent organique de la revendication 11, dans lequel la couche d'émission comprend l'au moins un du composé organométallique ;
de préférence dans lequel la couche d'émission émet une lumière possédant une longueur d'onde d'émission maximale de 440 nanomètres à 470 nanomètres.

13. Dispositif électroluminescent organique de l'une des revendications 11 ou 12, dans lequel
la première électrode est une anode,
la seconde électrode est une cathode,
la couche organique comprend en outre une région de transport de trous agencée entre la première électrode et la couche d'émission et une région de transport d'électrons agencée entre la couche d'émission et la seconde électrode,
la région de transport de trous comprend une couche d'injection de trous, une couche de transport de trous, une couche de blocage d'électrons, une couche tampon, ou une combinaison de celles-ci, et
la région de transport d'électrons comprend une couche de blocage de trous, une couche de transport d'électrons, une couche d'injection d'électrons ou une combinaison de celles-ci.

14. Appareil électronique, comprenant le dispositif électroluminescent organique de l'une quelconque des revendications 11 à 13.
